(19)

**Europäisches Patentamt**
**European Patent Office**
**Office européen des brevets**

(11) **EP 1 801 861 B1**

(12) **EUROPEAN PATENT SPECIFICATION**

(45) Date of publication and mention
of the grant of the patent:
**03.10.2012 Bulletin 2012/40**

(51) Int Cl.:
**H01L 21/00** *(2006.01)*   **H01L 21/02** *(2006.01)*

(21) Application number: **05758323.9**

(22) Date of filing: **08.07.2005**

(86) International application number:
**PCT/JP2005/012662**

(87) International publication number:
**WO 2006/006526 (19.01.2006 Gazette 2006/03)**

(54) **METHOD AND DEVICE FOR TREATING OUTER PERIPHERY OF A SUBSTRATE**

VERFAHREN UND EINRICHTUNG ZUM BEHANDELN DER ÄUSSEREN PERIPHERIE EINES
SUBSTRATS

MÉTHODE ET DISPOSITIF POUR TRAITER LA PÉRIPHÉRIE EXTÉRIEURE D'UN SUBSTRAT

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **09.07.2004  JP 2004203993**
        **09.07.2004  JP 2004203994**
        **22.10.2004  JP 2004308597**
        **26.10.2004  JP 2004311140**
        **26.11.2004  JP 2004342993**
        **26.11.2004  JP 2004342994**
        **09.03.2005  JP 2005066296**
        **09.03.2005  JP 2005066297**
        **05.07.2005  JP 2005195960**
        **05.07.2005  JP 2005195961**
        **05.07.2005  JP 2005195962**
        **05.07.2005  JP 2005195963**
        **05.07.2005  JP 2005195964**
        **05.07.2005  JP 2005195965**
        **05.07.2005  JP 2005195966**

(43) Date of publication of application:
**27.06.2007  Bulletin 2007/26**

(60) Divisional application:
**07012585.1 / 1 833 078**

(73) Proprietor: **SEKISUI CHEMICAL CO., LTD.**
**Osaka-shi,**
**Osaka 530-8565 (JP)**

(72) Inventors:
• **NOGAMI, Mitsuhide**
  **Hachioji-city, Tokyo 1920906 (JP)**
• **HASEGAWA, Taira**
  **Hachioji-city, Tokyo 1920906 (JP)**
• **KUNUGI, Syunsuke**
  **Hachioji-city, Tokyo 1920906 (JP)**

(74) Representative: **Merkle, Gebhard**
**TER MEER STEINMEISTER & PARTNER GbR,**
**Patentanwälte**
**Mauerkircherstrasse 45**
**81679 München (DE)**

(56) References cited:
**JP-A- 03 241 741      JP-A- 08 279 494
JP-A- 10 189 515      JP-A- 2000 124 189
JP-A- 2003 197 570      JP-A- 2003 197 570
JP-A- 2003 243 380      JP-A- 2003 273 075
US-A1- 2002 030 047**

• **KUNUGI S. ET AL DENSHI ZAIRYO vol. 44, no. 3,
01 March 2005, pages 69 - 73, XP003004614**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

[TECHNICAL FIELD]

This invention relates to a method for removing unnecessary matters such as organic films coated on the outer peripheral part of a substrate such as a semiconductor wafer, a liquid crystal display substrate or the like.

[BACKGROUND ART]

As means for coating or depositing a thin film such as an insulative film an organic resist, polyimide on a substrate such as, for example, a semiconductor wafer, a liquid crystal display glass substrate or the like, there are known various methods/processes such as a spin coating process, methods for deposition of a thin film by means of CVD and PVD, and the like. However, in the spin coating technique, the coating matter is coated heavier on the outer peripheral part than on the central part of the substrate and thus, the outer peripheral part is swollen. Moreover, in case the plasma CVD, for example, is used as CVD, the electric field is concentrated on the edge part of the outer periphery of the substrate. Since this results in abnormal growth of film, the film is likely more increased in thickness on the outer peripheral part than on the central part. In case of the thermal CVD using $O_3$, TEOS or the like, film on the outer peripheral part of the substrate becomes different in quality from that on the central part because the reactive gas is different in conductance between the outer peripheral part of the substrate and the central part. This means that the film is also more increased in thickness on the outer peripheral part of the substrate than on the central part.

In the manufacturing process of a semiconductor wafer, the fluorocarbon, which is deposited during anisotropic etching, is flowed around to the rear surface of the wafer from the outer end face and deposited there, too. As a result, unnecessary organic matters are adhered to the outer peripheral part of the rear surface of the wafer.

Such thin film on the outer peripheral part of the substrate is readily broken during the time the substrate is transported by a transport conveyor or during the time the substrate received in a transport cassette is transported in that condition. This is liable to generate dust, thus adhering particles onto the wafer and reducing the yield of production.

Conventionally, the film formed by fluorocarbon flowing around to the rear surface of the wafer during anisotropic etching is removed by sending the $O_2$ plasma around to the rear surface of the wafer from the front surface through the dry ashing processing, for example. However, in case of low-k film, it is damaged when subjected to dry ashing. In order to avoid damage, some attempt is made to process the film with a low output power. However, it is difficult to completely remove the fluorocarbon deposited on the rear surface of the wafer, and particles are generated during transportation of the substrate or under other similar conditions. This turns out to be the chief cause for low yield of production.

As prior art documents teaching the technique for processing the outer peripheral part of a semiconductor wafer, the followings are known, for example.

Patent Document 1: Japanese Patent Application Laid-Open No. H05-82478 discloses that the central part of a semiconductor wafer is covered with a pair of upper and lower holders and the outer peripheral part of the wafer is allowed to project so that plasma can be sprayed onto the projected part of the wafer. However, since this technique is for physically contacting an O-ring of the holders to the wafer, there is possibility for generating particles.
Patent Document 2: Japanese Patent Application Laid-Open No. H08-279494 discloses that the central part of a substrate is placed on a stage and plasma is sprayed onto the outer peripheral part from above.
Patent Document 3: Japanese Patent Application Laid-Open No. H10-189515 discloses that plasma is sprayed onto the outer peripheral part of a substrate from below
Patent Document 4: Japanese Patent Application Laid-Open No. 2003-264168 discloses that a wafer is placed on a stage and attractingly chucked so as to be rotated, and then, a reactive gas composed of ozone and hydrofluoric acid is vertically sprayed onto the front surface of the outer peripheral part of the wafer through a gas supply nozzle while heating the outer peripheral part of a wafer in a contact manner from its reverse side by a heater embedded in the outer periphery of the stage.
Patent Document 5: Japanese Patent Application Laid-Open No. 2004-96086 discloses that the outer peripheral part of a wafer is inserted in the interior of a C-shaped member and an oxide radical is sprayed onto the outer peripheral part of the wafer from the ceiling of the interior of the C-shaped member while radiantly heating the outer peripheral part of the wafer by an infrared lamp and the outer peripheral part of the wafer is sucked through a suction port formed on the innermost side of the interior of the C-shaped member.

In general, a cutout part such as an orientation flat, a notch or the like is formed in the outer peripheral part of a wafer for the purposes of indication of crystal orientation and positioning with respect to the stage. In order to remove the unnecessary film adhered to the edge of the cutout part, an action is required in match with the contour of the cutout part. In a technique disclosed by Patent Document 6: Japanese Patent Application Laid-Open No. H05-144725, a nozzle for an orientation flat is provided separately from a main nozzle for processing the circular part of a wafer, and the nozzle for an orientation flat is linearly moved along the orientation flat part, thereby processing the orientation flat part.

Patent Document 7: Japanese Patent Application Laid-Open No. 2003-188234 discloses that a plurality of pins are abutted with the outer periphery of a wafer from mutually different angles in order to perform alignment of the wafer. In Patent Document 8: Japanese Patent Application Laid-Open No. 2003-152051 and in Patent Document 9: Japanese Patent Application Laid-Open No. 2004-47654, eccentricity of a wafer is detected in a non-contact manner using an optical sensor and correction is made by a robot arm based on this detection result and then, the wafer is set on a processing stage.

[Patent Document 1] Japanese Patent Application Laid-Open No. H05-82478
[Patent Document 2] Japanese Patent Application Laid-Open No. H08-279494
[Patent Document 3] Japanese Patent Application Laid-Open No. H10-189515
[Patent Document 4] Japanese Patent Application Laid-Open No. 2003-264168
[Patent Document 5] Japanese Patent Application Laid-Open No. 2004-96086
[Patent Document 6] Japanese Patent Application Laid-Open No. H05-144725
[Patent Document 7] Japanese Patent Application Laid-Open No. 2003-188234
[Patent Document 8] Japanese Patent Application Laid-Open No. 2003-152051
[Patent Document 9]: Japanese Patent Application Laid-Open No. 2004-47654
Reference is also made to prior art documents US-A1-2002 036047 and JP 2003 197570.

[DISCLOSURE OF THE INVENTION]

[PROBLEM TO BE SOLVED BY THE INVENTION]

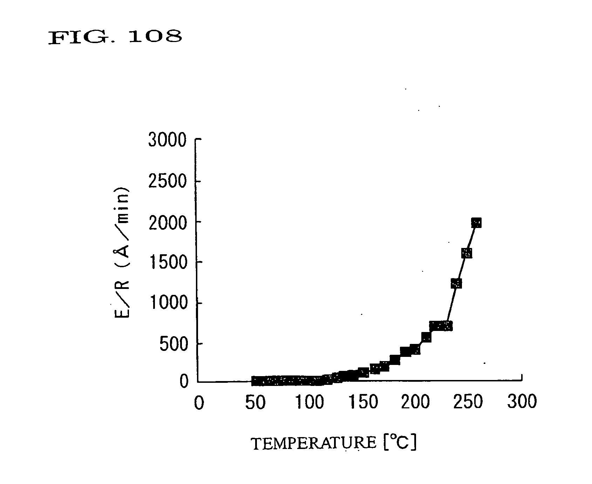

Heating is required in order to efficiently remove organic films such as photoresist and low-k film, and organic matters such as fluorocarbon deposited during etching under normal pressure using a reactive gas such as ozone. For example, as shown in FIG. 108, in case photoresist is removed as unnecessary organic film, reaction hardly occurs until the temperature reaches the level of approximately 100 degrees C and the etching rate rises at the level of approximately 150 degrees C. The etching rate is almost linearly increased at the level of more than 200 degrees C with respect to temperature. However, if the entire wafer is exposed to high-temperature atmospheric air, wiring, insulative film, etc. are changed in quality (for example, oxidation of Cu occurs and low-k is changed in characteristic). This adversely affects to device characteristic and tends to spoil the reliability. In the above-mentioned Patent Documents, a heater is abutted with the outer peripheral part from which film is to be removed. However, there is such a fear that heat is conducted from the outer peripheral part of a substrate to the central part and the central part is also heated to high temperature. Moreover, in case the heater is an infrared lamp or the like, there is such a fear that the infrared ray is also irradiated to the central part of the substrate, thus directly heating the central part to high temperature. If a reactive gas such as ozone is flowed into the high-temperature central part of the substrate, there is such an undesirable possibility that even the film on the central part is subjected to etching. Moreover, this is such a fear that the film on the central part of the substrate is changed in quality.

[MEANS FOR SOLVING THE PROBLEM]

In order to solve the above-mentioned problem, according to the present invention, there is provided an apparatus according to claim 2
Also, there is provided a method according to claim 1.
More preferably, the method comprises bringing the substrate into contact with a support surface of a stage so as to be supported thereon, locally radiantly heating the outer peripheral part of the substrate by thermal light, supplying the reactive gas to the local area, and heat absorbing a part located inside the outer peripheral part by a heat absorbing means disposed on the stage.
Owing to the above-mentioned arrangement, the unnecessary matter coated on the outer peripheral part of the substrate can be removed effectively. On the other hand, even in case heat is conducted to the area (central part) inside the outer peripheral part of the substrate from the outer peripheral part or heat of the heater is applied directly thereto, the heat can be absorbed by the heat absorbing means. This makes it possible to prevent the film and wiring at the area inside the substrate from being changed in quality. Moreover, even in case the reactive gas is flowed inside the outer peripheral part of the substrate from the outer peripheral side, reaction can be restrained. This makes it possible to prevent the area inside the peripheral part of the substrate from being damaged.

It is preferable that the support surface of the stage is slightly smaller than the substrate, and the target position

which is supposed to exist on the outer peripheral part of the substrate is located on a surface extending radially outward from support surface.

The heat absorbing means is, for example, a refrigerator for cooling the stage.

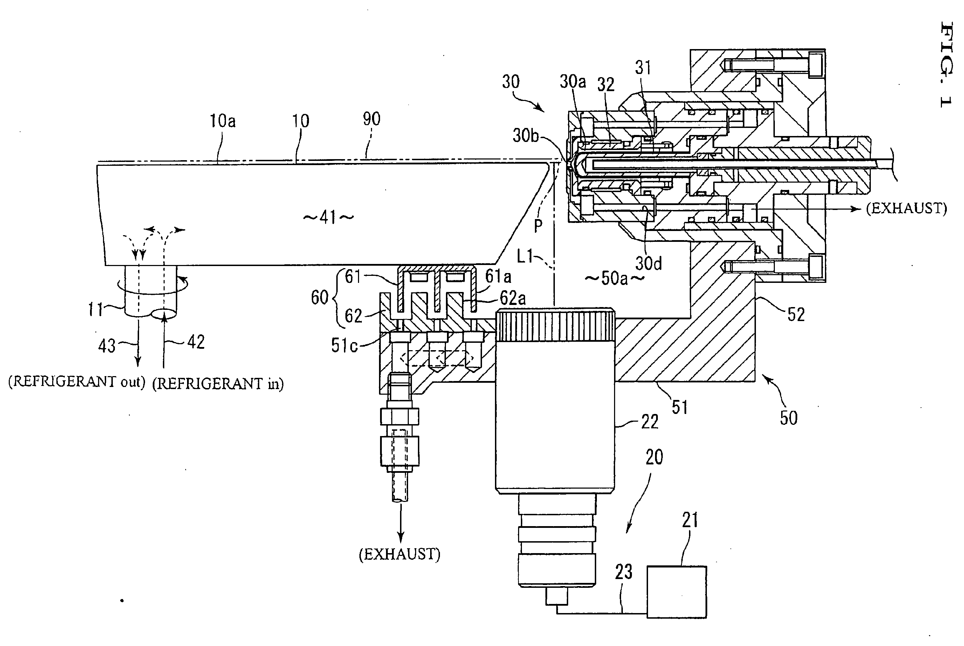

As a specific example thereof, a refrigerant chamber as the heat absorbing means is formed within the stage, and the refrigerant chamber is connected with a refrigerant supply path and a refrigerant exhaust path (see FIGS. 1, 6, 7 and 10, as well as elsewhere). By sending the refrigerant into this refrigerant chamber so as to be filled, flowed or circulated therein, heat can be absorbed from the substrate. By increasing the internal volume of the refrigerant chamber, the heat capacity or heat absorbing performance can be increased sufficiently. As the refrigerant, water, air, helium or the like is used, for example. The refrigerant may be vigorously supplied into the refrigerant chamber by being compressed or by some other suitable means. This makes it possible for the refrigerant to evenly flow into every corner of the refrigerant chamber and thus, the heat absorbing efficiency can be enhanced. It should be noted that the refrigerant may be supplied gently or the refrigerant once supplied into the refrigerant chamber may be held as it is without being additionally supplied/ exhausted because the heat absorbing property can be obtained by natural convection taken place in the refrigerant chamber. The refrigerant supply path and the refrigerant exhaust path connected to the refrigerant chamber may be composed of a common path.

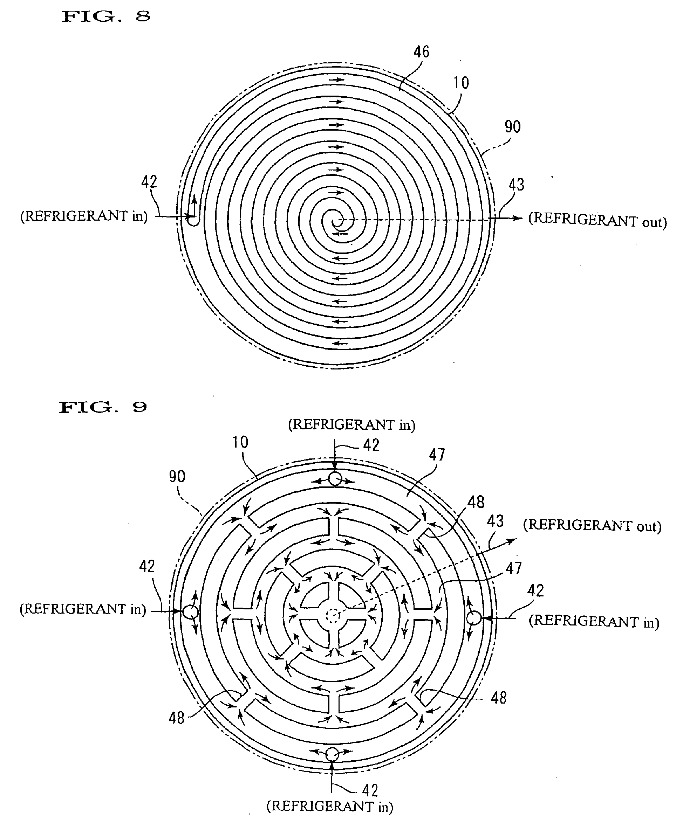

It is also accepted that a refrigerant path composed of a tube or the like is disposed within or at the rear side (surface on the other side of the support surface) as said heat absorbing means and the refrigerant is passed through this refrigerant path (see FIGS. 8 and 9, as well as elsewhere).

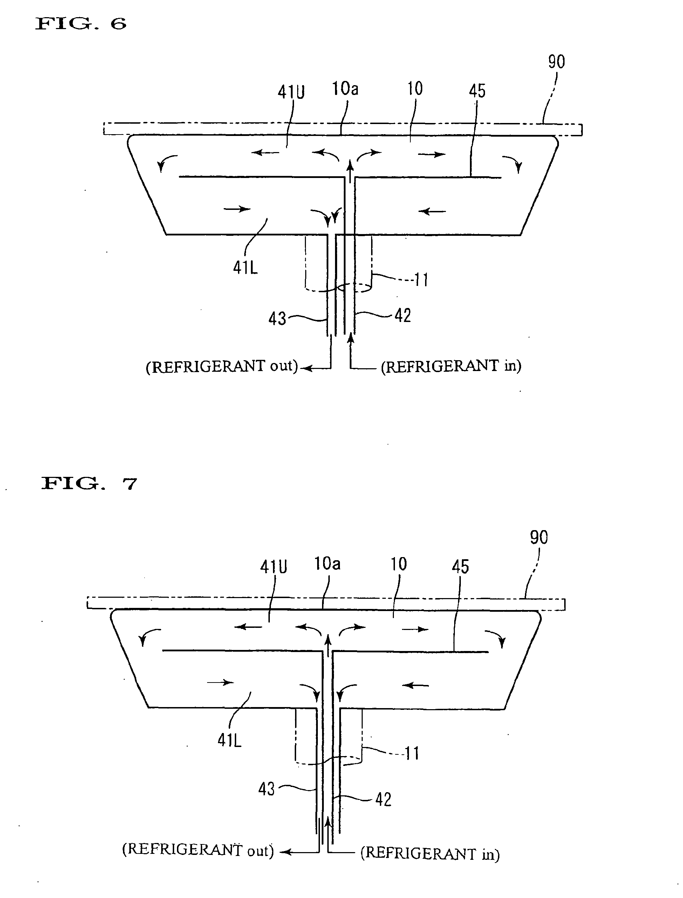

The refrigerant path may be formed in such a manner as to be extended from the support surface side part within the stage to the part on the other side of the support surface (see FIGS. 6 and 7, as well as elsewhere). Owing to this arrangement, the heat absorbing efficiency can be more enhanced. It is also accepted that a chamber is formed within the stage, this chamber is partitioned into a first chamber part on the support surface side and a second chamber part on the other side of the first chamber part, the first and second chamber parts are communicated with each other, the first chamber part constitutes a path part on the upstream side of the refrigerant path and the second chamber part constitutes a path part on the downstream side of the refrigerant path (see FIGS. 6 and 7, as well as elsewhere).

The refrigerant path may be formed in such a manner as to extend from the outer peripheral part of the stage to the central part (see FIGS. 8 and 9, as well as elsewhere). Owing to this arrangement, the near side to the outer peripheral part of the substrate can fully be cooled, the heat conducted from the outer peripheral part of the substrate can reliably be absorbed, and the film coated on the central part can reliably be protected. The refrigerant path is in a spiral form, for example (see FIG. 8, as well as elsewhere). In the alternative, the refrigerant path includes a plurality of concentric annular paths and a communication path for interconnecting the annular paths (see FIG. 9, as well as elsewhere).

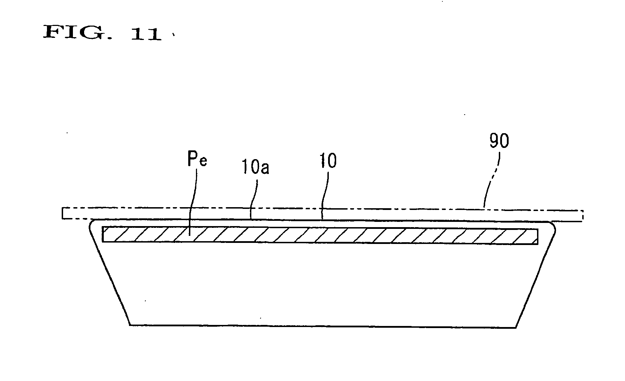

The heat absorbing means may include a peltier element having a heat absorbing side and disposed within the stage with the heat absorbing side thereof facing the support surface (see FIG. 11, as well as elsewhere). The peltier element is preferably disposed near the support surface. Moreover, the peltier element may be provided at a rear side (heat radiating side) with a fan, fin or the like for enhancing heat radiation.

The heat absorbing means may be provided over the entire area of the stage (see FIGS. 1 through 11, as well as elsewhere). Owing to this arrangement, heat can be absorbed from the generally entire support surface.

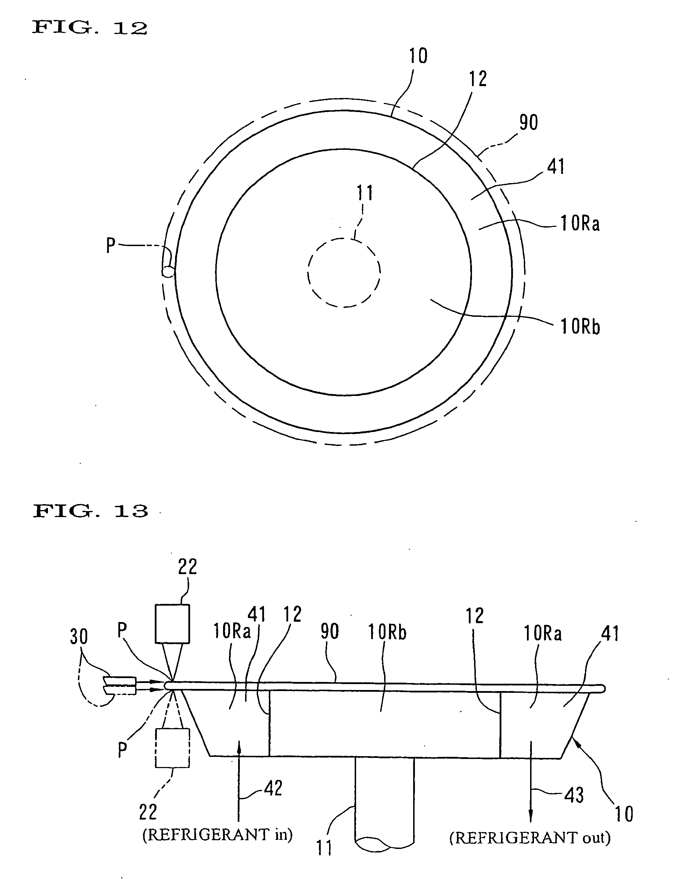

The heat absorbing means may be disposed at least at the outer peripheral part of the stage=and not at the central part (see FIGS. 13, 21 and 23, as well as elsewhere).

The heat absorbing means may be disposed only at the outer peripheral side part of the stage and not at the central side part (see FIGS. 13, 21 and 23, as well as elsewhere).

Owing to the above-mentioned arrangement, heat can be absorbed only from the outer peripheral side of the support surface, and heat can reliably be absorbed and removed from the outer peripheral side part of the substrate which is located outside the outer peripheral side of the support surface. On the other hand, it can be prevented that the central side part is also heat-absorbed and cooled and thus, the heat absorbing source can be saved.

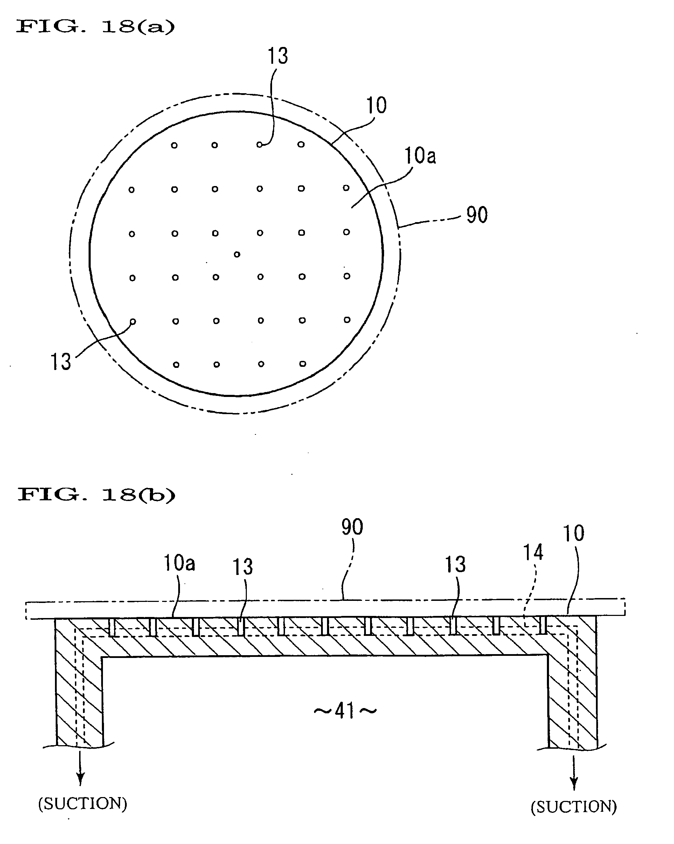

The stage is preferably incorporated with an electrostatic or vacuum chuck mechanism for sucking the substrate as a means for fixing the substrate (see FIGS. 18 through 23, as well as elsewhere). Owing to this arrangement, the substrate can firmly be contacted with the support surface, and the sucking performance can reliably be obtained. It is also accepted to use a mechanical chuck mechanism of the drop-in method. However, in case the mechanical chuck mechanism is used, the film coated on a part of the outer peripheral part of the substrate is physically contacted with the mechanical chuck. Therefore, it is desirable to use, as much as possible, the electrostatic chuck mechanism or the vacuum chuck mechanism. The suction hole and the suction groove of the vacuum chuck mechanism are preferably made as small as possible. Owing to this arrangement, the contact area between the substrate and the stage can be increased and the heat absorbing efficiency can be enhanced.

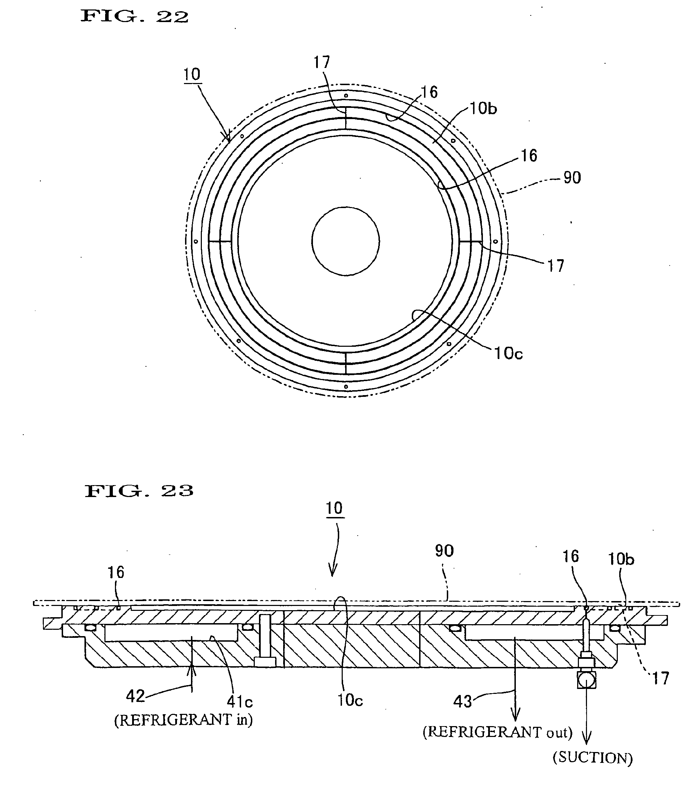

The chuck mechanism is preferably disposed only at the outer peripheral part of the stage and not at the central side part (see FIGS. 22 and 23, as well as elsewhere). More preferably, the stage is disposed at the central side support part with a recess which is depressed with respect to the outer peripheral side part (see FIGS. 22 and 23, as well as elsewhere).

Owing to the above-mentioned arrangement, the contact area between the stage and the substrate can be reduced, and the particles attributable to suction can be reduced, too. In the case where the heat absorbing means is disposed only at the outer peripheral side part of the stage, the heat, which tends to be conducted to the inside part of the wafer from the outer peripheral part can reliably be absorbed and so, the central part of the wafer can reliably be prevented from heating because the outer peripheral part of the stage is in contact with the wafer.

The chuck mechanism may be provided over the generally entire area of the support surface of the stage (see FIGS. 18 through 21, as well as elsewhere).

The components of the gas are selected depending on the unnecessary matters which are to be removed. In case the unnecessary matters which are to be removed are organic films such as fluorocarbon, it is preferable to use gases containing oxygen and more preferable to use gases containing such highly reactive gases as ozone and $O_2$ plasma. It is also accepted that the pure gases and air containing normal oxygen which is not ozonized nor radicalized are used as they are.

The ozone ($O_3$) is decomposed into oxygen particles and oxygen atoms ($O_2 + O$) and a thermal equilibrium state of ($O_3$) and ($O_2 + O$) is created. The life of ozone depends on temperature. The ozone has a good long life in the vicinity of 25 degrees C but the life of ozone is reduced to a half when the temperature is lowered to the vicinity of 50 degrees C.

In case the unnecessary matters to be removed are inorganic films, 03 may be added with parfluorocarbon (PFC) so as to be plasmatized. Also, the reactive gas may be a gas containing acid such as hydrofluoric acid vapor.

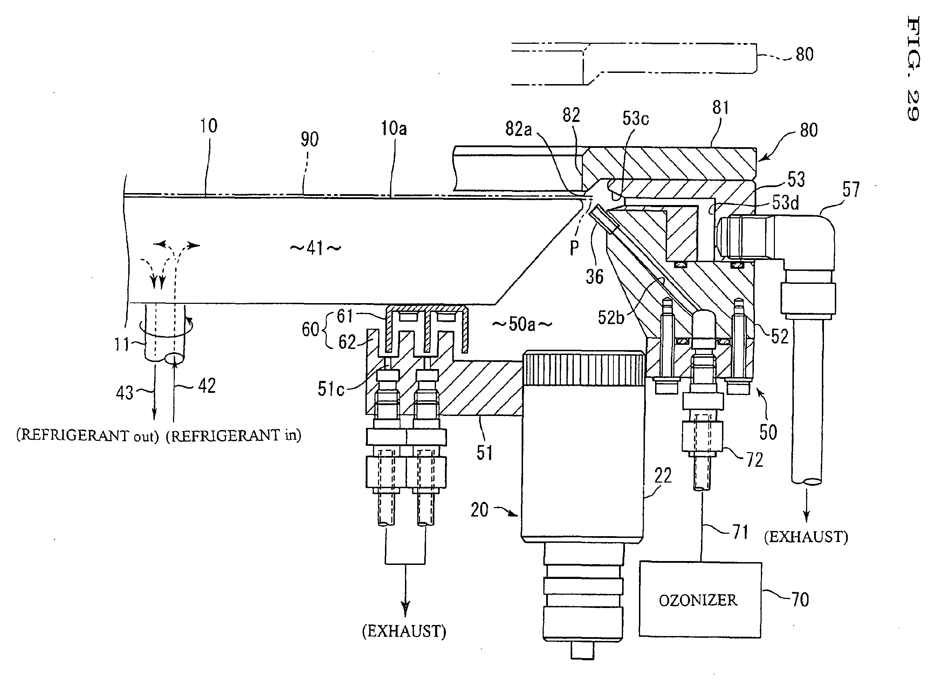

As a reactive gas supply source (reactive gas generating reactor) for the reactive gas supplying means, a normal pressure plasma processing apparatus, for example, may be used (see FIGS. 1 and 24 through 27, as well as elsewhere). In case the reactive gas is ozone, an ozonizer may be used (see FIGS. 29 through 31, 34 through 37, 41 through 44 and 47 through 52, as well as elsewhere). In case the reactive gas is hydrofluoric acid vapor, a hydrofluoric acid carburetor or a hydrofluoric acid injector may be used.

The normal plasma processing apparatus is used for forming glow discharge between the electrodes under generally normal pressure (pressure in the vicinity of the atmospheric pressure) and plasmatizing (including radicalizing and ionizing) the process gas so as to obtain a reactive gas. The "generally normal pressure" used in the present invention refers to a pressure range from $1.013 \times 10^4$ to $50.633 \times 10^4$ Pa. When the easiness of pressure adjustment and the simplification of construction of the apparatus are taken into account, the pressure range is preferably from $1.333 \times 10^4$ to $10.664 \times 10^4$ Pa and more preferably from $9.331 \times 10^4$ to $10.397 \times 10^4$ Pa.

The reactive gas supplying means preferably includes a jet path forming member for forming a jet path for introducing a reactive gas coming from the reactive gas supply source to the target position (see FIG. 29, as well as elsewhere).

The reactive gas supply source may be disposed near the target position. It is also an interesting alternative that the reactive gas supply source is disposed away from the target position and the reactive gas is introduced near the target position through the jet path forming member.

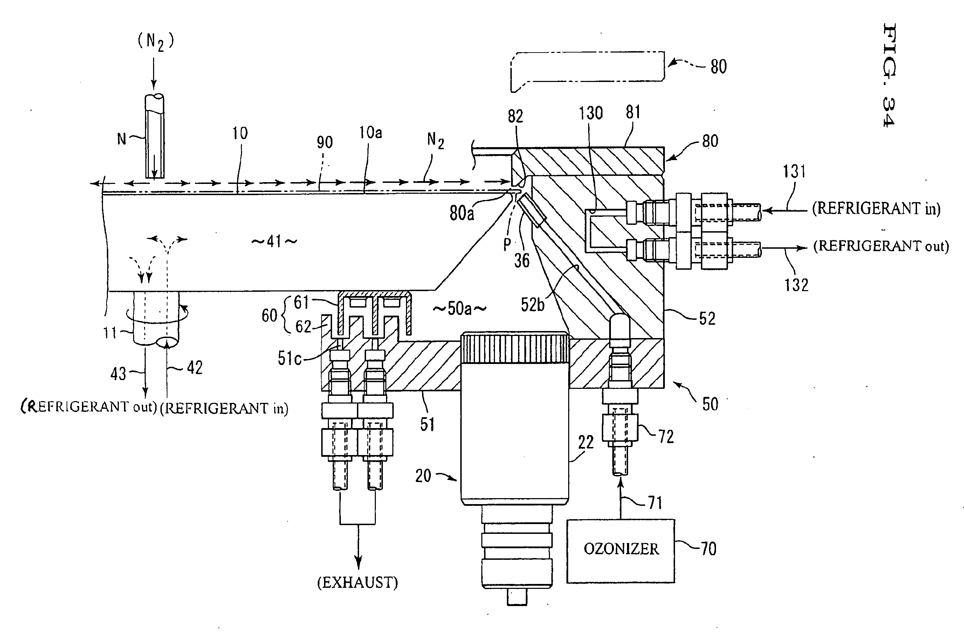

The jet path forming member may be adjusted in temperature by the jet path temperature adjustment means (see FIGS. 34, 25 and 37, as well as elsewhere). Owing to this arrangement, the reactive gas passing through the jet path can be adjusted in temperature and the temperature can be maintained at an appropriate level. Thus, the degree of activity of the reactive gas can be maintained. In case ozone is used as the reactive gas, for example, the gas is cooled down and maintained at the level of about 25 degrees C. By doing so, the life of the oxygen radical can be prolonged. As a result, the reactive gas can reliably be reacted with the unnecessary matters, and thus, the removing efficiency can be enhanced.

The means for adjusting the temperature of the jet path may be constituted, for example, by a temperature adjusting path for allowing a temperature adjusting medium to pass therethrough or a fan. It is also accepted that the jet path forming member is of a double tubular structure, a reactive gas is flowed through its inner path as a jet path, and a temperature adjusting medium is flowed through its outer annular path as a temperature adjusting path, for example. As the temperature adjusting medium, water, air, helium, chlorofluorocarbon or the like can be used.

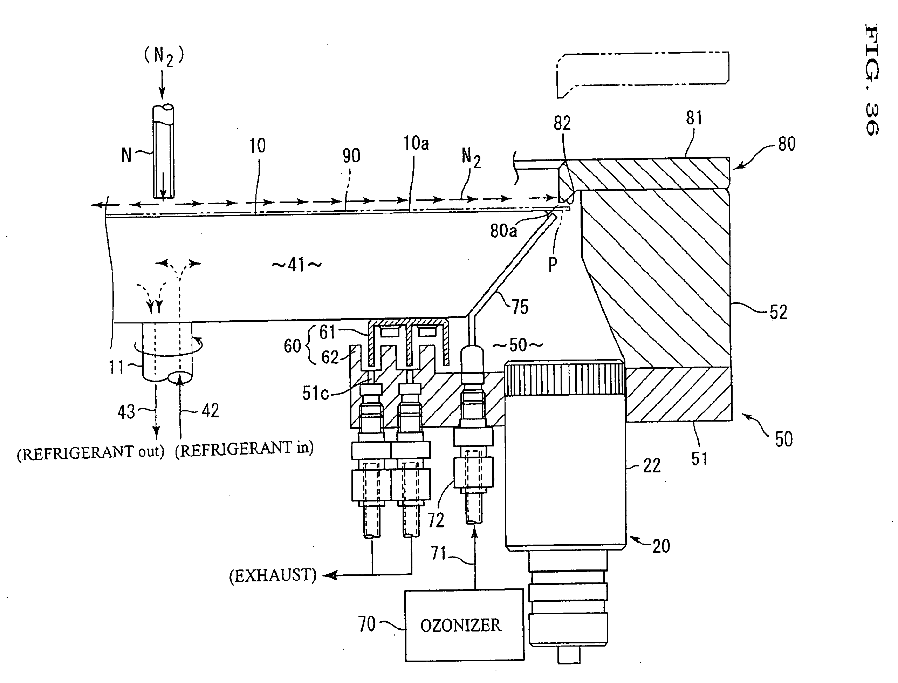

It is also accepted that the jet path forming member is cooled by the heat absorbing means along the stage (see FIG. 36, as well as elsewhere). Owing to this arrangement, the need for employing a cooling means for the specific use of the jet path can be eliminated, the structure can be simplified, and the cost-down can be achieved. This arrangement is particularly advantageous in case the reactive gas is required to be cooled or in case ozone is used as the reactive gas, for example.

The reactive gas supplying means preferably includes a jet port forming member (jet nozzle) for forming a jet port for jetting out the reactive gas (see FIGS. 29, 41 through 45, and 47 through 52, as well as elsewhere).

The jet port is preferably disposed toward and proximate to the target position (see FIGS. 1, 24 through 29 and 17 through 50, as well as elsewhere).

It is also accepted that a plurality of jet paths are branched from a single reactive gas supply source and connected to a plurality of jet ports.

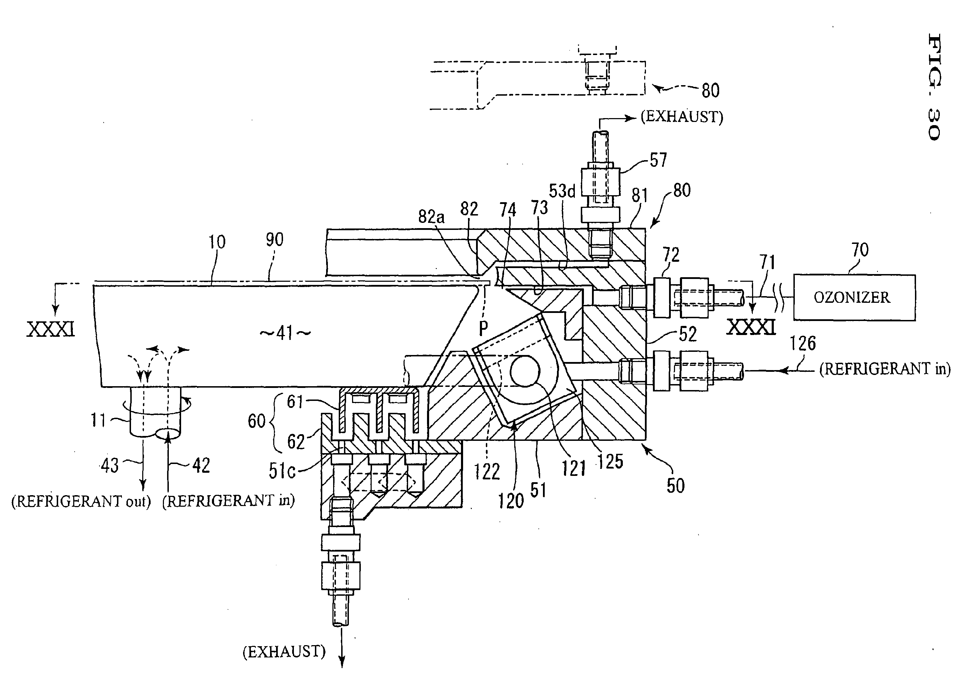

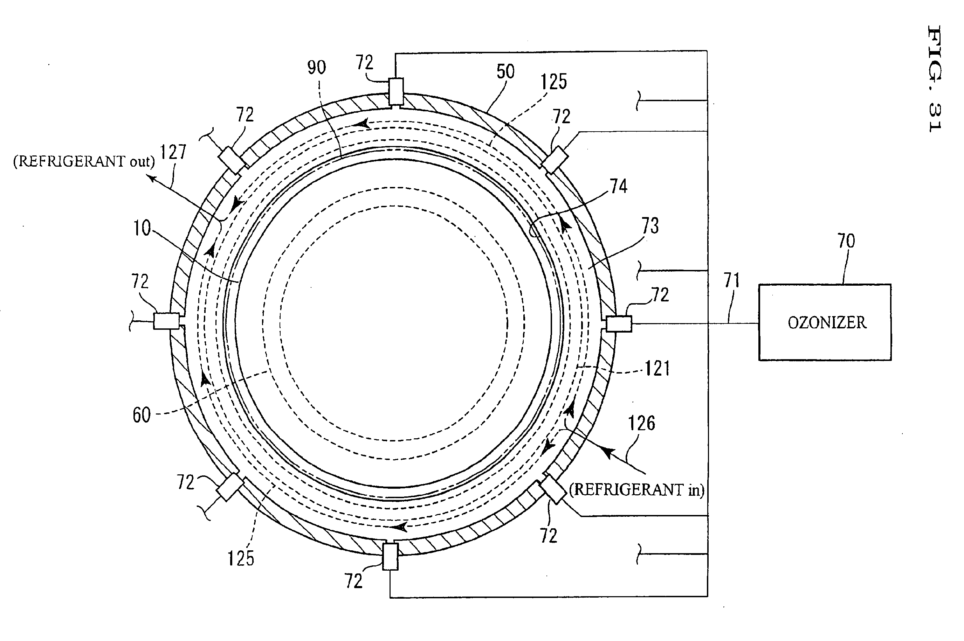

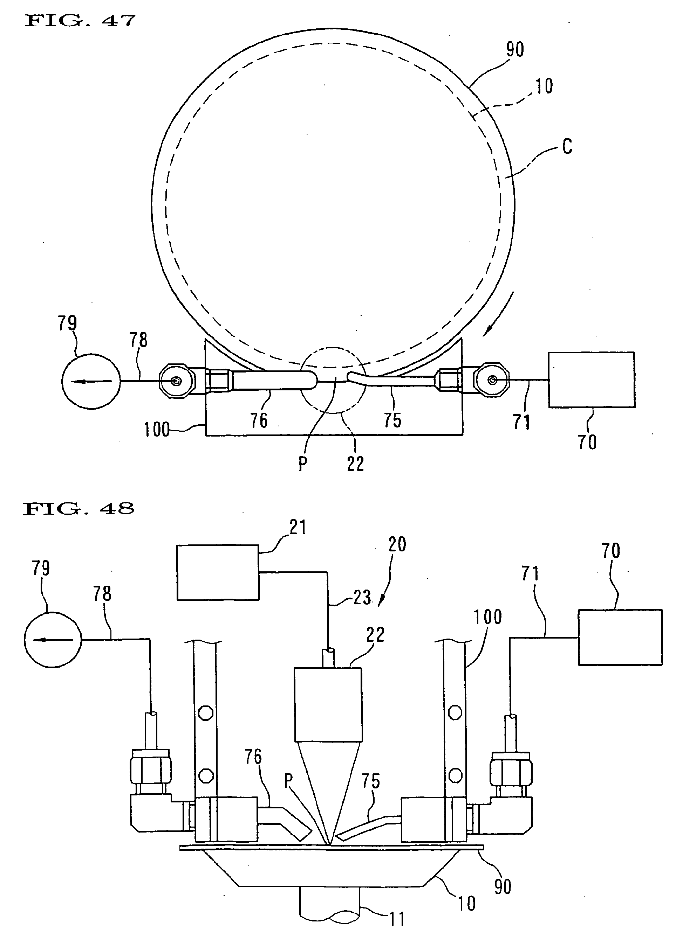

The jet port may have a dot-like (spot-like) configuration (see FIGS. 47 through 50, as well as elsewhere), a line-like configuration extending along the peripheral direction of the stage, or an annular configuration extending along the entire periphery in the peripheral direction of the stage (see FIGS. 30 and 31, as well as elsewhere). It is also accepted that a point-like (spot-like) jet port is provided with respect to a spot-like light source, a line-like jet port is provided with respect to a line-like light source and an annular jet port is provided with respect to an annular light source.
A plurality of spot-like jet ports and a plurality of line-like jet ports may be arranged along the peripheral direction of the stage.

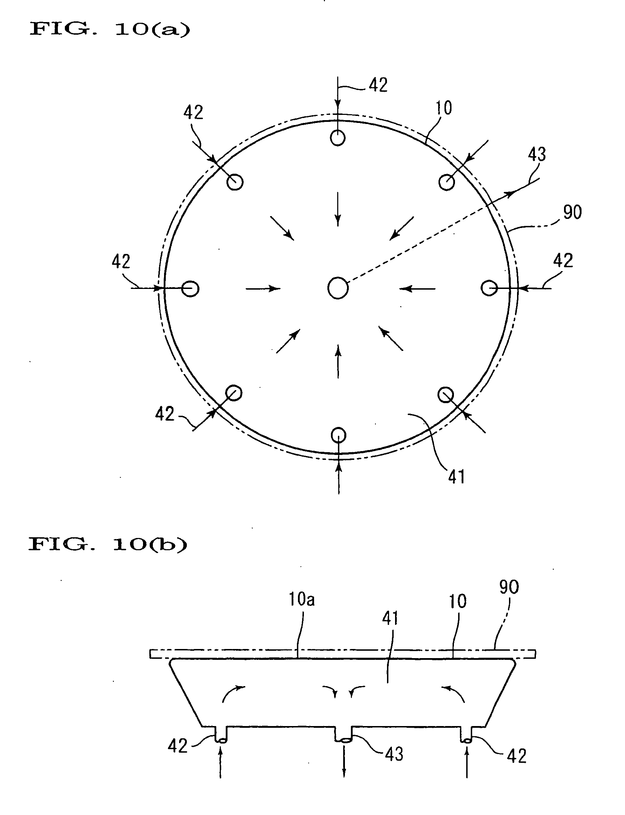

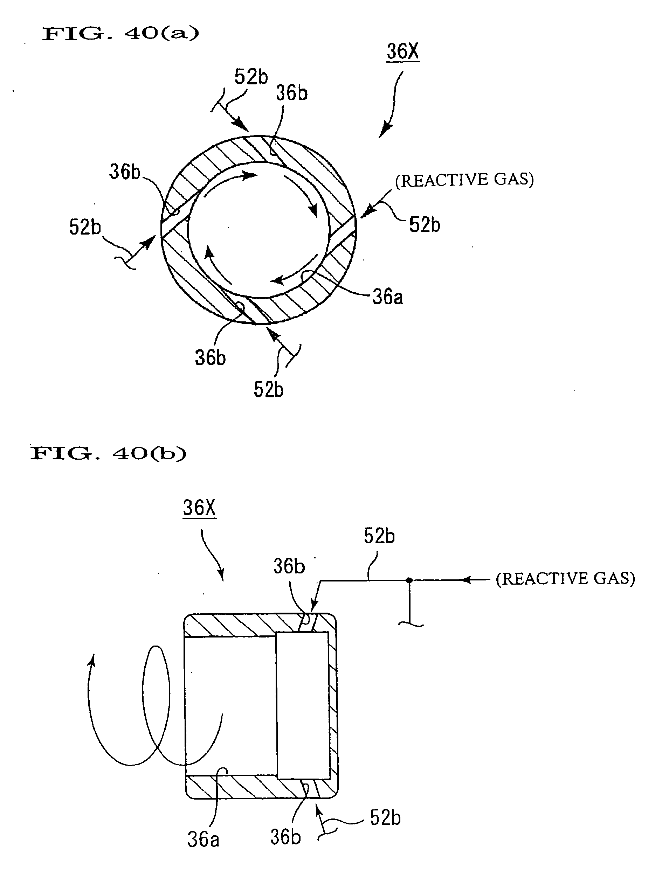

The jet port forming member may be provided with a turning flow forming part for turning the reactive gas in the peripheral direction of the jet port (see FIG. 40, as well as elsewhere). Owing to this arrangement, the reactive gas can evenly be sprayed onto the target position of the substrate.
The turning flow forming part includes a plurality of turning introduction holes extending generally in the tangential direction of the jet port and connected to the inner peripheral surface of the jet port and mutually spacedly arranged in the peripheral direction of the jet port. Those turning holes preferably constitute the path part on the upstream side of the jet port (see FIG. 10, as well as elsewhere).

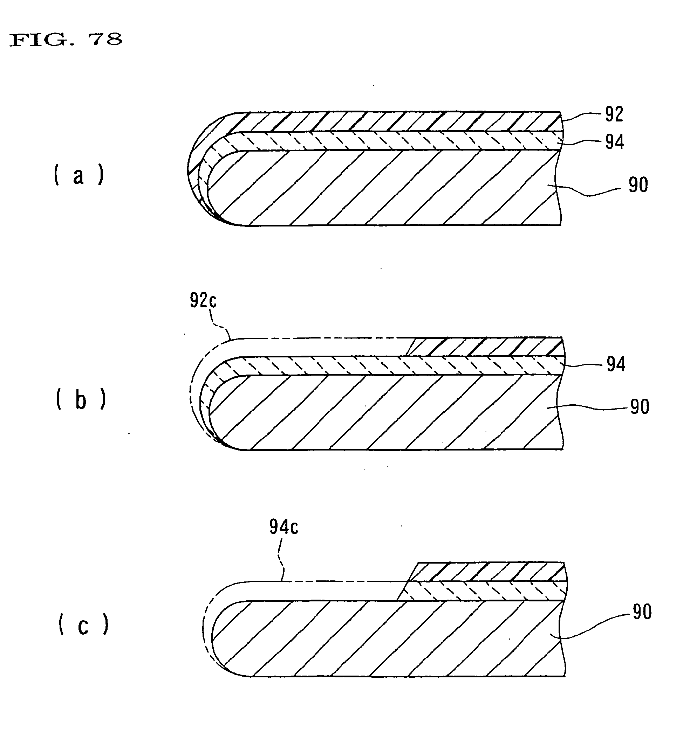

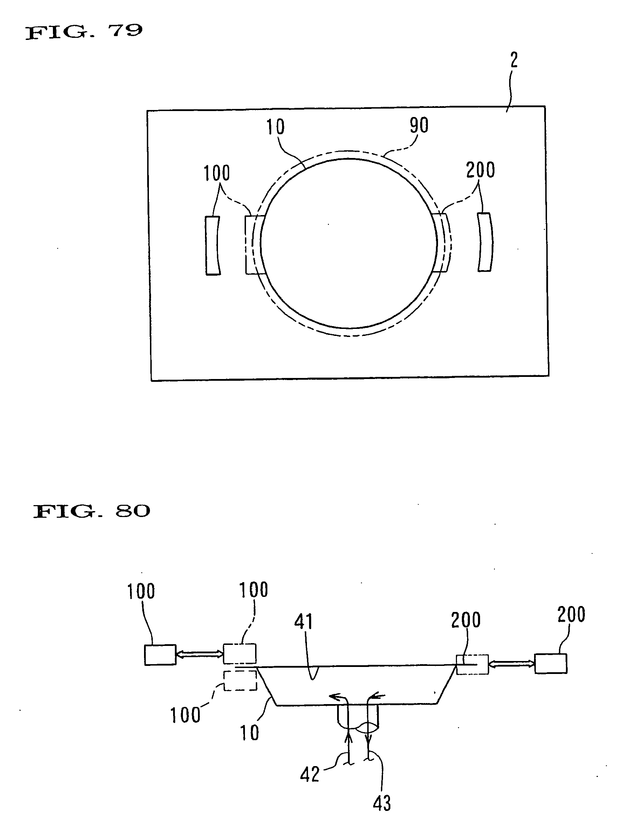

Organic films and inorganic films are sometimes laminated on the outer peripheral part of the substrate as unnecessary matters (see FIG. 78). In general, the gas which is reacted with organic films is different in kind from the gas which is reacted with inorganic films, and they are also different in way of reaction including the necessity/unnecessity of heating. For example, it is necessary for such an organic film as photoresist to be heated to cause oxidation reaction and ashed as mentioned previously. In contrast, it is possible for such an inorganic film as $SiO_2$ to be etched by chemical reaction under the normal temperature. Therefore, it is preferable that a first reactive gas such as an oxygen-based reactive gas which is reacted with the organic film is used as the reaction gas and the reactive gas supplying means (first reactive gas supplying means) is used for removing the organic film. Preferably, the apparatus further comprises a second reactive gas supplying means for supplying a second reactive gas (for example, fluorine-based reactive gas), which is reacted with the inorganic film, to the outer peripheral part of the substrate placed on the stage (see FIGS. 79 and 80, as well as elsewhere). Owing to this arrangement, the chamber and the stage which are for the specific use of removal of the inorganic films are no more required, the apparatus can be simplified in construction, transportation from the organic film processing place to the inorganic film processing place or from the inorganic film processing place to the organic film processing place is no more required and thus, particles caused by transportation can more effectively be prevented from occurrence, and the throughput can be enhanced. Moreover, by using different heads depending on kind of gases, the problem of cross contamination can be avoided.

The film is composed of an organic matter which is represented by $C_mH_nO_l$ (wherein m, n and 1 are integers) such as photoresist and polymer, for example. The first reactive gas having a reactivity with an organic film is preferably a gas containing oxygen and more preferably an oxygen-containing gas having a high reactivity such as oxide radical and ozone. A normal gas-contained pure gas and air may be used as they are. The oxygen-contained reactive gas can be produced using a plasma discharge apparatus or an ozonizer and serving the oxygen gas ($O_2$) as a source gas. The organic film is increased in reactivity with the first organic gas by applying heat thereto.
It should be noted that the oxygen-contained reactive gas is not suitable for removing the inorganic film.

The inorganic film is composed of $SiO_2$, SiN, p-Si, low-k film, or the like, for example. The second reactive gas having reactivity with the inorganic film is preferably a fluoric reactive gas such as a fluoric radical (F*). The fluoric reactive gas can be produced using a plasma discharge apparatus and serving a fluoric gas such as PFC gas (for example, $CF_4$, and $C_2F_6$) and HFC (for example, $CHF_3$) as a source gas. The hydrofluoric reactive gas is hardly reacted with the organic film.

As mentioned above, in general, the inorganic film can be etched under normal temperature. However, there are some inorganic substances which require heating. One such example is SiC.
The apparatus for processing the outer periphery of a substrate can likewise be applied when an inorganic film requiring heating is to be removed as an unnecessary matter.
The reactive gas corresponding to SiC is, for example, $CF_4$. The apparatus for processing the outer periphery of a substrate having the above-mentioned constructions (a) through (d) is also effective in the case where a first inorganic film (for example, SiC) which can be etched under high temperature and a second inorganic film (for example, $SiO_2$) whose etching rate is lower than that of the first inorganic film under high temperature are laminated on the substrate, and only the first inorganic film of all the first and second inorganic films, is to be etched.

The heater is preferably a radiating heater including a light source of a thermal light and an irradiator for irradiating a thermal light coming from the light source toward the target position in a converging manner (see FIG. 1, as well as elsewhere). Owing to this arrangement, the substrate can be heated in a non-contact manner.
The heater is limited to the radiating heater.

In case a radiating heater is used as a heater, a laser, a lamp or the like may be used as a light source.
The light source may be a spot-like light source, a line-like light source extending along the peripheral direction of the stage, or an annular light source extending along the entire surface in the peripheral direction of the stage.

In case of a spot-like light source, one place on the outer peripheral part of the substrate can locally be heated in a spot-like manner.

The laser light source is, in general, a spot-like light source and good in light collecting property. It is suitable for converging irradiation and capable of exerting energy to the unnecessary matter in the target position with high density. Thus, the unnecessary matter in the target position can be heated to high temperature instantaneously. The processing width can also be controlled with ease. The kind of laser may be LD (semiconductor) laser, YAG laser, excimer laser or any other type. The wavelength of the LD laser is 808 nm to 940 nm, the wavelength of the YAG laser is 1064 nm and the wavelength of the excimer laser is 157 nm to 351 nm. The output density is preferably about 10 W/mm$^2$ or more. The oscillation form may be CW (continuous wave) or pulse wave. Preferably, the oscillation form is of the type capable of being continuously processed by switching the high frequency.

It is also accepted that the output wavelength of the light source is made in correspondence with the absorption wavelength of the unnecessary matter. By doing so, the energy can be exerted to the unnecessary matter efficiently and the heating efficiency can be enhanced. The light emitting wavelength of the light source may be in correspondence with the absorption wavelength of the unnecessary matter, or only the absorption wavelength may be extracted by a wavelength extraction means such as a bandpass filter or the like. Incidentally, the absorption wavelength of the photoresist is 1500 nm to 2000 nm.

It is also accepted that the spot-like light coming from the spot-like light source is converted into a line-like light traveling along the outer peripheral part of the substrate by a convex lens, a cylindrical lens or the like and then irradiated. In case the light source is of line-like light, the peripherally extending range of the outer peripheral part of the substrate can be heated locally and linearly.

In case the light source is of annular light, the entire outer peripheral part of the substrate can be heated locally and annularly. A plurality of spot-like light sources and a plurality of line-like light sources may be arranged along the peripheral direction of the stage.

As a lamp light source, there can be listed, for example, a near infrared lamp such as a halogen lamp, and a far infrared lamp. The light emitting form of the lamp light source is of the continuous light emission. The light emitting wavelength of the infrared lamp is, for example, 760 nm to 10000 nm, and the wavelength of 760 nm to 2000 nm belongs to the near infrared band. A wavelength in match with the absorption wavelength of the unnecessary matter is preferably extracted from the afore-mentioned wavelength region by a wavelength extraction means such as the bandpass filter and then, irradiated.

Desirously, the radiating heater (especially, of the lamp light source type) is cooled by a cooling means such as a refrigerator and a fan (see FIG. 30, as well as elsewhere).

The radiating heater may includes an optical transmission system such as a guidewave extending to the target position from the light source (see FIG. 1, as well as elsewhere). Owing to this arrangement, the thermal light coming from the light source can reliably be transmitted to the vicinity of the outer peripheral part of the substrate. As the guidewave, an optical fiber is preferably used. By using the optical fiber, distribution can be made easily. It is preferable that a plurality of optical fibers are bundled.

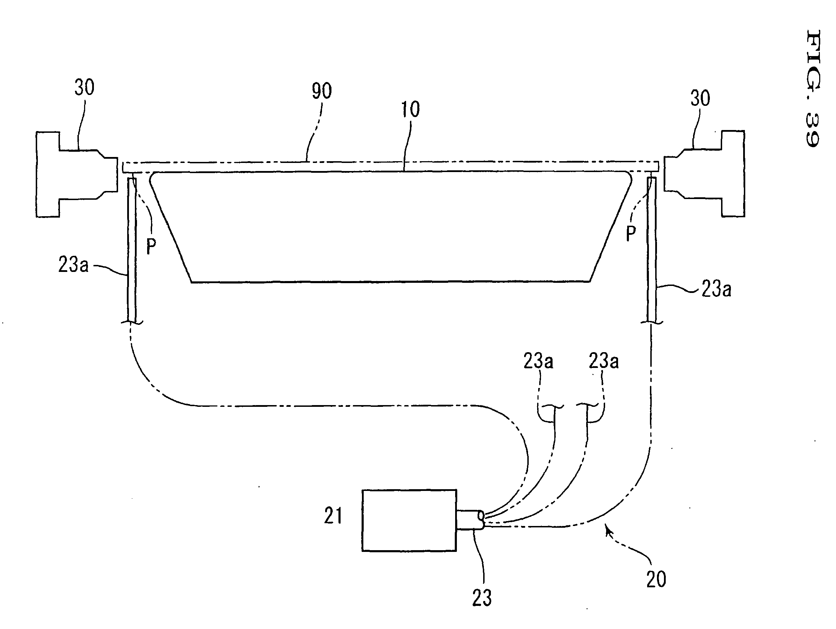

It is also accepted that the guidewave includes a plurality of optical fibers, and those optical fibers are branched and extended from the light source such that the tip parts spacedly arranged along the peripheral direction of the stage (see FIG. 39, as well as elsewhere). Owing to this arrangement, the thermal light can be irradiated simultaneously to a plurality of places in the peripheral direction of the outer peripheral part of the substrate.

The tip part of the guidewave such as the optical fibers is preferably optically connected with an irradiator including the converging optical member (see FIG. 1, as well as elsewhere).

Desirously, the irradiator of the radiating heater includes a converging optical system (condensing part) comprising a parabolic reflector, a convex lens, a cylindrical lens, and the like and adapted to converge the thermal light coming from the light source towards the target position. The converging optical system may be any one of the parabolic reflector, the convex lens, the cylindrical lens, and the like, or a combination thereof.

It is desirous that the irradiator is incorporated with a focus adjusting mechanism. The focus may be made exactly coincident with the target position or slightly deviated from the target position. Owing to this arrangement, the density and irradiating area (condensing diameter, spot diameter) of the radiant energy which is to be exerted to the outer peripheral part of the substrate can appropriately be adjusted in size.

The focus adjusting mechanism can be used in the following manner.

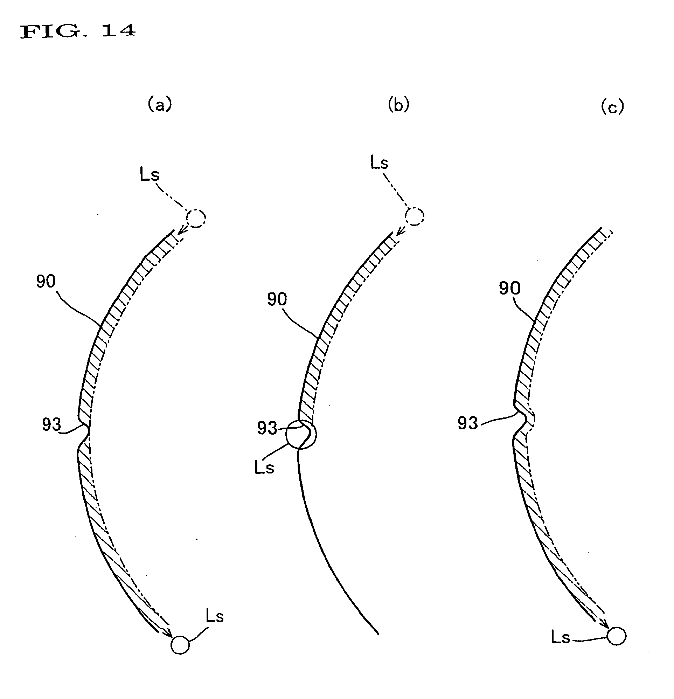

For example, when a cutout part such as a notch or orientation flat formed in the outer periphery of the substrate is to be processed, the focus of the radiating heater is deviated toward the direction of the optical axis compared with when all the outer periphery of the substrate only excluding the cutout part is to be processed. Owing to this arrangement, the irradiating width (optical diameter) on the substrate can be increased compared with when all the outer periphery only excluding the notch or orientation flat is to be processed, the thermal light can also be hit to the edge of the notch or orientation flat and thus, the film coated on the edge of the notch or orientation flat can be removed (see FIG. 14, as well as elsewhere).

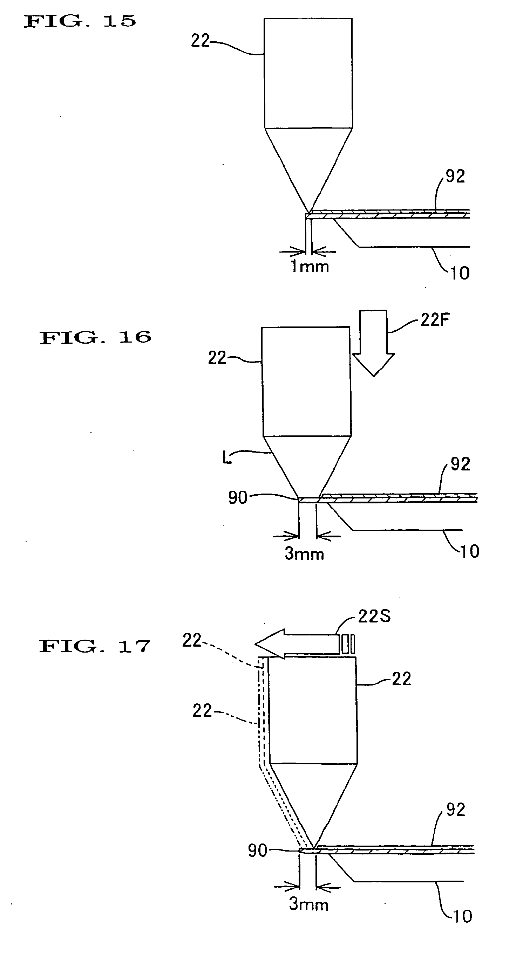

By adjusting the focus of the radiating heater toward the direction of the optical axis through the focus adjusting mechanism, the irradiating width on the outer periphery of the substrate can be adjusted and thus, the processing width (width of the unnecessary film to be removed) can be removed, too (see FIG. 16, as well as elsewhere).

The processing width can also be adjusted by finely sliding the radiating heater in the radial direction of the substrate (see FIG. 17, as well as elsewhere). In that case, it is preferable that the radiating heater is finely slid in the radial direction of the substrate by a portion generally equal to the radiating width on the substrate of the radiating heater whenever the substrate makes one rotation. Preferably, irradiation is made first at the inner peripheral side of the range to be processed of the outer periphery of the substrate and then, gradually finely slid in the radially outwardly.

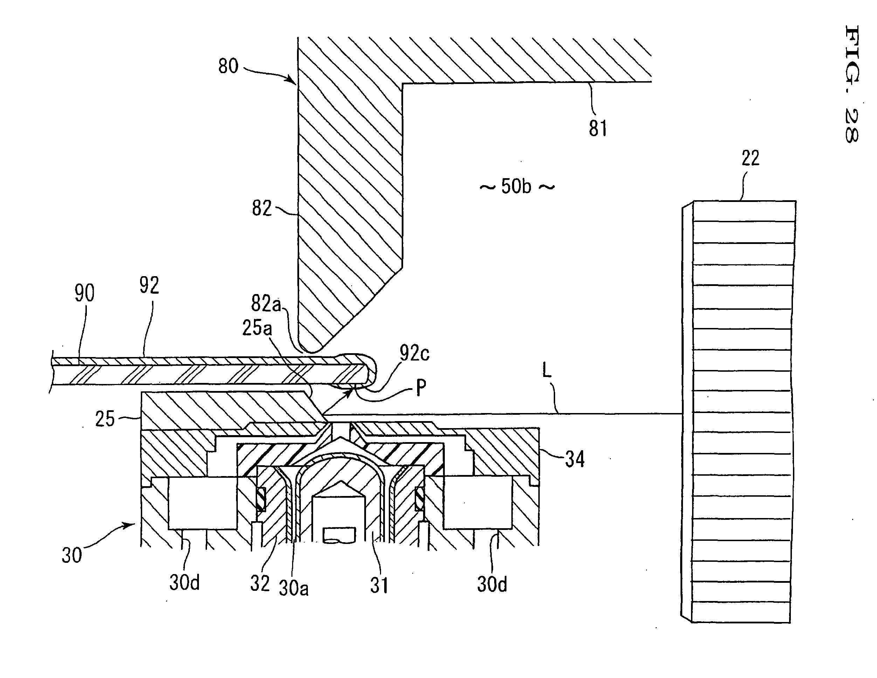

It is also accepted that a reflecting member for totally reflecting the thermal light coming from the light source to the target position is disposed at the rear side and in the vicinity of the target position (see FIG. 28, as well as elsewhere). Owing to this arrangement, the light source can be arranged in the vicinity of the extension surface of the support surface or at a place displaced frontward therefrom.

In a preferred embodiment of the apparatus for processing the outer periphery of a substrate

(a) a stage includes a support surface which supports the substrate such that the outer peripheral part of the substrate is projected outward,
(b) a radiating heater includes a light source disposed away from the target position which is supported to exist on the outer peripheral part in the rear surface of the substrate which is supported on the stage, and an optical system for delivering the thermal light coming from the light source to the target position in such a manner as that the thermal light is not dispersed, and
(c) a reactive gas supplying means includes a jet port connected to a reactive gas supply source for supplying a reactive gas and for jetting out the reactive gas for removing a unnecessary matter, the jet port being arranged at a rear side of the support surface or of its extension surface, or proximate to the target position generally on the extension surface (see FIGS. 1, 24 through 30. 34 through 39 and 41 through 44, as well as elsewhere).

It is also accepted that the substrate is supported on the stage such that the outer peripheral part of the substrate is projected outward, a thermal light coming from the radiating heater is irradiated in such a manner as to focus on the outer peripheral part of the rear surface of the substrate or in the vicinity of the outer peripheral part so that the substrate is locally heated, a jet port of a reactive gas supplying means is placed in the vicinity of the located heated part such that the jet port is directed toward this part and by jetting out a reactive gas for removing an unnecessary matter through the jet port, the unnecessary matter coated on the outer peripheral part of the rear surface of the substrate can be removed. Owing to the above-mentioned arrangement, the substrate can locally be heated by locally applying the thermal light to the outer peripheral part of the rear surface of the substrate, and the reactive gas can be sprayed onto the locally heated part from its vicinity. This makes it possible to remove the unnecessary matter coated on the specific part efficiently.

It is preferable that the support surface of the stage is slightly smaller than the substrate and the target position, which is supposed to exist on the outer peripheral part of the substrate, is located on the extension surface extended radially outwardly from the support surface.
It is also accepted that the irradiator is disposed at the rear side of the extension surface, and the jet port is disposed at the rear side of the extension surface or generally on the extension surface (see FIG. 1, as well as elsewhere).
Owing to the above-mentioned arrangement, the substrate can locally be heated by locally applying a thermal light to the outer peripheral part of the rear surface of the substrate, and a reactive gas can be sprayed onto this locally heated part from its vicinity. By doing so, the unnecessary matter coated on this specific part can be removed efficiently.

The jet port is preferably disposed more proximate to the target position than from the irradiator. Owing to this arrangement, the reactive gas can reliably supplied to the target position in a non-dispersed, high density and highly active condition, and the unnecessary matter removing efficiency can reliably be enhanced. It is preferable that the irradiator is arranged in such a manner as to be more away from the target position than the jet port. This makes it possible to layout the irradiator and the jet port forming member easily.

It is preferable that the irradiator of the radiating heater and the jet port are arranged in a mutually different direction with respect to the target position (see FIG. 1, as well as elsewhere). This makes it possible to layout the radian heater and the jet port forming member more easily.

Preferably, one of the irradiator of the radiating heater and the jet port is arranged generally on a line passing through the target position and orthogonal to the extension surface (see FIG. 1, as well as elsewhere). By arranging the irradiator of the radiating heater generally on the orthogonal line, the heating efficiency can be enhanced, and by arranging the jet port generally on the orthogonal line, the reacting efficiency can be enhanced.

It is desirous that the jet port forming member (jet nozzle) forming the jet port of the reactive gas supplying means is composed of a light transmissive material. Owing to this arrangement, even if the optical path of the radiating heater is interfered with the jet port forming member, the light can reliably be irradiated to the target position of the substrate after transmitting through the jet port forming member, and this specific part can reliably be heated. Thus, the jet port forming member can reliably be arranged in a position very near the target part without being limited by the optical path of the radiating heater, and the reactive gas can reliably be sprayed onto the specific part from the very near position. As the light transmissive material, a transparent resin such as quartz, acryl, transparent teflon (registered trademark) and transparent vinyl chloride, for example, is preferably used. In case, a transparent resin having a low heat resistance is used as the light transmissive material, it is desirous to adjust the output of the radiant heat, etc. are properly adjusted so that the transparent resin will not be deformed nor dissolved.

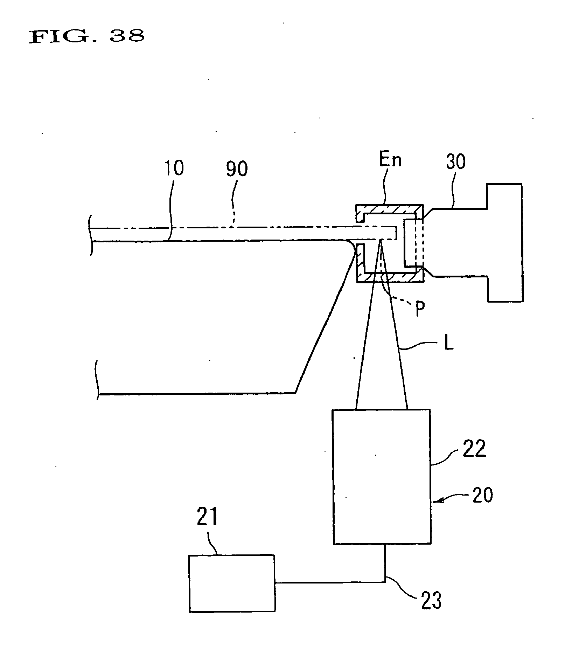

It is also accepted that an enclosure for enclosing the target position is employed, and the jet port for the reactive gas is arranged inside the enclosure. Moreover, it is also accepted that the irradiator of the radiating heater is disposed outside the enclosure and at least a part of the enclosure on the side facing the irradiator is composed of a light transmissive material (see FIGS. 38, and 61 through 77, as well as elsewhere). Owing to this arrangement, the processed reactive gas can reliably be prevented from leaking outside, and the thermal light coming from the radiating heater can transmit through the enclosure, thereby enabling to reliably radiantly heat the target part of the substrate.

It is desirable that the irradiator and the jet port are relatively moved.

Preferably, the stage is a circular stage, and this circular stage is relatively rotated about the center axis with respect to the light source and jet port. Owing to this arrangement, even in case the light spot is a spot-like light source, the unnecessary matter removing processing can be conducted along the peripheral direction of the outer peripheral part of the rear surface of the substrate. Even in case the light source is a ring-like light source, uniformity of processing can be enhanced by executing the afore-mentioned relative rotation. The relative rotation number (relative movement speed) is properly set in accordance with the temperature at which the outer peripheral part of the rear surface of the substrate is to be heated.

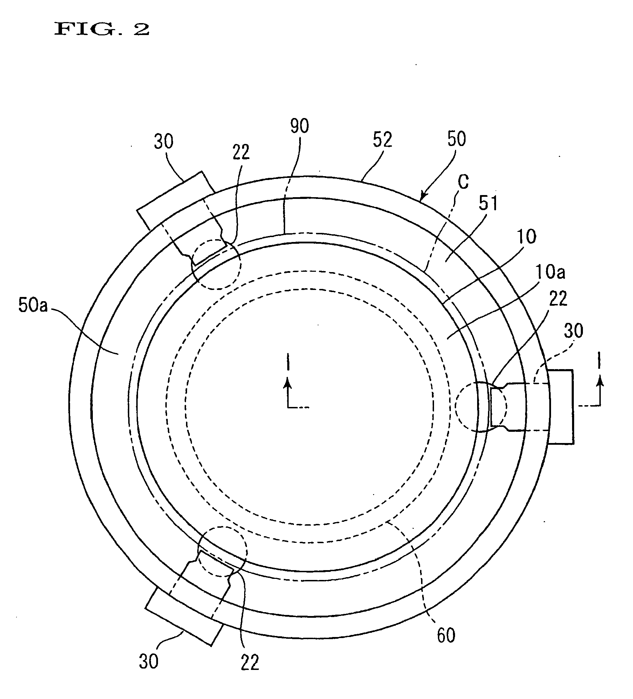

It is desirable to employ a frame for surrounding the stage and thus the target position in the peripheral direction and forming an annular space between the stage and the frame (see FIGS. 1 and 2, as well as elsewhere). Owing to this arrangement, the processed reactive gas can be temporarily reserved in the vicinity of the target position so that the gas will not disperse to outside, and sufficient time for reaction can be obtained. It is desirable that the light source and the jet port are received in or faced with this annular space and positionally fixed to the frame.

The apparatus desirably further comprises a rotation driving mechanism for relatively rotating the stage about the center axis with respect to the frame.

It is accepted that the frame is fixed, while the stage is rotated or that the stage is fixed, while the frame is rotated.

Desirably, the apparatus further comprises a labyrinth seal for sealing between the rear surface part on the opposite side of the support surface side (front side) of the stage, while allowing the relative rotation of the stage (see FIG. 1, as well as elsewhere). Owing to this arrangement, the stage or the frame can be rotated without any interference, and the processed gas can be prevented from leaking outside from between the rear side of the state and the frame.

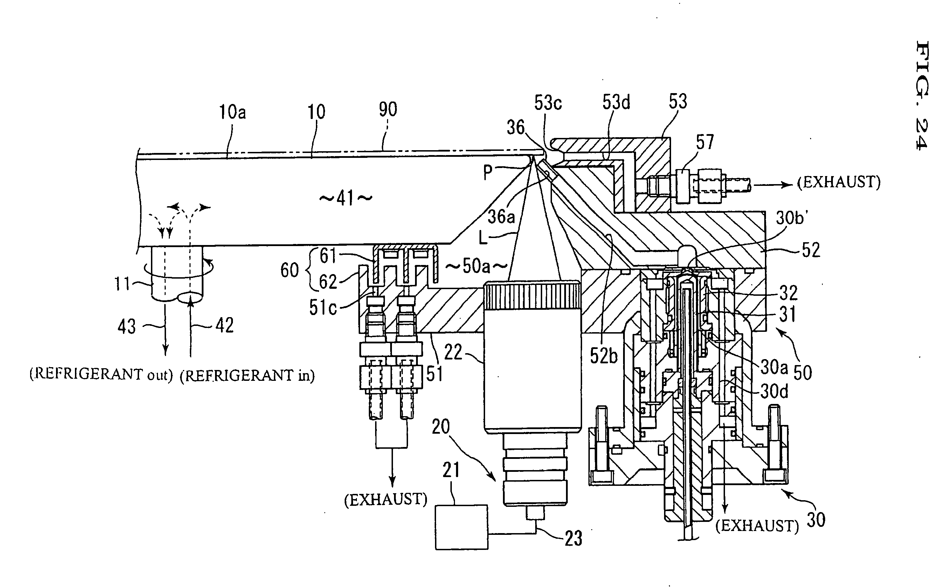

It is desirable that the frame is provided at a part on the front side thereof with a cover member extending toward the stage and overlain the front side of the target position, such that the cover member alone or co-acting with the outer peripheral part of the substrate placed on the stage covers the annular space (see FIGS. 24 through 30, as well as elsewhere). Owing to this arrangement, the processed reactive gas can be prevented from leaking to the front side from the annular space.

The cover member is desirably retreatable from the position where it covers the annular space (see FIG. 29, as well as elsewhere). Owing to this arrangement, when the substrate is to be placed on and removed from the stage, the cover member will not interfere with the operation for placing the substrate on the stage and removing the substrate from the stage by retreating the cover member.

It is desirable that the annular space is connected with an annular space suction means for sucking the annular space (see FIGS. 1 and 24 through 27, as well as elsewhere). Owing to this arrangement, the processed reactive gas can be sucked from the annular space and exhausted.

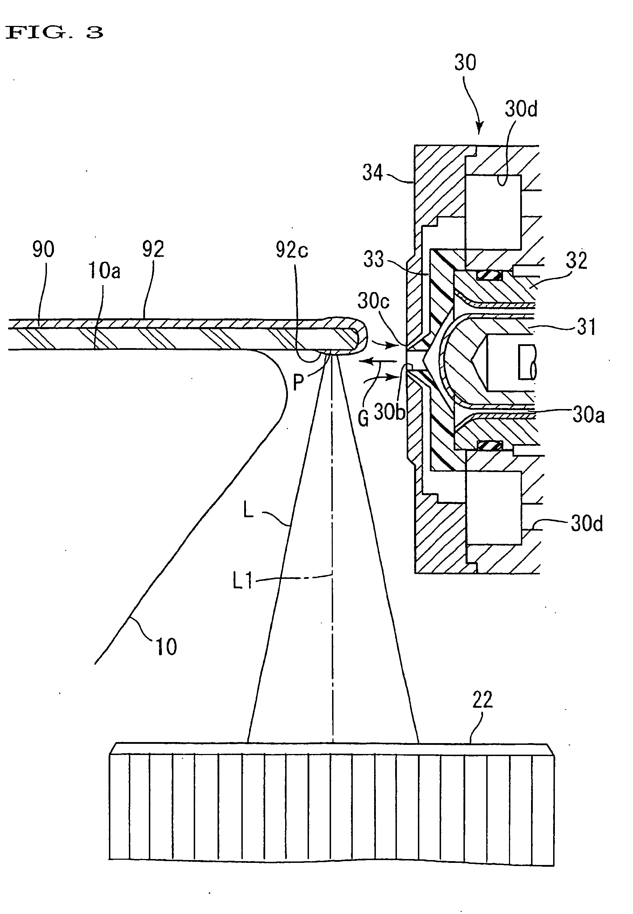

The apparatus desirably further comprises a suction means for sucking the vicinity of the jet port (see FIG. 3). Owing to this arrangement, the processed gas can rapidly be sucked from the periphery of the target part and exhausted.

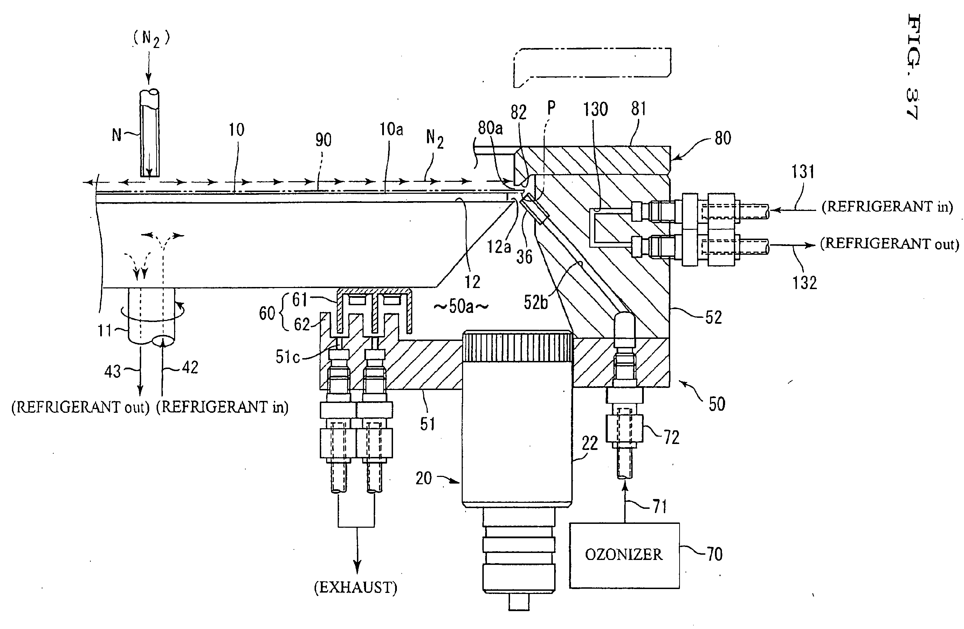

It is desirable that the stage is provided at the outer peripheral part of the support surface thereof with a step which co-acts with the outer peripheral part of the substrate and forms a gas reservoir (see FIG. 37, as well as elsewhere). Owing to this arrangement, the reactive gas jetted out from the jet port can temporarily be reserved in the gas reservoir so that the time for the reactive gas contacts the outer peripheral part of the substrate can be increased. Thus, sufficient time for reaction can be obtained and the reaction efficiency can be enhanced.

It is desirable that an inert gas jet member for jetting out an inert gas is disposed just in front of the central part of the support surface (see FIGS. 34 through 37, as well as elsewhere). Owing to this arrangement, the reactive gas can be prevented from not flowing to the front surface of the substrate and the film on the front side can reliably be prevented from being damaged. The inert gas jet member may be a nozzle or a fan filter unit. Of course, this inert gas jet member is disposed in such a manner to be away upward by at least a portion equal to or larger than the thickness of the substrate from the support surface. At the time of performing the operation for placing/removing the substrate, the inert gas jet member is retreated in order not to interfere with the operation. As the inert gas, a pure nitrogen gas, a clean dry air (CDA) or the like may be used.

As previously mentioned, in case an organic film such as fluorocarbon is etched by oxygen-based reactive gas such as ozone, the etching rate can be more increased as the temperature under which the etching is carried out becomes higher. As the heating means, radiant heat caused by laser is more preferable than a heater or the like with which physical contact is accompanied, because particles can more effectively be prevented from occurring.

On the other hand, in case a radiant light such as laser is irradiated onto the outer peripheral part of the wafer from just above or just under, the light is made incident to the slantwise surface part or the vertical part at the end edge of the wafer in a slantwise or parallel fashion. Thus, sufficient heating efficiency is difficult to obtained and the rating rate tends to be reduced.

It is also accepted that the substrate is supported on the stage, and the unnecessary matter coated on the outer peripheral part of the substrate is removed by contacting the outer peripheral part with the reactive gas, while irradiating a thermal light toward the outer peripheral part of the substrate from the direction declined radially outwardly of the substrate (see FIGS. 30, 53, 56 and 57, as well as elsewhere).

Owing to the above-mentioned arrangement, the irradiating direction of the thermal light with respect to the slantwise surface and the vertical outer end face of the outer peripheral part of the substrate can be brought nearly to vertical, the heating efficiency can sufficiently be enhanced by fully increasing the density of radiant energy and thus, the etching rate for removing the film form on the outer periphery of the substrate can be increased.

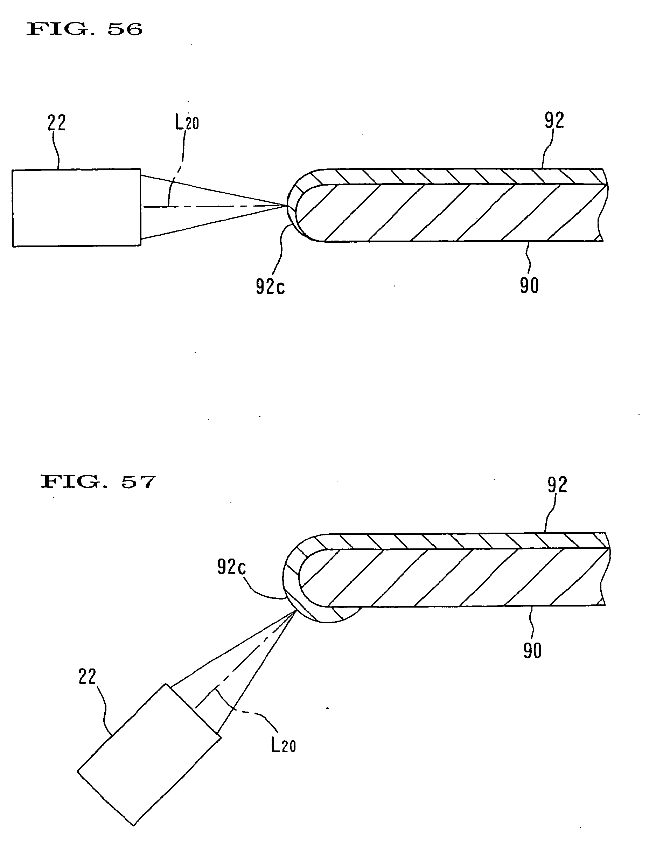

The declined direction includes not only the slantwise direction (see FIGS. 30, 53 and 57, as well as elsewhere) with respect to the substrate but also the just lateral direction (parallel with the substrate) (see FIG. 56, as well as elsewhere).

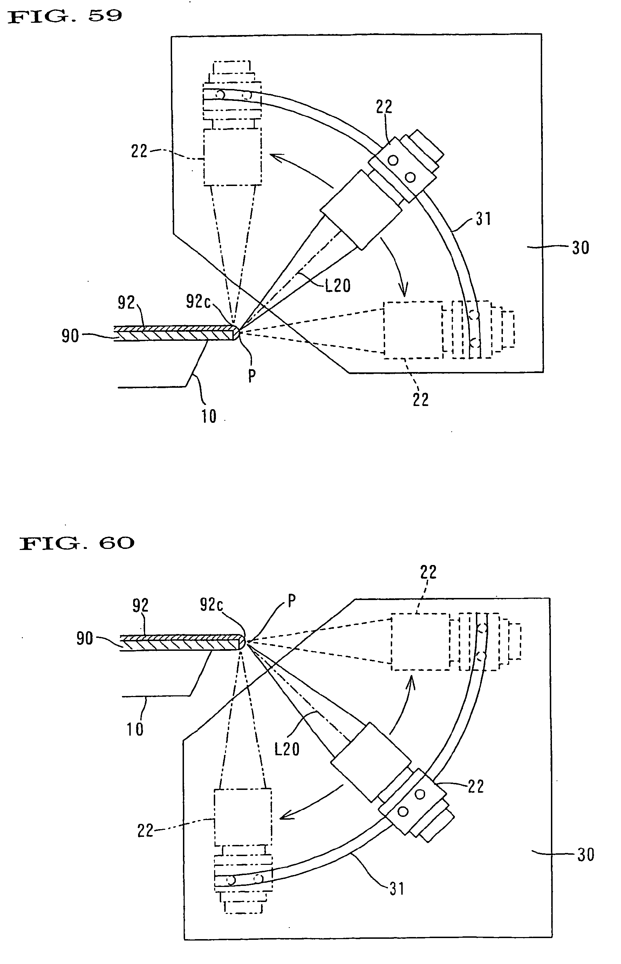

It is also accepted that the substrate is supported by the stage, a reactive gas is supplied toward the outer peripheral part of the substrate while irradiating a thermal light, and by moving the irradiating direction of the thermal light in a plane orthogonal to the substrate (its main surface) about the outer peripheral part of the substrate, the unnecessary matter coated on the outer peripheral part of the substrate is contacted with the reactive gas and removed (see FIGS. 59 and 60, as well as elsewhere).

Owing to the above-mentioned arrangement, the thermal light can be irradiated generally vertically to the respective parts, such as the front side, the outer end face and the rear side of the substrate, and thus, each and every part can efficiently be processed.

It is preferable that the plane across which the thermal light moves, is a plane passing through a single radius of the substrate.

The apparatus for processing the outer periphery of a substrate may further comprise:

(a) a stage for supporting the substrate,
(b) a reactive gas supplying means adapted to supply the reactive gas to the target position which is supposed to exist on the outer peripheral part of the substrate placed on the stage, and
(c) an irradiator for irradiating a thermal light toward the target position from the direction declined radially outwardly of the support surface (see FIGS. 30, 53, 56 and 57, as well as elsewhere).

Owing to the above-mentioned arrangement, the incident angle can be brought nearly to zero by bringing the irradiation angle of the thermal light nearly to vertical with respect to the slantwise surface part and the outer end face of the outer peripheral part of the substrate, the heating efficiency can sufficiently be enhanced by fully increasing the density of radiant energy, and thus, the etching rate for removing the film coated on the outer periphery of the substrate can be increased.

In a preferred embodiment of the apparatus for processing the outer periphery of a substrate

(a) a stage includes a support surface for supporting the substrate,
(b) a reactive gas supplying means is adapted to supply the reactive gas toward a target position which is supposed to exist on the outer peripheral part of the substrate placed on the stage,
(c) an irradiator is for irradiating a thermal light toward the target position, and
(d) a moving mechanism is for moving the irradiator in a plane orthogonal to the support surface (thus, the substrate on this support stage) while directing the irradiator to the target position (see FIGS. 59 and 60, as well as elsewhere).

Owing to the above-mentioned arrangement, the thermal light can be irradiated generally vertically to the respective parts such as the front side, the outer end face and the rear side of the outer peripheral part of the substrate, and each part can efficiently be processed.

The plane orthogonal to the support surface is preferably a plane passing through the center of the support surface.

It is accepted that the supply nozzle and the exhaust nozzle of the reactive gas supplying means are movable or adjustable in angle together with the irradiator. It is also accepted that the supply nozzle and the exhaust nozzle are positionally fixed irrespective of movement of the irradiator.

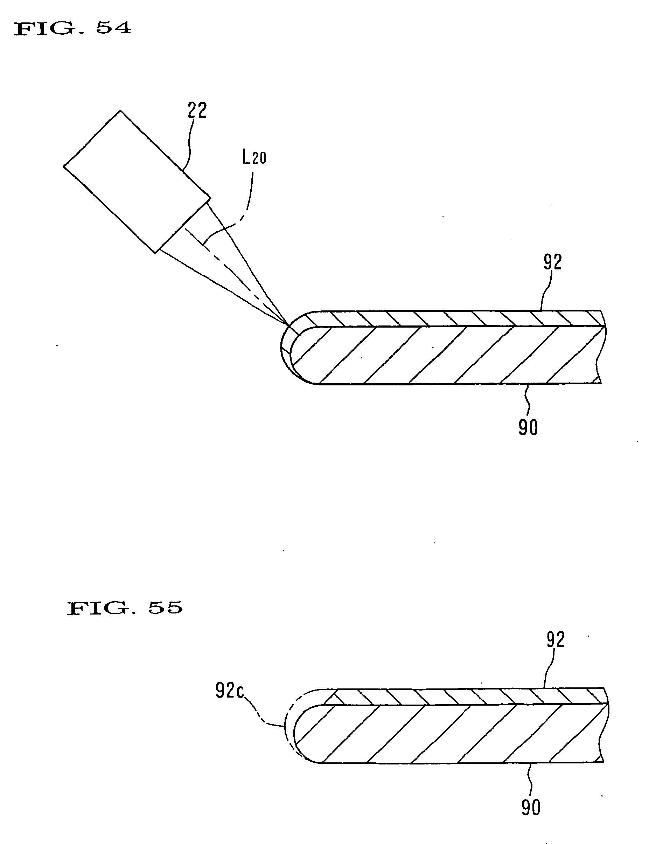

It is preferable that the irradiation direction is generally along the normal line at a point to be irradiated (center of the part to be irradiated) of the outer peripheral part of the substrate (see FIG. 54, as well as elsewhere).
Owing to the above-mentioned arrangement, the incident angle can be made generally zero at the above-mentioned point, the density of radiant energy can reliably be increased and the heating efficiency can reliably be enhanced.

In case the jet nozzle of the reactive gas supplying means of the apparatus for processing the outer periphery of a substrate is in an elongated straw-like configuration having a uniform diameter from its basal end to its distal end, it can be contemplated that the reactive gas readily hits the substrate and dispersed. Then, the reaction time given to active pieces is reduced, the use efficiency and the reaction efficiency of the active pieces are decreased, and the required quantity of the reactive gas is increased.

In view of the above, it is also accepted that the reactive gas supplying means of the apparatus for processing the outer periphery of a substrate comprises

an introduction part for introducing the reactive gas for removing an unnecessary matter to the vicinity of the target position, and
a cylindrical part connected to the introduction part and overlain the target position,
the interior of the cylindrical part being more widely spread than the introduction part and defined as a temporary reservoir space for temporarily reserving therein the reactive gas (see FIGS. 60 through 66 and 70 through 77, as well as elsewhere).

Owing to the above-mentioned arrangement, the use efficiency and the reaction efficiency of the reactive gas can be enhanced, and the required quantity of gas can be reduced.

It is preferable that a releasing port connected to the temporary reservoir space is formed in the cylindrical part itself or between the cylindrical part and the outer edge of the substrate in the target position, and the reactive gas is encouraged to flow out of the temporary reservoir space through the releasing port.
Owing to the above-mentioned arrangement, the reactivity-decreased processed gas and the reaction by-products can stay in the temporary reservoir space long, new reactive gas can be supplied to the temporary reservoir space from time to time, and the reaction efficiency can be enhanced more reliably.

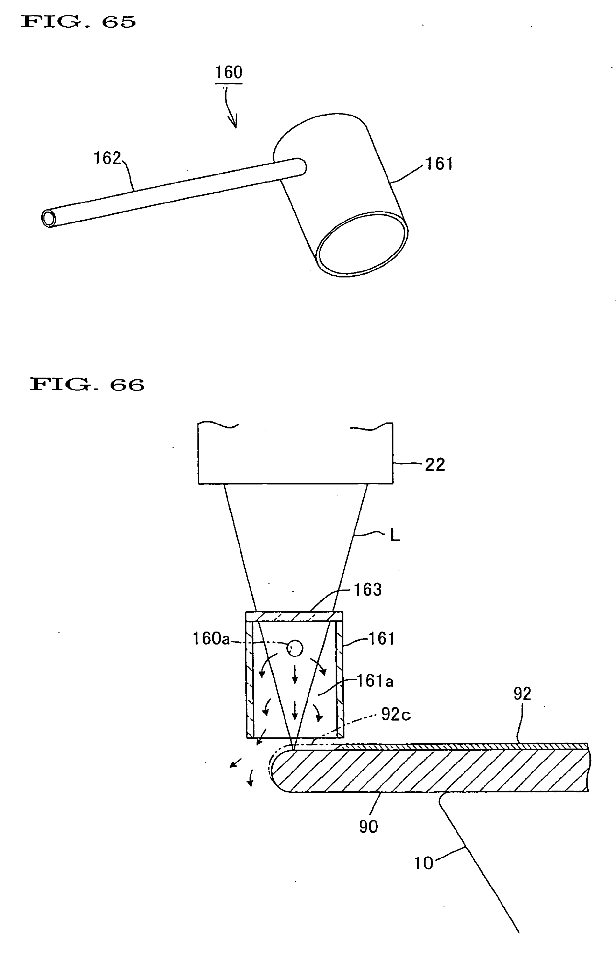

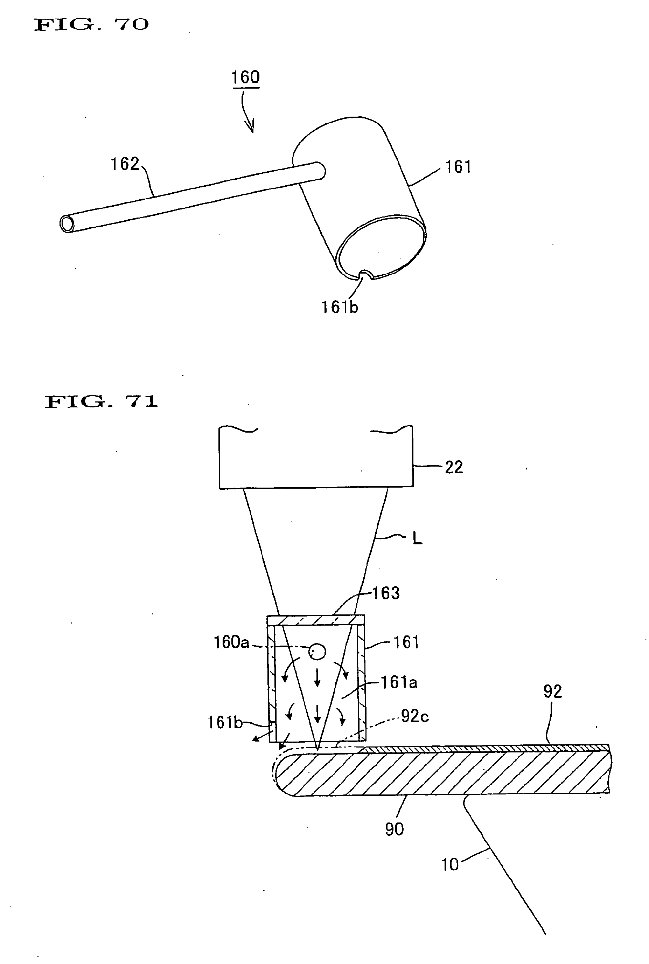

For example, the tip of the cylindrical part is opened facing the target position (see FIGS. 66 and 71, as well as elsewhere).
In that case, a cutout serving as the releasing port is preferably formed in corresponding place located radially outward of the substrate in the distal end edge of the cylindrical part (see FIGS. 70 and 71, as well as elsewhere).
Owing to the above-mentioned arrangement, the processed gas and the reaction by-products can rapidly be flown out of the temporary reservoir space through the cutout, new reactive gas can be supplied to the temporary reservoir space from time to time, and the reaction efficiency can be enhanced more reliably.

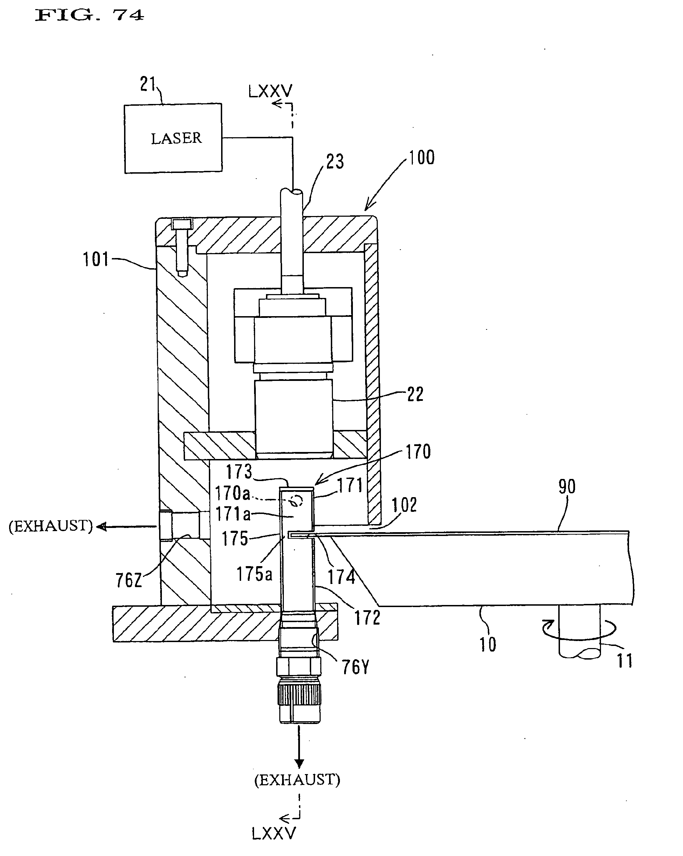

It is also accepted that the cylindrical part is disposed in such a manner as to pass through the target position, a cutout for allowing the peripheral part of the substrate to be inserted therein is formed in the peripheral part corresponding to the target position of the substrate, and the introduction part is connected to the cylindrical part which is located on the basal end side of the cutout (see FIGS. 74 through 77, as well as elsewhere).
In the above-mentioned arrangement, the interior of the cylindrical part on the basal end side of the cutout constitutes the temporary reservoir space, the inner peripheral surface of that part, which is left uncut, corresponding to the target position of the cylindrical part is constitutes the releasing port by co-acting with the outer edge of the wafer in the target position.

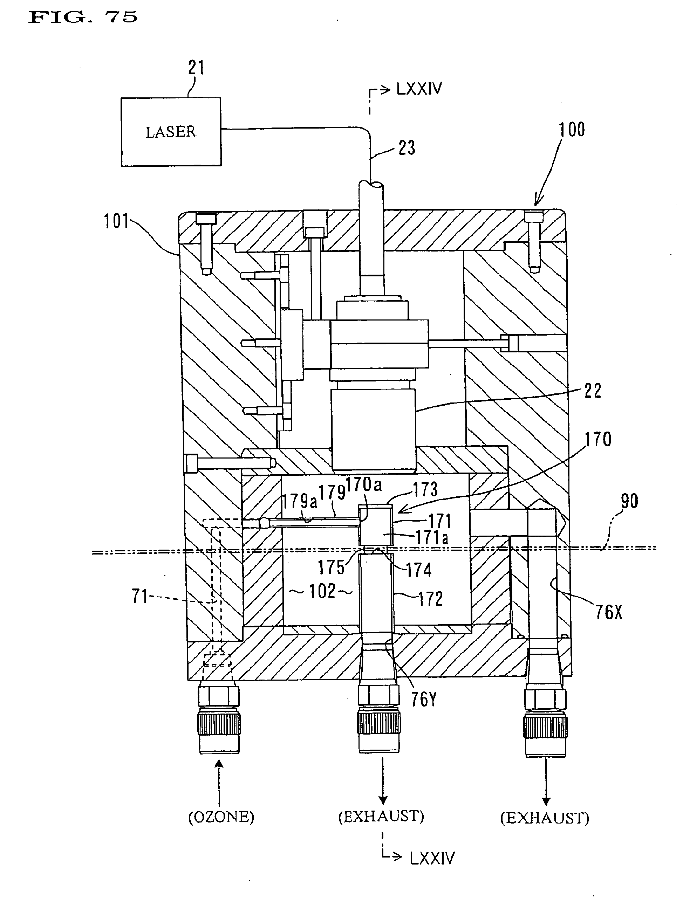

The cylindrical part on the distal end side of the cutout is preferably connected directly with an exhaust path (see FIGS. 74 and 75, as well as elsewhere).
Owing to the above-mentioned arrangement, the processed gas and the reaction by-products can reliably introduced to the exhaust path, particles, if any, can reliably forcibly be exhausted and the reaction can easily be controlled.

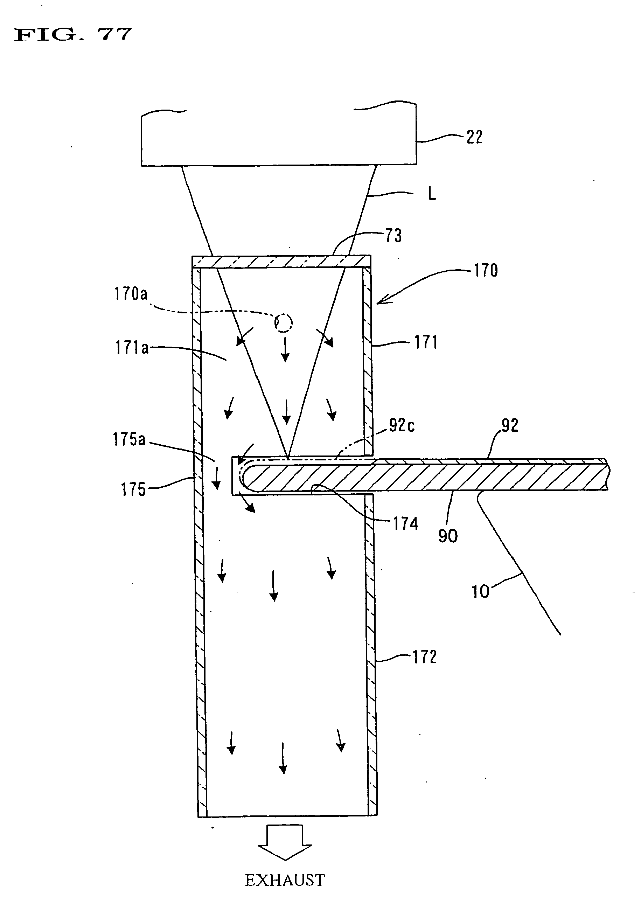

Preferably, the cylindrical part is provided at a basal end part thereof with a light transmissive closure part for closing the basal end part, and the irradiator of thermal light is disposed outside the closure part in such a manner as to be directed toward the target position (see FIGS. 70 and 77, as well as elsewhere).
Owing to the above-mentioned arrangement, in case the unnecessary film and the reactive gas carry out endothermic reaction, the reaction can reliably be enhanced.

As mentioned above, since it is effective for the heat absorbing means to be located just inside the outer peripheral part of the substrate such as a wafer, the diameter of the stage is made slightly smaller than that of the substrate such as a wafer so that only the outer peripheral part of the substrate projects radially outwardly of the stage.

On the other hand, at the time for placing the substrate on the stage and removing it from the stage, the front surface of the substrate is preferably not touched. For that purpose, it is preferable that a fork-like arm is employed, and this arm is brought into abutment with the under surface (rear surface) of the substrate and lifted. However, in case only a small part of the outer peripheral part of the substrate is projected from the stage, there is almost no room for the fork to be abutted with the under surface of the substrate.

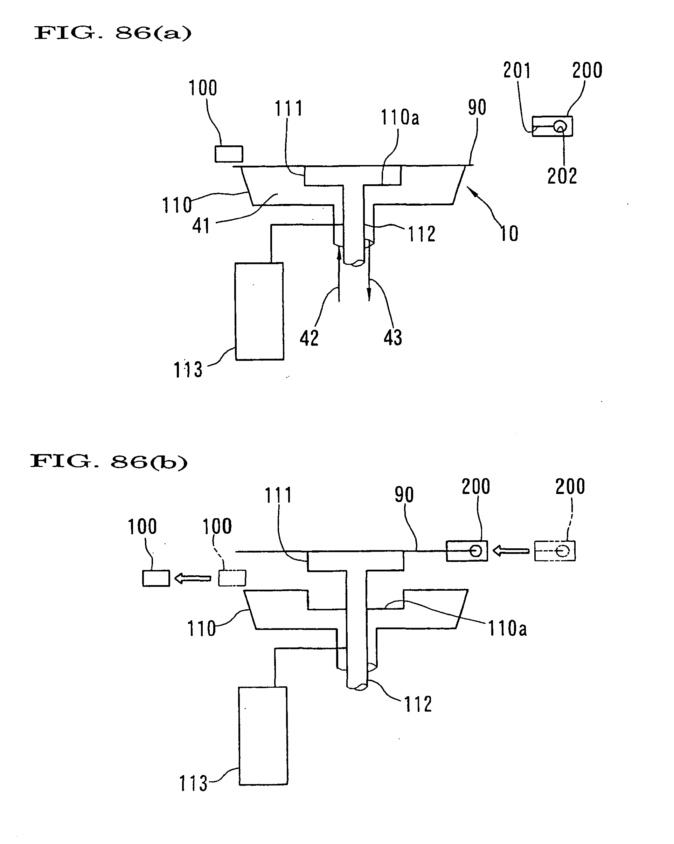

Therefore, the stage is preferably provided at a central part thereof with a reduced-diameter center pad such that the center pad is movable up and down (see FIGS. 86 through 87, as well as elsewhere). With this center pad projected from the stage, the substrate is placed on the center pad by the fork-like robot arm and the fork-like robot arm is retreated. When, the center pad is made flush with or lowered therefrom in that condition, the substrate can be placed on the stage. After processing finished, the center pad is lifted up and the fork-like robot arm is inserted between the substrate and the stage. The wafer can then be lifted up by the fork-like robot arm and carried out.

In the stage with the center pad, the up and down motion mechanism for the center pad is arranged on the center axis. The center pad is preferably furnished with a function for absorbing the substrate. In that case, a suction flow path leading from the center pad is arranged on the center axis. In case no cooling is required in processing, there is an instance where it is convenient to use the center pad directly as the stage. In that instance, the rotation mechanism of the center pad may also be connected to the center axis.

In case the above-mentioned arrangement is employed, the suction flow path for allowing the stage to absorb the substrate and the cooling flow path leading to the cooling chamber become difficult to be arranged on the center axis, and they are obliged to be arranged in such a manner as to be eccentric from the center axis. On the other hand, since the stage is rotated about the center axis, it becomes a problem how to interconnect the stage and the eccentric flow path.

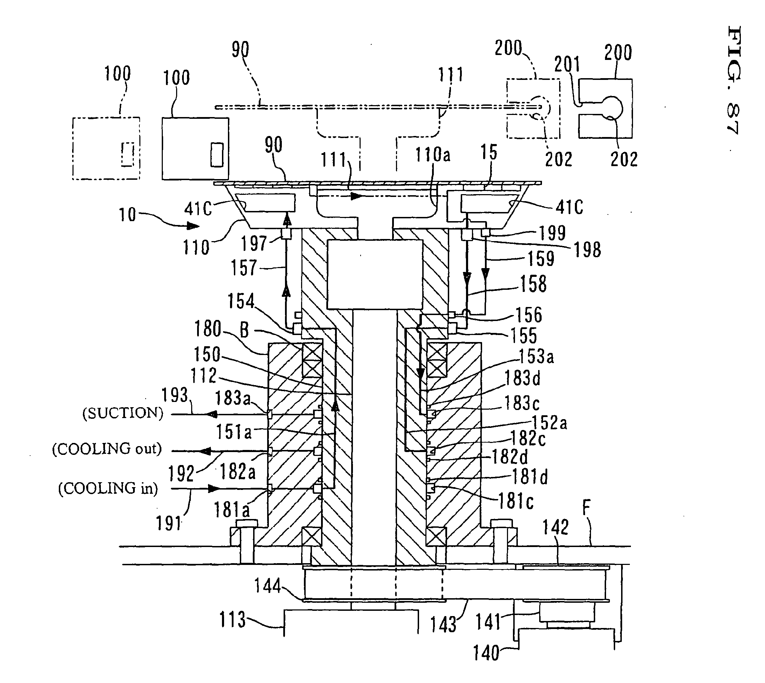

Therefore, it is accepted that the apparatus comprises a stage including a flow path for prevailing a required (temperature adjustment (including cooling), absorbing, etc.) action on the substrate such as the wafer and rotatable about the center axis,
this stage comprises a stage main body provided thereon with an installation surface on which the substrate is placed, and a terminal (part for carrying out the required action such as temperature adjustment and absorption) of the flow path, a fixed cylinder provided with a port for the flow path, a rotary cylinder rotatably passed through the fixed cylinder and coaxially connected to the stage main body, and a rotation driver adapted to rotate the rotary cylinder,
an annular path connected to the port is formed in the inner peripheral surface of the fixed cylinder or the outer peripheral surface of the rotary cylinder,
an axial path extending in the axial direction is formed in the rotary cylinder, and
one end part of this axial path is connected to the annular path, and the other end part is connected to the terminal (see FIG. 87, as well as elsewhere).
Owing to the above-mentioned arrangement, the stage can be rotated while flowing a fluid for prevailing a required action such as temperature adjustment and absorption on the substrate such as the wafer in a position eccentric from the center of the stage, and a space for arranging other component members such as, for example, an advancing/ retreating mechanism for the center pad can be obtained on the center axis.

For example, the terminal is a chamber or path for cooling the substrate. The chamber or path as the terminal is formed within the stage main body. The cooling fluid for cooling the substrate is passed through the flow path.
Owing to the above-mentioned arrangement, the substrate can be cooled as the required action.
In that case, the stage comprises
a stage main body having a refrigerant chamber or a refrigerant path formed therein as the heat absorbing means,
a fixed cylinder provided with a port for a refrigerant,
a rotary cylinder rotatably passing through the fixed cylinder and coaxially connected to the stage main body, and
a rotation driver adapted to rotate the rotary cylinder,
an annular port connected to the port being formed at an inner peripheral surface of the fixed cylinder or an outer peripheral surface of the rotary cylinder,
an axial path extending in the axial direction being formed in the rotary cylinder, one end part of the axial path being connected to the annular path and the other end part being connected to the refrigerant chamber or the refrigerant path (see FIG. 87, as well as elsewhere).

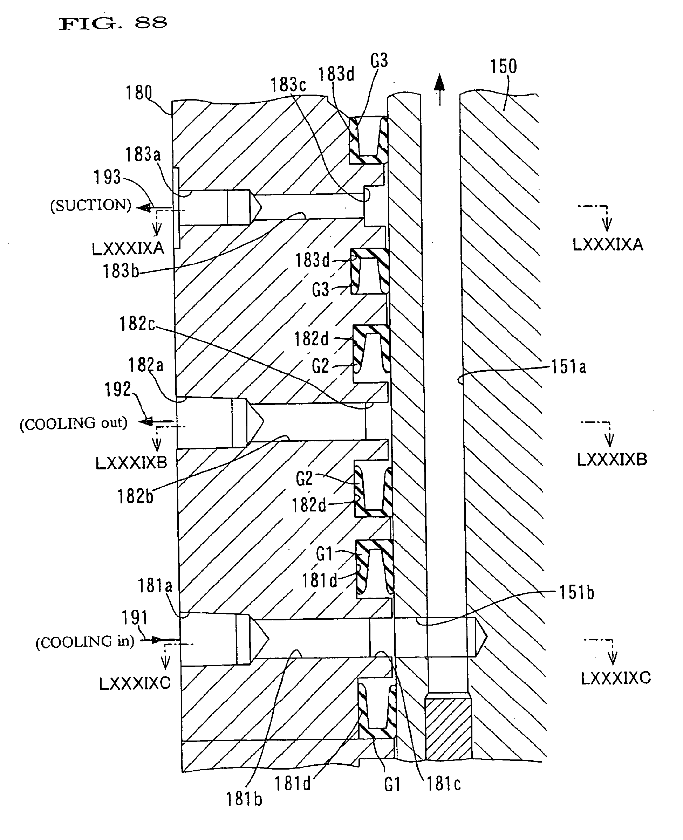

In the cooling flow path construction, it is preferable that two annular seal grooves are formed in an inner peripheral surface of the fixed cylinder or an outer peripheral surface of the rotary cylinder such that the seal grooves are located on both sides of the annular path, and
each of the seal grooves receives therein a gasket opening toward the annular path and having a $\Pi$-shaped configuration in section (see FIG. 88, as well as elsewhere).
In case the cooling fluid enters the annular seal groove through a clearance between the inner peripheral surface of the fixed cylinder and the outer peripheral surface of the rotary cylinder, the fluid pressure (positive pressure) acts on the gasket having a U-shape in section in the spreading direction of the opening of the gasket and the gasket can be pushed against the inner peripheral surface of the annular seal groove. As a result, a seal pressure can reliably be obtained and the cooling fluid can reliably be prevented from leaking.

It is accepted that the terminal is an absorption groove formed in the installation surface and the port is vacuum sucked (see FIG. 87, as well as elsewhere).

Owing to this arrangement, absorption of the substrate can be carried out as the required action.

In the absorption flow path construction mentioned above, it is preferable that two annular seal grooves are formed in an inner peripheral surface of the fixed cylinder or an outer peripheral surface of the rotary cylinder such that the seal grooves are located on both sides of the annular path, and

each of the seal grooves receives therein a gasket opening toward an opposite side with regard to the annular path and having a U-shaped configuration in section (see FIG. 88, as well as elsewhere).

Owing to the above-mentioned arrangement, in case the negative pressure of the absorption flow path is prevailed on the annular seal groove through the clearance between the inner peripheral surface of the fixed cylinder and the outer peripheral surface of the rotary cylinder, this negative pressure acts on the rear part of the sectionally U-shaped gasket and tries to spread the gasket, and as a result, the gasket is pushed against the inner peripheral surface of the annular seal groove so that leakage can reliably be prevented from occurrence.

It is preferable that a pad shaft connected to the center pad is received within the rotary cylinder. The center pad is preferably advanced/retreated in the axial direction through the pad shaft. It is also accepted that the center pad is rotated through the pad shaft. It is preferable that the pad shaft is incorporated with a part or whole of a pad reciprocation mechanism for advancing/retreating the center pad and a pad rotation mechanism for rotating the center pad. An absorption groove for absorbing the substrate is also formed in the center pad, and the pad shaft is provided with a suction path connected to the absorption groove of the center pad.

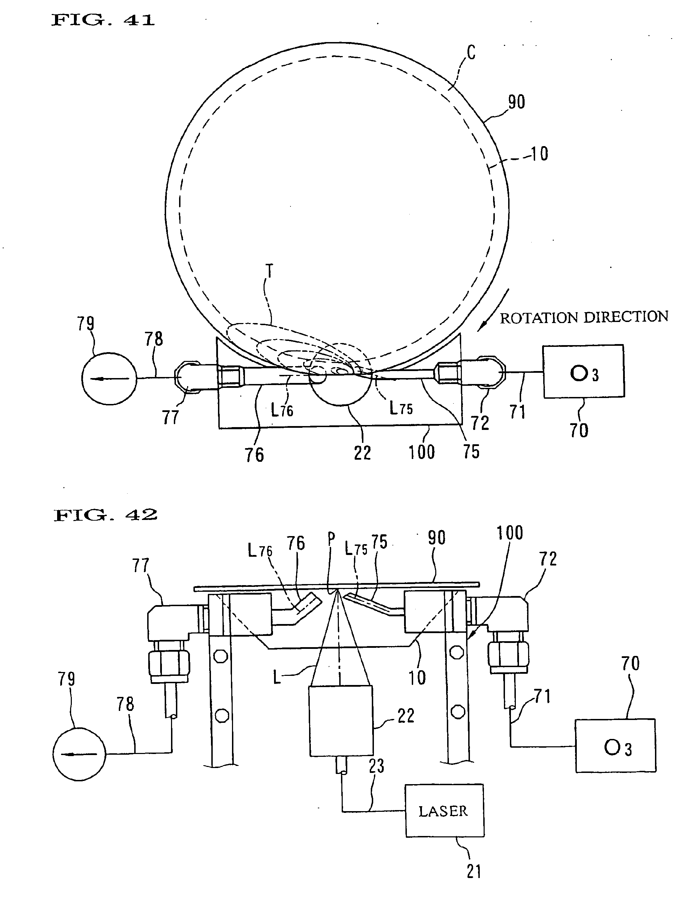

It is also accepted that the jetting direction from the jet nozzle of the reactive gas for removing the unnecessary matter to the outer peripheral part of the substrate such as the wafer is generally directed in the peripheral direction (tangential direction at the target position) of the substrate (see FIGS. 41 through 45, as well as elsewhere).

It is also accepted that the jetting direction of the jet nozzle of the reactive gas supplying means of the apparatus for processing the outer periphery of a wafer is generally directed in the peripheral direction (tangential direction at the target position) of the annular surface in the vicinity of the annular surface where the outer peripheral part of the substrate is to be located (see FIG. 41, as well as elsewhere).

Owing to the above-mentioned arrangement, the reactive gas can flow along the outer periphery of the substrate, the time for the reactive gas to contact the outer periphery of the substrate can be increased, and the reaction efficiency can be enhanced.

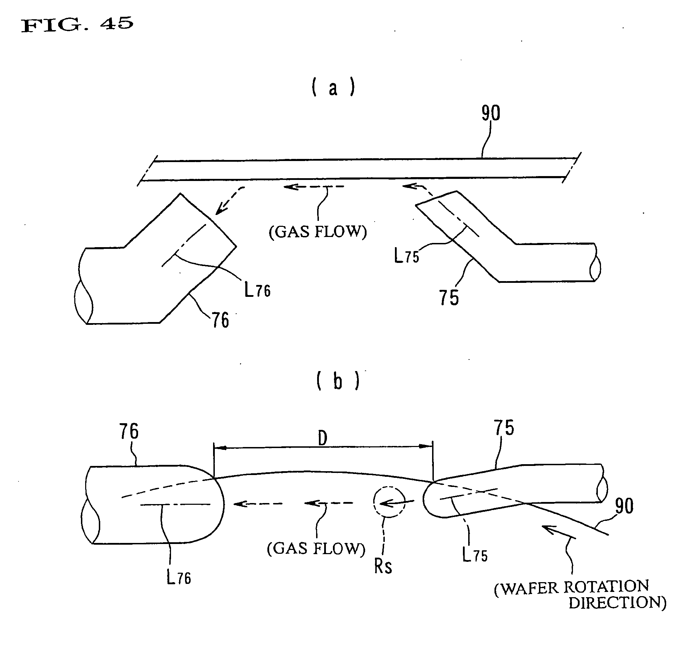

In case the unnecessary matter coated on the rear surface of the wafer is chiefly to be removed, it is desirable that the jet nozzle is arranged at the rear side (thus, the rear side of the wafer) of the annular surface (see Fig. 42, as well as elsewhere). It is also desirable that the distal end part (jet shaft) of the jet nozzle is slanted radially inwardly of the annular surface (see FIG. 45(b), as well as elsewhere). Owing to this arrangement, the reactive gas can be prevented from not turning to the front side of the substrate, and the front side can be prevented from being damaged.

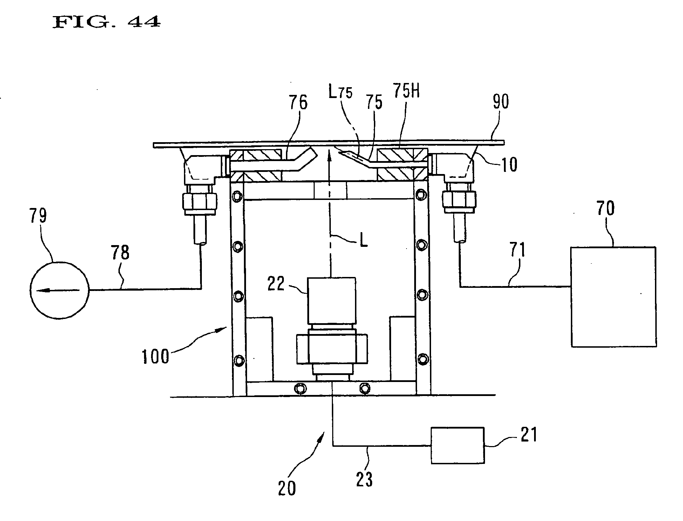

Desirably, the distal end part (jet shaft) of the jet nozzle is slanted from the front or rear side of the annular surface to the annular surface (see FIGS. 42 and 44, as well as elsewhere). Owing to this arrangement, the reactive gas can reliably be hit to the substrate.

Of course, it is also accepted that the distal end part (jet shaft) of the jet nozzle is directed just in the peripheral direction (tangential direction) of the substrate.

It is preferable that the apparatus comprises, in addition to the jet nozzle, a suction nozzle (exhaust nozzle) for sucking the processed gas (see FIG. 41, as well as elsewhere). The suction nozzle is connected with a suction exhaust means such as a vacuum pump.

The suction nozzle is preferably arranged opposite to the jet nozzle with the target position sandwiched therebetween (see FIG. 41, as well as elsewhere).

The suction nozzle is preferably arranged opposite to the jet nozzle generally along the peripheral direction (tangential direction) of the annular surface (see FIG. 41, as well as elsewhere).

Owing to the above-mentioned arrangement, the flowing direction of the reactive gas can reliably be controlled so as to be along with the peripheral direction of the substrate, and the part, which is not required to be processed, can reliably be prevented from being adversely affected by the reactive gas. Then, the reactive gas is jetted out generally in the tangential direction through the jet nozzle and reacted. After reaction, the processed gas (containing reaction by-products such as particles) is directly allowed to flow generally straight along the tangential direction of the substrate. Then, the processed gas can be sucked by the suction nozzle so as to be exhausted. Thus, particles can be prevented from being stacked on the substrate.

In case the jet nozzle is arranged at the rear side of the annular surface, the suction nozzle is also arrange at the rear side. In that case, the distal end part (suction shaft) of the suction nozzle is desirably slanted toward the annular surface (see FIG. 42, as well as elsewhere). Owing to this arrangement, the reaction gas, which flows along the substrate, can reliably be sucked.

It is also accepted that the distal end part (suction shaft) of the suction nozzle is directed straight in the peripheral direction (tangential direction) so that it is aligned with the distal end part (jet shaft) of the jet nozzle.

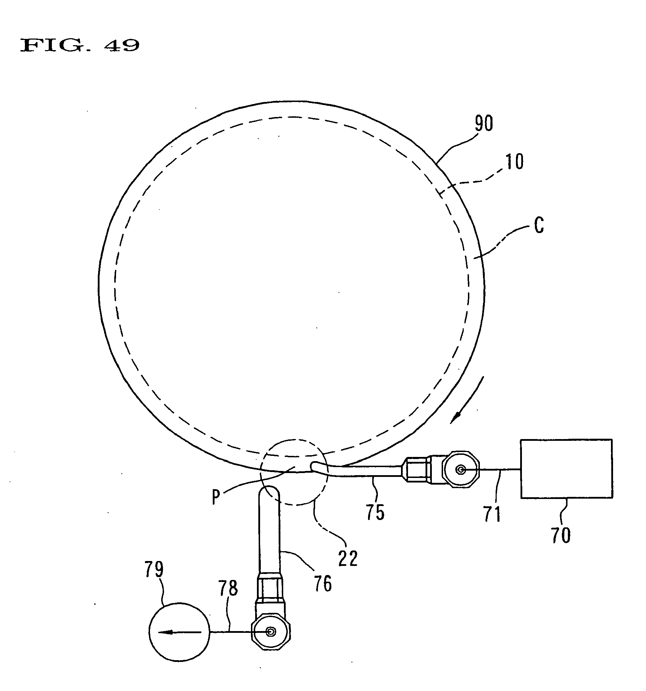

It is also accepted that the suction shaft of the distal end part of the suction nozzle is directed generally radially inwardly from the outside of the annular surface on which the outer periphery of the substrate is to be arranged, so that the suction shaft is generally orthogonal to the jet shaft of the distal end part of the jet nozzle (see FIG. 49, as well as elsewhere).

Owing to the above-mentioned arrangement, the reactive gas is jetted out through the jet nozzle and reacted. After reaction, the processed gas (containing reaction by-products such as particles) can rapidly be brought radially outward so as to be sucked/exhausted. Thus, particles can be prevented from being stacked on the substrate.

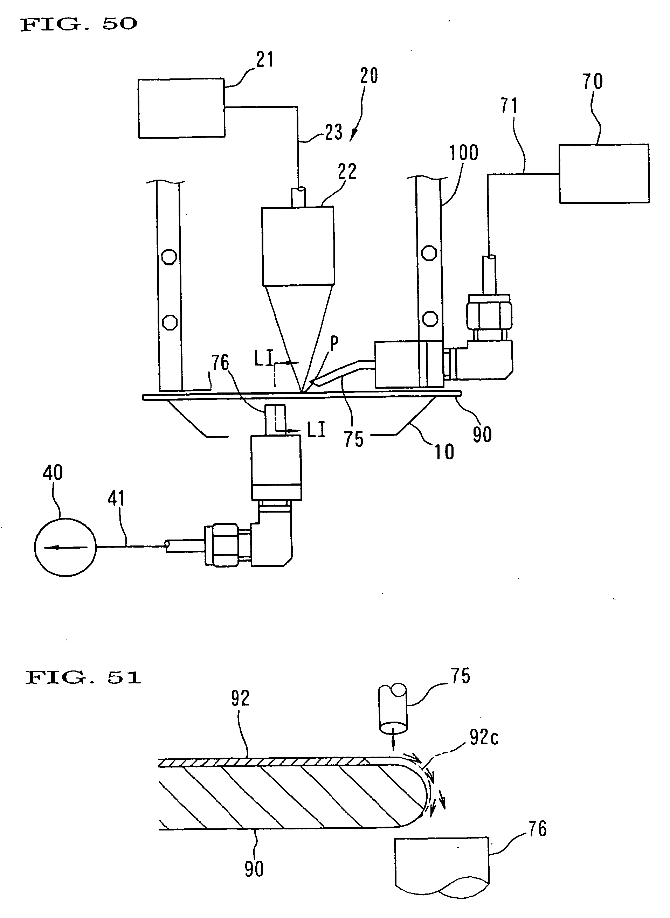

It is also accepted that the suction shaft of the distal end part of the suction nozzle is arranged in such a manner as to be directed toward the annular surface on which the outer periphery of the substrate is to be arranged, and that the suction shaft is arranged on the opposite side to the side where the distal end part of the jet nozzle is arranged and the annular surface is sandwiched between the suction shaft and the distal end part of the jet nozzle (see FIG. 50, as well as elsewhere).

Owing to the above-mentioned arrangement, the gas jetted out through the jet nozzle can be flown from the surface of the outer periphery of the substrate on the side where the jet nozzle is arranged, via the outer end face, to the surface on the side where the suction nozzle is arranged. Thus, the unnecessary film coated on the outer end face of the substrate can reliably be removed (see FIG. 51, as well as elsewhere). Then, the processed gas (containing reaction by-products such as particles) can be sucked into the suction nozzle so as to be exhausted. Thus, particles can be prevented from stacking on the substrate.

The bore diameter of the suction nozzle is preferably larger than that of the jet nozzle.

The suction nozzle preferably has a bore diameter 2 to 5 times as large as that of the jet nozzle.

The bore diameter of the jet nozzle is preferably about 1 to 3 mm, for example. On the other hand, the bore diameter of the suction nozzle is preferably about 2 to 15 mm, for example.

Owing to the above-mentioned arrangement, the processed gas and the reaction by-products can be restrained from being dispersed, and then can reliably be sucked into the suction port so as to be exhausted.

It is desirable to employ a rotation means for relatively rotating the substrate in the peripheral direction with respect to the jet nozzle.

It is preferable that the jet port is arranged on the upstream side along the normal direction in the rotating direction of the substrate, and the suction port is arranged on the downstream side (see FIG. 41, as well as elsewhere).

Desirably, the radiating heater locally irradiates a radiant heat between the jet nozzle and the suction nozzle in the annular surface.

Owing to the above-mentioned arrangement, while locally heating the outer peripheral part of the substrate located between the jet nozzle and the suction nozzle, a reactive gas can be contacted therewith. This is effective when a film (organic film such as photoresist), whose etching rate is increased as the temperature is increased, is to be removed. Since the heating is made locally, the part, which is not required to be processed, can be prevented or restrained from being heated. Moreover, since the heating can be made in a non-contact manner, particles can reliably be prevented from occurrence. This radiating heater is desirably a laser heater.

As mentioned previously, in case an organic film such as photoresist is to be removed, the reaction gas is preferably ozone. In order to generate such ozone gas, an ozonizer or an oxygen plasma may be used. In case ozone is used, it is desirable that the jet nozzle is provided with a cooling means. Owing to this arrangement, ozone can be kept in a low temperature so that the life of ozone can be prolonged, and the reaction efficiency can be enhanced. As the cooling means for the jet nozzle, for example, a cooling path is formed in a nozzle retaining member for retaining the jet nozzle and a cooling medium such as a cooling water is passed through this cooling path. The temperature of the cooling medium may be about room temperature. Desirably, the nozzle retaining member is formed of an excellent heat conductive material.

The local radiation position of the radiating heater is desirably offset to the jet nozzle side between the jet nozzle and the suction nozzle (see FIG. 45(b), as well as elsewhere).

Owing to the above-mentioned arrangement, the respective processing points of the outer peripheral part of the substrate can be radiantly heated soon after the reactive gas coming from the nozzle hits them. Thereafter, during the greater part of the period the reactive gas keeps hitting, high temperature can be maintained with the residual heat and the processing efficiency can more reliably be enhanced.

The rotating direction of the basal material may be the reverse direction opposite to the direction mentioned above. In that case, the local radiation position of the radiating heater is preferably offset to the suction nozzle side between the jet nozzle and the suction nozzle.

It is desirable that the distance between the jet nozzle and the suction nozzle is properly established taking into consideration such factors as rotation speed of the rotation means and the heating performance of the radiating heater.

It is also accepted that after the reactive gas for removing the unnecessary matter is introduced to the outer peripheral part of the substrate, the gas is guided in such a manner as to flow in the peripheral direction through a guide path extending along the outer periphery of the substrate, thereby removing the unnecessary mater coated on the outer peripheral part of the substrate such as a wafer.

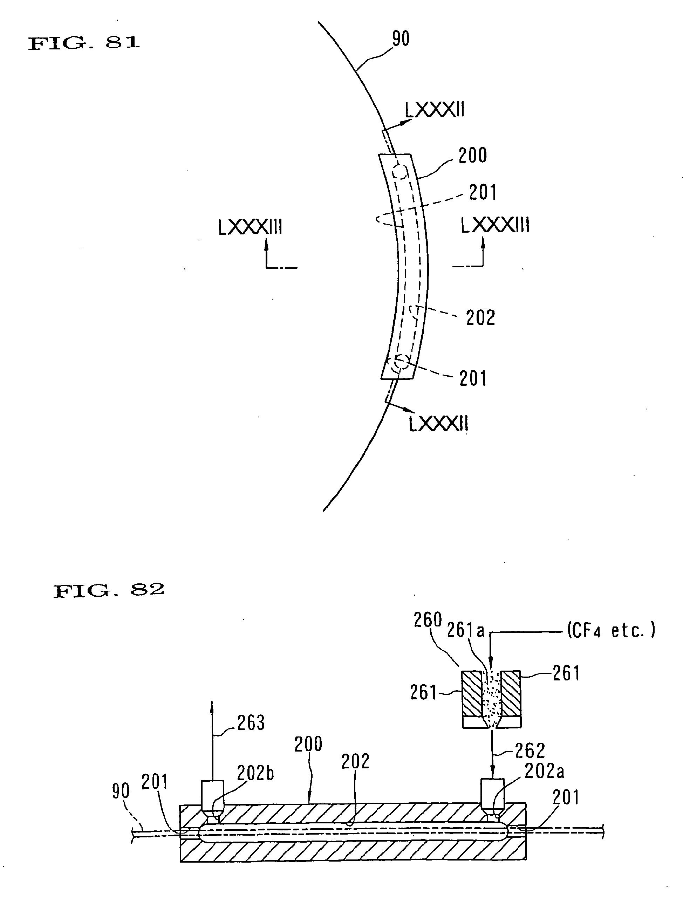

It is also accepted that the reactive gas supplying means of the apparatus for processing the outer periphery of a wafer comprises a gas guide member,
the gas guide member includes a guide path extending in the peripheral direction of the substrate in such a manner as to enclose the outer peripheral part of the substrate, and
the reactive gas is passed in the extending direction of the guide path (see FIGS. 81 through 83 and 91 through 94, as well as elsewhere).
Owing to the above-mentioned arrangement, the time for the active pieces to contact the outer periphery of the substrate can be increased and the reaction efficiency can be enhanced. Moreover, the required quantity of process gas can be reduced.
This gas guide member can be applied as a gas supplying means of the second reactive gas supplying means and is suitable for removing an inorganic film such as Sin and $SiO_2$.

Desirably, the gas guide member includes an insertion port for allowing the outer peripheral part of the substrate to be removably inserted therein, and the innermost end of the insertion port is spread in width, thereby forming the guide path. The thickness of the insertion port is desirably slightly larger than that of the substrate. A space between the insertion port and the substrate is desirably as small as possible when the substrate is inserted in the insertion port.

It is desirable that one end part in the extending direction of the guide path is connected with an introduction port for the reactive gas and the other end part is connected with an exhaust port (see FIG. 82, as well as elsewhere). Owing to this arrangement, the reactive gas can be flowed from one end part of the guide path toward the other end part.

A rotation means for relatively rotating the gas guide member in the peripheral direction of the substrate is desirably provided in such a manner that the speed of rotation can be adjusted.
Owing to the above-mentioned arrangement, the unnecessary matter can evenly be removed from the entire periphery of the outer peripheral part of the substrate and the processing width of the unnecessary matter can be adjusted by adjusting the speed of rotation. The speed of rotation is preferably in the range of 1 rpm to 1000 rpm, more preferably in the range of 10 rpm to 300 rpm. If the speed of rotation exceeds 1000 rpm, the time for the reactive gas to contact the target part is overly reduced and thus not preferable.
It is preferable that the flowing direction of the gas in the guide path is aligned with the rotating direction of the substrate.

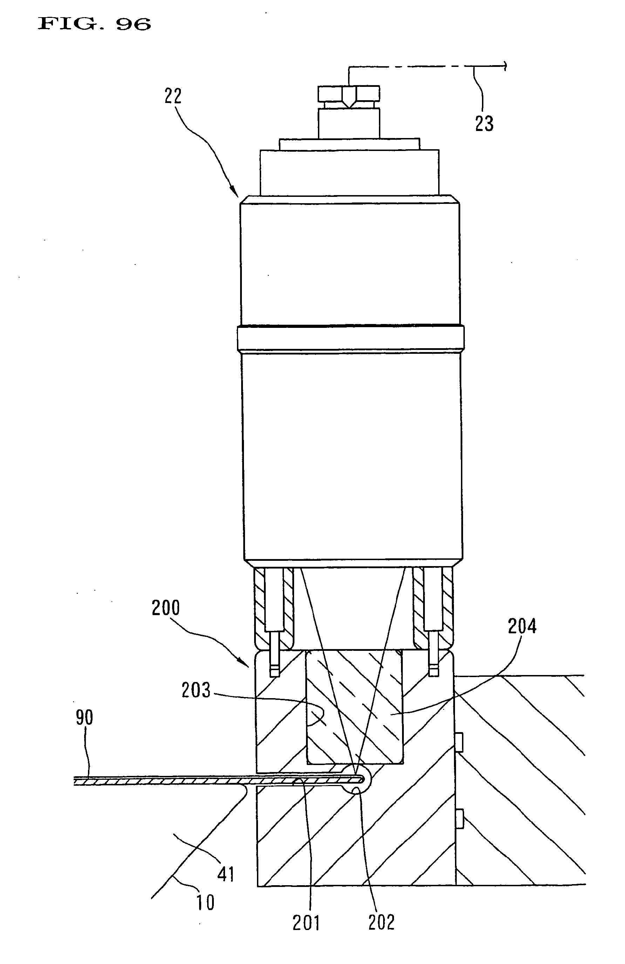

It is also accepted that the irradiator of the radiating heater is disposed within or in the vicinity of the guide path. The irradiator may be additionally attached to the gas guide member. A light transmissive member for allowing the thermal light of the irradiator to transmit therethrough is preferably embedded in the gas guide member in such a manner as to face with the guide path (see FIG. 96, as well as elsewhere)
Owing to the above-mentioned arrangement, inorganic films (for example, SiC) such as photoresist and polymer which require heating for etching can be removed using the gas guide member.
The gas guide member with an irradiator is also effective when only one of the first inorganic film (for example, SiC) which can be etched under high temperature and the second inorganic film (for example, $SiO_2$) which is lower in etching rate than the first inorganic film under high temperature, laminated on the substrate, is to be removed.

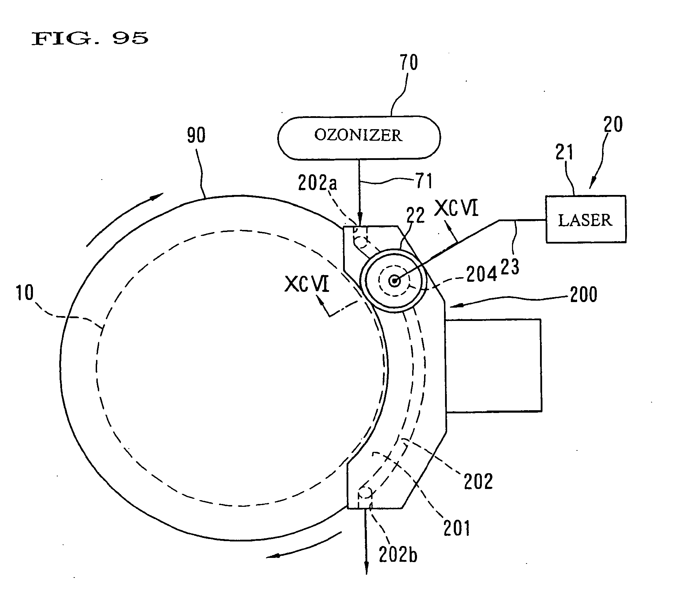

It is preferable that the heater heats the outer peripheral part of the substrate within the guide path (particularly, on the upstream side (the introduction port side) of the guide path). It is also preferable that the heater heats the outer peripheral part of the substrate on the upstream side in the rotating direction of the guide path (see FIG. 95, as well as elsewhere).
Preferably, the flowing direction of the gas in the guide path is aligned with the rotating direction of the substrate, and the irradiator irradiates the thermal light near the upstream end of the guide path in a converging manner (see FIG. 95, as well as elsewhere). Owing to this arrangement, the outer peripheral part of the substrate can be radiation heated at a location near the upstream end of the guide path, the film coated on the outer periphery of the substrate can sufficiently be reacted with fresh reactive gas, and thereafter, since the substrate keeps high temperature for a short time while rotating toward the downstream side of the guide path, a satisfactory reaction can be taken place not only at the part on the upstream side of the guide path but also at the intermediate part and the downstream side part. Owing to this arrangement, the processing efficiency can reliably be enhanced.

In case the film contains such components which are liable to produce a residue, in other words, which tend to produce by-products in a solid state under normal temperature, the outer periphery of the substrate on the downstream side in the rotating direction of the guide path may be locally heated by the above-mentioned heater. Owing to this arrangement, the residue can be evaporated and removed from the outer periphery of the substrate. For example, when SiN is etched, by-products each in a solid state such as $(NH_4)_2SiF_6$, $NH_4F \cdot HF$ are produced. This residue can be evaporated and removed by the heater.

It is also accepted that the apparatus comprises, in addition to the gas guide member, an organic film removing head as the above-mentioned first reactive gas supplying means, and this organic film removing head includes an irradiator for locally supplying a radiant heat to the outer peripheral part of the substrate and a gas supply part for locally supplying a first reactive gas such as an oxygen reactive gas, which is reacted with organic films, to the outer peripheral part of the substrate (see FIG. 79, as well as elsewhere). The organic film removing processing head and the gas guiding

**EP 1 801 861 B1**

member are preferably arranged away in the peripheral direction of the stage. The solid by-products produced during the process using the gas guide member are preferably heated by the irradiator of the organic film removing processing head so as to be evaporated and removed.

As mentioned above, in general, a cutout part such as an orientation flat and notch is formed in a part of the outer peripheral part of the circular wafer.

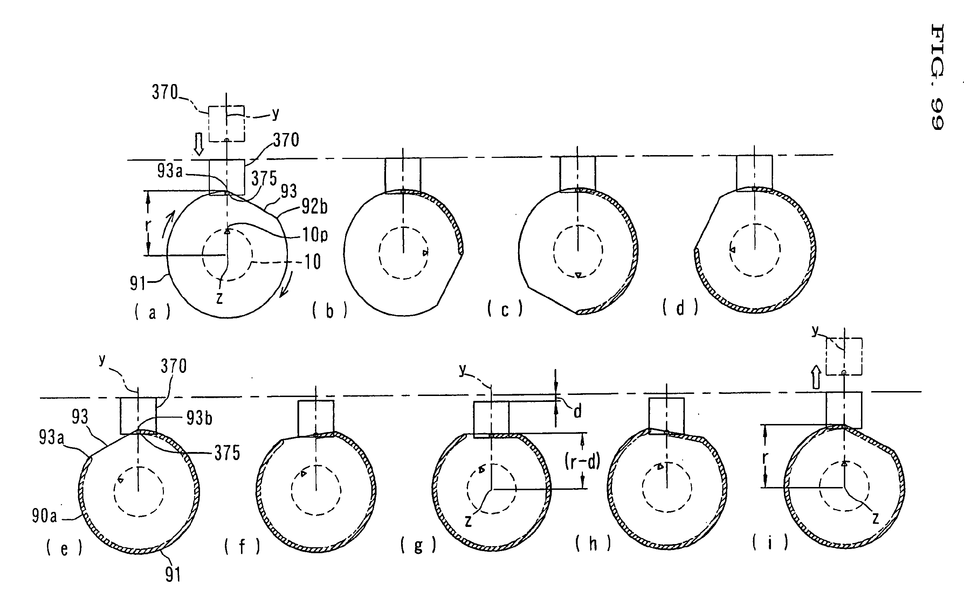

It is also accepted that the wafer is arranged on the stage, this stage is then rotated about a rotation axis, the processing fluid (reactive gas) is supplied from the supply nozzle while the supply nozzle is directed to the spot where the outer peripheral part of the wafer moves across the first axis which is orthogonal to the rotation axis and while the supply nozzle is slid along the first axis in correspondence with a continuous or temporary change of the spot, if the change is caused by the rotation of the stage (see FIG. 99, as well as elsewhere).

Preferably, the wafer is concentrically arranged on the stage, the stage is rotated about the rotation axis, the processing fluid (reactive gas) is supplied from the supply nozzle while the supply nozzle is always directed to a crossing spot where the outer peripheral part of the wafer is moved across the first axis orthogonal to the rotation axis, by means of keeping the supply nozzle directing to a position that is disposed on the first axis and that is away from the rotation axis by a substantially equal distance to the radius of the wafer when a circular part of the outer peripheral part of the wafer is moved across the first axis, and by means of sliding the supply nozzle along the first axis in correspondence with a change the crossing spot along the first axis when a cutout part of the outer peripheral part of the wafer moves across the first axis.

In a preferred embodiment of the apparatus for processing the outer periphery of a wafer

a stage on which the wafer is arranged and which is rotated about a rotation axis,

a processing fluid (reactive gas) supply nozzle is slidably disposed along the first axis which is orthogonal to the rotation axis, and

a nozzle position adjusting mechanism is for normally directing the supply nozzle to the crossing spot by positionally adjusting the supply nozzle along the first axis in correspondence with continuous or temporary change of the crossing spot where the outer peripheral part of the wafer moves across the first axis in accordance with the rotation of the stage (see FIG. 99, as well as elsewhere).

In a preferred embodiment of the apparatus for processing the outer periphery of a wafer

a stage is rotated about a rotation axis (center axis),

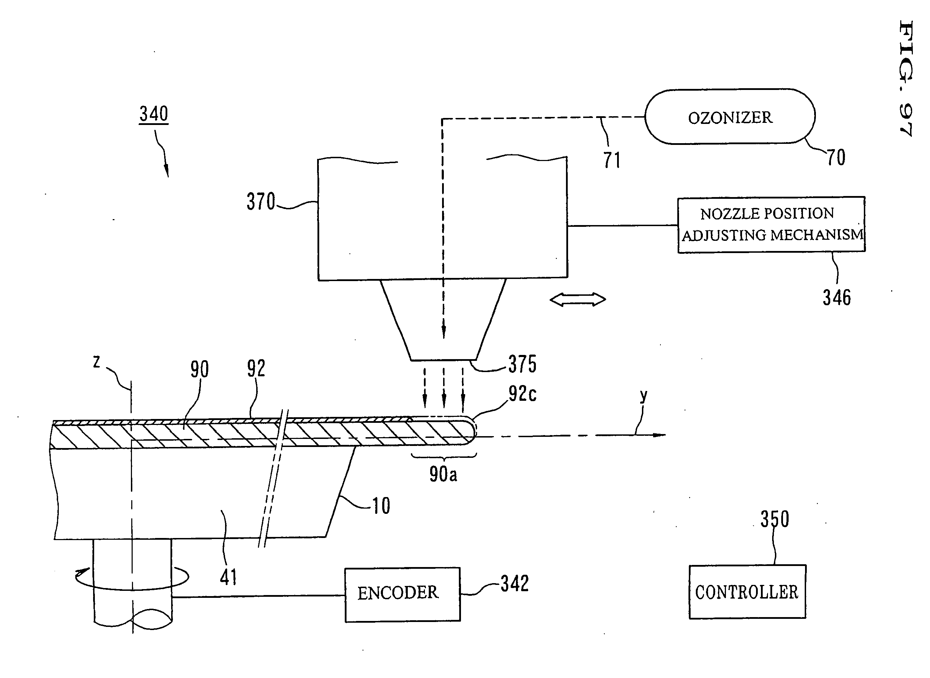

an alignment mechanism is for aligningly (concentrically) arranging a wafer having a circular outer peripheral part on which a cutout part such as an orientation flat and a notch is partly formed, on the processing stage,

a processing fluid (reactive gas) supply nozzle is slidably disposed along the first axis which is orthogonal to the rotation axis, and

a nozzle position adjusting mechanism is for keeping the supply nozzle stationary while directing the supply nozzle to a crossing point, i.e., position on the first axis away by a substantially equal distance to the radius of the wafer from the rotation axis when the circular outer peripheral part of the wafer moves across the first axis and for sliding the supply nozzle along the first axis in correspondence with change of the crossing point when the cutout part of the wafer moves across the first axis, thereby normally directing the supply nozzle to the crossing spot (see FIGS. 97 through 99, as well as elsewhere).

It is also accepted that the reactive gas supplying means includes a reactive gas supply nozzle slidable along a first axis which is orthogonal to the center axis of the stage,

the wafer is concentrically arranged on the stage and the stage is rotated about the center axis,

when the circular outer peripheral part of the wafer moves across the first axis, the distal end part of the supply nozzle is kept stationary while being directed to a position on the first axis away by an equal distance to the radius of the wafer from the center axis, and

when the cutout part of the wafer moves across the first axis, the supply nozzle is slid along the first axis in synchronism with the rotation of the stage so that the distal end part of the supply nozzle is normally directed to the crossing spot (see FIGS. 97 through 99, as well as elsewhere).

It is desirable that the alignment mechanism includes a cutout detection part for detecting the cutout part of the wafer and the cutout part is directed to a predetermined direction in parallel with the concentric operation.

The nozzle position adjusting mechanism desirably adjusts the position of the supply nozzle in synchronism with the rotation of the stage. That is, when the stage is in the range of a rotation angle corresponding to the time period required for the circular outer peripheral part to moves across the first axis, the supply nozzle is fixed to a position located on the first axis which is away by a substantially equal distance to the radius of the wafer from the rotation axis, and when the stage is in the range of a rotation angle corresponding to the time period required for the cutout part to move across the first axis, the supply nozzle is brought to a speed and direction (direction toward or away from the rotation axis along the first axis) corresponding to the rotation angle and rotation speed of the stage. As a result of this synchronizing control, the supply nozzle is desirably normally directed to the spot where the supply nozzle moves across the first axis.

On the other hand, in case the alignment is made by the alignment mechanism, the equipment cost for the alignment mechanism is required and in addition, the time required for transferring the wafer from the place where the alignment is made to the rotational stage is required. Moreover, the alignment accuracy depends on the operation accuracy of a robot.

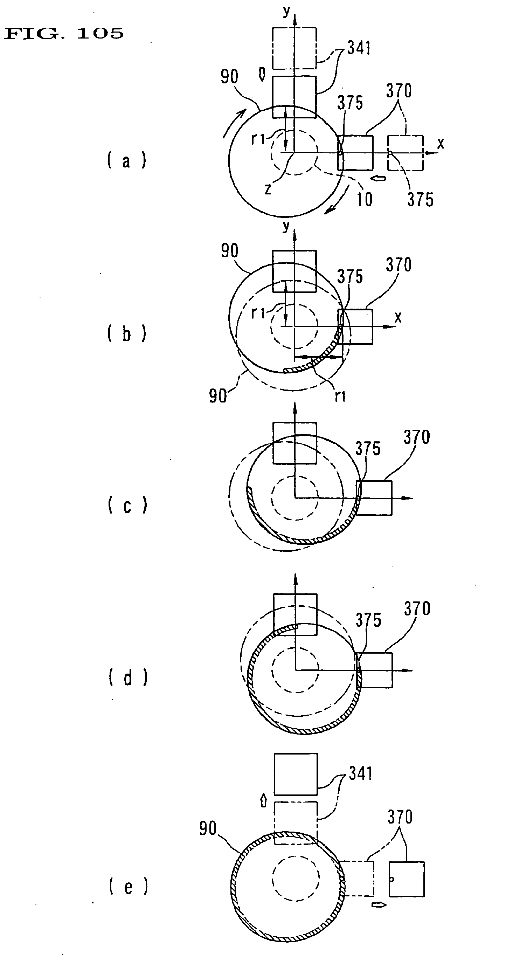

It is also accepted that the wafer is arranged on the stage, this stage is then rotated about a rotation axis (center axis), the supply nozzle of the processing fluid (reactive gas) is directed to the spot where the outer peripheral part of the wafer moves across the first axis which is orthogonal to the rotation axis, and the processing fluid is supplied while sliding the supply nozzle along the first axis in correspondence with the change when the crossing spot is changed in accordance with the rotation of the stage (see FIG. 105, as well as elsewhere).

Preferably, the wafer is arranged on the stage, this stage is then rotated about a rotation axis (center axis), a momentary spot where the outer peripheral part of the wafer moves across is calculated, and the processing fluid (reactive gas) is supplied while normally directing the supply nozzle to the crossing spot by positionally adjusting the supply nozzle along the first axis based on the calculated result (see FIG. 105, as well as elsewhere).

Owing to the above-mentioned arrangement, eccentricity correcting alignment mechanism can be eliminated, and the apparatus can be simplified in construction. Moreover, since the alignment operation can be eliminated, the entire processing time can be shortened.

In parallel with the calculation of the momentary crossing spot which is made from time to time, it is also accepted that the supply nozzle is positionally adjusted and the processing fluid is supplied.

In that case, it is preferable that the position of the outer peripheral part of the wafer is measured on the upstream side of the supply nozzle along the rotating direction of the stage, and the above-mentioned calculation is made based on this measured result.

It is also accepted that after the calculation of the crossing spot is carried out over the entire periphery of the outer peripheral part of the wafer, the supply nozzle is positionally adjusted and the processing fluid is supplied.

In a preferred embodiment of the apparatus for processing the outer peripheral part of a wafer

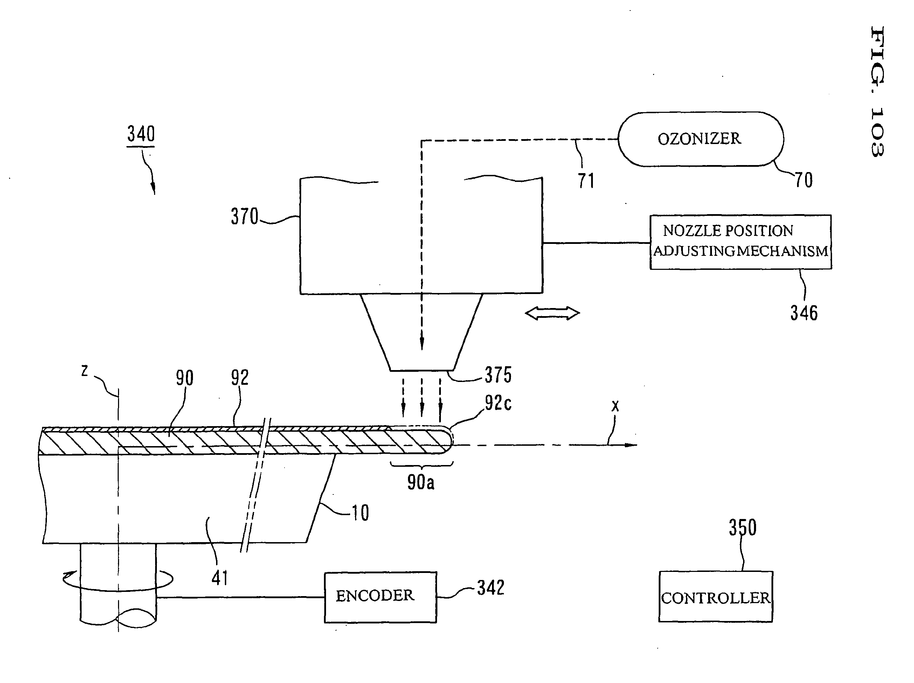

a stage on which the wafer is arranged is rotated about a rotation axis (center axis),

a processing fluid (reactive gas) supply nozzle slidably is disposed along a first axis orthogonal to the rotation axis,

a calculation part is for calculating a momentary spot where the outer peripheral part of the wafer moves across the first axis, and

a nozzle position adjusting mechanism is for normally directing the processing fluid supply nozzle to the crossing spot by positionally adjusting the supply nozzle along the first axis based on the calculated result (see FIGS. 103 through 105, as well as elsewhere).

It is also accepted that the reactive gas supplying means includes a reactive gas supply nozzle slidably along a first axis which is orthogonal to the center axis of the stage,

the stage is rotated about the center axis while retaining the wafer,

the apparatus further comprises a calculator for calculating an momentary spot where the outer peripheral part of the wafer moves across the first axis which is orthogonal to the center axis, and

the processing fluid is supplied while normally directing the supply nozzle to the crossing spot by positionally adjusting the supply nozzle along the first axis based on the calculated result (see FIGS. 103 through 105, as well as elsewhere).

The calculator desirably includes a measurer for measuring the outer periphery of the wafer.

EFFECT OF THE INVENTION

According to the present invention, unnecessary matters can efficiently be removed by heating the outer peripheral part of a wafer and spraying a reactive gas onto the heated outer peripheral part.

Owing to a provision of the heat absorbing means on the stage, even in case heat is conducted to a part located inside the outer peripheral part of the substrate from the outside or heat of a heater is applied thereto, the heat can be absorbed by this heat absorbing means. Accordingly, film and wiring disposed at the part inside the outer periphery of the substrate can be prevented from changing in quality. Moreover, even in case a reactive gas flows into the inside from the outer peripheral side of the substrate, reaction can be restrained. This makes it possible to prevent that damage prevails on the inside part from the outer periphery of the substrate.

BRIEF DESCRIPTION OF DRAWINGS

FIG. 1 is a front cross-sectional view taken on line I-I of FIG. 2, showing an apparatus for processing the outer periphery of a substrate according to a first embodiment of the present invention.

FIG. 2 is a plan view of the above-mentioned apparatus.

FIG. 3 is a front cross-sectional view showing, on an enlarged scale, a film removing part of the above-mentioned apparatus.

FIG. 4(a) is a graph showing the result of an experiment in which the wafer temperatures vs. the distances in a radially inward direction from the vicinity of the part to be heated at the outer end edge of a wafer are measured by the same apparatus of FIG. 1.

FIG, 4(b) is a graph showing the measured temperatures in which a position (immediate vicinity of the part to be heated) nearer to the part to be heated than the comparable position in FIG. 1(a) serves as the origin of the horizontal axis.

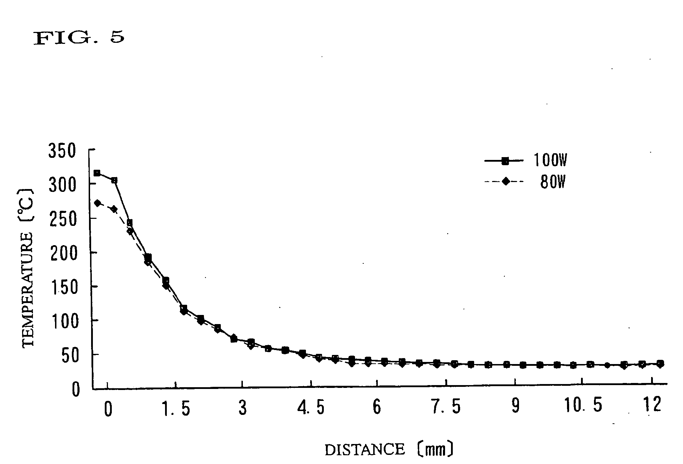

FIG. 5 is a graph showing the result of another experiment in which the wafer temperatures vs. the distances in a radially inward direction from the vicinity of the part to be heated at the outer end edge of a wafer are measured by the same apparatus of FIG. 1.

FIG. 6 is an explanatory front view of a stage according to an improvement of a heat absorbing means.

FIG. 7 is an explanatory front view of a stage according to an improvement of a heat absorbing means.

FIG. 8 is an explanatory plan view of a sage according to an improvement of a heat absorbing means.

FIG. 9 is an explanatory plan view of an improvement of a stage heat absorbing means.

FIG. 10(a) is an explanatory plan view of a stage according to an improvement of a heat absorbing means.

FIG. 10(b) is an explanatory front view of a stage of FIG. 10(a).

FIG. 11 is an explanatory front view of a stage according to an improvement in which a Peltier element is used as a heat absorbing means.

FIG. 12 is a plan view of a stage in which a heat absorbing means is disposed only at the outer peripheral area.

FIG. 13 is an explanatory side view of a stage, etc. of FIG. 12.

FIG. 14 is a plan view showing, on an enlarged scale, the peripheral area of a notch formed in the outer periphery of a wafer, (a) shows a state in which the peripheral area of the notch is processed while maintaining the irradiation spot diameter of a laser irradiation unit constant, (b) shows another state in which the irradiation spot diameter is increased at the notch position, and (c) shows a state after the processing of (b) is conducted.

FIG. 15 is an explanatory front view showing a state in which the laser irradiation unit is focused on the outer periphery of the wafer while setting the irradiation spot diameter to 1 mm.

FIG. 16 is an explanatory front view showing a state in which the peripheral area of the notch is processed by adjusting the focus such that the irradiation spot diameter to 3 mm on the outer periphery of the wafer of the laser irradiation unit.

FIG. 17 is a front view for explaining a processing state in which the laser irradiation unit is finely slid in the radial direction of the wafer so that the processing width becomes larger than the irradiation spot diameter.

FIG. 18(a) is a plan view of the stage incorporated therein with a vacuum chuck mechanism.

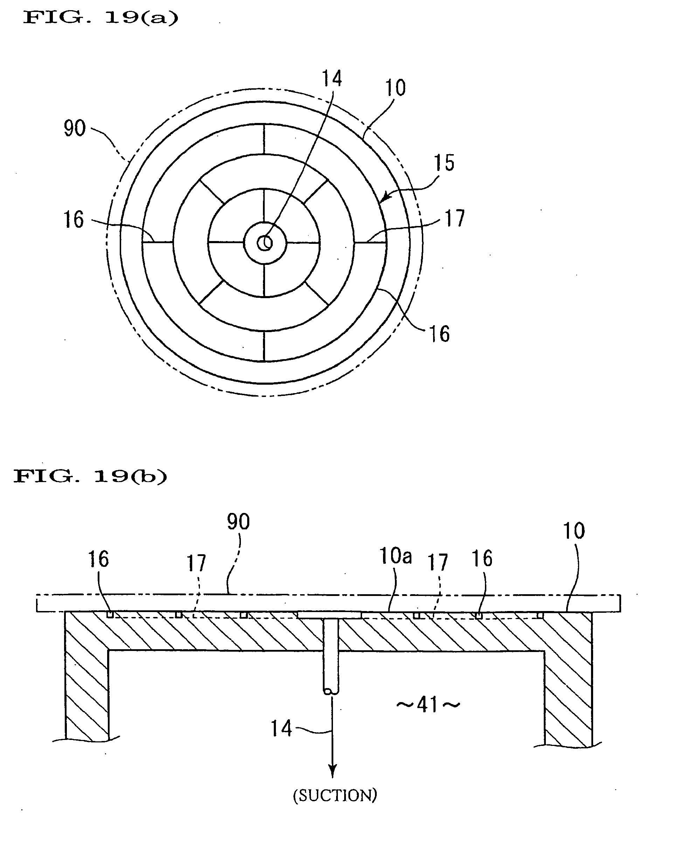

FIG. 19(a) is a plan view of the state according an improvement of the vacuum chuck mechanism.

FIG. 19(b) is an explanatory front sectional view of the stage of FIG. 19(a).

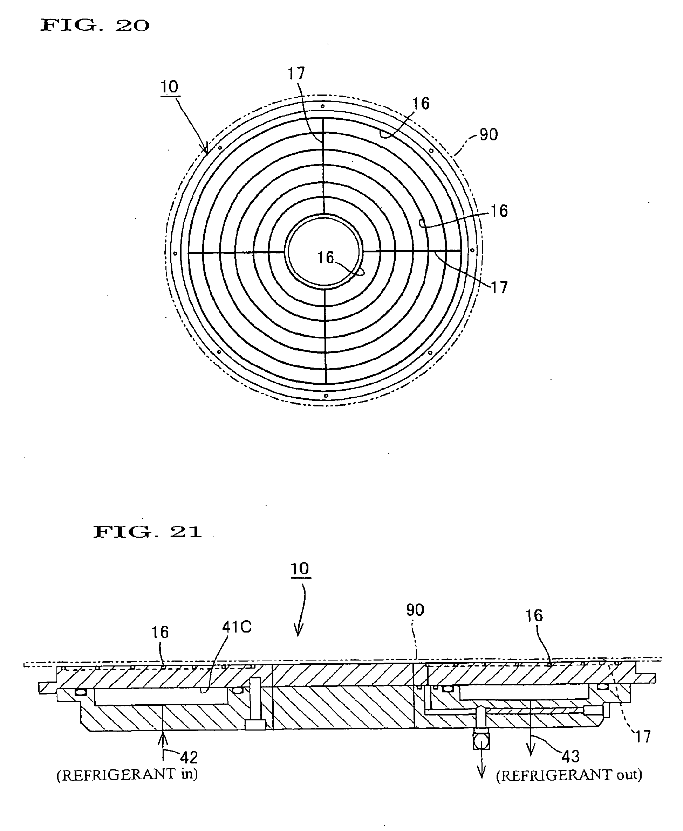

FIG. 20 is a plan view of a stage according to a modification of a vacuum chuck mechanism.

FIG. 21 is a front sectional view of the stage of FIG. 20.

FIG. 22 is a plan view of a stage according to a modification in which a check mechanism is disposed only at the outer peripheral area.

FIG. 23 is a front sectional view of the stage of FIG. 22.

FIG. 24 is a front sectional view showing an apparatus for processing the outer periphery of a substrate according to an improved embodiment of a reactive gas supplying means, etc.

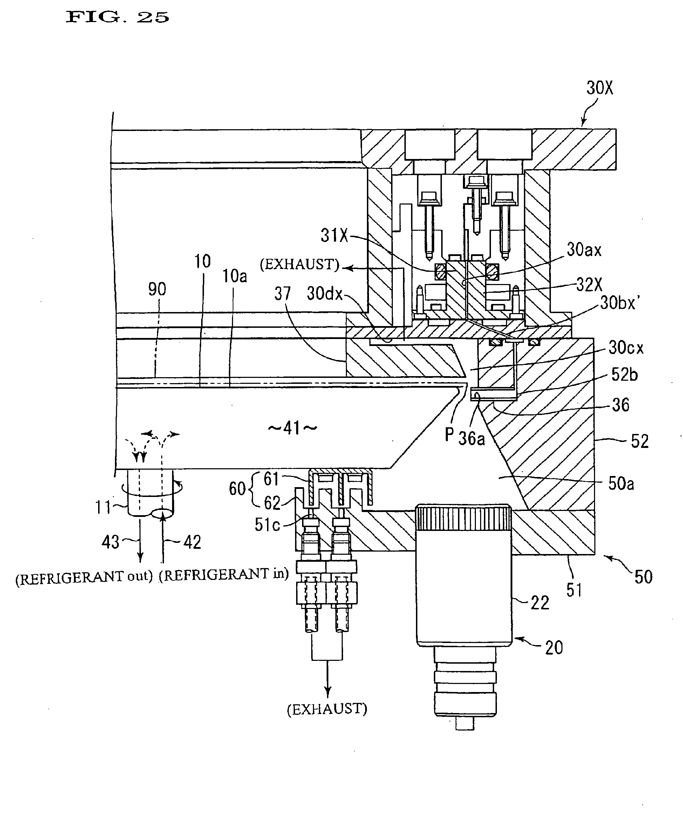

FIG. 25 is a front sectional view showing an apparatus for processing the outer periphery of a substrate according to an improved embodiment of a reactive gas supplying means, etc.

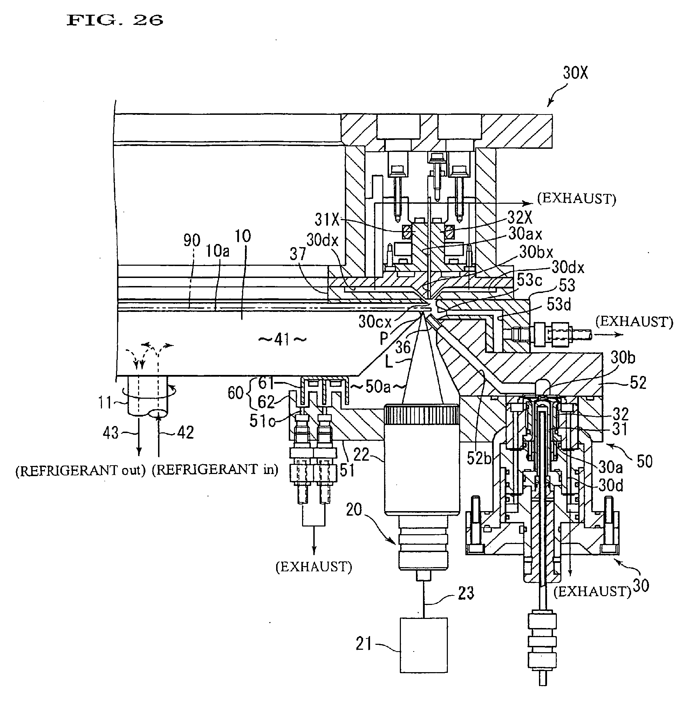

FIG. 26 is a front sectional view showing an apparatus for processing the outer periphery of a substrate according to an improved embodiment of a reactive gas supplying means, etc.

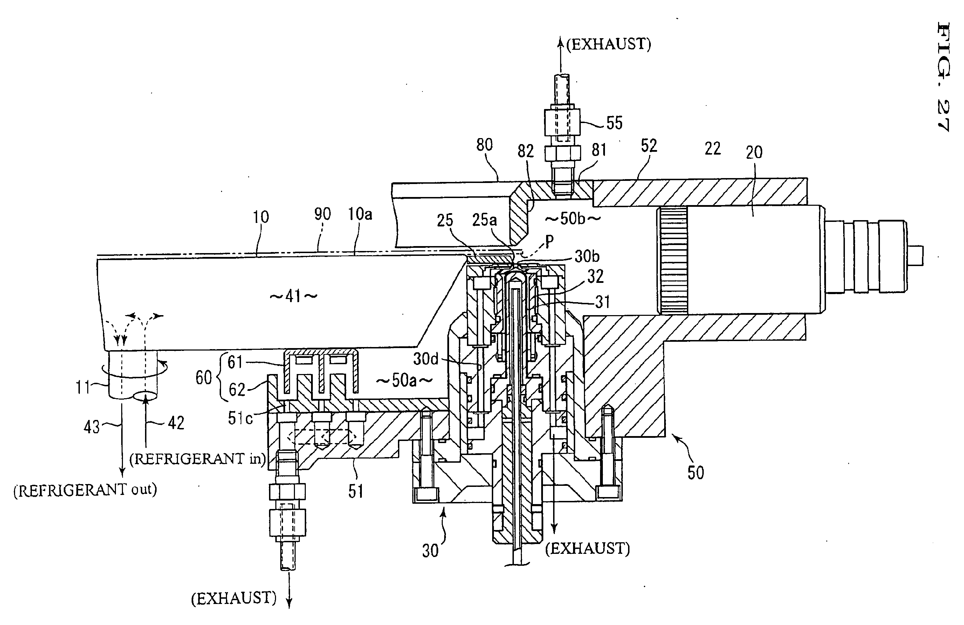

FIG. 27 is a front sectional view showing an apparatus for processing the outer periphery of a substrate according to an improved embodiment of the arrangement relation etc. between a radiating heater and a reactive gas supplying means.

FIG. 28 is a front sectional view showing, on an enlarged scale, a film removing part of the apparatus of FIG. 27.

FIG. 29 is a front sectional view showing an apparatus for processing the outer periphery of a substrate according to an improved embodiment of a reactive gas supply source, etc. of a reactive gas supplying means.

FIG. 30 is a front sectional view showing an apparatus for processing the outer periphery of a substrate according to an improved embodiment of a radiating heater, a reactive gas supplying means, etc.

FIG. 31 is a plan sectional view of the above-mentioned apparatus taken on line XXXI-XXXI of FIG. 30.

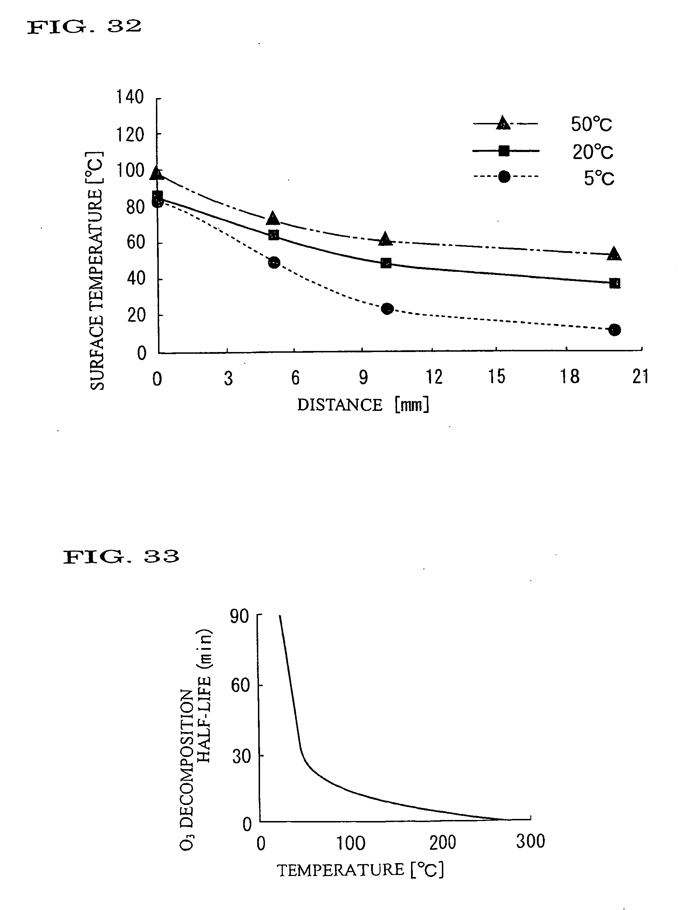

FIG. 32 is a graph showing the result of an experiment in which the wafer temperatures vs. the distances in a radially inward direction from the vicinity of the part to be heated at the outer end edge of a wafer are measured by the same apparatus of FIG. 30.

FIG. 33 is a graph showing the ozone decomposition half-life vs. temperatures.

FIG. 34 is a front sectional view showing an apparatus for processing the outer periphery of a substrate according to an improved embodiment in which a nozzle cooling part, an inert gas supply part, etc. are additionally employed.

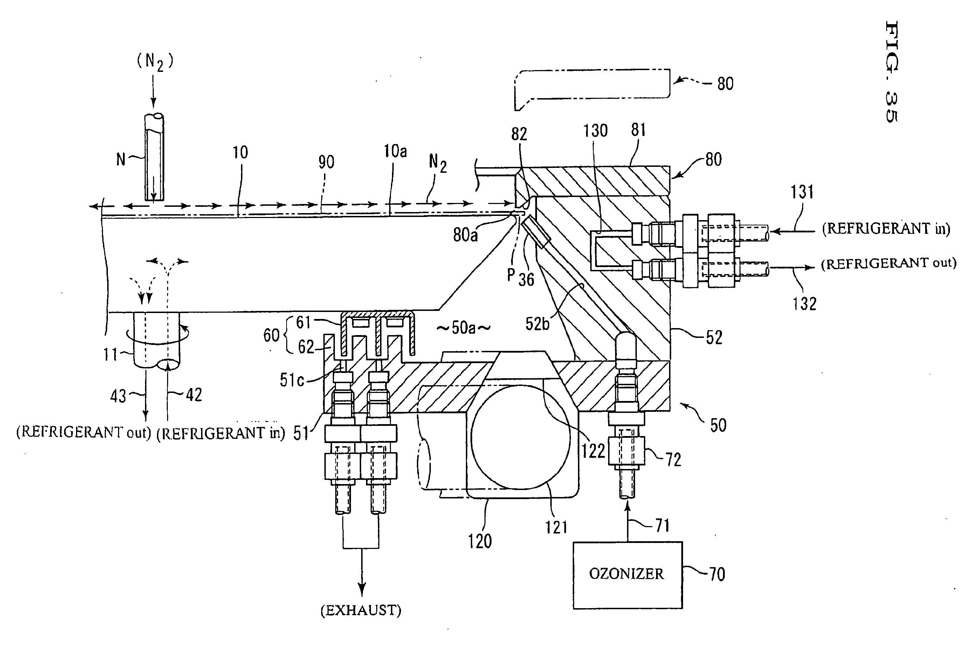

FIG. 35 is a front sectional view showing an apparatus for processing the outer periphery of a substrate according to an improved embodiment of a radiating heater of FIG. 34.

FIG. 36 is a front sectional view showing an apparatus for processing the outer periphery of a substrate according to an improved embodiment of a nozzle cooling part, etc.

FIG. 37 is a front sectional view showing an apparatus for processing the outer periphery of a substrate according to an improved embodiment in which a gas reservoir is additionally employed.

FIG. 38 is an explanatory front view showing an embodiment in which a light transmissive enclosure is additionally employed.

FIG. 39 is an explanatory front view showing an embodiment in which a plurality of optical fiber cables are used as an optical system of a radiating heater.

FIG. 40(a) is a front sectional view of a jet port forming member including a turning flow forming part.

FIG. 40(b) is a side sectional view of the jet port forming member including a turning flow forming part.

FIG. 41 is a plan sectional view showing an apparatus for processing the outer periphery of a substrate comprising a processing head part which includes a jet nozzle and an exhaust nozzle.

FIG. 42 is a front explanatory view of the apparatus for processing the outer periphery of a substrate of FIG. 41.

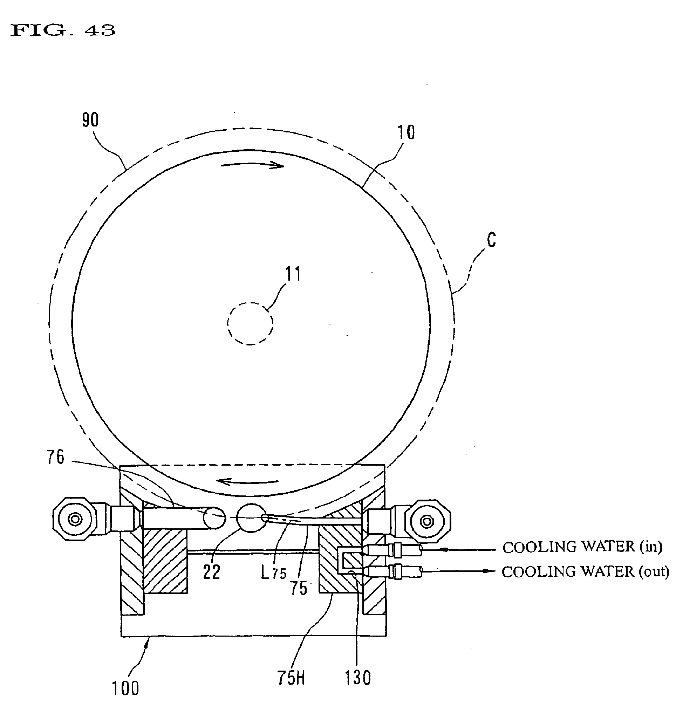

FIG. 43 is a plan explanatory view showing an improvement of an apparatus for processing the outer periphery of a substrate including a jet nozzle and an exhaust nozzle.

FIG. 44 is a front explanatory view of the apparatus for processing the outer periphery of a substrate of FIG. 43.

FIG. 45(a) is a front view showing, on an enlarged scale, a nozzle part of the apparatus of FIG. 43, and (b) is a bottom view thereof.

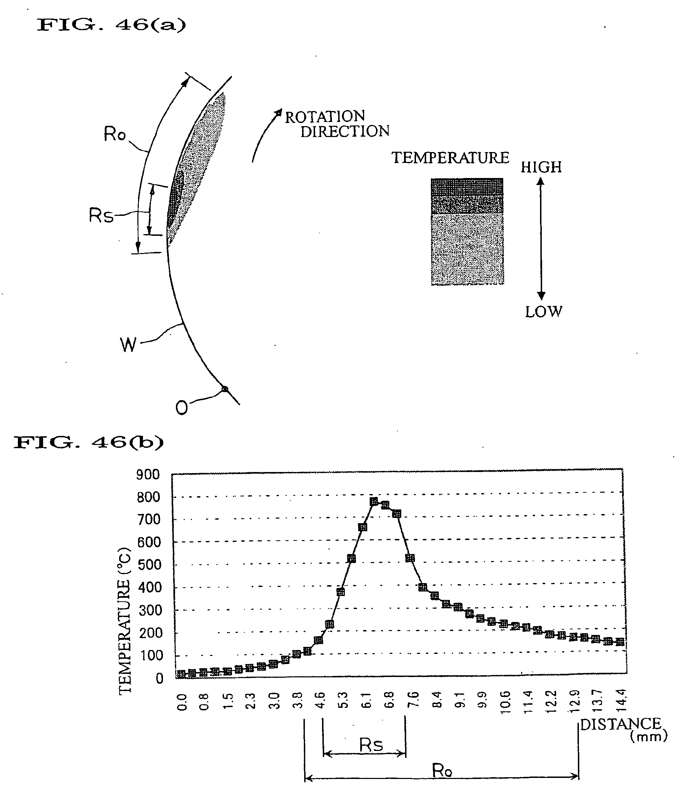

FIG. 46(a) is a plan explanatory view showing the measured result of temperature distribution on the front surface of a wafer at the time of locally radiantly heating the outer peripheral part of the rear surface of the rotating wafer with a laser.

FIG. 46(b) is a graph showing the measured result of temperatures vs. positions in the peripheral direction of the rear surface of the wafer of FIG. 46(a).

FIG. 47 is a plan explanatory view showing another modification of the apparatus for processing the outer periphery of a substrate comprising a processing head which includes a jet nozzle and an exhaust nozzle.

FIG. 48 is a front explanatory view of the apparatus for processing the outer periphery of a substrate of FIG. 47.

FIG. 49 is a plan view showing a schematic construction of an apparatus for processing the outer periphery of a wafer according to a modification in which a suction nozzle is disposed outside the radius of a wafer.

FIG. 50 is a plan view showing a schematic construction of an apparatus for processing the outer periphery of a wafer according to a modification in which a suction nozzle is disposed at the opposite side of a jet nozzle with respect to the wafer.

FIG. 51 is an enlarged sectional view of a peripheral area of the outer peripheral part of the wafer taken on line L1-L1 of FIG. 50.

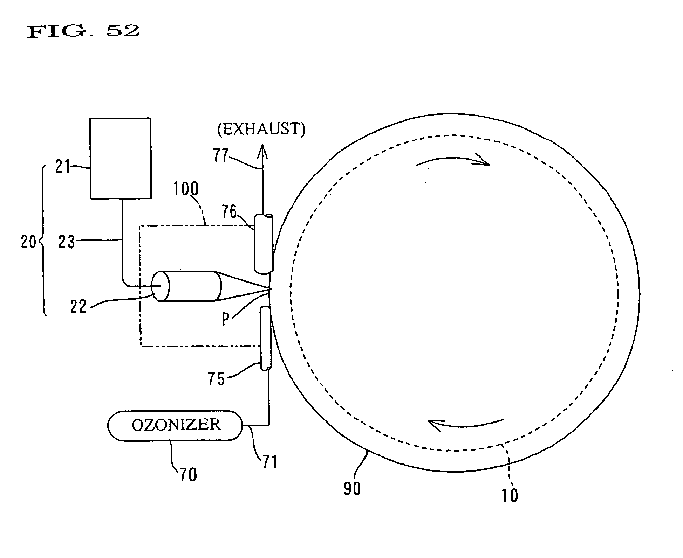

FIG. 52 is a plan explanatory view of an apparatus for processing the outer periphery of a substrate in which the irradiating direction is directed toward a slantwise downward wafer outer peripheral part from the upper side and outside the radius of the wafer.

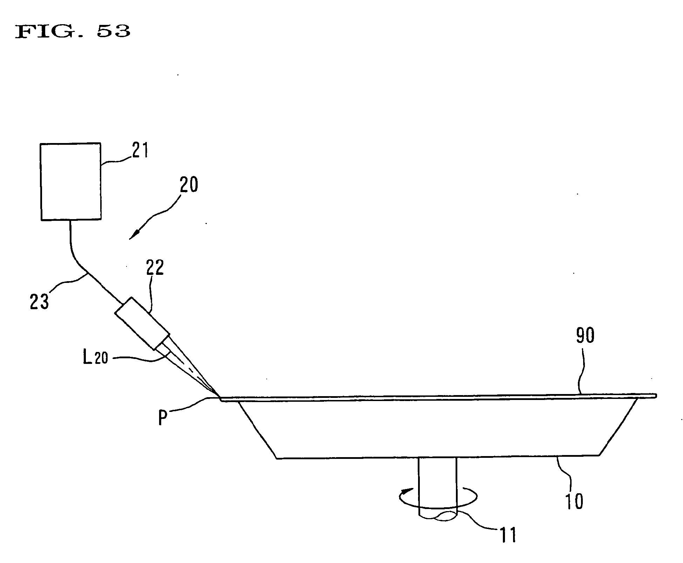

FIG. 53 is a front explanatory view of the apparatus for processing the outer periphery of a substrate of FIG. 52.

FIG. 54 is a front sectional view showing, on an enlarged scale, an irradiation unit and the wafer outer peripheral part of FIG. 53.

FIG. 55 is a sectional view of the outer peripheral part of the wafer after the unnecessary film is removed.

FIG. 56 is a front sectional explanatory view of an irradiation unit in which the irradiating direction is directed toward a wafer from just the side of a wafer.

FIG. 57 is a front explanatory view of an irradiation unit in which the irradiating direction is directed toward a slantwise upward wafer outer peripheral part from the lower side and outside the radius of the wafer.

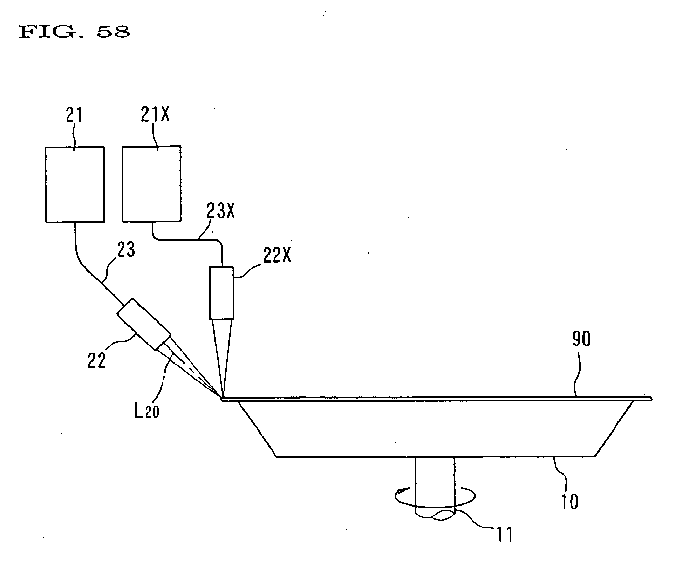

FIG. 58 is a front explanatory view of an apparatus for processing the outer periphery of a substrate including a slanted irradiation unit and a vertical irradiation unit.

FIG. 59 is a front explanatory view of an apparatus for processing the outer periphery of a substrate, comprising a mechanism for arcuately moving an irradiation unit above a wafer.

FIG. 60 is a front explanatory view of an apparatus for processing the outer periphery of a substrate, comprising a mechanism for arcuately moving an irradiation unit under a wafer.

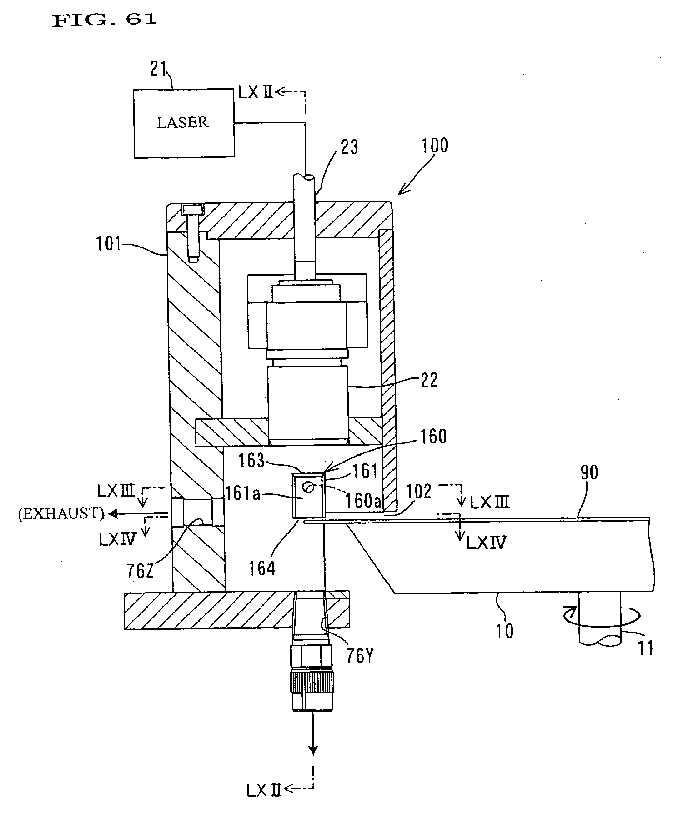

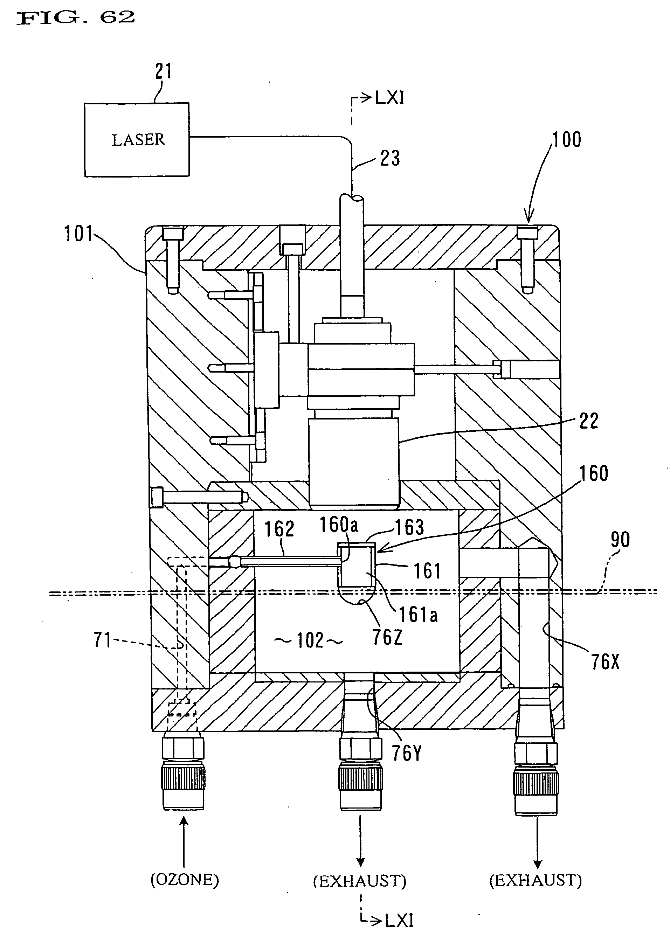

FIG. 61 is a vertical sectional view taken on line LXI-LXI of FIG. 62, showing an apparatus for processing the outer periphery of a substrate, comprising a ladle nozzle.

FIG. 62 is a vertical sectional view of a processing head taken on line LXII-LXII of FIG. 61.

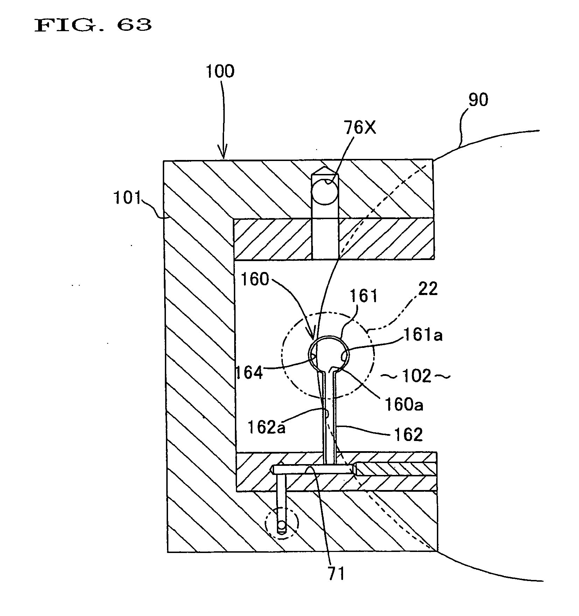

FIG. 63 is a plan sectional view of an apparatus for processing the outer periphery of a substrate, taken on line LXIII-LXIII of FIG. 61

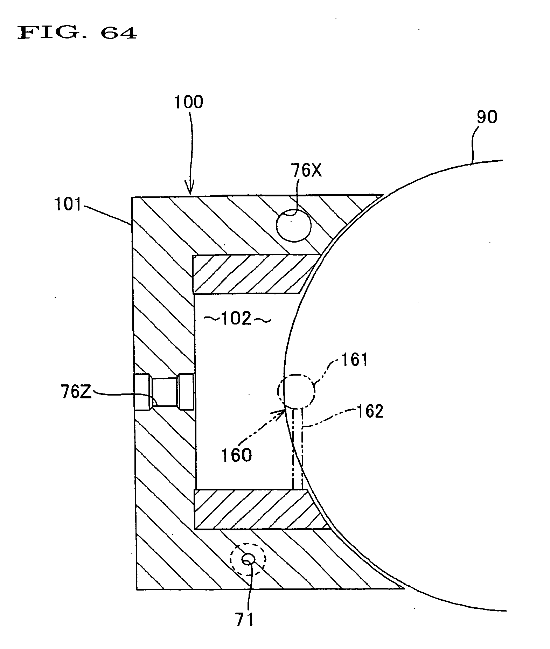

FIG. 64 is a plan sectional view of an apparatus for processing the outer periphery of a substrate, taken on line LXIV-LXIV of FIG. 61

FIG. 65 is a perspective view of the ladle nozzle.

FIG. 66 is an explanatory sectional view showing, on an enlarged scale, the outer peripheral part of the wafer after the unnecessary film is removed by the apparatus of FIG. 61.

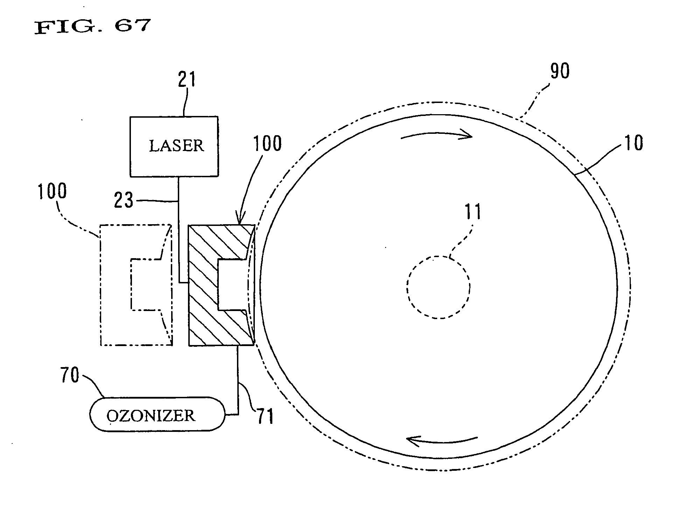

FIG. 67 is a plan view of the apparatus for processing the outer periphery of a substrate of FIG. 61.

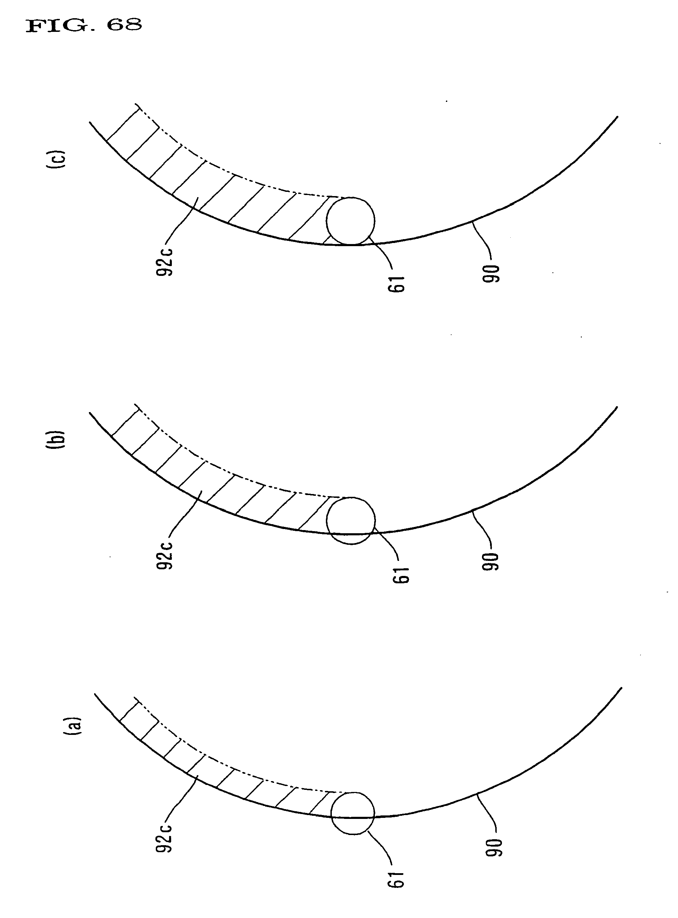

FIG. 68 is an explanatory plan view showing the setting examples of the arrangement relation between a short cylindrical part of the ladle nozzle and the wafer outer edge.

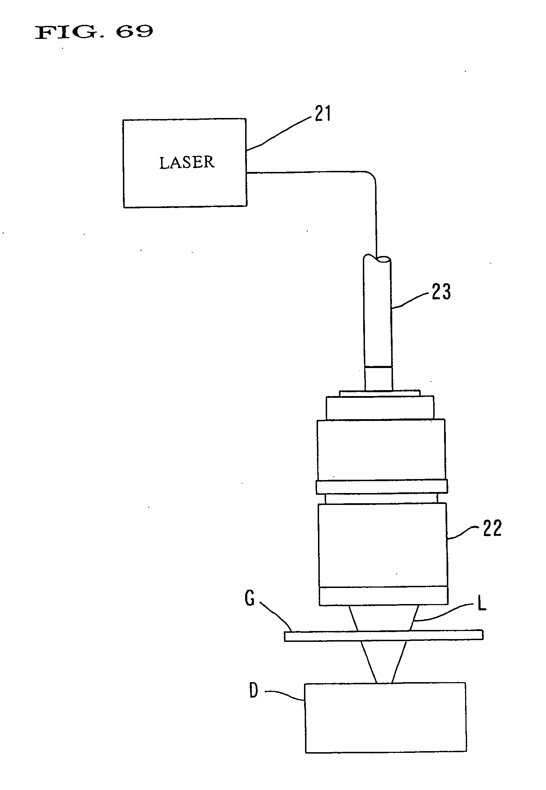

FIG. 69 is an explanatory front view of an experimental equipment used in the experiment for measuring the light transmission property of the ladle nozzle.

FIG. 70 is a perspective view showing an improvement of the ladle nozzle.

FIG. 71 is an explanatory sectional view showing, on an enlarged scale, a state of the outer periphery of a wafer from which the unnecessary film is removed by an apparatus for processing the outer periphery of a bas material in which the ladle nozzle of FIG. 70 is used.

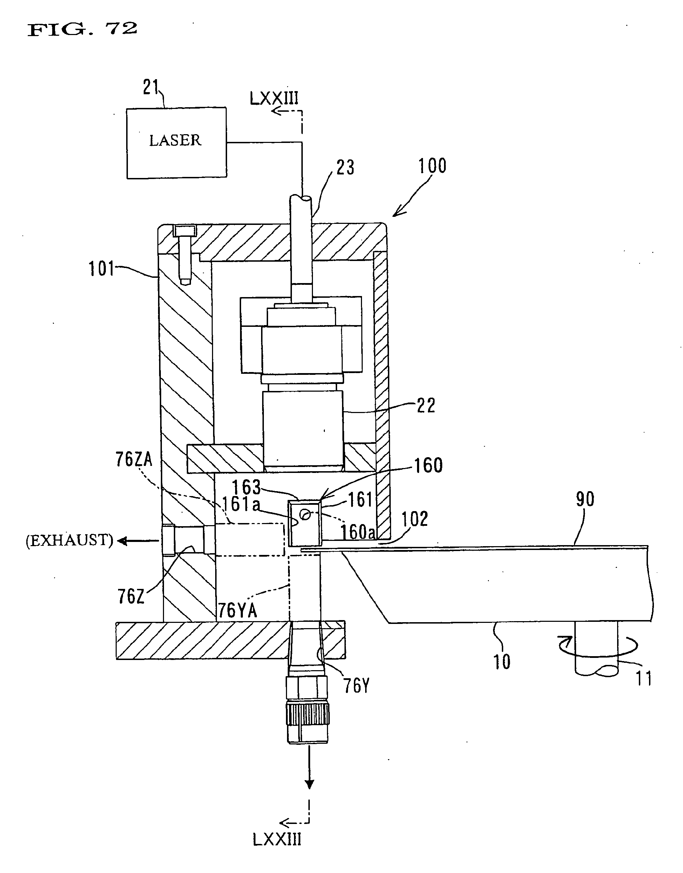

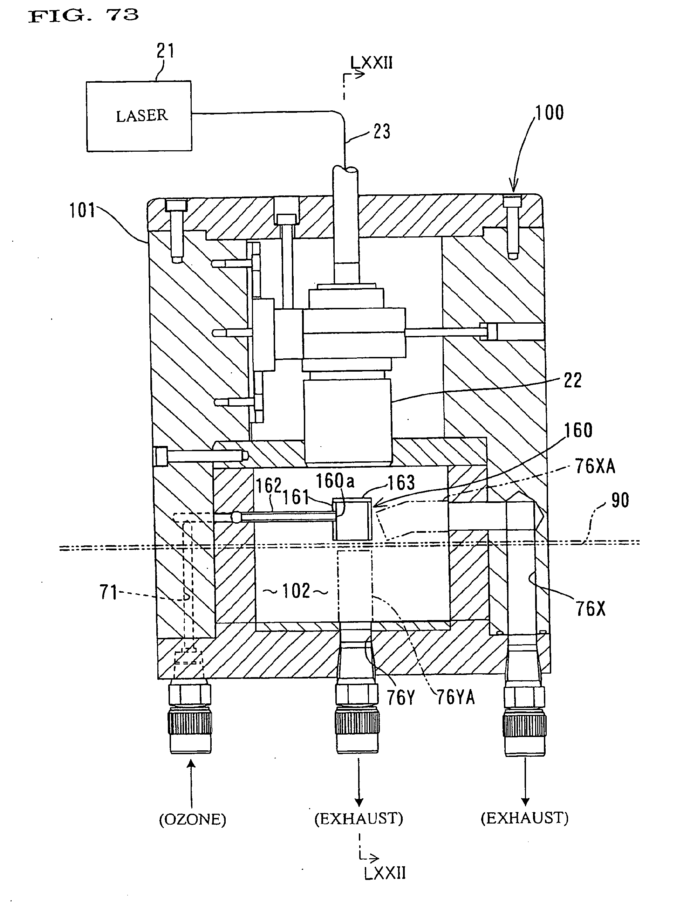

FIG. 72 is a vertical sectional view, taken on line LXXII-LXXII of FIG. 73, showing a modified embodiment of an exhaust system of an apparatus for processing the outer periphery of a substrate which is equipped with a ladle nozzle.

FIG. 73 is a vertical sectional view of the above-mentioned apparatus, taken on line LXXIII-LXXIII of FIG. 72.

FIG. 74 is a vertical sectional view, taken on line LXXIV-LXXIV of FIG. 75, showing an apparatus for processing the outer periphery of a substrate which is equipped with a long cylindrical nozzle instead of a ladle nozzle.

FIG. 75 is a vertical sectional view, taken on line LXXV-LXXV of FIG. 74, of a processing head of the above-mentioned apparatus.

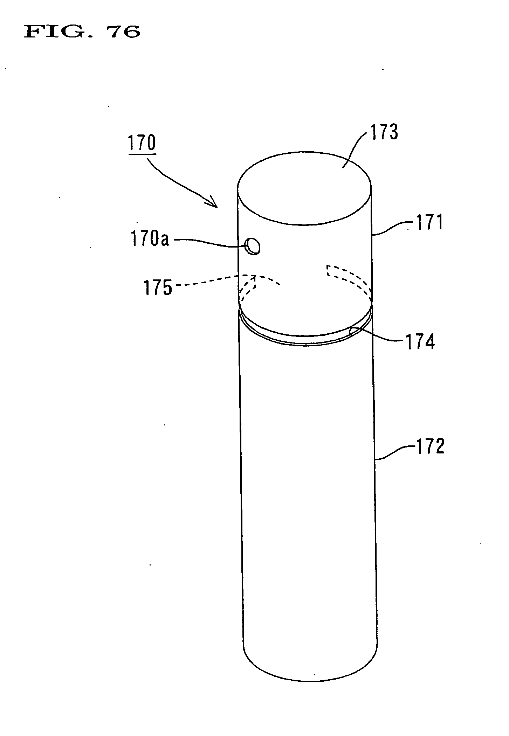

FIG. 76 is a perspective view of the above-mentioned long cylindrical nozzle.

FIG. 77 is an explanatory sectional view showing, on an enlarged scale, the apparatus outer periphery after the unnecessary film is removed therefrom by the apparatus of FIG. 74.

FIG. 78 is an enlarged sectional view of the outer peripheral part a wafer on which an organic film and an inorganic film are laminated, (a) shows a state before the organic film and the inorganic film are removed, (b) shows a state where the organic film is removed but the inorganic film is not yet removed, and (c) shows a state after the organic film and the inorganic film are removed.

FIG. 79 is a plan explanatory view showing a schematic construction of an apparatus for processing the outer periphery of a substrate which is suitable for the two film laminated wafer of FIG. 78.

FIG. 80 is a front explanatory view of an apparatus for processing the outer periphery of a substrate which is suitable for the two film laminated wafer.

FIG. 81 is a plan view of a second processing head (gas guide member) of an apparatus for processing the outer periphery of a substrate which is suitable for the two film laminated wafer.

FIG. 82 is a sectional view in which the second processing head is developed in the peripheral direction (longitudinal direction) along line LXXXII-LXXXII of FIG. 81..

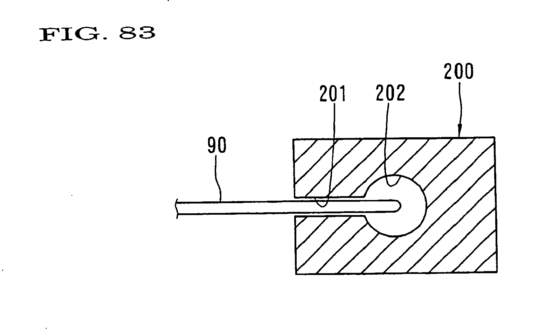

FIG. 83 is a sectional view of the second processing head (gas guide member) taken on line LXXXIII-LXXXIII of FIG. 81.

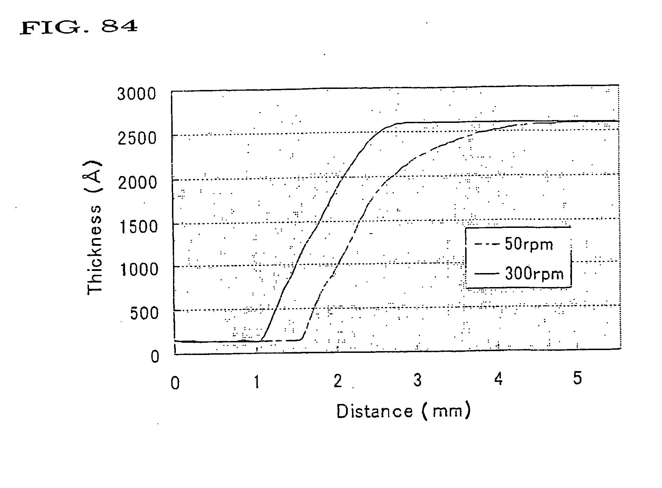

FIG. 84 is a graph showing the result of an experiment using the same second processing head as in FIG. 81 and showing the film thickness after the unnecessary film is removed vs. the radially inward distances from the outer end part of a wafer.

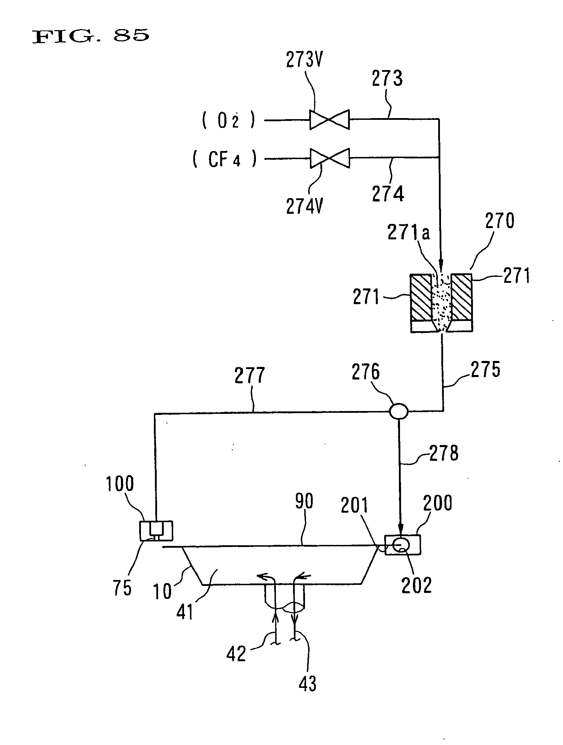

FIG. 85 is a schematic construction view showing an improvement of an apparatus for processing the outer periphery of a substrate which is suitable for the two film laminated wafer.

FIG. 86(a) is a front explanatory view showing a schematic construction of another improvement of an apparatus for processing the outer periphery of a substrate which is suitable for the above-mentioned two film laminated wafer and for which an organic film removing process is undergoing.

FIG. 86(b) is a front explanatory view showing the apparatus of FIG. 86(a) for which an inorganic film removing process is undergoing.

FIG. 87 is a vertical sectional view showing an improvement of a stage construction including a center pad.

FIG. 88 is a vertical sectional view showing, on an enlarged scale, a boundary area between a fixed cylinder and a rotary cylinder of the stage construction of FIG. 87.

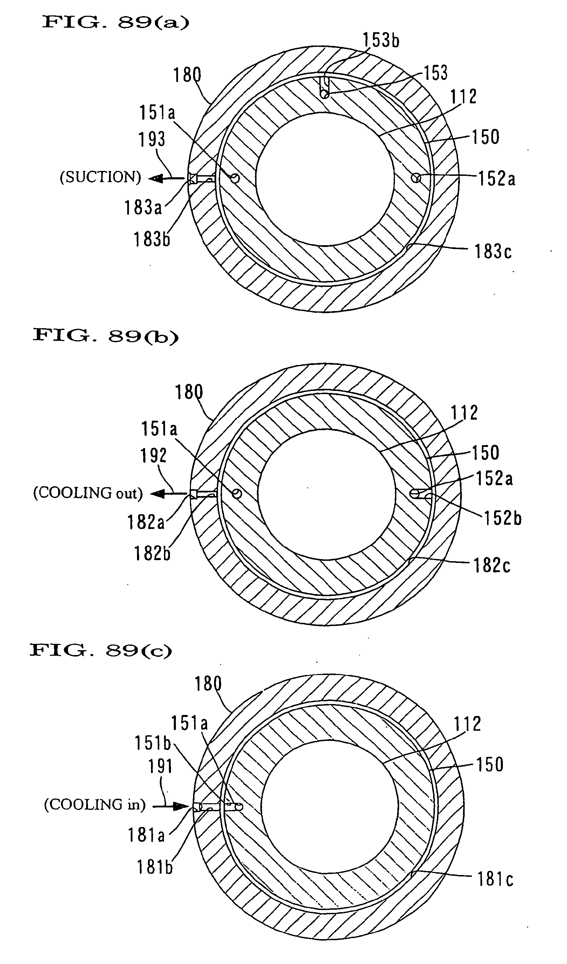

FIG. 89(a) is a horizontal sectional view of a shaft assembly of a stage taken on line LXXXIXA-LXXXIXA of FIG. 88.

FIG. 89(b) is a horizontal sectional view of a shaft assembly of a stage taken on line LXXXIXB-LXXXIXB of FIG. 88.

FIG. 89(b) is a horizontal sectional view of a shaft assembly of a stage taken on line LXXXIXC-LXXXIXC of FIG. 88.

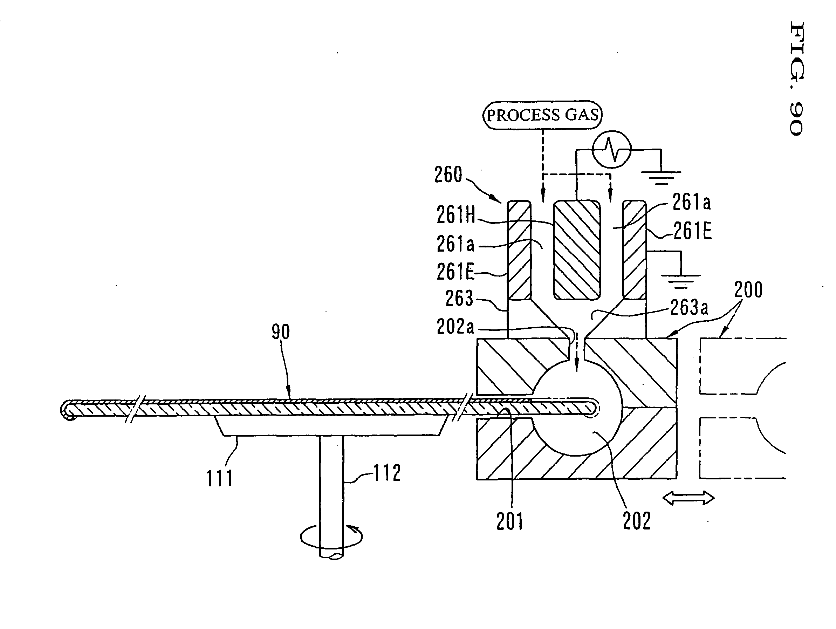

FIG. 90 is a front sectional view schematically showing an improvement of the second processing head.

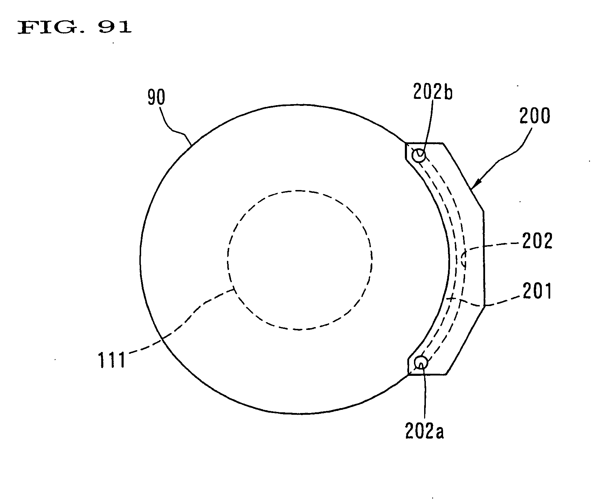

FIG. 91 is a plan view of the second processing head (gas guide member).

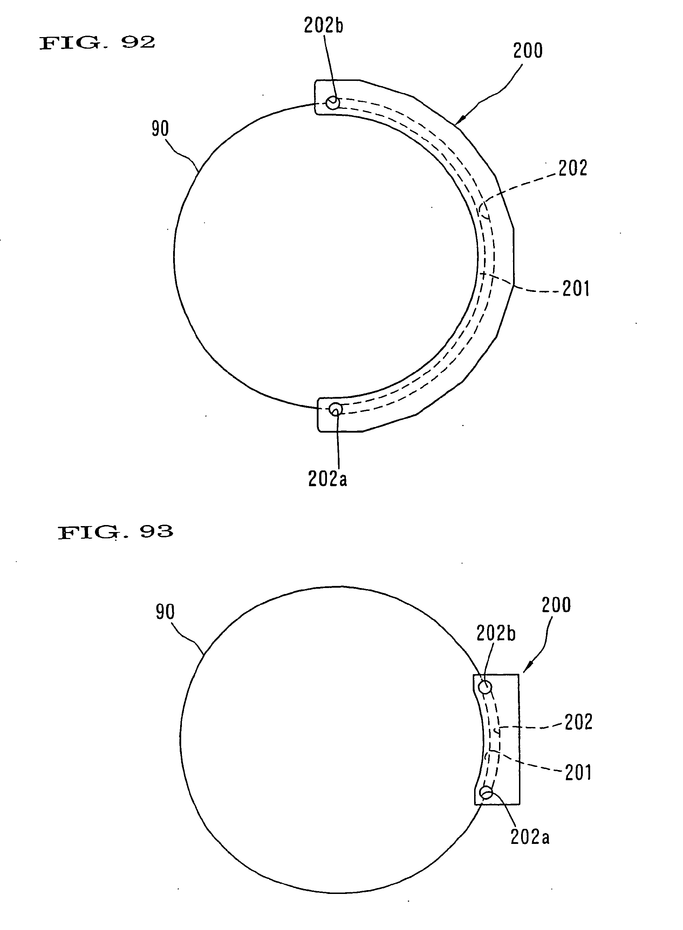

FIG. 92 is a plan view showing a gas guide member whose peripheral length is increased.

FIG. 93 is a plan view showing a gas guide member whose peripheral length is reduced.

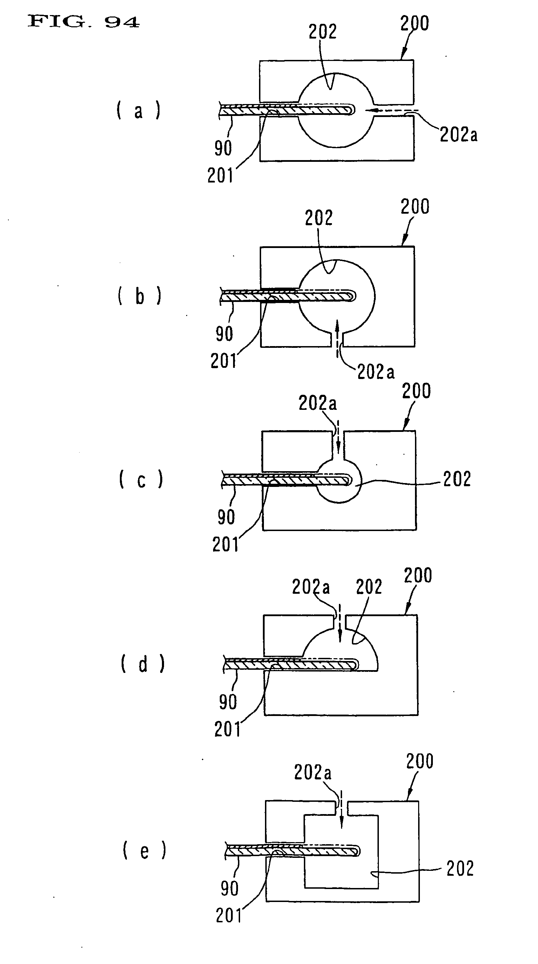

FIGS. 94(a) through 94(e) are sectional views showing several modified embodiments of the sectional configuration of the gas guide member.

FIG. 95 is a plan view showing an embodiment a gas guide member which can cope with a film which is required to be heated.

FIG. 96 is an enlarged sectional view taken on line XCVI-XCVI of FIG. 95.

FIG. 97 is a side sectional view showing a target part of an apparatus for processing the outer periphery of a substrate which can cope with an orientation flat or notch formed at the outer periphery of a wafer.

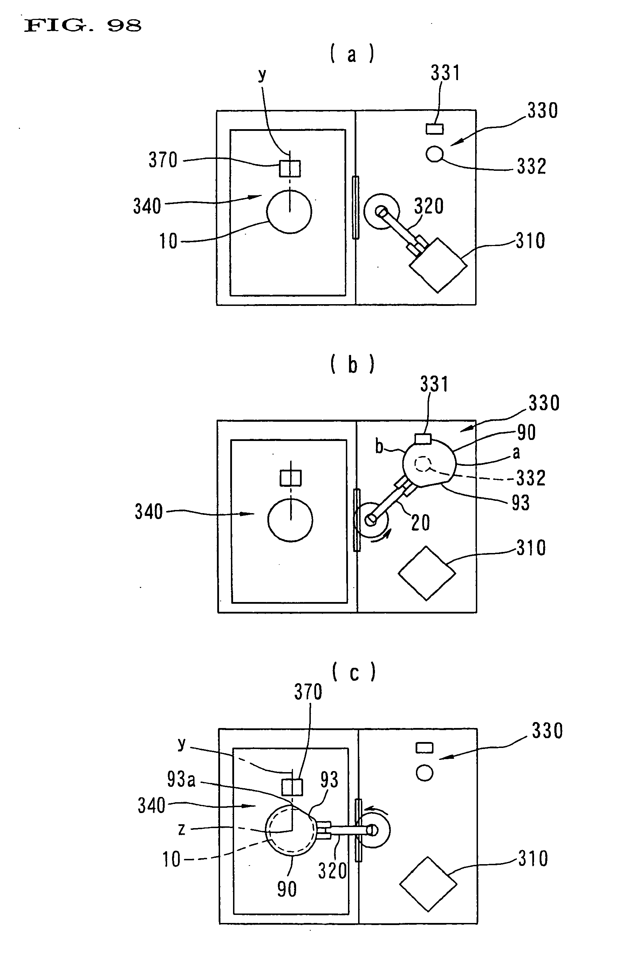

FIG. 98 is a plan view of FIG. 97, (a) shows a state where a wafer is picked up from a cassette, (b) shows another state where a wafer is aligned, and (c) shows still another state where a wafer is set to the part.

FIGS. 99(a) through 99(i) are plan views showing how the unnecessary film is removed from the outer peripheral part of a wafer at the target part of FIG. 97 with the passage of time.

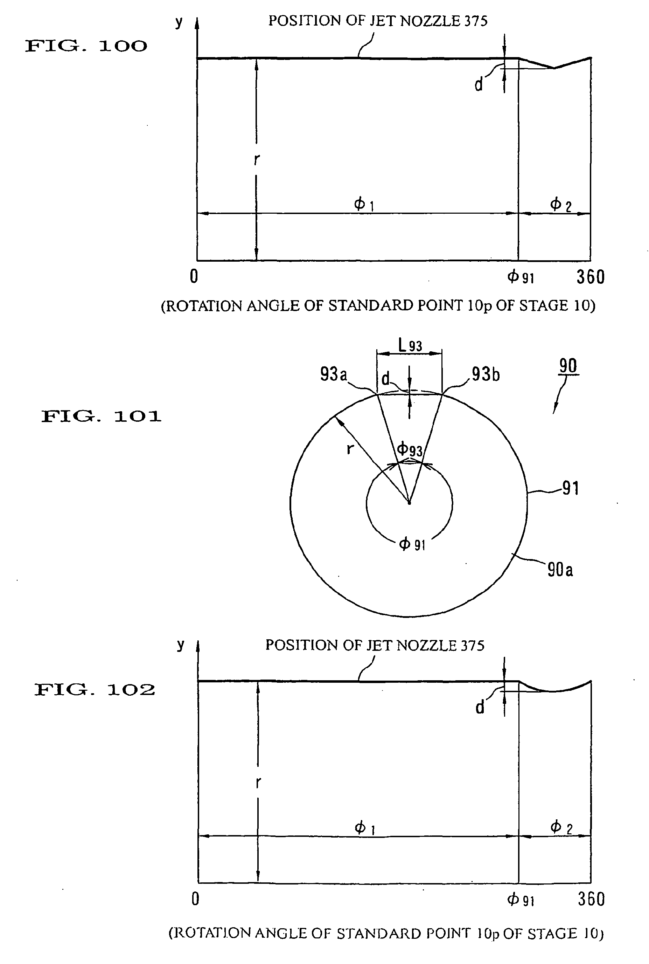

FIG. 100 is a view in which the setting information of the supply nozzle position stored in the control part of a nozzle position adjusting mechanism is shown in the form of a graph.

FIG. 101 is a plan view showing an orientation flat of a wafer in an exaggerated manner.

FIG. 102 is a view showing a modified example of the setting information of FIG. 100 in the form of a graph.

FIG. 103 is a side sectional view showing a target part of an apparatus capable of processing the outer periphery of a wafer without a need of alignment.

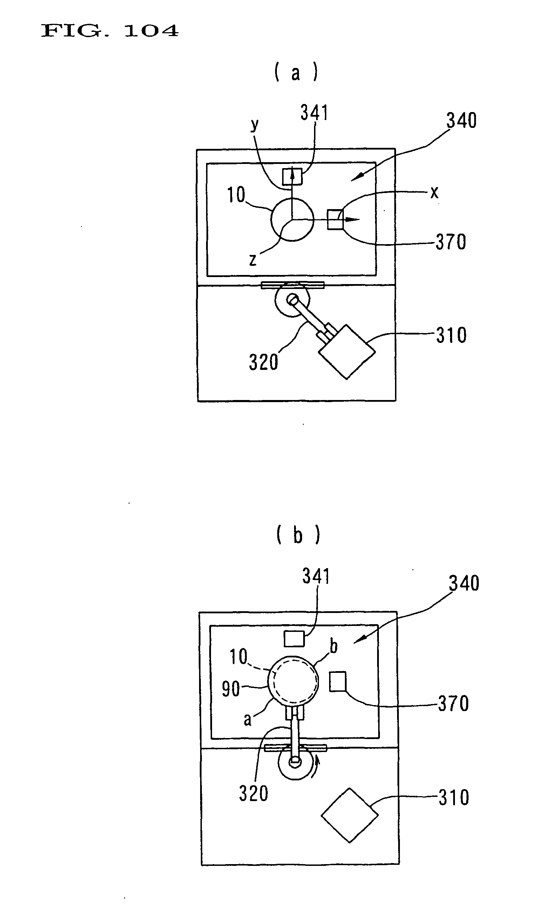

FIG. 104 is a plan view of FIG. 103, (a) shows a state where a wafer is picked up from a cassette, and (b) shows another state where a wafer is set to a target part.

FIGS. 105(a) through 105(e) are plan views sequentially showing the steps for removing the unnecessary film coated on the outer peripheral part of a wafer in the processing part of the apparatus of FIGS. 103 and 104 every quarter of a cycle,

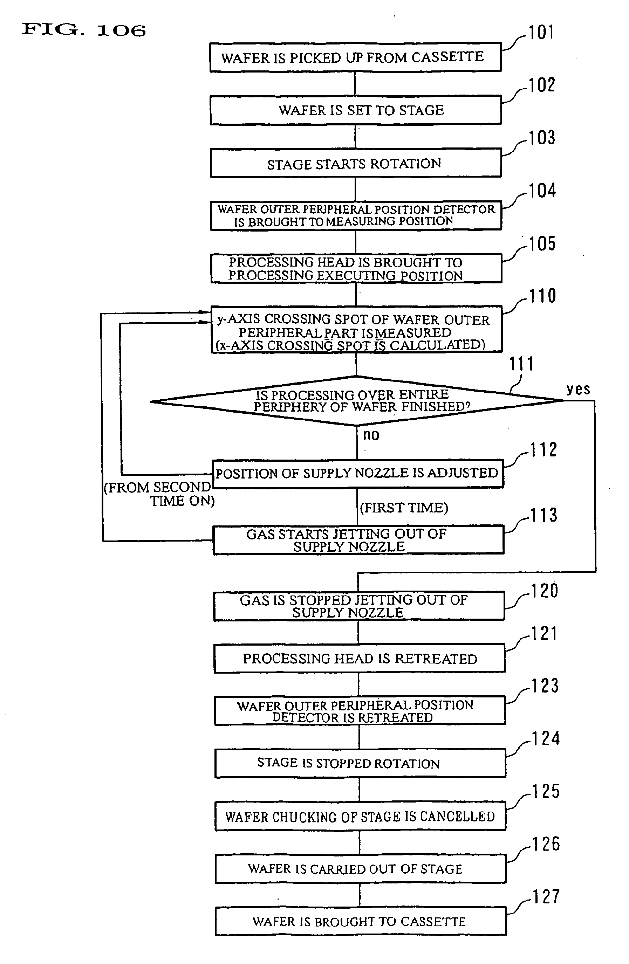

FIG. 106 is a flowchart showing the operation of the apparatus of FIGS. 103 and 104.

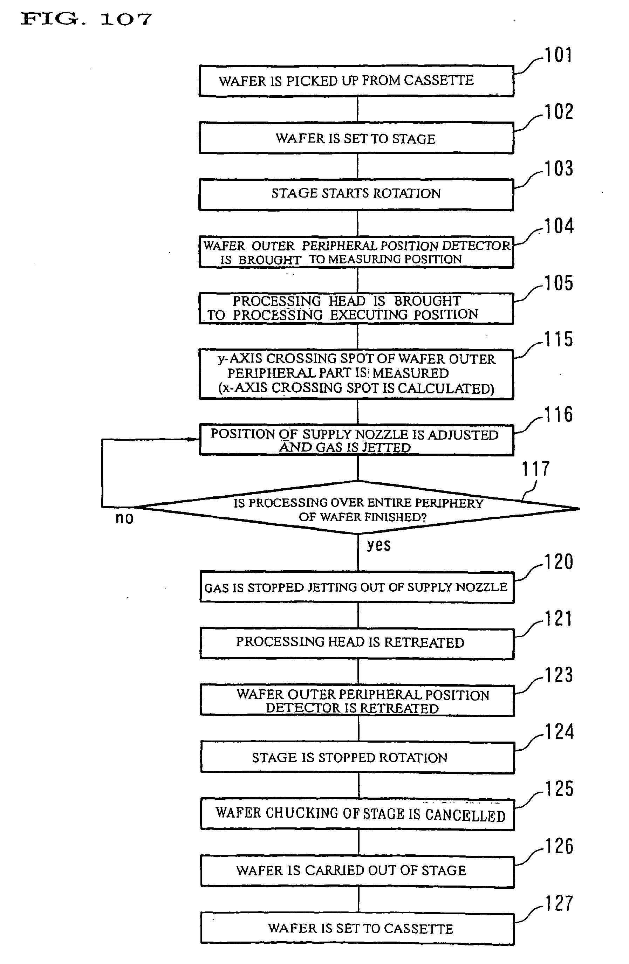

FIG. 107 is a flowchart showing a modified embodiment of the operation of the apparatus of FIGS. 103 and 104.

FIG. 108 is a graph showing the relation between an etching rate of an organic film by ozone and the temperatures.

DESCRIPTION OF REFERENCE NUMERALS

10.....stage
10a.....support surface
13.....suction holes
14.....suction path
15.....suction groove
16.....annular groove
17.....communication groove
20.....laser heater (radiating heater)
21.....laser light source
22.....irradiation unit (irradiator)
23.....optical fiber cable (optical transmission system)
30.....plasma nozzle head (reactive gas source)
36.....jet nozzle
36a.....jet port
41.....refrigerant chamber (heat absorbing means)
41C.....annular cooling chamber
41U, 41L.....refrigerant chambers (heat absorbing means)
46.....refrigerant path (heat absorbing means)
47.....annular path
46.....communication path
Pe..... Peltier element (heat absorbing means)
70.....ozonizer (reactive gas source)
75.....jet nozzle
76.....suction nozzle
90.....wafer (substrate)
90a..... outer peripheral part of the wafer
92.....organic film

93.....cutout part such as notch, orientation flat, etc.

94.....inorganic film

92c, 94c.....film (unnecessary matter) on the outer peripheral part of the wafer

100....first processing head

110.....stage main body

111....center head

120..... infrared heater (radiating heater)

121.....infrared lamp (light source)

122.....converging optical system (irradiator)

140.....rotation drive motor (rotation drive means)

150.....rotary cylinder

160.....ladle nozzle

162.....introduction part

161.....cylindrical part

161a.....lid part

180.....fixed cylinder

G1, G2.....gaskets

200.....second processing head (gas guide member)

201.....inserting opening

202.....guide path

204.....light transmission member

346.....nozzle position adjusting mechanism

350.....controller

375.....supply nozzle (jet nozzle)

P.....target position

C.....annular surface

[BEST MODE FOR CARRYING OUT THE INVENTION]

Embodiments of the present invention will be described in detail hereinafter with reference to the drawings. FIGS. 1 through 3 show a first embodiment of the present invention. First, a substrate as a target to be processed will be described. As indicated by an imaginary line of FIGS. 1 and 2, the substrate is, for example, a semiconductor wafer 90 and has a circular thin plate-like configuration. As shown in FIG. 3, a film 92 composed of, for example, a photoresist is coated on the upper surface or front surface of the wafer 90. The absorption wavelength of the photoresist is 1500 nm to 2000 nm. The film 92 covers not only the entire upper surface of the wafer 90 but also reaches the outer peripheral part of the reverse surface via the outer end face. There is provided an apparatus according to this embodiment for removing a film 92c, as an unnecessary matter, coated on the outer peripheral surface of the reverse surface of the wafer 90.

It should be noted that the present invention is not only limited to an apparatus of the type for removing the film on the outer peripheral part of the reverse surface of the substrate such as the wafer 90 but it can also be applied to other type of apparatus for removing the film on the outer peripheral part and the outer end face of the front surface.

As shown in FIGS. 1 and 2, the apparatus for processing an outer periphery of a substrate comprises a frame 50, a stage 10 as a supporter for supporting the wafer 90, a laser heater 20 as a radiating heater, and a plasma nozzle head 30 as a supplier for supplying a reactive gas.

The frame 50 includes a holed disc-like bottom plate 51, and a cylindrical peripheral wall 52 projecting upward from the outer periphery of this bottom plate 51. The frame 50 has a sectionally L-shaped annular configuration and is fixed to a support base not shown.

The stage 10 is disposed inside the frame 50 in such a manner as to be surrounded by the frame 50. The stage 10 has a circular configuration, in a plan view, which is concentric with but having a smaller diameter than a peripheral wall 52. The peripheral side surface of the stage 10 is tapered in such a manner as to be reduced in diameter downward. The stage 10 is connected with a rotation drive mechanism not shown and rotated about a center axis 11 by the rotation drive mechanism. It is also accepted that the stage 10 is fixed, the rotation drive mechanism is connected to the frame 50 and this frame 50 is rotated.

The wafer 90 to be processed is horizontally placed on the upper surface 10a (support surface, front surface) of the stage 10 with its center coincident with the center of stage 10.

Although not shown, a vacuum or electrostatic chuck mechanism is incorporated in the stage 10. By this suction check mechanism, the wafer 90 is sucked and fixed onto the support surface 10a of the stage 10.

The diameter of the upper surface of the stage 10 is slightly smaller than that of the wafer 90 which is circular.

Accordingly, with the wafer 90 placed on the stage 10, the entire periphery of the outer peripheral part of the wafer 90 is slightly radially outwardly protruded. That is, the outer peripheral part of the wafer 90 is positioned at an imaginary annular surface C which imaginarily surrounds the outer periphery of the upper surface of the stage 10. The amount of protrusion (width of the imaginary annular surface C) of the outer peripheral part of the wafer 90 is, for example, 3 to 5 mm. Owing to this arrangement, the reverse surface of the wafer 90 is exposed (opened) at the narrow part of the entire outer periphery. On the other hand, the part located inside the narrow part, i.e., the most part of the entire reverse surface of the wafer 90 is abutted with the upper surface of the stage 10 and covered up therewith.

The position where the outer periphery of the reverse surface of the wafer 90 is placed on the stage 10 is to be located is a target position P to be processed. This target position P is located on the imaginary annular surface C.

As a material for forming the stage 10, aluminum, for example, is used which is good in heat conductivity and which hardly causes the occurrence of metal contamination. It is also accepted that in order to obtain corrosion resistance to reactive gas, an alumina layer is formed on the outer surface by anodic oxidation and a fluoric resin such as PTTE is permeated therein.

A heat absorbing means for absorbing heat from the upper surface 10a is disposed on the stage 10 of the processing apparatus. Specifically, the interior of the stage 10 is hollow and this hollow interior is defined as a refrigerant chamber 41 (heat absorbing means). The refrigerant chamber 41 has a sufficient internal volume. The refrigerant chamber 41 is extended over the entire area (entire periphery in the peripheral direction and entirety in the radial direction) of the stage 10. The refrigerant chamber 41 is communicated with a refrigerant supply path 42 and a refrigerant discharge path 43. Those paths 42, 43 are extended from the stage 10 through the inside of a center shaft 11.

The upstream end of the refrigerant supply path 42 is connected to a refrigerant supply source not shown. The refrigerant supply source supplies, for example, water as refrigerant to the refrigerant chamber 41 through the refrigerant supply path 42. By this, the refrigerant chamber 41 is filled with water. The water temperature may be normal. The water as refrigerant is properly discharged through the refrigerant discharge path 43 and newly supplied through the refrigerant supply path 42. The discharged refrigerant may be returned to the refrigerant supply source so that it can be cooled again for recirculation.

As refrigerant, air, helium and the like may be used instead of water. It is also accepted that the refrigerant may be in the form of a compressed fluid and the compressed fluid is vigorously sent into the refrigerant chamber 41 so that it flows within the refrigerant chamber 41.

The heat absorbing means may be disposed at least at the outer peripheral part (immediate inner part of the projected part of the outer periphery of the wafer 90) of the stage 10 and not at the central part.

The stage 10 is located above the bottom plate 51 of the arm 50 and located at the generally middle height between the top and bottom of the peripheral wall 52. The stage 10 is larger in diameter than the inner periphery of the bottom plate 51. Owing to this arrangement, the inner end edge of the bottom plate 51 is entered radially inward of the lower side (reverse side) of the stage 10.

A labyrinth seal 60 is provided between the lower surface of the stage 10 and the inner peripheral edge of the bottom plate 51. The labyrinth seal 60 includes a pair of upper and lower labyrinth rings 61, 62. The upper labyrinth ring 61 includes a plurality of multi-annular hanging pieces 61 a concentric with the stage 10 and is fixed to the lower surface of the stage 10. The lower labyrinth ring 62 includes a plurality of multi-annular projecting pieces 62a concentric with the frame 50 and thus the stage 10, and is fixed to the upper surface of the bottom plate 51 of the frame 50. The hanging pieces 61a of the upper labyrinth ring 61 and the projecting pieces 62a of the lower labyrinth ring 62 are engaged with each other in a zigzag manner. The frame 50, the stage 10 and the labyrinth seal 60 defines an annular space 50a.

A suction path 51c extending from each valley part of the labyrinth ring 62 is formed in the bottom plate 51 of the frame 50. The suction path 51c is connected to a suction/exhaust apparatus (not shown) consisting of a vacuum pump, an exhaust processing system, etc. through piping. The suction path 51 c, the piping and the suction/exhaust processing system constitute "an annular space suction means".

An irradiation unit 22 (irradiator) of the laser heater 20 is attached to the radially outer part of the labyrinth ring 62 of the frame 50 in such a manner as to be downwardly away from the outer peripheral edge of the stage 10.

The laser heater 20 includes a laser light source 21 as a point light source and the irradiation unit 22 which is optically connected to the laser light source 21 through an optical transmission system 23 such as an optical fiber cable.

An LD (semiconductor) laser light source, for example, is employed as the laser light source 21. The laser light source 21 emits a laser beam (heat beam) of an emission wavelength of 808 nm to 940 nm. The emission wavelength may be set into a range corresponding to the absorption wavelength of the photoresist film 92 coated on the wafer 90.

The laser light source 21 is not limited to the LD, but it may be selected from many other types of light sources such as YAG, excimer and the like. The laser wavelength outputted by the laser light source 21 is preferably longer than that of visible light so as to be easily absorbed by the film 92. More preferably, the wavelength outputted by the laser light source 21 is in match with the absorption wavelength of the film 92.

It is also accepted that the light source 21 is received in the unit 22 and the optical transmission system 23 such as an optical fiber is eliminated.

The laser irradiation unit 22 is more greatly away from the target position P than the plasma nozzle head 30. As shown in FIG. 2, a plurality (three in FIG. 2) of the laser irradiation units 22 are equidistantly arranged in the peripheral direction of the frame 50 and thus, of the stage 10. As shown in FIG. 1, the laser irradiation unit 22 is arranged on a line L1 passing through the target position P and orthogonal to the extension surface. The laser irradiating direction of the laser irradiation unit 22 is directed just above along the line L2 and orthogonal to (intersected with) the outer peripheral part of the wafer 90 on the stage 10.

Various optical members such as a convex lens, a cylindrical lens and the like are accommodated in the laser irradiation unit 22. As shown in FIG. 3, the laser L emitted from the light source 21 is converged toward the target position P, i.e., the outer peripheral part of the reverse surface of the wafer 90 placed on the stage 10 by the laser irradiation unit 22. A focus adjusting mechanism is incorporated in the laser irradiation unit 22. By use of this focus adjusting mechanism, the laser beam can be correctly focused on the target position P and in addition, the focus of the laser beam can be deviated slightly up and down with respect to the target position P.

Owing to the above-mentioned arrangement, the light condensing diameter on the outer peripheral part of the wafer 90 and thus, the area of the part to be heated, as well as the density of radiant energy and thus, the heating temperature of the part to be heated can be adjusted. The focus adjusting mechanism includes a slide mechanism for sliding, for example, a focus lens arranged within the laser irradiation unit 22 in the direction of the optical axis. The focus adjusting mechanism may be of the type where the entire laser irradiation unit is slid in the direction of the optical axis.

The optical transmission system 23 and the irradiation unit 22 constitute an "optical system" for converging and irradiating the heat light source emitted from the light source 21 toward the target position after the heat light source is transmitted to the vicinity of the target position in such a manner as not to be dispersed.

As shown in FIG. 1, the plasma nozzle head 30 is attached to the peripheral wall 52 of the frame 50. The plasma nozzle head 30 is disposed radially outwardly of the target position P and arranged in a mutually different direction from the laser irradiation unit 22 with respect to the target position P. As shown in FIG. 2, the same number (three in FIG. 2) of the plasma nozzle heads 30 as the laser irradiation units 22 are arranged at equal spaces in the peripheral direction of the stage 10. Moreover, each plasma nozzle head 30 is arranged in the same peripheral direction as the corresponding laser irradiation unit 22 or at a position slightly downstream side of the corresponding laser irradiation unit 22 in the rotating direction of the wafer 90 in such a manner as to form one pair with the corresponding laser irradiation unit 22.

The plasma nozzle head 30 has a stepped circular column-like configuration which is stepwise tapered. The plasma nozzle head 30 is arranged in such a manner as to direct its axis horizontally along the radial direction of the stage 10. As shown in FIG. 1, the plasma nozzle head 30 receives therein a pair of electrodes 31, 32. Those electrodes 31, 32 have a double tubular structure and an annular normal pressure space 30a is formed between the electrodes 31, 32. A solid dielectric is coated on the opposing surface of at least one of the electrodes 31, 32.

The inner electrode 31 is connected with a power source (electric field incurring means), not shown, and the outer electrode 32 is grounded to the earth. The power source outputs, for example, a pulse-like voltage to the electrode 31. It is desirable that the rising time and/or falling time of this pulse is 10 microseconds or less, the electric field intensity in the interelectrode space is 10 to 1000 k/cm, and the frequency is 0.5 kHz. Instead of the pulse voltage, a continuous wave-like voltage or the like such as sine wave or the like may be outputted.

The basal end part (upstream end) facing the opposite side of the stage 10 side of the interelectrode space 30a is connected with a process gas supply source not shown. The process gas supply source reserves therein, for example, oxygen or the like as process gas and supplies it in a proper amount to the interelectrode space 30a each time.

As best shown in FIG. 3, the plasma nozzle head 30 is provided at the distal end part facing the stage 10 side with a disc-like resin-made jet port forming member 33. A jet port 30b is formed in the central part of this jet port forming member 33. The jet port 30b is connected to the downstream end facing the stage 10 side of the interelectrode space 30a. The jet port 30b is located on or slightly lower than the extension surface of the upper surface 10a of the stage 10 such that the axis of the jet port 30b is directed horizontally along the radial direction of the stage 10 and open to the distal end of the plasma nozzle head 30. The distal end of the plasma nozzle head 30 and thus, the jet port 30b are arranged in the vicinity of the target position P, so that when the wafer 90 is placed on the stage 10, the distal end of the plasma nozzle head 30, etc. are extremely proximate to the outer end edge of the wafer 90. A reactive gas G into which the process gas has been changed by plasmatizing is jetted out along the axis of the jet port 30b. This jetting direction is orthogonal (with angles) to the irradiating direction of the laser beam L of the laser heater 20. The crossing part between the jetting direction and the irradiating direction is located generally on the reverse surface of the outer peripheral part of the wafer 90 placed on the stage 90.

A suction port 30c is formed in the distal end face of the plasma nozzle head 30 between the distal end face forming member 34 and the jet port forming member 33. The suction port 30c has an annular configuration which is disposed proximate to the jet port 30b in such a manner as to surround the jet port 30b. As shown in FIG. 1, the suction port 30c is connected to the suction/exhaust apparatus, not shown, through a suction path 30d which is formed in the plasma nozzle head 30. The suction port 30c, the suction path 30d and the suction/exhaust apparatus constitute a "jet port vicinity suction means" or an "annular space suction means".

The plasma nozzle head 30, the power source, the process gas supply source, the suction/exhaust apparatus, etc. constitute a normal pressure plasma processing apparatus.

The method for removing the film 92c coated on the outer peripheral part of the reverse surface of the wafer 90 using the apparatus for removing the outer periphery of a wafer thus construction will now be described.

The wafer 90 to be processed is concentrically placed on the upper surface of the stage 10 by a transfer robot or the like and suction chucked. The outer peripheral part of the wafer 90 is projected radially outwardly of the stage 10 over the entire periphery. A laser beam L is emitted from the laser irradiation unit 22 of the laser heater 20 in such a manner as to generally focusing on the reverse surface, or the target position P, of the reverse surface of the projected outer peripheral part of the wafer 90. By doing so, the film 92c coated on the outer peripheral part of the reverse surface of the wafer 90 can be radiantly heated in a spotting state (locally). Since the laser beam L is a point condensing light, the laser energy can be applied to the part to be heated with a high density (in case the wavelength of the laser is in correspondence to the absorption wavelength of the film 92c, the absorbing efficiency can be more enhanced). By this, the spot-like part to be heated of the film 92c can instantaneously be heated upto several hundreds degree (for example, 600 degrees C).

Since this is a radiant heating, the part to be heated of the wafer 90 is no required to be contacted with the heating source and no particles are generated, either.

In parallel with the forgoing, a process gas (oxygen or the like) is supplied to the interelectrode space 30a of the plasma nozzle head 50 from the process gas supply source. Moreover, a pulse voltage is supplied to the electrode 31 from the pulse source and a pulse voltage is incurred to the interelectrode space 30a. By doing so, a normal pressure glow discharge plasma is formed in the interelectrode space 30a, and a reactive gas such as ozone and oxide radical is formed from the process gas such as oxygen. This reactive gas is jetted out through the jet port 30b and sprayed onto the locally heated part just at the reverse surface of the wafer 90 so that a reaction is taken place. This makes it possible to remove the film 92c coated on this part by etching. Since this part is locally sufficiently heated to high temperature, the etching rate can satisfactorily be enhanced.

Moreover, the gas staying around the part where the etching processing is carried out can be sucked into the suction port 30c by the suction means and exhausted through the suction path 30d. As a result, the etching rate can be enhanced by rapidly removing the processed reactive gas and the by-products caused by etching from the peripheral area of the part where the etching processing is carried out. Moreover, gas can be prevented from flowing to the front surface of the wafer 90.

Moreover, by the suction means, the processed reactive gas, etc. can be introduced in the direction of the labyrinth seal 60 from the peripheral area of the outer peripheral part of the wafer 90 and sucked and exhausted through a gap formed by the labyrinth seal 60. The reactive gas can also reliably be prevented from flowing radially inwardly from the labyrinth seal 60.

In parallel with the above-mentioned operation, the stage 10 is rotated by the rotation driving mechanism. By doing so, the removing range of the film 92c coated on the outer peripheral part of the reverse surface of the wafer 90 can be developed in the peripheral direction and thus, the film 92c coated on the outer peripheral part of the reverse surface can be removed from the entire periphery.

By using the labyrinth seal 60 between the stage 10 and a frame 50, the stage 10 can smoothly be rotated without any friction with the frame 50.

With the progress of the heating operation, the heat of the part to be heated of the wafer 90 is sometimes conducted to a part which is located radially inwardly of the wafer 90. This heat is transferred to the stage 10 through the contact surface between the wafer 90 and the stage 10 and absorbed by water filled in the refrigerant chamber 41. This makes it possible to restrain the increase of temperature of the part which is located inside of the part to be heated of the wafer 90. Accordingly, the film 92 coated on the inner part of the wafer 90 can be restrained from being changed in quality which would otherwise be caused by heat. In addition, even in case the reactive gas flows to the center side of the upper surface of the wafer 90, its reaction with the film 92 can be restrained. This makes it possible to prevent damage from prevailing on the film 92 and the film 92 can reliably be maintained in good quality.

Since the quantity of water and thus, the heat capacity reserved in the refrigerant chamber 41 is sufficiently large, the heat absorbing capability can satisfactorily be obtained. By replacing the water in the refrigerant chamber 41 through the supply path 41 and the discharge path 42, the heat absorbing capability can more sufficiently be maintained. This makes it possible to reliably restrain the temperature from increasing at the part located inside the outer peripheral part of the wafer 90 and the film 92 can reliably be prevented from being damaged.

The inventors have measured the surface temperatures of the wafer vs. distances in the radially inward direction from the vicinity of the part to be heated of the outer end edge of the wafer using the same apparatus as in FIG. 1 under the conditions that the outer end edge of the wafer was projected by 3 mm from the stage 10 and the water temperatures in the refrigerant chamber 41 were 50 degrees C, 23. 5 degrees C and 5. 2 degrees C. The output conditions of the laser heater 20 were as follows.

laser emitted light wavelength: 808 nm
output: 30 W
diameter of the locally heated part: 0.6 mm
output density: 100 w / mm$^2$
oscillating form: continuous wave

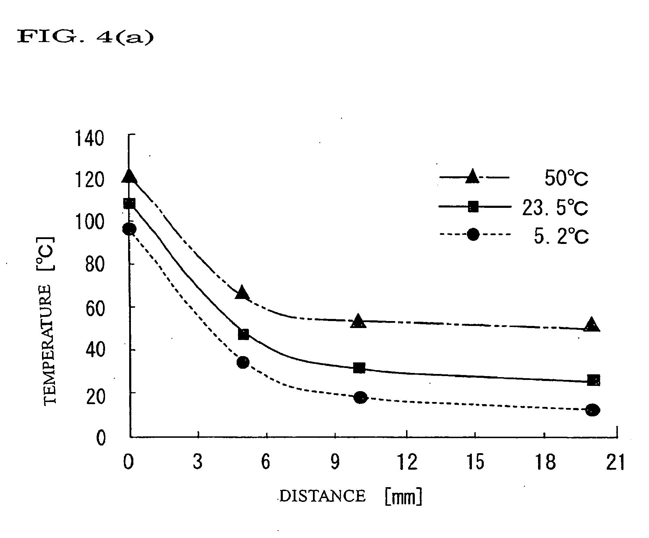

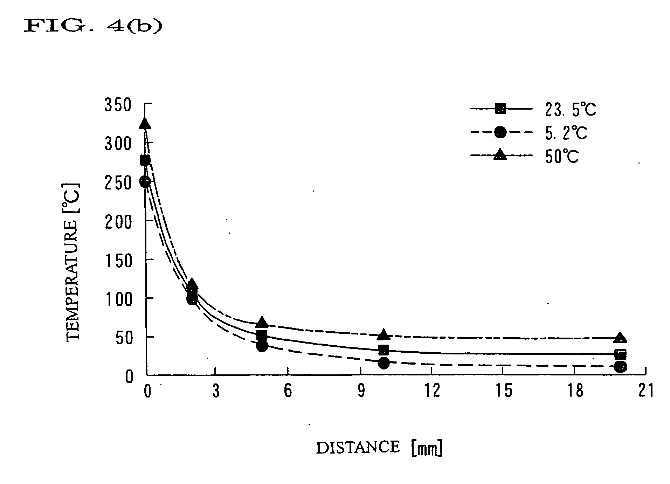

The results are shown in FIG. 4. FIG. 4(a) is a graph serving the peripheral portion (position slightly away from the very near portion) of the part to be heated of the outer end edge of the wafer as the origin of the horizontal axis, and FIG. 4 (b) is a graph serving the very near portion of the part to be heated of the outer end edge of the wafer as the origin of the horizontal axis. In case the water temperature is 23.5 degrees C that is a normal temperature, In the portion near the part to be heated of the outer end edge of the wafer, the temperature was raised to about 110 degrees C (FIG. 4 (a)) by the heat conducted from the part to be heated, and in the very near portion of the part to be heated, the temperature was raised to about 300 degrees C (in the portion to be heated, the temperature was raised to 600 or more degrees C (FIG. 4 (b)). However, in a central portion away radially inwardly from there by only 3 mm, the temperature was maintained at 50 or less degrees C. Owing to the foregoing feature, it was confirmed that even in case ozone as the reactive gas is flown to the central portion of the front surface of the wafer, reaction hardly occurs and the film 92 can be restrained from being damaged.

Also, the inventors have measured, through a thermography and using the same apparatus as in FIG. 1, the surface temperatures of the wafer vs. distances in the radially inward direction from the vicinity of the portion to be heated of the outer end edge of the wafer under the conditions that the outer end edge of the wafer was projected by 3 mm from the stage 10, and the laser outputs were 80 W and 100 W. All the other conditions were as follows.

diameter of wafer: 300 mm
diameter of locally heated part: 1 mm
rotation speed of stage: 3 rpm
water temperature in refrigerant chamber of stage: 23.5 degrees C

As a result, as shown in FIG. 5, the surface temperature at the very near portion of the portion to be heated of the outer end edge of the wafer was around 300 degrees C (about 700 to 800 degrees C at the portion to be heated), but the wafer temperature was abruptly lowered radially inwardly from there and even lowered than 100 degrees C at the portion only 3 mm away radially inwardly from there. Owing to this feature, it was confirmed that the film coated on the central part of the wafer was restrained from being damaged.

Next, other embodiments of the present invention will be described. In the embodiments to be described hereinafter, the components corresponding to those in the above-mentioned embodiment are denoted by identical reference numerals, where appropriate, in the drawings and description thereof are omitted, where appropriate.

In the stage 10 shown in FIG. 6, the refrigerant chamber is partitioned into an upper (support surface side) first chamber part 41U and a lower (opposite side to the support surface) second chamber part 41L by a horizontal partition plate 45. The diameter of the partition plate 45 is smaller than the inside diameter of the peripheral wall of the stage 10 and thus, the upper and lower first and second chamber parts 41 U, 41L are connected to each other at a space outside the partition plate 45. One end part of a tube, which constitutes a refrigerant supply path 42, is connected to the central part of the partition plate 45, and the refrigerant supply path 42 is connected to the upper first chamber part 41 U. Similarly, one end part of a tube, which constitutes a refrigerant discharge path 43, is connected to the central part of a bottom plate of the stage 10, and the refrigerant discharge path 43 is connected to the lower second chamber part 41L.

The first and second chamber parts 41 U, 41L constitute a refrigerant path as a heat absorbing means.

A refrigerant is introduced into the central part of the upper (support surface side) first chamber part 41U through the refrigerant supply path 42 and flowed in such a manner as to radially spread radially outwardly. The refrigerant is then moved around the outer end edge of the partition plate 45, entered into the lower (opposite side to the support surface) second chamber part 41 L where it is flowed radially inwardly, and then, discharged through the central refrigerant discharge path 43.

Owing to the above-mentioned arrangement, the entire stage 10 can reliably be cooled and thus, the wafer 90 can evenly reliably be cooled. Thus, the film 92 coated on the upper surface can reliably be protected. Since the refrigerant is introduced first into the first chamber part 41U on the side near the support surface 10a and thus, the wafer 90, the heat absorbing efficiency can be more enhanced.

In the embodiment of FIG. 6, the refrigerant supply path 42 and the refrigerant discharge path 43 are arranged in parallel. As shown in FIG. 7, it is also accepted that the refrigerant supply path 42 is passed through the refrigerant discharge path 43 so as to form a double tubular structure.

In the embodiment of FIG. 8, a refrigerant path 46 is provided as a heat absorbing means within the stage 10. The refrigerant path 46 is of a spiral construction. The refrigerant supply path 42 is connected to an end part of the outer peripheral side of the spiral refrigerant path 46, and the refrigerant discharge path 43 is connected to the end part on the central side. Owing to this arrangement, a refrigerant is spirally flown to the inner peripheral side of the refrigerant path 46 from the outer peripheral side. Thus, the side near the outer peripheral part of the wafer 90 can fully be cooled. As a result, the heat conducted from the outer peripheral part can reliably be absorbed and the film 92 coated on the upper surface can reliably be protected.

Although not shown in detail, not only the refrigerant discharge path 43 on the central side but also the refrigerant supply path 42 on the outer peripheral side are passed through the center axis 11 of the stage 10. The refrigerant supply path 42 is, for example, extended radially outwardly from the center axis 11 side between the bottom plate of the stage 10 and the refrigerant path 46 and connected to the end part on the outer peripheral side of the refrigerant path 46.

In case the stage 10 is fixed and the frame 50 is rotated, the refrigerant supply path 42 is not required to be passed through the center axis 11.

The arrangement in which a refrigerant is flown toward the center of the stage 10 from the outer peripheral side is not limited to the spiral construction of FIG. 8. For example, the refrigerant path within the stage 10 shown in FIG. 9 includes a plurality of concentric annular paths 47 and communication paths 48 for intercommunicating those annular paths 47. The plurality of communication paths 48 are disposed at equal intervals in the peripheral direction between the adjacent annular paths 47. The communication path 48 on the radially outer side and the communication path 48 on the radially inner side with a single annular path 47 disposed therebetween are arranged in such a manner as to be mutually displaced in the peripheral direction. The refrigerant supply path 42 is branched and connected to the outermost annular path 47 at a plurality of positions equally spaced away from each other in the peripheral direction. A basal end part of the refrigerant discharge path 43 is connected to the central annular path 47.

Owing to the above-mentioned arrangement, as indicated by arrows of FIG. 9, after branched and flown in the peripheral direction along the outer annular path 47, the refrigerant is converged in the communication path 48 and flown into the next inner side annular path 47 where the refrigerant is branched and flown again in the peripheral direction. While repeating this process, the refrigerant is flown toward the center from the outer peripheral side of the stage 10.

The stage 10 shown in FIGS. 10(a) and 10(b) has a hollow interior which is defined as a refrigerant 41 as in the case of FIG. 1, as well as elsewhere. The refrigerant supply path 42 is branched and connected to positions which are equally spacedly away from each other in the peripheral direction of the outer peripheral part of the refrigerant chamber 41. A refrigerant discharge path is extended from the central part of the refrigerant chamber 41. Owing to this arrangement, the refrigerant is introduced to the outer peripheral part of the refrigerant chamber 41 and flowed toward the center. The refrigerant chamber 41 constitutes a concentric refrigerant path.

In FIGS. 6 through 10, the refrigerant supply path 42 and the refrigerant discharge path 43 may be revered in arrangement. By doing so, the flow of the refrigerant in the upper refrigerant chamber 41 U is directed to the center from the outer peripheral side.

In the embodiment shown in FIG. 11, a heat absorbing element is used as a heat absorbing means instead of a refrigerant system. That is, the stage 10 is incorporated therein with a peltier element as a heat absorbing means. The peltier element Pe is arranged near the upper surface 10a of the stage 10 such that its heat absorbing side is directed upward (upper surface 10a side of the stage 10). Owing to this arrangement, the heat of the wafer 90 can be absorbed through the upper plate of the stage 10. The stage 10 may be provided under the peltier element Pe with a fan, a fin or the like in order to enhance heat dispersion from the heat dispersing side of the peltier element Pe.

The heat absorbing means of the embodiments so far described, is provided over the generally entire region of the stage 10 and heat is absorbed from the entire supporting surface of the substrate. It is also accepted, however, that as shown in FIGS. 12 and 13, the heat absorbing means is disposed only at the outer peripheral part of the stage 10. An annular partition wall 12 is concentrically disposed within the stage 10. The stage 10 is divided into an outer peripheral region 10Ra and a central region 10Rb by this annular partition wall 12.

The refrigerant supply path 42 and the refrigerant discharge path 43 are connected to the outer peripheral region 10Ra which is located outside the annular partition wall 12. Owing to this arrangement, the interior of the outer peripheral region 10Ra serves as a refrigerant chamber 41 (heat absorbing means).

On the other hand, the inner peripheral region 10Rb which is located inside the annular partition wall 12, does not serve as a refrigerant chamber but it serves as a non-arrangement part of the heat absorbing means.

The outer peripheral part of the wafer 90 is projected radially outwardly of the outer peripheral region 1 0Ra of the stage 10. An annular part located just inside the projected part is abutted with and supported by the outer peripheral region 1 0Ra of the stage 10, and a central part located inside the annular part is abutted with and supported by the central region 10Rb of the stage 10.

Owing to the above-mentioned arrangement, the heat coming from the part to be heated of the outer peripheral part of the wafer 90 is conducted to a part located just inside the part to be heated and absorbed by the outer peripheral region 10Ra of the stage 10 there. On the other hand, the rest part which has nothing to do with the heat conduction of the center of the wafer 90 is not cooled by being heat absorbed. This makes it possible to save the heat absorbing source.

The embodiments shown in FIGS. 6 through 11 may be applied as a heat absorbing means which is disposed only at the outer peripheral region 10Ra of the stage 10.

As indicated by a solid line in FIG. 13, an irradiation unit 22 of a laser heater is disposed above the wafer 90. Owing to this arrangement, the front surface of the outer peripheral part of the wafer 90 is locally heated and a reactive gas is supplied thereto from a supply nozzle 30N of the reactive gas supplying means. By doing so, the unnecessary film coated on the front surface of the outer peripheral part of the wafer 90 can be removed. As indicated by an imaginary line in FIG. 13, in case an unnecessary film coated on the reverse surface of the outer peripheral part of the wafer 90, the laser irradiation unit 22 is preferably arranged under the wafer 90.

As already described in the first embodiment, the laser irradiation unit 22 is provided with a focus adjusting mechanism. The following processing operation can be carried out using this focus adjusting mechanism.

As shown in FIG. 14, in general, a cutout part 93 such as, for example, a notch is disposed a one place in the peripheral direction of the outer peripheral part of the wafer 90. As shown in FIG. 14(a), when a processing operation is carried out by setting constant the size (irradiation range) of the irradiation spot Ls on the wafer 90 of the laser irradiation unit 22, there is possibility that the edge of the notch 93 is not processed (hatched part of FIG. 14(a) indicates a processed part). Thus, as shown in FIG. 14(b), when the notch 93 is brought to the target position, the focus of the laser irradiation unit 22 is deviated in the direction of the optical axis by the focus adjusting mechanism. Owing to this arrangement, the irradiation spot Ls can be made large and the laser can hit even the edge of the notch 93. As a result, as shown in FIG. 14(c), the film coated on the edge of the notch 93 can also be removed reliably. Since the density of energy is lowered when the irradiation spot Ls is made large, adjustment is preferably made by increasing the output of the laser and decreasing the rotation speed of the wafer, so that energy per unit area will be same as that before the irradiation spot Ls is made large.

After the irradiation spot Ls passes through the notch 93, the size of the irradiation spot Ls is returned to its original size.

FIG. 14 shows an example in which the notch 93 is provided as a cutout part of the outer periphery of the wafer 90. However, even in case an orientation flat is provided instead of the notch 93, the film coated on the edge of the orientation flat can be removed by carrying out the same operation (including the energy adjusting operation per unit area) as mentioned above.

As shown in FIGS. 15 and 16, the processing width adjustment can also be carried out using the focus adjusting mechanism of the laser irradiation unit 22.

As shown in FIG. 15, the laser L coming from the laser irradiation unit 22 is generally focused on the outer periphery of the wafer 90 by the focus adjusting mechanism, and in case the spot diameter in the irradiation range on the wafer 90 is, for example, about 1 mm, the film 92c coated on the outer peripheral part of the wafer 90 can be removed in a width of about 1 mm.

On the other hand, in case a larger processing width than the above-mentioned processing width is to be obtained using the same laser irradiation unit 22, as shown in FIG. 16, the focus of the laser L is deviated farther than the wafer 90 by the focus adjusting mechanism 22F. By doing so, the irradiation spot diameter on the wafer 90 can be increased and the processing width can be increased. For example, in case a processing width of about 3 mm is to be obtained, the focus is adjusted such that the irradiation spot diameter on the wafer 90 becomes about 3 mm. In FIG. 16, adjustment is made such that the focus of the laser L is deviated farther than the wafer 90. It is also accepted that the laser L forms focus on a position nearer than the wafer 90 and then, the laser L is spread toward the wafer 90.

As shown in FIG. 17, the processing width can also be adjusted by sliding the laser irradiation unit 22 in the radial direction besides the focus adjustment of the laser irradiation unit 22. This laser irradiation unit 22 can be finely slid in the radial direction of the stage 10 and thus in the radial direction of the wafer 90 by the radial slide mechanism 22S. In the laser irradiation unit 22, as in FIG. 13, the laser is generally focused on the outer periphery of the wafer 90 and the irradiation spot radius on the wafer 90 is set to be, for example, about 1 mm.

To obtain a processing width of, for example, about 3 mm, while maintaining the above-mentioned irradiation spot radius, first, as indicated by the solid line of FIG. 17, the laser irradiation unit 22 is positioned in the radial direction of the wafer 90 so that the irradiation spot will come to the position about 3 mm away from the outer edge of the wafer 90. The processing is carried out by rotating the wafer 90 while maintaining the afore-mentioned radial direction.

When the wafer 90 makes one full rotation, as indicated by the broken line of FIG. 17, the irradiation unit 22 is displaced radially outwardly by a size (about 1 mm) which is generally equal to the irradiation spot radius by the slide mechanism 22S. The processing is carried out while making another one full rotation of the wafer 90 in that position.

Then, after one full rotation of the wafer 90, as indicated by the two-dot chain line of FIG. 17, the irradiation unit 22 is further displaced radially outwardly by a size (about 1 mm) which is generally equal to the irradiation spot radius by the slide mechanism 22S. The processing is carried out while making another one full rotation of the wafer 90 in that position. By dosing so, the processing width can be made 3 mm.

FIGS. 18(a) and 18(b) show a stage 10 incorporated therein with a vacuum chuck mechanism as a substrate fixing means. A large number of suction holes 13 are formed in the upper plate of the stage 10 made of favorable heat conductive metal in a dispersed state. These suction holes 13 are connected to a suction means such as a vacuum pump, not shown, through a suction path 14. The suction holes 13 are as small as possible in diameter. Owing to this arrangement, a sufficient contact area between the stage 10 and the wafer 90 can be obtained. Thus, sufficient heat absorbing efficiency of the wafer 90 can be obtained.

FIGS. 19(a) and 19(b) show a modified embodiment of the vacuum chuck mechanism. A suction groove 15 is formed in the upper surface of the stage 10 instead of the spot-like suction holes. The suction groove 15 includes a plurality of concentric annular grooves 16 and communication grooves 17 for intercommunicating those annular grooves 16. The communication grooves 17 are arranged at equal spaces in the peripheral direction between every adjacent annular grooves 16. The relatively radially outward communication groove 17 and the relatively radially inward communication groove 17 with a single annular groove 16 disposed therebetween are mutually deviated in the peripheral direction. The annular grooves 16 and the communication grooves 17 are as small as possible in width. Owing to this arrangement, the contact area between the stage 10 and the wafer 90 and thus, the heat absorbing efficiency of the wafer 90 can fully be obtained.

FIGS. 20 and 21 show a modified embodiment of the suction groove 15. A communication groove 17 of this suction groove 15 is extended straight in the radial direction of the stage 10 upto the outermost annular groove 16 from the innermost annular groove 16 in such a manner as to cross the annular groove 16 which is located in the midway position. The communication grooves 17 are arranged at an interval of 90 degrees in the peripheral direction of the stage 10.

As shown in FIG. 21, an annular cooling chamber 41C is formed within the stage 10 as a heat absorbing means. The annular cooling chamber 41 C is arranged at a part near the outer periphery of the stage 10 such that the chamber 41 C is concentric with the stage 10. Though not shown, a refrigerant supply path 42 is connected to one place in the peripheral direction of the annular cooling chamber 41 C, and a refrigerant discharge part 43 is connected to the opposite side by 180 degrees.

In FIGS. 18 through 21, the chuck mechanism is provided over the generally entire area of the upper surface of the stage 10. In the embodiment shown in FIGS. 22 and 23, the chuck mechanism is provided only at the outer peripheral region of the upper surface of the stage 10.

An annular projection 10b is formed on the upper surface on the outer peripheral side of the stage 10. In correspondence to this, a shallow recess 10c having a circular configuration in a plan view is formed in the central part of the stage 10.

A plurality (for example, three) of annular grooves 16 are concentrically formed in a flat upper surface of the annular projection 10b of the stage 10.

An annular cooling chamber 41C is defined within the stage 10 as in the case with FIG. 19 mentioned above.

According to this stage 10, only the upper surface of the annular projection 10b on the outer peripheral side contacts the reverse surface of the wafer 90 and absorbs the wafer 90. Since the central part of the stage 10 is provided with the recess 10c, the central part does not contact the wafer 90. Owing to this arrangement, the contact area between the stage 10 and the wafer 90 can be reduced to the necessary minimum and particles caused by contact can be reduced.

The annular projection 10b can be cooled by the annular cooling chamber 41 C. On the other hand, the contact part of the wafer 90 with the annular projection 10b is a portion located just inside the part to be irradiated of the projected part of the outer periphery of the wafer 90. Accordingly, when the heat generated by laser irradiation tends to be transferred to the inner side from the part to be irradiated of the projected part of the outer periphery of the wafer 90, the heat is immediately absorbed through the annular projection 10b and never prevailed on the central part of the wafer 90. This makes it possible to obtain the sufficient function as a heat absorbing means of the stage 10.

The inventors have checked the relation between contact area, between the wafer and the stage, and generation of particles. A wafer having a diameter of 300 mm was used. After the wafer was sucked to a stage (contact area of 678.2 cm$^2$) having the same construction as in FIGS. 20 and 21, the number of particles having a diameter of 0.2 microns or more was counted. The counted number was about 22000 pieces. On the other hand, after the wafer was sucked to a stage (contact area of 392.7 cm$^2$) having the same construction as in FIGS. 22 and 23, the number of particles having a diameter of 0.2 microns or more was counted. The counted number was about 5400 pieces. It became clear from this that the number of generated particles can greatly be reduced by diminishing the contact area.

In the apparatus for processing the outer periphery of a substrate shown in FIG. 24, the plasma nozzle head 30 is fixed to the bottom plate 51 of the frame 50 such that the plasma nozzle head 30 is located away from the target part and in parallel with the laser irradiation unit 22 of the laser heater 20. The distal end face of the plasma nozzle head 30 is directed vertically upward. A reactive gas path 52b extending from a distal end opening 30b' of the plasma nozzle head 30 is formed in the peripheral wall 52 of the frame 50. The distal end of the reactive gas path 52b reaches the inner peripheral surface of the peripheral wall 52 and connected with a small circular cylindrical jet nozzle 35 there. This jet nozzle 36 constitutes a jet port forming member and the interior of the jet port forming member constitutes a jet port 36a. The jet nozzle 36 is composed of a transparent light transmissive material such as, for example, a tetrafluoroethylene-perfluoroalkyl vinyl ether copolymer (PFA).

The jet nozzle 36 is extended slantwise upward in such a manner as to project from the inner periphery of the peripheral wall 52, and its distal end part is extremely proximate to the reverse side of the projected outer peripheral part of the wafer 90 placed on the target position P, i.e., the reverse side of the projected outer peripheral part of the wafer 90 placed on the stage 10. Owing to this arrangement, the blowing direction from the blow nozzle 36 is intersected at acute angles with the irradiating direction of the laser heater 20 directing vertically upward on the reverse surface of the protected outer peripheral part (the radiating heater and the jet port are arranged in mutually different direction (acute direction) with respect to the target position P on the reverse side of the extension surface of the support surface 10a). The frame 50 including a reactive gas path 52b and the jet nozzle 36 are component elements of a "reactive gas supplying means" together with the plasma nozzle head 30.

According to the above-mentioned construction, since the jet nozzle 36 is arranged in a position very near the target position of the wafer 90, the reactive gas such as ozone jetted out through the jet nozzle 36 can reliably be arrived at the target position while the gas is still in its active condition and still in high density without being dispersed. Thus, the reaction efficiency with the film 92c can be enhanced and the etching rate can be increased. Moreover, since the blowing direction of the reactive gas is angled instead of parallel with the reverse surface of the wafer 90, the reaction efficiency with the film 92c can further be enhanced and the etching rate can further be increased.

On the other hand, the blow nozzle 36 is, in fact, arranged such that it is advanced in an optical path of the laser L coming from the laser heater 20. However, since the jet nozzle 36 has a light transmitting property, the laser L is never blocked. Thus, the target position can reliably be heated and a high etching rate can be obtained.

It is also accepted that the jet nozzle 36 is arranged in such a manner as to be deviated from the optical path of the laser L. In that case, it is not necessary to form the jet nozzle 36 from a light transmissive material. Instead, the jet nozzle 36 may be formed of, for example, stainless steel. Taking into consideration of the fact that temperature is likely to increase due to laser reflection and the concentration of ozone is lowered due to thermal reaction, however, the jet nozzle 36 is preferably be formed from teflon (registered trademark) or the like, which has a small radiant heat absorbing property and a high ozone-resisting property.

In FIG. 24, a step is formed on the upper surface of the peripheral wall 52 of a base plate. An annular upper peripheral wall 53 having an inverted L-shape in section is overlain this step. The inner end edge of the upper peripheral wall 53 is arranged in the vicinity of the jet nozzle 36 and thus, in the vicinity of the outer end edge of the wafer 90 placed on the stage 10. An annular groove 53c (suction port) extending in the entire periphery in the peripheral direction of the upper peripheral wall 53 is formed in the inner end edge of the upper peripheral wall 53 such that the annular groove 53c is open in such a manner as to be spread toward the inner end edge. A suction path 53d is extended to the outer periphery of the upper peripheral wall 53 and connected to a suction connector 57 from the groove bottom located in the same peripheral position as the jet nozzle 36 in this annular groove 53c. Moreover, the suction path 53d is connected to a suction/exhaust apparatus not shown. Owing to this arrangement, the processed reactive gas can be sucked and exhausted from the periphery of the outer peripheral part of the wafer 90.

The groove 53c, the suction path 53d and the suction/exhaust apparatus constitute a "blow port vicinity suction means" or a "annular space suction means".

In the apparatus for processing the outer periphery of a substrate shown in FIG. 25, the plasma nozzle head is different in construction from the previously-described one. That is, the plasma nozzle head 30X of FIG. 25 has an annular configuration of a size corresponding to the stage 10 or the frame 50 and concentrically arranged on the upper side of the sage 10 and the frame 50. The plasma nozzle head 30X can be lifted up and down between a retreated position (this state is not shown) largely spaced away to the upper part of the stage 10 and the frame 50 and a setting position (this state is shown in FIG. 25) where the plasma nozzle head 30X is placed on the peripheral wall 52 of the frame 50 by a lift mechanism not shown. When the plasma nozzle head 30X is lifted up to the retreated position, the wafer 90 is placed on the stage 10. Thereafter, the plasma nozzle head 30X is lifted down to the set position where the processing is carried out.

Electrodes 31X, 32X having a double tubular structure over the entire periphery are received within the plasma nozzle head 30X. The inner electrode 31X is connected with a pulse source not shown and the outer electrode 32X is grounded to the earth. An annular narrow space 30ax is formed over the entire periphery of the plasma nozzle head 30X by the confronting surfaces of the electrodes 31X, 32X. A process gas such as oxygen coming from a process gas supply source not shown is evenly introduced into the interelectrode space 30ax over the entire periphery of the upper end part (upstream end) and plasmatized by a normal pressure glow discharge within the interelectrode space 30ax so that a reactive gas such as ozone is generated. As in the case with the above-mentioned plasma nozzle head 30, a solid dielectric layer is coated on at least one of the confronting surfaces of the electrodes 31X, 32X.

A reactive gas path 30bx' is formed on the bottom part of the plasma nozzle head 30X. This reactive gas path 30bx' is slantwise extended from the lower end part (downstream end) of the interelectrode space 30ax. On the other hand, a vertically extending reactive gas path 52b is also formed in the peripheral wall 52 of the frame 50 such that when the plasma nozzle head 30X is set in the set position, the reactive gas paths 30xb', 52b are connected to the plasma nozzle head 30X.

A basal end part of the jet nozzle 36 composed of a light transmissive material is connected to the lower end part (downstream end) of the reactive gas path 52b of the frame 50. The jet nozzle 36 is embedded in the peripheral wall 52 in its horizontal posture along the radial direction of the frame 50, and a distal end part is allowed project from the inner end face of the peripheral wall 52. Owing to this arrangement, the jet nozzle 36 is located in a position very near the reverse side of the outer peripheral part of the wafer 90 which is installed in the target position P or on the stage 10. The same number of jet nozzles 36 as the number of the laser irradiation units 22 are spacedly arranged in the peripheral direction and located, in a one-to-one relation, in the same peripheral position as the laser irradiation units 22 of the laser heater 20. Owing to this arrangement, the process gas provided reactivity in the inter electrode space 30ax is passed through the reactive paths 30bx', 32b and jetted out through the jet nozzle 36. The reactive gas thus jetted out hits the film 92c which is locally heated by the laser heater 20 and removes the film by etching. Even in case the optical path of the lease L and the jet nozzle 36 are interfered with each other, the laser L is not blocked because the jet nozzle 36 has a light transmitting property as in the case with the embodiment of FIG. 24.

A cover ring 37 is disposed at a radially inward part of the bottom part of the plasma nozzle head 30X. When the plasma nozzle head 30X is located in the set position, a suction port 30cx is formed between the tapered outer end face of the cover ring 37 and the upper part of the inner peripheral surface of the peripheral wall 52 of the frame 50. The suction part 30cx is positioned just above the outer end edge of the wafer 90 placed on the stage 10. The suction port 30cx is connected to a suction/exhaust apparatus not shown through a suction path 30dx connected to the innermost end of the suction/exhaust apparatus. Owing to this arrangement, the processed gas can be sucked from the periphery of the outer peripheral part of the wafer 90 and exhausted.

The suction port 30cx, the suction path 30dx and the suction/exhaust apparatus constitute a "jet port vicinity suction means" or an "annular space suction means".

The cover ring 37 constitutes a suction port forming member.

An apparatus for processing the outer periphery of a substrate shown in FIG. 26 comprises a combination of the entirety of the apparatus for processing the outer periphery of a substrate of FIG. 24 and the annular plasma nozzle head 30X. Accordingly, in the apparatus of FIG. 26, two kinds of plasma nozzle heads 30, 30X are disposed at the lower side and at the upper side, respectively. The lower plasma nozzle head 30 is employed for removing the film 92c coated on the outer peripheral part of the reverse surface of the wafer 90 as in the case with the afore-mentioned embodiment. In contrast, the upper plasma nozzle head 30X is employed for removing the film 92 (see FIG. 3) coated on the outer end face of the front surface of the wafer 90. For this purpose, a jet port 30bx is formed in the bottom part of the plasma nozzle head 30X of the apparatus for processing the outer periphery of a substrate of FIG. 26. This jet port 30bx is extended straightly downward from the interelectrode space 30ax and open to the bottom surface as different from the apparatus for processing the outer periphery of a substrate of FIG. 25. The jet port 30bx has an annular configuration extending over the entire periphery in the peripheral direction of the plasma nozzle head 30X. When the plasma nozzle head 30X is set to the set position, the jet port 30bx is located just above the outer peripheral port of the substrate placed on the stage 10. The reactive gas coming from the interelectrode space 30ax is jetted out straightly downward through the jet port 30bx and sprayed onto the outer peripheral part of the front surface of the wafer 90. A part of the reactive gas is flowed around to the outer end face of the wafer 90. This makes it possible to remove the film 92 coated on the outer peripheral part and the outer end face of the front surface of the wafer 90 by etching, too. Since the jet port 30bx has an annular configuration extending over the entire periphery of the outer periphery of the wafer 90, the reactive gas can be sprayed onto the entire periphery of the outer periphery of the wafer 90 at a time and the efficient etching can be carried out. It is also accepted that the components of the process gas for the upper and lower plasma nozzle heads 30X, 30 can be different in accordance with the kind of the films coated on the front and reverse surfaces of the wafer 90.

The jet port 30bx is arranged at the center in the width direction of the suction port 30cx. This suction port 30cx is divided into an inner peripheral side and an outer peripheral side with the jet port 30bx disposed therebetween. Suction paths 30dx are extended from the inner peripheral side suction port portion and the outer peripheral side suction port portion, respectively and connected to a suction/exhaust apparatus not shown.

In the apparatus for processing the outer periphery of a substrate shown in FIG. 27, the plasma nozzle head 30 and the laser irradiation unit 22 are different in arranging relation from the apparatus shown in FIG. 1. That is, in the apparatus of FIG. 27, the plasma nozzle head 30 is fixed to the bottom plate 51 of the frame 50 with the distal end face and thus, the jet port 30b directed just above. The jet port 30b is arranged proximate to the lower side of the outer peripheral edge of the wafer 90 placed on the stage 10 and jets out the reactive gas in the direction orthogonal to the outer peripheral part of the reverse surface of the wafer 90 (on the line passing through the target position P and orthogonal to the extension surface of the support surface 10a).

As shown in FIG. 28 on an enlarged scale, a plate-like total reflection member 25 is disposed at a part on the stage 10 side of the jet port 30b of the distal end face of the plasma nozzle head 30. The surface on the opposite side to the stage 10 side of the total reflection member 25 is slanted upwardly toward the stage 10 side. This inclination surface serves as the total reflection surface 25a for totally reflecting the light such as laser.

On the other hand, the laser unit 22 is fixed to the peripheral wall 52 of the frame 50 such that the laser irradiation unit 22 is away radially outwardly of the plasma nozzle head 30 and the axis of the unit 22 is laid horizontally such that the laser irradiating direction is directed radially inwardly. The laser L irradiated from the laser irradiation unit 22 hits the reflection surface 25a where the laser L is reflected upwardly to hit the outer peripheral part of the reverse surface of the wafer 90. Owing to this arrangement, the outer peripheral part of the reverse surface of the wafer 90 can be locally heated.

The member 34, etc. of the upper end part of the plasma nozzle head 30 may be composed of a light transmissive material so that the laser L is allowed to transmit therethrough.

In case the laser coming from the laser irradiation unit 22 is not linear but conical converging toward the reflection surface 25a, it is also accepted that the plasma nozzle head 30 is lowered to be away from the wafer 90, and the total reflection mirror 25 is increased in thickness by a portion equal to the lowered distance so that the laser does not interfere the plasma nozzle head 30.

As shown in FIG. 27, the frame 50 is provided at an upper end part of the peripheral wall 52 with a ring-like cover member 89 along the entire periphery of the inner periphery. The cover member 80 includes a horizontal part 81 having a horizontal disc-like configuration and extending radially inwardly from the peripheral wall 52, and a cylindrical hanging part 82 hanging down from the entire periphery of the inner end edge of this horizontal part 81. The cover member 80 has an L-shaped configuration in section. The cover member 80 can be lifted up and down between a retreated position (this state is not shown) largely spaced away to the upper part of the peripheral wall 52 and a setting position (this state is shown in FIG. 27) where the outer peripheral surface of the horizontal part 81 is abutted with the inner peripheral surface of the peripheral wall 52 by a lift mechanism not shown. When the wafer 90 is placed on and removed from the stage 10, the cover member 80 is brought to the retreated position and when the wafer 90 is being processed, the cover member 80 is brought to the set position.

In the set position, the inner end edge of the horizontal part 81 and the hanging part 82 of the cover member 80 are located above the target position P or the outer peripheral part of the wafer 90 and the cover member 80 covers the upper part of the annular space 50a by co-acting with the outer peripheral part of the wafer 90. Between the cover member 80 and the peripheral wall 52, a space 50b integrally connected with the annular space 50a is formed. A lower end part of the handing part 82 is located slightly higher than the wafer 90 so that a gap 82a (FIG. 28) formed between the hanging part 82 and the wafer 90 is much reduced. Owing to this arrangement, after hitting the outer peripheral part of the wafer 90, the processed reactive gas can be reliably confined within the spaces 50a, 50b and prevented from flowing to the central part side of the upper surface of the wafer 90. Thus, the film coated on this upper surface can be prevented from being damaged. The space 50b formed between the cover member 80 and the peripheral wall 52 is connected to a suction/exhaust apparatus not shown through a suction connector 55, etc. of the cover member 80. Owing to this arrangement, the processed gas within the spaces 50a, 50b can be sucked and exhausted.

The suction connector 55 and the suction/exhaust apparatus constitute an "annular space suction means".

In the apparatus for processing the outer periphery of a substrate, an ozonizer 70 is used as a reactive gas supply source of the reactive gas supplying means instead of the normal pressure glow discharge type plasma nozzle heads 30, 30X in the afore-mentioned embodiment. The system for generating ozone employed in the ozonizer may be of any type such as silent discharge, a surface discharge, and the like. The ozonizer 70 is installed in such a manner as to be spaced apart from the frame 50. An ozone supply tube 71 is extended from this ozonizer 70. This ozone supply tube 71 is connected to the reactive gas path 52b of the peripheral wall 52 of the frame 50 through a supply connector 72 disposed at the bottom plate 51 which is located in a position radially outward of the laser irradiation unit 22 of the frame 50. The same number (for example, five) of supply connectors 72 as the number of the laser irradiation units 22 are equally spacedly arranged in the peripheral direction and located, in a one-to-one relation, in the same peripheral position as the laser irradiation units 22. The ozone supply tube 71 is branched and connected to the respective supply connectors 72. A reactive gas path 52b is extended from each supply connector 72.

The reactive gas path 52b reaches the inner peripheral surface of the peripheral wall 52, the light transmissive jet nozzle 36 is slantwise projected therefrom, and the distal end part of the jet nozzle 36 is located in a position very near the reverse side of the projected outer peripheral part of the wafer 90 placed on the stage 10 as in the case with the apparatus of FIG. 24.

The ozonizer 70, the ozone supply tube 71, the supply connector 72, the frame 50 including the reactive gas path 52b, and the jet nozzle 36 serve as the component elements of the "reaction gas supplying means".

The ozone as a reactive gas generated by the ozonizer 70 are sequentially passed through the ozone supply tube 71, the supply connector 72 and the reactive gas path 52b and jetted out through the jet nozzle 36. Since the jet nozzle 36 is arranged in a position very near the outer peripheral part of the reverse surface of the wafer 90, the ozone can reliably be hit to the outer peripheral part of the reverse surface of the wafer 90 so as to efficiently remove the film 92c before the ozone is dispersed and deactivated, and in case the jet nozzle 36 is interfered with the optical path of the laser L emitted from the laser heater 20, the laser L can be transmitted through the jet nozzle 36 and the target part of the wafer 90 can reliably be heated as in the case with the apparatus of FIG. 6. Similarly, the processed gas is passed either through a discharge route such as a suction means, i.e., the suction path and the suction connector 57 located in the vicinity of the jet nozzle 36, or another discharge route such as the space 50a and the gap of the labyrinth seal 60 and sucked and discharged by a suction/discharge apparatus not shown, as in the case with the examples of FIGS. 1 through 24.

A cover member 80 is disposed above the upper peripheral wall 53. This cover member 80 can be lifted up and down between an upward retreated position (indicated by an imaginary line in FIG. 29) and a set position (indicated by a solid line in FIG. 29) by a lift mechanism not shown, as in the case with the apparatus of FIG. 27. The cover member 80 located in the set position is abutted with the upper surface of the upper peripheral wall 53 and extended radially inwardly. A hanging part 82 of the inner end part of the cover member 80 is located above the outer peripheral edge of the stage 10. Owing to this arrangement, the cover member 80 alone covers the annular space 50a. This makes it possible to prevent the processed ozone from flowing toward the central side of the upper surface of the wafer 90, as in the case with apparatus of FIG. 27.

In the apparatus for processing the outer periphery of a substrate shown in FIG. 30, an infrared heater 120 is used instead of the laser heater 20 of the previously-mentioned embodiments. As shown in FIGS. 30 and 31, the infrared heater 120 includes a light source comprising an infrared lamp 121 such as a halogen lamp, and an optical system 122 as an irradiator for irradiating a beam of light in a converging manner. The infrared heater 120 has an annular configuration extending over the entire periphery in the peripheral direction of the frame 50. That is, the infrared lamp 121 is an annular light source extending over the entire periphery in the peripheral direction of the frame 50, and the optical system 122 is also arranged over the entire periphery in the peripheral direction of the frame 50. The optical system 122 comprises, among others, a condensing system such as a parabolic reflector, a convex lens, and a cylindrical lens, a wavelength extraction part such as a bandpass filter. Moreover, a focus adjusting mechanism is incorporated in the optical system 122. The optical system 122 is designed such that the infrared light coming from the infrared lamp 121 is passed through the bandpass filter, condensed by the parabolic reflector and lens and converged to the entire periphery of the outer periphery of the reverse surface of the wafer 90. Owing to this arrangement, the film 92c coated on the outer peripheral part of the reverse surface can be heated locally and yet over the entire periphery at a time. The infrared lamp 121 herein used may be a far infrared lamp or a near infrared lamp. The emitting wavelength is, for example, 760 nm to 10000 nm. Among them, a suitable light in match with the absorbing wavelength of the film 92c is selected extracted by the bandpass filter. By doing so, the heating efficiency of the film 92c can be more enhanced.

A lamp cooling path 125 is formed within the infrared heater 120 over the entire periphery. This lamp cooling path 125 is connected with a refrigerant supply source not shown through a refrigerant forward path 126 and a refrigerant backward path 127. Owing to this arrangement, the infrared heater 120 can be cooled. An example of the refrigerant may include water, air, helium gas or the like. In case air and water are used as the refrigerant, they may be discharged without returning them to the refrigerant supply source from the backward path 127. This refrigerant supply source for cooling the heater may be commonly used as a refrigerant supply source for absorbing heat of the substrate.
The lamp cooling path 125, the forward path 126, the backward path 127 and the refrigerant supply source for cooling the heater constitute a "radiating heater cooling means".

As the reactive gas supply source of the reactive gas supplying means, an ozonizer 70 is used as in the apparatus of FIG. 29. The ozonizer 70 is connected to a plurality of supply connectors 72 of the frame 50 through the ozone supply tube 71. The number of the supply connectors is comparatively large, for example, eight. Those supply connectors 72 are equally spacedly arranged in the peripheral direction of the upper part of the outer peripheral surface of the peripheral wall 52.

The upper part of the peripheral wall 52 is provided as a jet path and a jet port forming member. That is, a reactive gas path 73 connecting to those supply connectors 72 is formed in the upper part of the peripheral wall 52 in a horizontal posture toward radially inwardly and in an annular fashion over the entire periphery in the peripheral direction. The reactive gas path 73 is open to the entire periphery of the inner periphery of the peripheral wall 52, and the opening part of the reactive gas path 73 serves as an annular jet port 74. The height of the jet port 74 is slightly lower than the upper surface of the stage 10 and thus, the reverse surface of the wafer 90 which is to be placed on the upper surface of the stage 10. The jet port 74 is arranged proximate to the outer peripheral edge of the wafer 90 and in such a manner as to surround the entire periphery.

The ozone coming from the ozonizer 70 is introduced to the respective positions of the reactive gas path 73 where the respective supply connectors 72 are connected to the reactive gas path 73 and then, jetted out radially inwardly from the entire periphery of the jet port 74 while spreading over the entirety in the peripheral direction of the reactive gas path 73. Owing to this arrangement, the ozone can be sprayed onto the entire periphery of the outer peripheral part of the reverse surface of the wafer 90 at a time, and the film 92c coated on the entire periphery can be efficiently removed therefrom.
In the apparatus of FIG. 30, since the entire periphery of the wafer 90 can be processed at a time as mentioned above, the stage 10 is not required to be rotated but the stage 10 is preferably rotated in order to carry out the processing evenly in the peripheral direction.

In the apparatus of FIG. 30, when the cover member 80 is set in the set position, a suction path 53d is formed over the entire periphery between the upper surface of the peripheral wall 52 and the cover member 80. This suction path 53d is connected to a suction/exhaust apparatus not shown through the suction connector 57 which is disposed at the cover member 80. Owing to this arrangement, the processed gas can be sucked and exhausted from the periphery of the outer peripheral part of the wafer 90.

The inventors have measured, using the same apparatus as in FIG. 30, the surface temperatures of the wafer vs. distances in the radially inward direction from the vicinity of the portion to be heated of the outer end edge of the wafer under the conditions that the outer end edge of the wafer was projected by 3 mm from the stage 10, and the water temperatures within the refrigerant chamber 41 were 5 degrees C, 20 degrees C and 5-degrees C. The output conditions of the infrared heater 120 were as follows.

light source: annular halogen lamp
converging optical system: parabolic reflector
emitted light wavelength: 800 to 2000 nm
output: 200 W
locally heated portion width: 2 mm

The results are shown in FIG. 32. It was confirmed that in case the water temperature is 20 degrees C under the normal temperature, the temperature becomes about 80 degrees C (400 degrees C or higher in the portion to be heated) in the vicinity of the portion to be heated of the outer end edge of the wafer due to heat conduction but that the water temperature is held in a low temperature of 50 degrees C or lower at the part which is located radially inwardly by 9 mm or more therefrom, so that damage of the film can be restrained.

As shown in FIG. 33, the life of the oxygen atom radical obtained by decomposing ozone depends on temperature. The life is long enough in the vicinity of 25 degrees C but it is reduced to a half in the vicinity of 50 degrees C. On the other hand, since heating is carried out in order to obtain reaction with the film 92c, there is such a fear that the temperature of the ozone jet path is increased.

In view of the above, the apparatus for processing the outer periphery of a substrate shown in FIG. 34 is provided with a jet path cooling (temperature adjusting) means. That is, the reactive gas cooling path 130 is formed within the peripheral wall 52 of the frame 50 as a jet path forming member, and a refrigerant supply source not shown is connected to the reaction gas cooling path 130 through the refrigerant forward path 131 and the refrigerant backward path 132, so that the refrigerant can be circulated. As the refrigerant, for example, water, air, helium and the like are used. In case air and water are used, the refrigerant may be discharged without returning the refrigerant to the refrigerant supply source from the backward path 132. This jet path cooling refrigerant supply source may be commonly used with the refrigerant supply source for absorbing the heat of the substrate. By doing so, the ozone passing through the reactive gas path 52b can be cooled, and reduction of the quantity of the oxygen atom radical can be restrained, thereby maintaining activity. Thus, the efficiency for removing the film 92c can be enhanced.

In the apparatus for processing the outer periphery of a substrate of FIG. 34, the same ozonizer as in FIG. 29, as well as elsewhere is used as the reactive gas supply source. It is also accepted that the apparatus using the plasma nozzle head of FIG. 24 is provided with a reactive gas cooling path 130 so that the reactive gas path 52b can be cooled.

An inert gas nozzle N is provided, as an inert gas spray member, above the center of the stage 10 and thus, the wafer placed on the stage 10 such that the jet port is directed right under. The upstream end of the inert gas nozzle N is connected to the inert gas supply source not shown. For example, a nitrogen gas as an inert gas coming from the inert gas supply source is introduced to the inert gas nozzle N and then, jetted out through the jet port. The nitrogen gas thus jetted out is radially outwardly dispersed in a radial manner from the center along the upper surface of the wafer 90. Before long, the nitrogen gas reaches the gap 82a between the vicinity of the outer peripheral part of the upper surface of the wafer 90 and the cover member 80 and part of the gas tends to flow around to the reverse side of the wafer 90 through the gap 82a. By this flow of the nitrogen gas, the processed reactive gas around the reverse side of the outer peripheral part of the wafer 90 can be prevented from flowing around to the front side of the substrate, and thus, prevented from leaking out through the gap 82a reliably.

When the wafer 90 is placed on and removed from the stage 10, the inert gas nozzle N is retreated so as not to be interfered with the wafer 90.

In the apparatus for processing the outer periphery of the substrate of FIG. 34, the laser heater 20 is used as a radiating heater. It is also accepted that an infrared heater 120 may be used instead of the laser heater 20, as shown in FIG. 35. This infrared heater 120 is extended over the entire periphery of the frame 50 in an annular manner as in the case with the apparatus of FIG. 30.

In the apparatus for processing the outer periphery of a substrate shown in FIG. 36, the supply connector 72 from the ozonizer 70 is arranged between the laser irradiation unit 22 of the bottom plate 51 and the labyrinth seal 60. A tubular jet nozzle 75 as a jet path forming member is connected to this supply connector 72. The jet nozzle 75 is extended straightly upwardly from the supply connector 72. The jet nozzle 75 is abutted with the vicinity of the bottom part of the peripheral surface of the stage 10 and bent. Then, the jet nozzle 75 is extended slantwise upward along the tapered peripheral side surface of the stage 10. The distal end opening of the jet nozzle 75 serves as a jet port and is located in the vicinity of the upper edge of the peripheral side surface of the stage 10. This jet port is faced with the outer peripheral part of the reverse surface of the wafer 90 placed on the stage 10 so that ozone can be jet out toward the film 92c through the jet port.

According to the above-mentioned construction, by passing a refrigerant into the refrigerant chamber 41 defined within the stage 10, not only the wafer 90 can be heat-absorbed and cooled but also the jet nozzle 75 can also be cooled. This makes it possible that the substrate heat absorbing means also serves as a jet path cooling (temperature adjusting) means. Accordingly, since there is no need of forming the reactive gas cooling path 130, etc. as in FIG. 34, the cost down can be achieved.

It is preferable that a friction reducing material such as grease is applied to the peripheral side surface of the stage 10 or the outer peripheral surface of the jet nozzle 75 so that friction caused by rotation of the stage 10 can be reduced.

In the apparatus for processing the outer periphery of a substrate shown in FIG. 37, a step 12 is formed on the entire periphery of the outer peripheral part of the upper surface of the stage 10. Owing to this arrangement, when the wafer 90 is placed on the stage 10, a recess (gas reservoir) 12a is formed between the step 12 and the wafer 90. This recess 12a is extended over the entire periphery of the stage 10 and opened radially outwardly. The depth along the radial direction of the recess 12a is, for example, about 3 to 5 mm.

The ozone jetted out through the jet nozzle 36 is flowed into this recess, i.e., gas reservoir 12a and temporarily reserved therein. Owing to this arrangement, sufficient reaction time between the ozone and the film 92c coated on the outer peripheral part of the reverse surface of the wafer 90 can be obtained and the processing efficiency can be enhanced.

In the apparatus for processing the outer periphery of a substrate shown in FIG. 38, an enclosure En is provided radially outwardly of the outer peripheral part of the stage 10. A substrate insertion hole 10a is formed in the inner peripheral side wall facing the stage 10 of the enclosure En. The projected outer peripheral part of the wafer 90 placed on the stage 10 is inserted into the enclosure En through this substrate insertion hole 10a. The distal end part of the plasma nozzle head 30 is passed through the outer peripheral side wall of the enclosure En and thus, the reactive gas jet port is arranged within the enclosure En. On the other hand, for example, the laser irradiation unit 22 of the laser heater 20 is spacedly arranged below the enclosure En, i.e., outside the enclosure En as a radiating heater.

The enclosure En is composed of, for example, a light transmissive material such as quartz, boro-silicate glass and transparent resin. Owing to this arrangement, the laser light L coming from the laser irradiation unit 22 is transmitted through the bottom plate of the enclosure En and locally irradiated to the outer peripheral part of the reverse surface of the wafer 90. By this, the outer peripheral part of the reverse surface of the wafer 90 can be locally radiantly heated. On the other hand, the reactive gas such as oxygen radical and ozone generated by the plasma nozzle head 30 is jetted out into the enclosure En and hits the locally heated part, so that the film 92c coated on the locally heated part can reliably be removed. Owing to a provision of the enclosure En, the processed reactive gas can be prevented from leaking outside. Then, the processed reactive gas is sucked into and discharged through the suction port of the plasma nozzle head 30.

It is accepted that at least the bottom plate of the enclosure En facing the laser irradiation unit 22 is composed of a light transmissive material.

FIG. 39 shows another embodiment of an optical system of the radiating heater. An optical fiber cable 23 (wave guide) is optically connected to a light source 21 of a laser heater 20 as an optical system for line-transmitting the outgoing light to the outer peripheral part of the wafer 90. The optical fiber cable 23 is composed of a flux of a large number of optical fibers. The flux of optical fibers are extended from the laser light source 21 and branched in plural directions to form a plurality of branch cables 23a. Each branch cable 23a may be composed of a single optical fiber or it may be composed of a flux of a plurality of optical fibers. The distal end parts of those branch cables 23a are extended to the outer peripheral part of the stage 10 and equally spacedly arranged along the peripheral direction of the stage 10. The distal end part of each branch cable 23a is arranged in an upwardly directing manner so that it is orthogonal to and faced with the wafer 90 in a position just under the vicinity of the target position P or the outer peripheral part of the reverse surface of the wafer 90 placed on the stage 10. The plasma nozzle head 30 is horizontally disposed so that it corresponds to the distal end parts of the respective branch cables 23a in a one-to-one relation. Although not shown, the distal end part of each branch cable 23a is preferably provided with the laser irradiation unit 22.

According to this above-mentioned construction, the laser coming from the light source 21 is transmitted, without being dispersed, toward the outer peripheral part of the reverse surface of the wafer 90 through the optical fiber cable 23. Moreover, the laser is transmitted to peripherally different positions in a distributing manner through the branch cables 23a. Then, the laser is outputted upwardly from the distal end face of each branch cable 23a. This makes it possible to irradiate the laser to the outer peripheral part of the reverse surface of the wafer 90 from the vicinity thereof. The spot-like laser light coming from a single spot-like light source 21 can be irradiated to plural spots in the peripheral direction of the wafer 90. This makes it possible to remove the film by heating those plural spots simultaneously.

Moreover, the place where the light source 21 is to be arranged can freely be established. Distribution of the optical fibers can be made easily.

It is also accepted that a converging optical member such as a cylindrical lens is disposed at the distal end of the branch cable 23a so that the outgoing light is converged. It is also accepted that a plurality of light sources 21 are provided and each and every optical fiber cable 23 leading from each light source 21 may be extended toward a predetermined peripheral position. There may be various arrangement relations between the distal end part of the optical fiber and the jet port. One such example is that the distal end part of the optical fiber is disposed slantwise with respect to the wafer 90 and the jet port of the plasma nozzle head 30 is located right under the wafer 90. Of course, the ozonizer 70 may be used instead of the plasma nozzle head 30 and an infrared lamp may be used instead of the laser light source 21.

FIG. 40 shows a modified embodiment of the jet port forming member such as the jet nozzle 36 of the apparatus shown in FIG. 24, as well as elsewhere. As shown in FIG. 40(a), a plurality (for example, four) of aperture-like turning guide holes 36b are peripherally equally spacedly formed in the peripheral wall of the jet nozzle 36X as a turning flow forming part. The turning guide holes 36b are extending in the generally tangential direction of the inner periphery of the nozzle 36X, that is, the inner peripheral surface of the jet port 36a and allowed to pass through the peripheral wall of the nozzle 36X from the outer peripheral surface to the inner peripheral surface. Moreover, as shown in FIG. 40(b), the turning guide hole 36b is slanted in the direction of the distal end of the nozzle 36X as it goes from the outer peripheral surface of the peripheral wall of the nozzle 36X to the inner peripheral surface (that is, radially inwardly). The outer peripheral side end part of each turning guide hole 36b is connected to the jet path 52b, and the inner peripheral end part is connected to the jet port 36a. Accordingly, the turning guide hole 36b constitutes a communication path between the jet path 52b and the jet port 36a or the upstream side path part of the jet port.

According to this jet nozzle 36X, it is possible to form a turning flow along the inner peripheral surface of the jet port 36a by slantwise jetting out the reactive gas coming from the jet path 52b into the jet port 36a. Owing to this arrangement, the reactive gas can be supplied evenly. Moreover, since the reactive gas is jetted out through the comparatively large jet port 36a after passing through the aperture-like turning guide hole 36b, the reactive gas can be made more uniformed by pressure loss. The turning flow of the reactive gas thus uniformed is vigorously jetted out through the nozzle 36X and hit against the outer peripheral part of the reverse surface of the wafer 90, thereby carrying out the film removing operation in a favorable manner.

In the apparatus for processing the outer periphery of a substrate shown in FIGS. 41 and 42, a processing head 100 is disposed at the side part of the stage 10. This apparatus is chiefly designed for removing the film which is coated on the reverse surface of the outer peripheral part of the wafer 90. The processing head 100 is arranged lower than the upper surface of the stage 10. In case the film coated on the front side of the outer peripheral part of the wafer 90 is to be removed chiefly, the processing head 100 may be simply inverted up side down and arranged higher than the stage 10 in that condition.

The processing head 100 is provided with a jet nozzle 75 and a suction/exhaust nozzle 76.

An ozone supply tube 71 is extended from an ozonizer 70 as a reactive gas supply source, and this ozone supply tube 71 is connected to the basal end part of the jet nozzle 75 through a connector 72 of the processing head 100. The jet nozzle 75 is arranged lower than the target position (the outer peripheral part of the wafer 90 placed on the stage 10). A jet shaft L75 of the distal end part of the jet nozzle 75 is extended generally along the peripheral direction (tangential direction) of the outer periphery of the wafer 90 and slightly slanted toward the stage 10, i.e., radially inwardly of the wafer 90 in a plan view (FIG. 41). In a front view (FIG. 42), the jet shaft L75 is slanted upward toward the wafer 90. The jet port of the distal end of the jet nozzle 75 is faced with the vicinity of the target position P (reverse surface of the outer peripheral part of the wafer 90).

At least the distal end part of the jet nozzle 75 is preferably composed of a light transmissive material such as, for example, light transmissive teflon (registered trademark), pylex (registered trademark) glass, quartz glass and the like.

A connector connected to the suction/exhaust nozzle 76 is disposed at the side part opposite to the connector 72 on the jet side of the processing head. An exhaust tube 78 is extended from this connector 77, and this exhaust tube 78 is connected to an exhaust means 79 which includes an exhaust pump, etc.

The suction/exhaust nozzle 76 is arranged lower than the target position P (the outer peripheral part of the wafer 90 placed on the stage 10). The suction shaft L76 of the distal end part of the suction/exhaust nozzle 76 is straightly directed toward the tangentially direction of the outer periphery of the wafer 90 in a plan view (FIG. 41). In a front view (FIG. 42), the suction shaft L76 is slanted upward toward the wafer 90. The suction port of the distal end of the exhaust nozzle 76 is positioned at almost the same height (just under the reverse surface of the wafer 90) as that of the jet port of the jet nozzle 75.

As shown in FIG. 41, the distal end part of the jet nozzle 75 and the distal end part of the exhaust nozzle 76 are arranged opposite to each other along the peripheral direction (tangential direction) of the outer periphery (imaginary annular surface C disposed radially outwardly of the upper surface of the stage 10) of the wafer 90 and with the target position P disposed therebetween in a plan view. The target position P is arranged between the jet port of the distal end of the jet nozzle 75 and the suction port of the distal end of the exhaust nozzle 76. The jet nozzle 75 is arranged on the upstream side along the rotating direction (for example, clockwise direction in a plan view) of the stage 10 and thus, the wafer 90. Likewise, the suction/exhaust nozzle 76 is arranged on the downstream side. The distance between the jet port of the jet nozzle 75 and the suction port of the suction/exhaust nozzle 76 is properly established in a range of, for example, several mm to several tens of mm taking into consideration of reaction temperature of the film 92c to be removed, the speed of rotation of the stage 10, heating capacity of the laser heater 20, etc.

In case photoresist is to be removed, the interval between the jet port of the jet nozzle 75 and the suction port of the suction/exhaust nozzle 76 is established in a range where the processing temperature of the wafer is 150 degrees C or more, and preferably in a range, for example, 5 mm to 40 mm.

The diameter of the suction port of the exhaust nozzle 76 is larger than the diameter of the jet port of the jet nozzle 75, for example, about 2 to 5 times. For example, the diameter of the jet port is about 1 to 3 mm, while the diameter of the suction port is about 2 to 15 mm.

As shown in FIG. 42, a leaser irradiation unit 22 of the laser heater 20 is provided at the lower side part of the processing head 100 as a radiating heater. The laser irradiation unit 22 is arranged lower than the nozzles 75, 76 and arranged, as shown in FIG. 41, between the distal end part of the jet nozzle 75 and the distal end part of the exhaust nozzle 76 in a plan view. The target position P is positioned just above the laser irradiation unit 22.

With the above-mentioned construction, the laser light coming from the laser light source 21 is irradiated just above in a converging manner from the laser irradiation unit 22 via the optical fiber cable 23. Owing to this arrangement, the reverse surface of the outer peripheral part of the wafer 90 is locally heated. This locally heated part is moved toward the downstream side in the rotating direction according to rotation of the stage 10 while maintaining the high temperature for a short time. Therefore, the outer peripheral part of the wafer 90 is high in temperature not only at the part to be irradiated (target position P) just above the laser irradiation unit 22 but also at the part which is on the downstream side in the rotating direction therefrom. Of course, the target irradiator P located just above the laser irradiation unit 22 is highest in temperature, and the temperature is lowered toward the downstream side in the rotation direction therefrom. The curved lines T indicated by two-dot chain lines show temperature distribution of the wafer 90. The high temperature region distribution is deviated to the downstream side in the rotating direction about the target irradiator P (this radiantly heating operation will also be described with reference to the embodiments of FIGS. 43 through 46).

In parallel with the laser heating and the stage rotation, the ozone gas of the ozonizer 70 is sequentially flowed through the supply tube 71, the connector 72 and the jet nozzle 75 and then, jetted out through the jet nozzle 75 along the jet shaft L75. This ozone is sprayed onto the periphery of the target irradiator (target position P) of the reverse surface of the outer peripheral surface of the wafer 90. Since the jet shaft L75 is given an upward angle, the ozone gas can reliably be hit against the wafer 90. Likewise, since the jet shaft L75 is given a radially inward angle, the ozone gas is jetted out slightly inwardly of the wafer 90. Owing to this arrangement, the ozone can reliably be prevented from flowing around the front side from the outer end face of the wafer 90. After hit against the reverse surface of the wafer 90, the ozone gas is flowed toward the exhaust nozzle 76 almost along the tangential line in the target irradiator of the outer periphery of the wafer 90 for a short time without departing from the reverse surface of the wafer 90. Owing to this arrangement, a sufficient time for reaction between the ozone and the film 92c coated on the reverse surface of the wafer 90 can be obtained.

The ozone gas flow is moved along the deviating direction of temperature distribution. Therefore, the ozone gas can take place reaction with the film 92c not only at the target irradiator P soon after jetting, but also at the part on the exhaust nozzle 76 side which is located on the downstream side of the target irradiator P. Thus, the processing efficiency can be enhanced.

At the same time, the suction means 79 is actuated. By doing so, the processed ozone and the reaction by-products can be introduced into the suction port of the exhaust nozzle 76 so as to be sucked and exhausted therefrom and without being dispersed. Since the suction port is larger than the jet port, the processed ozone gas, etc. can surely be caught and sucked, and the processed ozone gas, etc. can surely be restrained from being dispersed. Thus, the ozone gas, etc. can reliably be prevented from flowing around to the front side of the wafer 90, and the front side film 92 can reliably be prevented from being damaged in the form of, for example, characteristic change or the like. Moreover, the reaction by-products can rapidly be cleaned out from the periphery of the target spot of the wafer 90.

As indicated by an arrowed curve line, the rotating direction of the stage 10 is directed in the normal direction (direction along the ozone gas flow) from the jet nozzle 75 to the suction nozzle 76.

FIGS. 43 and 44 show a modified embodiment of the embodiment of FIGS. 41 and 42.

A processing head 100 of this apparatus for processing the outer periphery of a substrate is provided with a nozzle retaining member 75H for retaining a jet nozzle 75. The nozzle retaining member 75H is composed of a material having a favorable heat conductive property such as aluminum. A cooling path 130 is formed within the nozzle retaining member 75H, and a cooling medium such as water is allowed to pass through the cooling path 130. Owing to this arrangement, the retaining member 75H and thus, the jet nozzle 75 can be cooled.

The position, in a plan view, of the laser irradiation unit 22 is arranged at an intermediate part between the distal end part of the jet nozzle 75 and the distal end part of the suction nozzle 76. Moreover, they are arranged one-sided toward the jet nozzle 75 side.

Both the jet nozzle 75 and the suction/exhaust nozzle 76 are removably attached to the processing head 100. Owing to this arrangement, the configuration can be changed to the most suitable one in accordance with necessity.

At the time of supplying the ozone, the cooling medium is passed through the cooling path 130 of the nozzle retaining member 75H. By doing so, the jet nozzle 75 can be cooled through the nozzle retaining member 75H and thus, the ozone gas are being passed through the jet nozzle 75 can be cooled. Owing to this arrangement, the quantity of oxygen atom radical can be prevented from being reduced, and the activity can be kept high. Thus, etching can be carried out by reliably making the ozone gas reacted with the film 892c.

In parallel with the supply of ozone, the laser heater 20 is turned on so that the laser light L is emitted just above from the irradiation unit 22. As shown in a bottom view of FIG. 45(b), this laser light is irradiated to a very small region Rs of the reverse surface of the wafer 90 in a spot-like manner. This region Rs is located between the jet port of the jet nozzle 75 and the suction port of the suction nozzle 76 and coincident with the passing way of the ozone gas. This region Rs is locally radiantly heated and instantaneously reached to such a high temperature as several hundreds degrees C. By bringing the ozone into contact with the region Rs having a high temperature, reaction can be enhanced and the processing efficiency can be enhanced.

In accordance with rotation of the stage 10 and thus, the wafer 90, the locally radiantly heated area Rs is sequentially shifted. That is, each point of the reverse surface of the outer periphery of the wafer 90 is only momentarily located in the radiantly heated region Rs and passed that region soon. Therefore, the radiantly heating period is instantaneous. For example, presuming that the diameter of the wafer 90 is 200 mm, the speed of rotation is 1 rpm and the diameter of the radiating region Rs is 3 mm, the radiantly heating period is only about 0.3 seconds.

On the other hand, when each point of the reverse surface of the outer periphery of the wafer 90 is once heated, heat remains there for a short time even after each point is passed that region. Thus, each point is still high in temperature (see the surface temperature distribution diagram of FIG. 46). During this high temperature period, each point is still located in the passing way of the ozone gas between the jet nozzle 75 and the suction nozzle 76, and the ozone is still kept contacted therewith. Owing to this feature, the processing efficiency can be more enhanced.

Moreover, since the radiating region Rs is deviated toward the jet nozzle 75 side, each point of the reverse surface of the outer periphery of the wafer 90 is radiantly heated soon when each point is contacted with ozone. Thereafter, this point keeps high temperature even after it moves away from the radiantly heating region Rs for a short time. During the time each point still keeps high temperature, the point is kept contacted with ozone. Owing to this feature, the processing efficiency can be more enhanced.

On the other hand, the part located inside the outer peripheral part of the wafer 90 is not subjected directly to radiant heat coming from the laser heater 20. Moreover, this specific part is heat-absorbed and cooled by the cooling medium within the stage 10. Therefore, even if heat of the radiantly heating region Rs should be transferred to the specific part, temperature increase could be restrained and thus, a low temperature state can reliably be maintained. This makes it possible to reliably prevent damage from prevailing on the film 92 which should not be removed, and an excellent film quality can be maintained.

FIG. 46(a) shows a temperature distribution of the front surface of a wafer at a certain moment when the outer peripheral part of the reverse surface of a rotating wafer is locally radiantly heated by laser, and FIG. 46(b) shows a single measured result of temperature vs. the peripheral position of the reverse surface. The laser output is 100 W, and the speed of rotation is 1 rpm. The diameter of the radiating region Rs is about 3 mm. The position O located on the outer periphery of the wafer 90 of FIG. 46(a) corresponds to the origin of the lateral axis of FIG. 46(b). The lateral axis of FIG. 46(b) shows the respective points of the outer peripheral part of the reverse surface of the wafer in terms of distance from the position O. In FIGS. 46 (a) and 46(b), the radiating region Rs and the region Ro including the region Rs are in corresponding relation. The region Ro corresponds to the length D (see FIG. 45(b)) portion between the jet nozzle and the suction nozzle.

As apparent from FIG. 46(b), even in the region before entering the radiating region Rs, the temperature became 150 degrees C or higher due to heat conduction from the radiating region Rs though such a range is small. In the radiating region Rs, the temperature was raised at a dash and showed a temperature distribution of 350 degrees C to 790 degrees C. In the region following the radiating region Rs, temperature was lowered but still kept at the level of 150 degrees C or higher for a short time. That is, a high temperature enough to remove organic matter was kept. From the foregoing, it became clear that a combination of rotation and radiant heating is effective for removing the organic matter.

The range of the region maintaining the high temperature following the radiating region Rs depends on laser output and speed of rotation of the stage. The distance D (width of the region Ro) between the jet nozzle and the suction nozzle may be established in accordance with this.

In order to lower the temperature of the radiating region Rs, the laser output is reduced and the speed of rotation of the stage is increased. In contrast, in order to raise the temperature, the laser output is increased and the speed of rotation of the stage is reduced.

A processing head 100 of the apparatus for processing the outer periphery of a substrate shown in FIGS. 47 and 48 is arranged higher than the wafer 90 placed on the stage 10. The jet nozzle 75 and the suction/exhaust nozzle 76 are also arranged higher than the wafer 90. Those nozzles 75, 76 are, in a plan view, arranged opposite to each other generally along the peripheral direction (tangential direction in the vicinity of the target position P) of the wafer 90 with the target position P disposed therebetween as in the case with FIGS. 41 to 44.

The irradiation unit 22 of the laser heater 20 is arranged just above the target position P in a posture directing downward. The laser light axis of the irradiation unit 22 is extended along the normal line orthogonal to the wafer 90 via the target position P and the focus is fixed to the target position P.

The laser coming from the irradiation unit 22 is irradiated to the target position P of the front surface of the outer peripheral part of the wafer 90 and the film coated on the front side of the target position P is radiantly heated. In parallel with this, the ozone from the ozonizer 70 is jetted out and then, jetted out onto the front surface of the outer periphery of the wafer 90 through the jet nozzle 75. The ozone is then flowed almost along the tangential direction of the wafer 90 in the vicinity of the target position P. Owing to this arrangement, the unnecessary film coated on the front side of the outer periphery of the wafer 90 can be removed.

The gas flow on the wafer 90 is along the rotating direction of the wafer 90 and also along the high temperature region forming direction (FIG. 46(a)) caused by residual heat. Owing to this arrangement, the processing efficiency can be enhanced.

The processed gas (containing reaction by-products such as particles) is kept maintained in its flow direction at the jet-out time owing to suction of the suction nozzle 76 and rotation of the wafer 90 and sucked into the suction nozzle 76 in that condition and then exhausted. Owing to this arrangement, particles can be prevented from being deposited on the outer periphery of the wafer 90. Since the suction nozzle 76 has a larger bore than the jet nozzle 75, leakage of the processed gas can be restrained.

FIG. 49 shows a modified embodiment of the arrangement of a suction nozzle.

The suction nozzle 76 is arranged from outside the radius of the stage 10 and thus, the wafer 90 toward generally inside the radius in such a manner as to be orthogonal to the jet nozzle 75 in a plan view. The position of the suction port of the distal end of the suction nozzle 76 is arranged slightly away in the normal direction of the rotating direction of the wafer 90 from the jet port of the jet nozzle 75. The position in the up-and-down direction of the distal end of the suction nozzle 76 is arranged at the almost same height as the upper surface of the stage 10 and thus, the wafer 90.

According to the above-mentioned construction, the gas (containing reaction by-products such as particles) jetted out through the jet nozzle 75, reacted and processed can rapidly be brought to outside the radius from the top of the wafer 90 and then, sucked into the suction nozzle 76 and exhausted. Thus, particles can be prevented from being deposited on the wafer 90.

In the construction of the suction nozzle shown in FIG. 50, the suction nozzle 76 is arranged lower than the very near part of the outer peripheral part of the wafer 90 placed on the stage 10 and in an upwardly directed posture. The position of the suction port of the distal end of the suction nozzle 76 is arranged slightly away in the normal direction of the rotating direction of the wafer 90 from the jet port of the distal end of the jet nozzle 75.

According to this construction, as indicated by arrows of FIG. 51, the gas jetted out through the jet nozzle 76 is flowed toward the lower surface along the outer end face of the upper surface of the outer peripheral part of the wafer 90. During this process, the gas is reacted with the unnecessary film 92c coated on the outer end face of the wafer 90 and the film 92c coated on the outer end face can reliably be removed. The processed gas (containing reaction by-products such as particles) is sucked into the lower suction nozzle 76 and exhausted.

In the apparatus for processing the outer periphery of a substrate shown in FIGS. 52 and 53, the irradiation unit 22 is arranged higher than the wafer 90 and in a slantwise posture toward the outer peripheral part (target position P) of the wafer 90 from outside the radius. The slantwise angle of the irradiation unit 22 is, for example, about 45 degrees.

As shown in FIG. 54, the irradiation light axis L20 (center axis of the laser light flux) coming from the irradiation unit 22 is intersected with the upper slantwise part of the outer peripheral part of the wafer 90 and generally aligned with the normal line of the front surface of the film just at this point of intersection. Or the light axis L20 is generally aligned with the width direction just at this point of intersection. The irradiation unit 22 is provided with a converging optical system including a convex lens, a cylindrical lens and the like and configured to irradiate the laser L coming from the light source 21 through the optical fiber 23 toward the point of intersection (point to be irradiated) with the light axis 20 of the upper slantwise part of the outer peripheral part of the wafer 90 in a converging manner.

According to the above-mentioned construction, as shown in FIG. 54, the laser light coming from the irradiation unit 22 is irradiated slantwise downward at an angle of about 45 degrees toward the outer peripheral part of the wafer 90 from above the outer peripheral part of the wafer 90 and outside the radius and gradually converged. Then, the laser light is irradiated to the upper slantwise part of the outer peripheral part of the wafer 90. The laser light axis L20 is generally orthogonal to this point to be irradiated and forms an angle of incidence of about 0 degree C. Owing to this arrangement, the heating efficiency can enhanced and the outer peripheral part of the wafer 90 in the periphery of the point to be irradiated can be heated to high temperature locally and reliably. The ozone coming from the jet nozzle 75 is contacted with such locally heated part. By doing so, as shown in FIG. 55, the film 92c can efficiently be removed at a high etching rate.

The inventors carried out an experiment, as shown in FIG. 54, for locally irradiating a laser to the outer peripheral part of a wafer from slantwise above at an angle of 45 degrees in a converging manner. The speed of rotation of the wafer was 50 rpm and the laser output was 130 W. The surface temperature of a vertical outer end face of the wafer was measured with a thermography. The measured result was 235.06 degrees C in a position just under the point to be irradiated.

Similarly, another experiment was carried out by making a laser irradiating angle 30 degrees with respect to vertical and making all other conditions same as in the case with the above-mentioned 45 degrees. The measured result was 209.23 degrees in a position right under the point to be irradiated.

From the above results, it became clear that a sufficiently large etching rate can be obtained.

The inventors also carried out a comparative experiment. Laser was irradiated from just above the outer peripheral part of a wafer. All other conditions such as the speed of rotation of the wafer and the output of the laser were same as in the above-mentioned experiments. The vertical outer end face temperature of the wafer was 114.34 degrees C. This temperature was lower than the rising temperature of the etching rate. The reason for this can be considered that irradiation of laser from just above (from the direction of 90 degrees with respect to the wafer) does not directly hit the vertical outer end face of the wafer. Moreover, it also became clear that if the irradiating direction is diagonally slanted to 45 degrees as shown in FIG. 54, the heating temperature can be made almost double of 90 degrees.

It is accepted that the laser irradiating axis L20 is directed to the outer peripheral part of the wafer 90 from the angle declined toward outside the radius of the wafer 90. This declined angle of the laser irradiating axis L20 may be declined not only within a range of diagonal but also it may be inclined until it becomes horizontal. In case the laser irradiating axis L20 is declined until it becomes horizontal, the laser coming from the irradiation unit 22 vertically hits the outer end face of the wafer 90 from right beside of the wafer 90. This angle of incidence is almost zero. Owing to this arrangement, the film 92c coated on the outer end face of the wafer 90 can more reliably be heated and the etching rate can be more enhanced.

The inventors carried out a heating experiment, in which as shown in FIG. 56, the irradiation unit 22 was fallen horizontally, laser was irradiated to the outer peripheral part of the wafer from right beside in a converging manner, and all other conditions were same (speed of rotation of the wafer: 50 rpm, laser output: 130 W) as in the experiment of FIG. 54. Then, the surface temperature of the vertical outer end face of the wafer was measured. The measured result was 256.36 degrees C. It became clear from this that by irradiating a laser to the vertical outer end face of the wafer from right beside the wafer, the temperature can be more increased and the processing can be performed at a higher speed.

As shown in FIG. 57, an organic film 92 such as fluorocarbon is liable to be formed also on the reverse side (lower side) of the outer peripheral part of the wafer in such a manner as to flow around thereto. In case this film coated on the reverse surface of all film coated on the outer peripheral part of the wafer 90 is to be removed, the irradiation unit 22 may be arranged in a position lower than the wafer 90 and outside the radius, so that laser can be irradiated toward the outer peripheral part of the wafer 90 from that position.

Owing to the above-mentioned arrangement, the laser coming from the irradiation unit 22 is irradiated slantwise upwardly toward the outer peripheral part of the wafer 90 from the position below the wafer 90 and outside the radius in a converging manner. The angle of this laser light axis L20 is, for example, about 45 degrees. This laser is made incident to the lower slantwise part of the outer peripheral part of the wafer 90 at an angle of incidence near zero degree. Owing to this arrangement, particularly the film 92c coated on the reverse side of all the outer peripheral part of the wafer 90 can be heated to high temperature and the film 92c coated on the reverse side can reliably be etched and removed at a high speed. In this reverse surface processing, both the jet nozzle 75 and the exhaust nozzle 76 are also preferably arranged in a position below the outer peripheral part of the wafer 90.

As shown in FIG. 58, an irradiation unit 22X vertical to the wafer 90 may be employed separately from the irradiation unit 22 which is arranged in its declined posture. The vertical irradiation unit 22X is connected to a laser light source 21X, which is separate from the one to which the declined irradiation unit 22 is connected, through an optical fiber cable 23X. It is also accepted that two branch optical cables are led out from the same laser light source, so that one of the branch optical cables is connected to the vertical irradiation unit 22X and the other is connected to the declined irradiation unit 22.

According to this apparatus construction including two irradiation units 22, 22X, the film 92c coated on the slantwise part and the outer end face of the outer periphery of the wafer 90 can be efficiently be removed by heating to high temperature chiefly using the declined irradiation unit 22, and the film 22c coated on the flat surface part of the outer periphery of the wafer 90 can be efficiently removed by heating to high temperature chiefly using the vertical irradiation unit 22X. Owing to this arrangement, the entire unnecessary film 92c coated on the outer peripheral part of the wafer 90 can reliably be removed.

The angle of the irradiation unit 22 is not limited to fixed one. Instead, as shown in FIG. 59, a variable angle may be employed. The apparatus for processing the outer periphery of a substrate shown in FIG. 59 is provided with a moving mechanism 30 for the irradiation unit 22. The moving mechanism 30 is provided with a slide guide 31. The slide guide 31 has an arcuate configuration having a quarter circumference extending about 90 degrees from about 12 o'clock position to about 3 o'clock position. The outer peripheral part (target position P) of the wafer 90 is arranged in a position which corresponds to the center of the arcuate configuration of the slide guide 31.

The irradiation unit 22 is mounted on the slide guide 31 such that the irradiation unit 22 is slidable in the peripheral direction of the slide guide 31. Owing to this arrangement, the irradiation unit 22 and the laser light axis L20 are always directed to the outer peripheral part of the wafer 90 and adjustable in angle over 90 degrees between a vertical posture position (where the irradiation unit 22 and the laser light axis L20 take a vertical posture as indicated by the two-dot chain line of FIG. 59)just above the outer peripheral part of the wafer 90 and a horizontal posture position (where the irradiation unit 22 and the laser light axis L20 take a horizontal posture as indicated by the broken line of FIG. 59) right beside the wafer 90. The moving track of the irradiation unit 22 and the laser light axis L20 is arranged on a vertical plane orthogonal to the upper surface of the stage 10 and the wafer 90 including a single radius of the stage 10 and the wafer 90. Though not shown, the moving mechanism 30 is provided with a drive means for moving the irradiation unit 22 between the vertical posture position and the horizontal posture position along the slide guide 31.

According to the apparatus for processing the outer periphery of a substrate equipped with this moving mechanism 30, as indicated by a solid line of FIG. 59, when the upper slantwise part of the outer peripheral part of the wafer 90 is to be primarily processed, the irradiation unit 22 and the laser light axis L20 are slanted to an angle of for example, about 45 degrees toward the upper side of the wafer 90. By doing so, the outer peripheral part of the wafer 90 can reliably be heated to high temperature mostly at its center and its periphery, and the unnecessary film 92c coated on the periphery of the upper slanted part can reliably be removed at a high etching rate.

As indicated by the broken line of FIG. 59, when the vertical outer end face of the wafer 90 is to be mostly processed, the irradiation unit 22 and the laser light axis L20 are fallen right beside the wafer 90 and brought in a horizontal posture. By doing so, the outer end face of the wafer 90 and its periphery can mainly reliably be heated to high temperature and the unnecessary film 92c coated on the periphery of the outer end face can reliably be removed at a high etching rate.

As indicated by the two-dot chain line of FIG. 59, when the upper flat surface part of the outer periphery of the wafer 90 is to be primarily processed, the irradiation unit 22 and the laser light axis L20 are positioned just above the wafer 90 so that they take a vertical posture. By doing so, the upper flat surface part of the outer periphery of the wafer 90 and its periphery can reliably primarily be heated to high temperature and the unnecessary film 92c coated on the periphery of the upper flat surface part can reliably be removed at a high etching rate.

In the manner as mentioned above, the respective parts of the outer peripheral part of the wafer 90 can be processed efficiently.

As shown in FIG. 60, when the film coated on the reverse surface side of the outer peripheral part of the wafer 90 is to be mainly processed, the slide guide 31 of the moving mechanism 30 may have an arcuate configuration having a quarter circumference extending about 90 degrees from about 3 o'clock position to about 6 o'clock position. The irradiation unit 22 and the laser light axis L20 are always directed to the outer peripheral part (target position P) of the wafer 90 and adjustable in angle over 90 degrees between a horizontal posture position (indicated by the broken line of FIG. 60) where the irradiation unit 22 and the laser light axis L20 take a horizontal posture right beside the wafer 90 and a vertical posture position (indicated by the two-dot chain line of FIG. 60) where the irradiation unit 22 and the laser light axis L20 take a vertical posture just under the outer peripheral part of the wafer 90.

Owing to the above-mentioned arrangement, as indicated by the solid line of FIG. 60, when the lower slantwise part of the wafer 90 is to be primarily processed, the irradiation unit 22 and the laser light axis L20 are slanted, for example, about 45 degrees downward of the wafer 90. Owing to this arrangement, the upper slantwise part of the outer peripheral part of the wafer 90 and its periphery can reliably be heated to high temperature and the unnecessary film 92c coated on the periphery of the upper slantwise part can reliably be removed at a high etching rate.

As indicated by the broken line of FIG. 60, when the vertical outer end face of the wafer 90 is to be primarily processed, the irradiation unit 22 and the laser light axis L20 are fallen just beside the wafer 90 so that they take a horizontal posture. Owing to this arrangement, the outer end face of the wafer 90 and it periphery can reliably be heated to high temperature and the unnecessary film 92c coated on the periphery of the outer end face can reliably be removed at a high etching rate.

As indicated by the two-dot chain line of FIG. 60, when the flat surface part of the reverse side of the outer periphery of the wafer 90 is to be processed, the irradiation unit 22 and the laser light axis L20 are positioned right under the wafer 90 so that they take a vertical posture. Owing to this arrangement, the flat surface part of the reverse side of the outer periphery of the wafer 90 and its periphery can reliably be heated to high temperature and the unnecessary film 92c coated on the periphery of the flat surface part of the reverse side can reliably be removed at a high etching rate.

In the manner as mentioned above, the respective parts of the outer peripheral part of the wafer 90 can efficiently be processed.

In FIGS. 59 and 60, the slide guide 31 has an arcuate configuration having a quarter circumference and the angle adjustable range of the irradiation unit 22 and the laser light axis L2 is bout 90 degrees. It is also accepted that the guide 31 has a half circular configuration extending about 180 degrees from about 12 o'clock position to about 6 o'clock position, and the irradiation unit 22 and the laser light axis L20 are adjustable in angle over an angular range of 180 degrees from just above to right under of the outer peripheral part of the wafer 90.

In the apparatus for processing the outer periphery of a substrate shown in FIGS. 61 through 67, the processing head 100 is arranged at one side part of the stage 10. As shown in FIG. 67, the processing head 100 is supported on an apparatus frame (not shown) such that the processing head 100 can advance and retreat between a processing position (indicated by the solid line of FIG. 67) where the processing head 100 is advanced toward the stage 10 and a retreating position (indicated by the imaginary line of FIG. 67) where the processing head 100 is away from the stage 10. The number of the processing head 100 is not limited to one. Instead, a plurality of such processing heads 100 may be spacedly provided in the peripheral direction of the stage 10.

As shown in FIGS. 61 through 64, the processing head 100 includes a head main body 101 and a ladle nozzle 160 disposed at the head main body 101.
The head main body 101 has a generally rectangular parallelepiped configuration. As shown in FIGS. 61 and 62, the head main body 101 is provided at the upper part with the irradiation unit 22 of a laser heater.

As shown in FIGS. 61 through 64, an opening 101 facing the stage 10 is formed in the lower part of the head main body 101. An irradiation window formed in a lower end of the irradiation unit 22 is faced with a ceiling surface of this opening 102.

A gas supply path 71 of a single route and exhaust paths 76X, 76Y, 76Z of three routes are formed in a lower part wall of the head main body 101.
As shown in FIG. 62, the basal end (upstream end) of the gas supply path 71 is connected with an ozonizer 70. As shown in FIGS. 62 and 63, the distal end (downstream end) of the gas supply path 71 is extended toward the inner surface of one side of the opening 102 of the head main body 101.

As shown in FIGS. 62 and 63, a suction end of the first exhaust path 76X is open to the inner side surface on the opposite side of the gas supply path 71 in the opening 102 of the head main body 101. The height of the suction end of the exhaust path 76X is slightly higher than the upper surface of the stage 10. The exhaust path 76X is arranged on the downstream side of the gas supply path 71 and thus, the ladle nozzle 160 along the rotating direction (for example, clockwise direction in a plan view) of the wafer 90.

As shown in FIG. 62, a suction end of the exhaust path 76Y is open to the central part of the bottom surface of the opening of the head main body 101. The suction end of the exhaust path 76Y is arranged right under the irradiation unit 22 and a short cylindrical part 161 as later described.

As shown in FIGS. 61 and 64, the remaining exhaust path 76Z is open to the inner surface on the innermost side of the opening 102 of the head main body 101. The suction end of the exhaust path 76Z is almost same in height as the upper surface of the stage 10.
The downstream ends of those exhaust paths 76X, 76Y, 76Z are connected to an exhaust means (not shown) such as an exhaust pump.

The ladle nozzle 160 is disposed at the inner part of the opening 102 of the head main body 101. As shown in FIG. 65, the ladle nozzle 160 includes a short cylindrical part 161 having a short cylindrical configuration and a fine straight tubular introduction part 162. The short cylindrical part 161 and the introduction part 162 are composed of an ozone-resisting transparent material such as quartz.

As shown in FIGS. 62 and 63, the introduction part 162 is extended horizontally. The basal end part of the introduction part 162 is embedded in and supported by the head main body 101 and connected to the distal end part of the gas supply path 71. The interior of the introduction part 162 defines an introduction path 162a for introducing ozone (reactive gas).
For example, the outer diameter of the introduction part 162 is 1 mm to 5 mm, and the flow path section area of the introduction path 162a is about 0.79 $mm^2$ to 19.6 mm2 and the length is 20 mm to 35 mm.

The distal end part of the introduction part 162 is extended into the opening 102 of the head main body 101, and the short cylindrical part 161 is connected to the extended part.
The short cylindrical part 161 is also arranged at the central part of the opening 102 of the head main body 101. The short cylindrical part 161 has a covered cylindrical configuration having a lower opening and also has an axis directed vertically. The diameter of the short cylindrical part 161 is larger enough than that of the introduction part 162. The axis of the short cylindrical part 161 is extended along the center axis of the head main body 101 and aligned with the irradiating axis of the irradiation unit 22.
For example, the outside diameter of the short cylindrical part 161 is 5 mm to 20 mm and the height is 10 mm to 20 mm.

A cover part 163 is integrally provided to the upper end (basal end) of the short cylindrical part 161 and adapted to close the upper end. The cover part 163 is arranged under the irradiation window of the irradiation unit 22 in such a manner as to correctly oppose the irradiation window. As mentioned above, the entire short cylindrical part 161 including the cover part 163 is composed of a light transmissive material such as quartz glass. It is also accepted that at least the cover part 163 has a light transmitting property. As a light transmissive material, in addition to quartz glass, general purpose glass such as sodium glass, and resin having a high transparency may be used.
The thickness of the cover part 163 is preferably 0.1 mm to 3 mm.

The introduction part 162 is connected to a part near the upper side of the peripheral side wall of the short cylindrical part 161, and the introduction path 162a formed within the introduction part 162 is communicated with the internal space 161 a of the short cylindrical part 161. The downstream end of the introduction path 162a serves as a communication port 160 with the internal space 161 a of the short cylindrical part 161. The flow path section area of the internal space 161 a of the short cylindrical part 161 is larger enough than that of the introduction path 162a and thus, the communication port 160a.

For example, the flow path section area of the communication port 160a is about 0.79 mm$^2$ to 19.6 mm$^2$, while the flow path section area of the internal space 161a of the short cylindrical part 161 is 19.6 mm$^2$ to 314 mm$^2$.

The ozone (reactive gas) flowed through the introduction path 162a is then flowed into the internal space 161a of the short cylindrical part 161 from the communication port 160a, expanded and temporarily reserved therein. The internal space 161a of the short cylindrical part 161 serves as a temporary reservoir space for ozone (reaction gas).

As shown in FIGS. 61 and 62, the lower distal end of the short cylindrical part 161 is open. With the processing head 100 located in the processing position, the outer peripheral part (target position) of the wafer 90 placed on the stage 10 is positioned right under the lower end edge of the short cylindrical part 161, and the short cylindrical part 161 is overlain the target position. A gap formed between the lower end edge of the short cylindrical part 161 and the outer peripheral part of the wafer 90 is very small, for example, about 0.5 mm. Through this very small gas, the temporary reservoir space 161 a formed within the short cylindrical part 161 is faced with the outer peripheral part (target position) of the wafer 90.

As shown in FIG. 63, the short cylindrical part 161 in the processing position is arranged slightly expanded radially outwardly of the wafer 90 from the outer edge of the wafer 90. Owing to this arrangement, the temporary reservoir space 161a formed within the short cylindrical part 161 is communicated with outside through between the lower end edge of the expanded part of the short cylindrical part 161 and the outer peripheral edge of the wafer 90. The space formed between the lower end edge of the expanded part of the short cylindrical part 161 and the outer peripheral part of the wafer 90 serves as a release port 164 for releasing the gas reserved in the temporary reservoir space 161 a.

A method for removing the film 92c coated on the outer peripheral part of the reverse surface of the wafer 90 by the apparatus for processing the outer periphery of a wafer constructed in the manner as mentioned above will now be described.

The wafer 90 to be processed is placed on the upper surface of the stage 10 by a transfer robot, etc. such that the axis of the wafer 90 is aligned with that of the stage 10 and chucked. Then, the processing head 100 is advanced from the retreating position and set to the processing position. Owing to this arrangement, as shown in FIG. 66, the outer peripheral part of the wafer 90 is inserted into the opening 102 formed in the head main body 101 and arranged in a position immediately under the short cylindrical part 161.

Then, the laser light source 21 is turned on and the laser light L is irradiated from the irradiation unit 22 toward the outer peripheral part of the wafer 90 located right under the irradiation unit 22 in a converging manner. By doing so, the film 92c coated on the outer peripheral part of the wafer 90 can radiantly be heated in a spot-like (locally) manner. Although there is intermediately provided the cover part 163 of the short cylindrical part 161 in the optical path, the quantity of light is hardly reduced because the cover part 163 has a light transmitting property. Thus, the heating efficiency can be maintained.

In parallel with the above-mentioned heating operation, ozone is sent to the gas supply path 71 from the ozonizer 70. This ozone is introduced to the introduction path 162a of the introduction part 162 of the ladle nozzle 160 and introduced to the temporary reservoir space 161 a within the short cylindrical part 161 from the communication port 160a. Since the temporary reservoir space 161 a is more widely spread than the introduction path 162a and the communication port 160a, the ozone is dispersed in the temporary reservoir space 161 a and temporarily reserved therein. This makes it possible to increase the time for the ozone to contact the locally heated place of the outer peripheral part of the wafer 90 and therefore, sufficient reaction time can be obtained. This again makes it possible to reliably removed the film 92c coated on the heated place by etching and thus, the processing rate can be enhanced. Moreover, usage of ozone can fully be increased, waste can be eliminated and the quantity of gas required can be reduced.

The short cylindrical part 161 is slightly bulged out from the outer peripheral edge of the wafer 90. A space formed between this bulged part and the outer peripheral edge of the wafer 90 serves as a relief port 164 for releasing gas from the interior 161 a of the short cylindrical part 161. Therefore, the gas reserved in the interior 61a of the short cylindrical part 161 is temporary, and the processed gas having degraded activity and the reaction by-products (particles, etc.) can rapidly be released from the relief port. Thus, reaction efficiency can be maintained at a high level by always supplying a fresh ozone to the temporary reservoir space 161 a.

By adjusting the sucking and exhausting quantity of gas in the three exhaust paths 76X, 76Y, 76Z, leakage control can be made for the gas released through the relief port 164 and gas flow control can be made for the gas after leakage within the opening 102. Owing to a provision of the three exhaust paths 86X, 76Y, 76Z, dispersed particles, if any, can reliably be sucked and exhausted.

Since the stage 10 is rotated in parallel with the above procedure, the film 92c coated on the outer peripheral part of the wafer 90 can be removed from the entire periphery. Moreover, by cooling the inner part of the outer peripheral part of the wafer 90 by a cooling/heat absorbing means installed within the stage 10, the inner part of the wafer 90 subjected to laser irradiation can be prevented from being increased in temperature. Thus, the film 92 coated on the inner part of the wafer 90 can be prevented from being damaged.

After the end of the removing operation, the processing head 100 is retreated, the stage 10 is unchucked, and the wafer 90 is picked up from the stage 10.

As shown in FIGS. 68(a) through 68(c), the position of the short cylindrical part 161 in the processing position is adjusted in the radial direction of the stage 10 and the bulging amount of the short cylindrical part 161 from the outer peripheral edge of the wafer 90 is adjusted. By doing so, the processing width (hatched part in FIGS. 68(a) through 68 (c)) of the film 62c to be removed can be adjusted.

The inventors carried out an experiment of light transmittance of the cover part 163 using the experiment equipment of FIG. 69. A quartz glass plate G was used as the cover part 163 and a laser light L coming from the laser irradiation unit 22 was irradiated to this quartz glass plate G. A laser power measuring instrument D was placed on the reverse side of the quartz glass plate G, the transmitted laser energy was measured and the attenuation coefficient was calculated. The output of the laser irradiation unit 22 was switched over in several steps and the laser energy in each step was measured. Two quartz glass plates G having different thickness ware prepared and the same measurement was carried out for each glass plate G.

The results are as follows.

[Table 1]

| glass plate thickness: 0.12 mm | | |
| --- | --- | --- |
| Irradiation unit output (Watt) | Transmitted laser energy (Watt) | Attenuation coefficient (%) |
| 2.79 | 2.7 | 3.23 |
| 12.4 | 12 | 3.23 |
| 21.6 | 20.9 | 3.24 |
| 29.5 | 28.4 | 3.73 |
| | | |
| glass plate thickness: 0.12 mm | | |
| Irradiation unit output (Watt) | Transmitted laser energy (Watt) | Attenuation coefficient (%) |
| 2.79 | 2.68 | 3.94 |
| 12.4 | 12 | 3.23 |
| 21.6 | 20.8 | 3.70 |
| 29.5 | 28.5 | 3.39 |

As shown in the above Table 1, the attenuation factor was less than 4% irrespective of the output of the irradiation unit 22 and the thickness of the glass plate.

Therefore, it became clear that even if the cover part 163 of the ladle nozzle 160 is intermediately provided in the optical path extending from the irradiation unit 22, the laser light L of 96% or more can transmit through the cover part 163 and the heating efficiency at the peripheral part of the wafer 90 is hardly decreased.

On the other hand, even if the attenuated portion of the laser energy should totally be absorbed in the cover portion 163, this absorption would be less than 4% and therefore, the cover part 163 would hardly be heated. Moreover, the cover part 163 can sufficiently be cooled by the ozone gas passing through the ladle nozzle 160. Therefore, the cover part 163 and the ladle nozzle 160 are hardly heated to high temperature and scarcely required to have a heat resisting property.

FIG. 70 shows a modified embodiment of the ladle nozzle 160. In this modified embodiment, a notch 161 b as a release port is formed in the lower end edge of the short cylindrical part 161 of the ladle nozzle 160. As shown in FIG. 71, this notch 161 b is arranged on the opposite side to the side facing the stage 10 in the peripheral direction of the short cylindrical part 161 (place corresponding to outside the radius of the wafer 90).

The notch 161 b has a half-circular configuration having the radius of about 2 mm. The configuration and the size of the notch 161b are not limited to the above but they can properly be changed in accordance with necessity.

According to this modified embodiment, the processed gas and the reaction by-products temporarily reserved in the temporary reservoir space 161 a can reliably be released through the notch 161b, a fresh ozone can reliably be supplied to the temporary reservoir space 161 a and a high reaction factor can reliably be obtained.

Since the short cylindrical part 161 itself of the ladle nozzle 160 is provided with the relief port 61b, it is no more required to form the relief port 164 between the short cylindrical part 161 and the outer edge of the wafer 90 by making the short cylindrical part 161 bulged out from the outer edge of the wafer 90. As shown in FIG. 68(c), in case the short cylindrical part 161 and the wafer 60 are aligned in the outer edge with each other, the processed gas and the reaction by-products can reliably be flowed out from the temporary reservoir space 161a and the establishable range of the processing width of the film 92c to be removed can be widened.

FIGS. 72, 73 show a modified embodiment of an exhaust system. Exhaust nozzles 76XA, 76YA, 76ZA may be provided in the opening 102 of the processing head 100. As indicated by the imaginary line of FIG. 73, the exhaust nozzle 76XA is extended from the exhaust path 76X on a side part of the head main body 101 toward the central part of the opening 102 almost in the tangential direction of the wafer 90 placed on the stage 10. The distal end opening of the exhaust nozzle 76XA is arranged slightly away toward the downstream side of the short cylindrical part 161 along the rotating direction (for example, clockwise direction in a plan view) of the wafer 90 in such a manner as to face the side part of the short cylindrical part 161. The exhaust nozzle 76XA is arranged slightly above the wafer 90 and slightly slanted downward. The distal end opening of the exhaust nozzle 76XA is directed slantwise downwardly.
The reaction by-products such as particles generated on the wafer 90 located right under the short cylindrical part 161 are flown toward the exhaust nozzle 76XA in accordance with the rotation of the wafer 90. By sucking and exhausting those reaction by-products through the exhaust nozzle 76XA, particles can reliably be prevented from being deposited on the wafer 90.

As indicated by the imaginary line of FIGS. 72 and 73, the exhaust nozzle 76YA is extended vertically upwardly from the exhaust path 76Y at the bottom part of the head main body 101. The distal end (upper end) opening of the exhaust nozzle 76YA is arranged just under the lower end opening of the short cylindrical part 161 in such a manner as to be slightly away from and faced with the lower end opening of the short cylindrical part 161. The outer peripheral part of the wafer 90 is to be inserted between the short cylindrical part 161 and the exhaust nozzle 76YA.
Owing to the above-mentioned arrangement, the reaction by-products such as particles generated on the wafer 90 located right under the short cylindrical part 161 can be sucked and exhausted in a position beneath the exhaust nozzle 76YA and the particles can reliably be prevented from being deposited on the wafer 90. In parallel, the reactive gas such as ozone coming from the short cylindrical part 161 can be controlled so as to flow from the upper edge of the outer peripheral part of the wafer 90 toward the lower edge. In this way, the reactive gas can be contacted not only with the upper edge but also with the outer end and lower edge of the wafer 90. Owing to this arrangement, the unnecessary film 92c coated on the entire outer peripheral part of the wafer 90 can reliably be removed.

As indicated by the imaginary line of FIG. 72, the exhaust nozzle 76ZA is extended radially inwardly of the wafer 90 from the exhaust path 76Z at the innermost side surface of the opening 102 of the head main body 101 toward the central part of the opening 102. The distal end opening of the exhaust nozzle 76ZA is arranged slightly inner side (outside the radius of the wafer 90) from the short cylindrical part 161 and directed toward the short cylindrical part 161. The upper and lower positions of the exhaust nozzle 76ZA are arranged almost same height as the lower end part of the short cylindrical part 161 and the wafer 90.
Owing to the above-mentioned arrangement, the particles generated on the wafer 90 located right under the short cylindrical part 161 can rapidly be brought to outside the radius from the top of the wafer 90 and sucked and exhausted through the exhaust nozzle 76ZA and the particles can reliably be prevented from being deposited on the wafer 90. In addition, the dispersed particles, if any, can reliably be sucked and exhausted.

Of three exhaust nozzles 76XA, 76YA, 76ZA, only the first one may be selectively employed, two of them may be selectively employed or all three may be employed. It is also accepted that two or three of them are preliminarily mounted, and only one of them is selectively used for sucking and exhausting the processed gas. It is also an interesting alternative that two or three are simultaneously used for sucking and exhausting operation.

In the apparatus for processing the outer periphery of a substrate shown in FIGS. 74 through 77, a long cylindrical nozzle 170 (cylindrical part) is used instead of the above-mentioned ladle nozzle 160. Moreover, an introduction part 179 composed of an ozone-resisting resin (for example, polyethylene terephthalate) is used instead of the quartz-made introduction part 162 which is integral with the ladle nozzle 160. The long cylindrical nozzle 170 and the introduction part 179 are separately formed.

As shown in FIG. 76, the long cylindrical nozzle 170 is composed of an ozone-resisting transparent material as in the case with the ladle nozzle 160. The long cylindrical nozzle 170 has a covered cylindrical configuration having an open lower surface and is longer than the short cylindrical part 161.
For example, the long cylindrical nozzle 170 is 40 mm to 80 mm in length, 5 mm to 20 mm in outside diameter, and 19.6 $mm^2$ to 314 $mm^2$ in flow path section area of the internal space.

The long cylindrical nozzle 170 is integrally provided at the upper end (basal end) with a transparent cover part 173 for closing the upper end. As shown in FIGS. 74 and 75, this cover part 173 is arranged below the irradiation window of the irradiation unit 22 in such a manner as to correctly oppose the irradiation window. The irradiation unit 22 is configured to irradiate a laser to the outer peripheral part (target position) of the wafer 90 placed on the stage 10 through the cover part 173 in a converging manner.
The cover part 173 is preferably 0.1 mm to 3 mm in thickness.

The long cylindrical nozzle 170 is arranged at the central part of the opening 102 of the head main body 101 such that the axis is directed vertically. The long cylindrical nozzle 170 is arranged in such a manner as to pass through the outer peripheral part (target position) of the wafer 90 placed on the stage 10 and intersected at the intermediate part with the outer peripheral part of the wafer 90. A notch 173 is formed in a peripheral side part of an intersecting part (part corresponding to the target position) between the long cylindrical nozzle 170 and the outer peripheral part of the wafer 90. The notch 174 is extended in the peripheral direction of the long cylindrical nozzle 170 generally over a half circumference. The notch 174 has a vertical thickness slightly larger than that of the wafer 90 so that the outer peripheral part of the wafer 90 can be inserted therein.

For example, the notch 174 is in the long cylindrical nozzle 170 at a position about 10 mm to 30 mm away from the upper end part of the long cylindrical nozzle 170. The thickness (vertical dimension) of the notch 174 is about 2 mm to 5 mm. The central angle of the notch 174 is preferably 240 degrees to 330 degrees.

The introduction part 179 is connected to the upper (basal end side) part 171 of the notch 174 of the long cylindrical nozzle 170. The downstream end of the introduction path 179a formed within the introduction part 179 is communicated with the interior of the upper nozzle part 171 and serves as a communication port 170a. The interior of the upper nozzle part 171 of the long cylindrical nozzle 170 constitutes the temporary reservoir space 171 a.

When the wafer 90 is inserted in the notch 174, a relief port 75a from the temporary reservoir space 171a within the upper nozzle part 171 is formed between the outer edge of the wafer 90 and the remaining part 75 of the long cylindrical nozzle 170 which is remained as it is when the notch 174 is formed.

The interior of a part of the long cylindrical nozzle 170, which is located lower than the notch 174, serves as a relief path connected to the relief port 75a. As shown in FIG. 75, an exhaust path 76Y is directly connected to the lower end of the long cylindrical nozzle 170.

According to this second embodiment, when the wafer 90 to be processed is placed on the upper surface of the stage 10 and the processing head 100 is advanced to the processing position, the outer peripheral part of the wafer 90 is inserted in the notch 174 of the long cylindrical nozzle 170. Owing to this arrangement, the interior of the long cylindrical nozzle 170 is vertically divided with the wafer 90 disposed therebetween. The internal spaces of the upper and lower nozzle parts 171, 172 are communicated with each other through the relief port 75a.

Then, the laser is irradiated to the outer peripheral part of the wafer 90 from the irradiation unit 22 in a converging manner so that the outer peripheral part of the wafer 90 is located heated, and the ozone coming from the ozonizer 70 is sent into the temporary reservoir space 171 a within the upper nozzle part 171 through the communication port 170a. By doing so, the film 92c coated on the outer peripheral part of the wafer 90 can efficiently be removed as in the case with the first embodiment. The gap formed between the edge of the notch 174 and the wafer 90 is very small. Moreover, the lower nozzle part 172 is sucked by the exhaust means. Accordingly, the gas can reliably be prevented from leaking through the very small gap between the edge of the notch 174 and the wafer 90. In addition, the reaction can efficiently be controlled. Furthermore, the processed gas and the reaction by-products are forcibly flowed to the lower nozzle part 172 through the relief port 75a so that they can be forcibly exhausted through the exhaust path 76Y. The generated particles, if any, can be forcibly exhausted through the exhaust path 76Y.

Two or more different kinds of films are, in some instance, laminated on the wafer 90. For example, as shown in FIG. 78(a), a film 94 composed of an inorganic matter such as SiO2 is coated on the wafer 90 and a film 92 composed of an organic matter such as photoresist is coated thereon. In that case, in addition to the reactive gas supplying means for removing the organic film 92 coated on the outer periphery of the substrate, another reactive gas supplying means may be provided in order to remove the inorganic film 94 coated on the outer periphery of the substrate.

That is, as shown in FIGS. 79 and 80, an apparatus for processing the outer periphery of a substrate for the use of a two-film laminated wafer is provided within a single atmospheric air pressure chamber 2, a single stage 10, a first processing head 100 of a reactive gas supplying means for removing an organic film, and a second processing head 200 (gas guide member) of a reactive gas supplying means for removing an inorganic film.

The first processing head 100 can be advanced and retreated by an advancing/retreating mechanism between a processing position (indicated by the imaginary line of FIGS. 79 and 80) extending along the outer peripheral surface of the stage 10 and thus, the wafer 90 and a retreating position (indicated by the solid line of FIGS. 79 and 80) located away radially outwardly from the processing position.

The construction of the first processing head 100 itself is same as the processing head 100 shown in FIGS. 47 and 48.

As indicated by the two-dot chain line in FIG. 80, the organic film processing head 100 is arranged in a position higher than the horizontal plane where the wafer 90 is to be arranged. It is also accepted that the organic film processing head 100 may be arranged in a position lower than the horizontal plane where the wafer 90 is to be arranged as indicated by the broken line in FIG. 80. This organic film processing head 100 has the same construction as the processing head 100 shown in FIGS. 41 through 44, as well as elsewhere. A pair of such organic film processing heads 100 may be arranged in a vertical relation with the above-mentioned horizontal plane disposed therebetween.

A second processing head 200 for an inorganic film is arranged 180 degrees away from the organic film processing head 100 in the peripheral direction of the stage 10.

The second processing head 200 can be advanced and retreated by an advancing/retreating mechanism between a processing position (indicated by the imaginary line of FIG. 80) extending along the outer peripheral part of the wafer 90 and a retreating position (indicated by the solid like in FIG. 80) located away radially outwardly from the wafer 90.

As shown in FIG. 81, the second processing head 200 has a generally arcuate configuration extending along the outer periphery of the wafer 90. As shown in FIG. 83, an insertion port 201 is formed in the peripheral side surface of the reduced-diameter side of the second processing head 200 in a cut-in fashion toward the interior of the second processing head 200. As shown in FIGS. 81 and 82, the insertion port 201 is extended over the entire length in the peripheral direction of the second processing head 200. The vertical thickness of the insertion port 201 is slightly larger than the thickness of the wafer 90. The outer peripheral part of the wafer 90 is inserted in and removed from the insertion port 201 in accordance with the advancing and retreating operation of the second processing head 200.

As shown in FIG. 83, the innermost end of the insertion port 201 is largely spread so as to serve as a second reaction gas guide path 202. As shown in FIG. 81, the guide path 202 is extended in the longitudinal direction (peripheral direction) of the second processing head 200. The guide path 202 has an arcuate configuration, in a plan view, having a radius of curvature almost same as the radius of the wafer 90. When the wafer 90 is inserted in the insertion port 201, the outer peripheral part of the wafer 90 is positioned within the guide path 202. As shown in FIG. 83, the sectional configuration of the guide path 202 is a genuine circle. It should be noted, however, that the sectional configuration of the guide path 202 is not limited to this. For example, it may be a semicircular configuration or a square configuration. Moreover, the flow path section area of the guide path 202 may be set to a proper size dimension.

The inorganic film removing reactive gas (second reactive gas) is reactable with an inorganic matter such as $SiO_2$. As an initial gas thereof, there can be used, for example, a hydrofluoric gas such as PFC gas such as $CF_4$ and $C_2F_6$ and an HFC such as $CHF_3$. As shown in FIG. 82, the hydrofluoric gas is introduced to an atmospheric pressure plasma discharge space 261 a between a pair of electrodes 261 of a hydrofluoric plasma discharge apparatus 260 as a second reactive gas generating source and plasmatized to obtain a second reactive gas containing a hydrofluoric active piece such as hydrofluoric radical. A second reactive gas supply path 262 is extended from the atmospheric pressure plasma discharge space 261a and connected to an introduction port 202a at one end part of the guide path 202 of the inorganic film processing head 200. A discharge path 263 is extended from a discharge port 202b a the other end part of the guide path 202 .
The inorganic film processing head 200 is composed of a fluorine-resistant material.

The unnecessary film composed of the organic film 92c and the inorganic film 92c coated on the outer periphery of the wafer 90 is removed in the following matter.

[Organic Film Removing Step]

First, the step for removing the organic film 92c coated on the outer peripheral part of the wafer 90 is executed. The processing heads 100, 200 are preliminarily retreated to the retreating position. Then, the wafer 90 to be processed is concentrically set onto the stage 10 by an alignment mechanism (not shown). Then, the organic film processing head 100 is advanced to the processing position. By doing so, the laser irradiation unit 22 is directed to a point P of the outer periphery of the wafer 90, and the jet nozzle 75 and the suction nozzle 76 are placed opposite to each other in the tangential direction of the wafer 90 with this place P disposed therebetween (see FIGS. 47 and 48). The inorganic film processing head 200 is directly preliminarily positioned in the retreating position.

Subsequently, the laser light source 21 is turned on so that the laser is locally heated to the point P of the outer peripheral part of the wafer 90 and the oxygen-based reactive gas such as ozone generated in the ozonizer 70 is jetted out through the jet nozzle 75 of the organic film processing head 100 and sprayed onto the target point P in a limited manner (see FIGS. 47 and 48). Owing to this arrangement, as shown in FIG. 78(b), the organic film 92c coated on the point P is oxide-reacted and etched (ashed). The processed gas containing the residue of the ashed organic film can rapidly be removed by sucking the gas through the suction nozzle 76.
Simultaneously, the part (main part) located inside the outer peripheral part of the wafer 90 is heat-absorbed and cooled by the stage 10. By doing so, the film coated on the part located inside the outer peripheral part of the wafer 90 can be prevented from being deteriorated in quality under the effect of heating, as previously mentioned.

The stage 10 is rotated once to plural times. By doing so, the organic film 92c coated on the outer peripheral part of the wafer 92 can be removed over the entire periphery, and the inorganic film 94c is exposed over the entire periphery.

[Inorganic Film Removing Step]

Then, the step for removing the inorganic film 94c coated on the outer peripheral part of the wafer 90 is carried out. At that time, the wafer 90 is kept set onto the stage 10. Then, the inorganic film processing head 200 is advanced and the outer peripheral part of the wafer 90 is inserted in the insertion port 201. By doing so, a part having a predetermined length of the outer peripheral part of the wafer 90 is enclosed by the guide path 202. By adjusting the inserting amount, the width (processing width) of the film 94c to be removed can easily be controlled.

Then, a fluoric gas such as $CF_4$ is supplied the interelectrode space 261 a of the hydrofluoric plasma discharge apparatus 260 and an electric field is incurred to the interelectrode space so that an atmospheric pressure glow discharge plasma is taken place. By doing so, the fluoric gas is activated and a hydrofluoric reactive gas composed of fluoric radical or the like is generated. This fluoric reactive gas is introduced to the guide path 202 of the inorganic film processing head 200 through the supply path 262 and then, flowed in the peripheral direction of the outer peripheral part of the wafer 90 along the guide path 202. By doing so, as shown in FIG. 78(c), the inorganic film 94c coated on the outer peripheral part of the wafer 90 can be etched and removed. In parallel, the stage 10 is rotated. By doing so, the inorganic film 94c coated on the outer peripheral part of the wafer 90 can be etched and removed over the entire periphery. The processed gas containing the by-products caused by etching is discharged through the discharge path 263. Since the insertion port 201 is reduced, the fluoric gas can be prevented from being dispersed to the part located inside the outer peripheral part of the wafer 90. In addition, by adjusting the flow rate of the fluoric reactive gas, the gas can more reliably be prevented from being dispersed to the portion located inside the outer peripheral part of the wafer 90.

The organic film processing head 100 may be retreated to the retreating position after the finish of the organic film removing step or before the start of the inorganic film removing step, or the organic film processing head 100 may be retreated after the finish of the inorganic film removing step. In case the organic film 92c can be removed by the first rotation of the stage 10, the inorganic may be removed simultaneously and in parallel with the organic film removing operation. A the time the inorganic film 94c begins to be partly exposed during the organic film removing step, the inorganic film removing step and the organic film removing step may be carried in parallel.

In case the inorganic film component is, for example, SiN or the like, by-products, which are in a solid state under normal temperature, such as $(NH_4) 2SiF_6$ and $NH_4F \cdot HF$ are generated by etching. Thus, it is accepted that the organic film processing head 100 is positioned in the processing position during the inorganic film removing step and laser irradiation to the outer peripheral part of the wafer 90 is continuously made by the laser heater 20. By doing so, the by-products, which are in the solid state under normal temperature can be evaporated. Moreover, the evaporated by-products can be sucked and discharged through the suction nozzle 76.

After the inorganic film removing step, the heads 100, 200 are retreated in the retreating position and the stage 1 is stopped rotating. Then, the chucking of the wafer 90 caused by the chuck mechanism within the stage 10 is canceled and the wafer 90 is carried out.

According to this removing method, the wafer 90 is continuously set onto the stage 10 during the entire period of the organic film removing step and the inorganic film removing step. Therefore, it is unnecessary to transfer the wafer 90 to other place at the time the organic film removing step is shifted to the inorganic film removing step and thus, the time required for transference can be eliminated. Moreover, particles are not generated, which would otherwise occur when the wafer 90 accidentally contacts the transferring cassette at the time of transferring the wafer 90. Moreover, no additional aligning operation is required. This makes it possible to reduce the entire processing time extensively, enhance the through-put and enable the high precision processing. In addition, the alignment mechanism 3 and the stage 10 can be used commonly. Thus, the apparatus can be simplified in structure and made compact in size. By installing a plurality of processing heads 100, 200 in a single common chamber 2, the apparatus can cope with various kinds of film. Moreover, the problem of cross contamination can also be avoided. Since the present invention relates to a normal pressure system, the driving part, etc. can easily be installed within the chamber 2.

In case there are laminated the organic film 92 and the inorganic film 94 in this order from below on the wafer 90, the inorganic film removing step is executed first and then, the organic film removing step is executed.

The separation angle between the organic film processing head 100 and the inorganic film processing head 200 is not limited to 180 degrees but it may be, for example, 120 degrees or 90 degrees.

The organic film processing head 100 and the inorganic film processing head 200 are satisfactory only if they are not interfered with each other when they are in the retreating positions and when the advancing/treating operation is made. It is also accepted that the processing positions are overlapped.

The organic film processing head 100 may be integrally mounted on the oxygen reactive gas generation source, and the inorganic film processing head 200 may be integrally mounted on the hydrofluoric reactive gas generation source.

The inventors carried out an etching experiment using the same second processing head (gas guide member) as one shown in FIGS. 81 through 83. As an object to be processed, a wafer having a diameter of 8 inches and a film of $SiO_2$ coated thereon was used. As a process gas, $CF_4$ was used. The flow rate was set to 100 cc / min. This process gas was plasmatized in the plasma generating space 261a and used it as a reactive gas. The reactive gas was then passed through the guide path 202 of the gas guide member 200. Then, unnecessary film was etched over the entire periphery of the outer peripheral part of the wafer.

The time required was 90 seconds and the quantity of processed gas was 150 cc.

(Comparative Example 1)

As a comparative example, by using an apparatus in which the gas guide member was eliminated and a reactive gas coming from a nozzle was directly jetted out in a spot-like manner, etching was carried out under the same conditions as in the embodiment 1. Time required was 20 minutes and the quantity of processed gas was 2 liters.
As a result, it became clear that owing to a provision of the gas guide member according to the present invention, both the time required and the quantity of processed gas were reduced extensively.

(Comparative Example 2)

A processing head having a double ring-like electrode structure and having a size corresponding to the outside diameter of the wafer was used, reactive gas was simultaneously jetted out from the entire periphery of a ring-like jet port having a generally same diameter as the outside diameter of the wafer, and etching was simultaneously carried out over the entire periphery of the outer peripheral part of the wafer. The flow rate of the process gas was 4 liters / min. All the other conditions were same as those in the embodiment 1. The time required was 30 seconds and the quantity of processed gas was 2 liters.
As a result, according to the present invention, it became clear that the time required was almost no change from the apparatus in which the entire periphery was simultaneously processed and in addition, the quantity of processed gas can be reduced extensively.

Moreover, the inventors carried out the respective processing using the same sample and apparatus as in the above-mentioned case and setting the speed of rotation of the wafer to 50 rpm and 300 rpm. Then, the film thickness vs. the radial position in the radial direction of the wafer was measured. The result is shown in FIG. 84. In FIG. 84, the horizontal axis shows the distance from the outer end part of the wafer to the radially inward position. When the speed of rotation was 50 rpm, the processing width was in the range of from the outer end part of the wafer to about 1.6 mm. In contrast, when the speed of rotation was 300 rpm, the processing width was reduced to the range of from the outer end part to about 1.0 mm. It became clear from the foregoing that the more increased the speed of rotation is, the reactive gas can be more restrained in dispersion in the radially inward direction and the processing width can be controlled in accordance with the speed of rotation.

FIG. 85 shows another modified embodiment of the apparatus for removing a laminated film. In this modified embodiment, the organic film removing oxygen reactive gas and the inorganic film removing fluoric reactive gas are generated by a common plasma discharge apparatus 270. Oxygen ($O_2$) is used as the initial gas of the organic film removing reactive gas. Fluoric gas such as $CF_4$ is used as the initial gas of the inorganic film removing reactive gas. Initial gas supply paths 273, 274 extending from the respective initial gas sources are converged and extended to an atmospheric pressure discharge space 271 a formed between a pair of electrodes 271 of the common plasma discharge apparatus 270. Stop valves 273V, 274V are provided to the initial gas supply paths 273, 274, respectively.

A reactive gas supply path 275 extending from the common plasma discharge apparatus 270 is divided into two paths, i.e., an oxygen reactive gas supply path 277 and a fluoric reactive gas supply path 278 through a three-way valve 276. The oxygen reactive gas supply path 277 is connected to the jet nozzle 75 of the organic film processing head 100. The fluoric reactive gas supply path 278 is connected to the upstream end of the guide path 202 of the inorganic film processing head 200.

In the organic film removing step, the stop valve 274V of the fluoric initial gas supply path 274 is closed, while the stop valve 273V of the oxygen initial gas supply path 273 is opened. By doing so, the initial gas such as $O_2$ is introduced into the discharge space 271a of the plasma discharge apparatus 270 and activated to generate an oxygen reactive gas such as oxygen radical and ozone. The common reactive gas supply path 275 extending from the plasma discharge apparatus 270 is connected to the oxygen reactive gas supply path 277 through a three-way valve 276. Owing to this arrangement, the oxygen reactive gas such as ozone is introduced into the jet nozzle 75 of the organic film processing head 100, so that the organic film 92c coated on the outer peripheral part of the wafer 90 can be removed by ashing.

In the inorganic film removing step, the stop valve 273V of the oxygen initial gas supply path 273 is closed, while the stop valve 274V of the fluoric initial gas supply path 274 is opened. By doing so, the fluoric initial gas such as $CF_4$ is introduced to the plasma discharge apparatus 270 and plasmatized so that a fluoric reactive gas such as F* is generated. The common reactive gas supply path 275 extending from the plasma discharge apparatus 270 is connected to the fluoric gas supply path 278 through the three-way valve 276. Owing to this arrangement, a fluoric reactive gas such as F* is introduced into the guide path 202 of the inorganic film processing head 200 and flowed in the peripheral direction of the wafer, so that the inorganic film 94c coated on the outer peripheral part of the wafer 90 can be removed by etching.

FIG. 86 shows a modified example of the above-mentioned laminated film removing apparatus. A stage 10 according to this modified example includes an enlarged-diameter stage main body 110 (first stage part) and a reduced-diameter center pad 111 (second stage part). The stage main body 110 has a disc-like configuration slightly smaller in diameter than the wafer 90. The stage main body 110 is provided therein with a heat absorbing means such as the refrigerant chamber 41. A receiving recess 110a is formed in the central part of the upper surface of the stage main body 110.

The center pad 111 has a disc-like configuration having a quite smaller diameter than the stage main body 110. The center pad 111 is coaxially arranged with the stage main body 110.

Though not shown, the stage main body 110 and the center pad 111 are provided at their upper surfaces with suction grooves for sucking the wafer 90, respectively.

A pad shaft 112 coaxial with the stage main body 110 and the center pad 111 is arranged below the center pad 111. The center pad 111 is connected to and supported by the upper end part of the pad shaft 112. The pad shaft 112 is connected with a pad drive unit 113.

The pad drive unit 113 is provided with a lift drive system for lifting the pad shaft 112 upward and downward. The pad shaft 112 and thus, the center pad 111 is caused to move upward and downward (advance and retreat) between a projecting position (FIG. 86(b)) where the pad shaft 112 and thus, the center pad 111 is projected upward of the stage main body 110 and a receiving position (FIG. 86(a)) where the pad shaft 112 and thus, the center pad 111 is received in the receiving recess 110a of the stage main body 110. It is also accepted that the center pad 111 is fixed and the stage main body 110 is connected to the pad drive unit 113, and the center pad 111 is lifted upward and downward in that condition, so the center pad 111 is projected and received. The upper surface of the center pad 111 located in the receiving position is flush with the upper surface of the stage main body 110. However, the upper surface of the center pad 111 located in the receiving position may be lower than the upper surface of the stage main body 110.

The pad drive unit 113 is provided with a rotation drive system for rotating the pad shaft 112 and thus, the center pad 111.

Though not shown, the stage main body 110 and the center pad 111 are provided therein with chucking mechanisms for chucking the wafer 9, respectively.

The heat absorbing means of the cooling chamber 41, etc., is provided only on the stage main body 110 and not provided on the center pad 111. However, the heat absorbing means may also be provided on the center pad 111.

The inorganic film processing head 200 is located in a position equal in height to the upper surface of the center pad 111 located in the projecting position. In that heightwise position, the inorganic film processing head 200 is advanceable and retreatable between the processing position (indicated by the imaginary line of FIGS. 1 and 2) approaching the center pad 111 and the retreating position (indicated by the solid line of FIGS. 1 and 2) departing from the center pad 111.

As shown in FIG. 86(a), in the organic film removing step, the cooling means is actuated with the center pad 111 located in the receiving position, and the processing operation is carried out by the organic film processing head 100 while integrally rotating the stage main body 110 and the center pad 111 about a co-axis.

As shown in FIG. 86(b), after the finish of the organic film removing step, the organic film processing head 100 is retreated to the retreating position. Then, the center pad 111 is lifted upward to bring the center pad 111 in the projecting position by the pad drive unit 113. By doing so, the wafer 90 can be brought to a position higher than the stage main body 110.

Then, the inorganic film processing head 200 is advanced from the retreating position (indicated by the imaginary line of FIG. 86(b)) to the processing position (indicated by the solid line of FIG. 86(b)) and the inorganic film removing step is executed. Since the wafer 90 is located in a position separated upwardly from the stage main body 110, the outer peripheral par of the stage main body 110 can be prevented from being interfered with the lower part of the inorganic film processing head 200. Thus, the depth along the radial direction of the wafer 90 of the insertion port 201 can be increased. Owing to this arrangement, the second reactive gas can more reliably be prevented from dispersing to the inner part of the wafer 90.

On the other hand, the diameter of the stage main body 110 can fully be increased and the wafer 90 can reliably be cooled upto the vicinity of the outer peripheral part of the wafer 90 by the heat absorbing means. As a result, the quality of film coated on the part located inside the outer peripheral part of the wafer 90 can more reliably be prevented from being damaged.

In this inorganic film removing step, only the center pad 111 may be rotated. By doing so, the inorganic film coated on the outer peripheral part of the wafer 90 can be removed by etching over the entire periphery.

FIG. 87 shows a modified example of a stage structure with a center pad.

An annular cooling chamber 41C is formed within the stage main body 110 as a heat absorbing means. The annular cooling chamber 41C constitutes a positive pressure fluid terminal for applying a cold to the wafer 90. Instead of the annular cooling chamber 41 Instead of the annular cooling chamber 41C, a cooling path having a concentric multi-circular configuration, a radial configuration, a spiral configuration, or the like may be formed in the stage main body 110.

A suction groove 15 for sucking the wafer 90 is formed in the upper surface of the stage main body 110. The suction groove 15 constitutes a negative pressure fluid terminal for applying a suction force to the wafer 90.

Though not shown, the center pad 111 is also provided at the upper surface with a suction groove for sucking the wafer 90. A suction path extending from this suction groove is passed through the pad shaft 112.

The center pad 111 is advanced and retreated upwardly and downwardly (lifted upwardly and downwardly) by the lift drive system of the pad drive unit 113 between a projecting position indicated by the imaginary line of FIG. 87 and the receiving position indicated by the solid line of FIG. 87. The center pad 111 located in the receiving position is fully received in the recess 110a formed in the stage main body 110 and the upper surface of the center pad 111 is slightly (several mm) retreated below from the upper surface of the stage main body 110.

The pad shaft 112 is passed through a rotary cylinder 150 coaxial with the shaft 112 such that the shaft 112 is liftable upwardly and downwardly and rotatable.
The important part of the rotary cylinder 150 has a cylindrical configuration having a uniform thickness over the entire periphery and is extended vertically. The upper end part of the rotary cylinder 150 connected and fixed to the stage main body 110. The lower end part of the rotary cylinder 150 is connected to a rotation drive motor 140 (rotation driver) via a pulley 144, a timing belt 143, a pulley 142 and a reduction gear 141 in order. The rotary cylinder 150 is rotated by the rotation drive motor 140 and thus, the stage main body 110 is rotated.

The rotary cylinder 150 is passed through and supported on the interior of a stationary cylinder 180 through a bearing B.
The fixed shaft 180 has a vertical cylindrical configuration coaxial with the rotary cylinder 150 and the pad shaft 112. The fixed shaft 180 is fixed to an apparatus frame F. The fixed shaft 180 is acceptable inasmuch as at least the inner peripheral surface has a circular configuration in section. The stationary cylinder 180 is lower than the rotary cylinder 150. The upper end part of the rotary cylinder 150 is projected from the stationary cylinder 180 and the stage main body 110 is arranged on the top thereof.

The rotary cylinder 150 and the stationary cylinder 180 are provided with a cooling flow path serving the annular cooling chamber 41 C of the stage main body 110 as a terminal and a suction flow path serving the suction groove 15 as a terminal.

A forward path of the cooling flow path is constructed in the following manner.
As shown in FIGS. 87, 88 and 89(c), a cooling water port 181a is formed in the outer peripheral surface of the stationary cylinder 180. A cooling forward path tube 191 is extended from a cooling water supply source not shown and connected to the port 181a. A communication path 181b is extended radially inwardly of the stationary cylinder 180 from the port 181 a. As shown in FIG. 89(c), an annular path 181 c extending over the entire periphery is formed in the inner peripheral surface of the stationary cylinder 180. The communication path 181 b is connected to a single place in the peripheral direction of the annular path 181c.

As shown in FIGS. 87 and 88, annular seal grooves 112d are formed on both upper and lower sides of the annular path 181c of the inner peripheral surface of the stationary cylinders 180. As shown in FIG. 88, an annular cooling forward path gasket G1 is received in each of the annular seal groove 112d. The gasket G1 has a U-shaped configuration (C-shaped) in section. An opening of the gasket G1 is directed to the annular path 181 c side. Lubrication treatment is preferably applied to the outer peripheral surface of the gasket G1.

As shown in FIGS. 87 and 88, an axial path 151a extending vertically straightly is formed in the rotary cylinder 150. As shown in FIGS. 88 and 89(c), the lower end part of the axial path 151 a is open to the outer peripheral surface of the rotary cylinder 150 through a communication path 151 b. The communication path 151 b is located in a position same in height as the annular path 181c and communicated with the annular path 181c. Although the communication path 151b is shifted in position in the peripheral direction in accordance with rotation of the rotary cylinder 150 but it always keeps its communication state with the annular path 181c over 360 degrees.

As shown in FIG. 87, the upper end part of the axial path 151 a is connected to an external relay tube 157 through a connectorI54 on the outer peripheral surface of the rotary cylinder 150. This relay tube 157 is connected to an annular cooling chamber 41C through a connector 197 on the lower surface of the stage main body 110.

The backward path of the cooling flow path is constructed in the following manner.
As shown in FIG. 87, the stage body 110 is provided at the lower surface with a connector 198 arranged on the 180 degrees opposite side of the forward path connector 197. The annular cooling chamber 41 C of the stage main body 110 is connected to an external relay tube 158 through the connector 198. The relay tube 158 is connected to a connector 155 arranged on the outer periphery of the upper part of the rotary cylinder 150.

As shown in FIG. 87, an axial path 152a extending vertically straightly is formed on the rotary cylinder 150. As shown in FIG. 89(b), the axial path 152a is arranged on the 180 degrees opposite side of the forward axial path 151 a. The upper end part of the axial path 152a is connected to the connector 155.
As shown in FIGS. 87 and 89(b), the lower end part of the axial path 152a is open to the outer peripheral surface of the rotary cylinder 150 through a communication path 152b. The communication path 152b is arranged on the 180 degrees opposite side of the forward communication path 151b and on the upper side of the communication path 151b. The communication path 152b is rotated about the center axis together with the axial path 152a in accordance with rotation of the rotary cylinder 150.

A groove-like annular path 182c is formed in the inner peripheral surface of the stationary cylinder 180 over the entire periphery. This annular path 182c is located in a position higher than the forward annular path 181 c but same in height as the communication path 152b. The annular path 182c is connected to a point in the peripheral direction of the communication path 152b. Although the communication path 152b is shifted in position in the peripheral direction in accordance with rotation of the rotary cylinder 150 but it always keeps the communication state with the annular path 182c over 360 degrees.

As shown in FIGS. 87 and 88, cooling backward path annular seal grooves182d are formed on both upper and lower sides of the annular path 182c of the inner peripheral surface of the stationary cylinders 180. As shown in FIG. 88, an annular cooling backward path gasket G2 is received in each of the seal groove 182d. The gasket G2 has a U-shaped (C-shaped) configuration in section and its opening is directed to the annular path 182c side. A lubrication treatment is preferably applied to the outer peripheral surface of the gasket G2.

As shown in FIGS. 87, 88 and 89(c), a communication path 182b extending radially outwardly from the annular path 182c and a water discharge port 182a connected to the communication path 182b are formed in the stationary cylinder 180. The port 182a is open to the outer peripheral surface of the stationary cylinder 180. A cooling backward path tube 192 is extended from this port 182a. The communication path 182b and the port 182a are arranged in the same peripheral position as the forward communication path 181b and the port 181a but higher than them.

The suction flow path is constructed in the following manner.

As shown in FIGS. 87, 88 and 89(a), a suction port 183a is formed on an upper side of the backward path port 182a in the outer peripheral surface of the stationary cylinder 180. A suction tube 193 is extended from a suction source including a vacuum pump, etc., not shown and connected to the port 183a. A communication path 183b is extended radially inwardly of the stationary cylinder 180 from the port 183a.

As shown in FIG. 89(a), a groove-like suction annular path 183c is formed in the inner peripheral surface of the stationary cylinder 180 over the entire periphery. A communication path 183b is connected to a single place in the peripheral direction of the annular path 183c.

As shown in FIGS. 87 and 88, suction annular seal grooves 183d are formed on both upper and lower sides of the annular path 183c of the inner peripheral surface of the stationary cylinders 180. As shown in FIG. 88, an annular suction gasket G3 is received in each of the seal groove 183d. The gasket G3 has the same U-shaped (C-shaped) configuration in section as in the case with the cooling forward and backward path gaskets G1, G2 but the gasket G3 is directed differently from the gaskets G1, G2. The opening of the gasket G3 is directed to the opposite side of the annular path 183c. A lubrication treatment is preferably applied to the outer peripheral surface of the gasket G3.

As shown in FIG. 87, a suction axial path 153a extending vertically straightly is formed in the rotary cylinder 150. As shown in FIG. 89(a), the lower end part of the axial path 153a is open to the outer peripheral surface of the rotary cylinder 150 through the communication path 153b. The communication path 153b is located in a position same in height as the annular path 183c and communicated with the suction annular path 183c. Although the communication path 153b is shifted in position in the peripheral direction in accordance with rotation of the rotary cylinder 150, but it always keeps the communication state with the suction annular path 183c over 360 degrees.

The axial path 153a and the communication path 153b are arranged in position 90 degrees deviated in the peripheral direction with respect to the axial paths 151 a, 152a of the cooling forward and backward paths.

As shown in FIG. 87, the upper end part of the axial path 153a is connected to an external relay tube 159 through a connector 156 on the outer peripheral surface of the rotary cylinder 150 through a connector 156. This relay tube 159 is connected to the suction groove 15 through a connector 199 on the lower surface of the stage main body 110.

Operation for removing the unnecessary films 94c, 92c coated on the outer periphery of the wafer 90 using the apparatus of FIGS. 87 through 89 will now be described.

The wafer 90 to be processed is picked up from a cassette by a fork-like robot arm not shown and aligned (centrically arranged) by the alignment mechanism. After alignment, the wafer 90 is horizontally lifted up by the fork-like robot arm and placed on a center pad 111 which is preliminarily located in the projecting position (indicated by the imaginary line of FIG. 87). Since the center pad 111 is smaller enough in diameter than the wafer 90, a sufficient margin of the fork-like robot arm can be obtained. After the wafer 90 is placed on the center pad 111, the fork-like robot arm is retreated. The suction mechanism for the center pad 111 is actuated to chuck the wafer 90 to the center pad 111.

Then, the center pad 111 is lifted downward by the lift drive system of the pad drive unit 113 until the upper surface of the center pad 111 is brought to be flush with the stage 10. By doing so, the wafer 90 is abutted with the upper surface of the stage 10. Then, the chucking of the wafer 90 by the center pad 111 is released and the center pad 111 is further lifted downward by several mm so that the pad 111 is brought to the receiving position (indicated by the solid line of FIG. 87). Subsequently, a suction source such as a vacuum pump or the like is actuated so that the suction pressure is introduced to the chuck groove 15 via the suction tube 193, the port 183a, the communication path 183b, the annular path 183c, the communication path 153b, the axial path 153a, the connector 156, the relay tube 159 and the connector 199 in order. By doing so, the wafer 90 can be chucked to the stage 10 and reliably retained thereon. Then, the rotation drive motor 140 is driven to integrally rotate the rotary cylinder 150 and the stage 10 and thus, rotate the wafer 90. By doing so, although the communication path 153b formed within the rotary cylinder 150 is rotationally moved in the peripheral direction of the annular path 183c of the stationary cylinder 180, the communication state between the communication path 153b and the annular path 183c is always maintained. Therefore, the chucking state of the wafer 90 can be maintained even at the time of rotation.

As shown on an enlarged scale in FIG. 88, the suction pressure of the suction flow path is also acted on a space between the inner peripheral surface of the seal groove 183d and the gasket groove G3 via a clearance formed between the outer peripheral surface of the rotary cylinder 150 and the inner peripheral surface of the stationary cylinder 180 from the communication part between the communication path 153b and the annular path 183c. This suction pressure acts in the direction for spreading the U-shaped gasket G3 in section. Therefore, the larger the suction pressure is, the more strongly the gasket G3 is pressed against the inner peripheral surface of the seal groove 183d so that the seal pressure is increased. Owing to this arrangement, leakage can reliably be prevented from occurring through the clearance formed between the outer peripheral surface of the rotary cylinder 150 and the inner peripheral surface of the stationary cylinder 180.

Almost at the time for starting rotation of the stage 10, the organic film processing head 100 is advanced to the processing position (indicated by the solid line of FIGS. 1 and 87) from the retreating position (indicated by the imaginary line of FIGS. 1 and 87). Then, the laser coming from the laser irradiation device 20 is irradiated to a single place of the outer peripheral part of the wafer 90 in a converging manner so that the outer peripheral part of the wafer 90 is locally heated. Then, a reactive gas such as ozone is jetted out through the jet nozzle 75 and contacted with the locally heated place of the outer periphery of the wafer 90. By doing so, as shown in FIG. 5(b), the organic film 92c coated on the outer periphery can efficiently be removed by etching. The processed gas and the by-products are sucked by the suction nozzle 76 and exhausted.

At this time for removing the organic film, a cooling water is supplied to the annular cooling chamber 41C of the stage main body 110. That is, the cooling water coming from the cooling water supply source is supplied to the annular cooling chamber 41C via the forward path tube 191, the port 181a, the communication path 181b, the annular path 181 c, the communication path 151b, the axial path 151 a, the connector 154, the relay tube 157, and the connector 197 in order. By doing so, the stage main body 110 and the part located inside the outer peripheral part of the wafer 90 located thereon can be cooled. Even if heat caused by the laser irradiation should be conducted to inside the radius from the outer peripheral part of the wafer 90, the heat could rapidly be absorbed. Thus, the part located inside the outer peripheral part of the wafer 90 can be prevented from being increased in temperature. Owing to this arrangement, the films 94, 92 coated on the part located inside the outer peripheral part of the wafer 90 can be prevented from being damaged.

After flowing through the annular cooing chamber 41 C, the cooling water is discharged through the cooling backward path tube 192 via the connector 198, the relay tube 158, the connector 155, the axial path 152a, the communication path 152b, the annular path 182c, the communication path 152b, the annular path 182c, the communication path 182b, and the port 182a in order.

The communication path 151 b within the rotary cylinder 150 is also rotated by rotation of the stage 10 in the peripheral direction of the annular path 181 c, but the communication path 151b always keeps its communication state with the annular path 181c irrespective of the rotation position. Likewise, the communication path 152b is also rotated in the peripheral direction of the annular path 182c, but its communication state with the annular path 181c is always maintained. Owing to this arrangement, the cooling water is kept flowing even during rotation of the stage 10.

As shown on the enlarged scale in FIG. 88, the cooling water in the cooling forward path is also flowed into the annular seal groove 112d from the communication part between the communication path 151 b and the annular path 181 c via the clearance formed between the outer peripheral surfaces of the upper and lower rotary cylinders 150 and the inner peripheral surface of the stationary cylinder 180. The cooling water is also flowed into the opening of the gasket G1 having a U-shaped configuration in section. The gasket G1 is spread by pressure of the cooling water and pressed against the inner peripheral surface of the seal groove 112d. This makes it possible to obtain the seal pressure reliably and prevent the cooling water from leaking. The same action can also be obtained in the gasket G2 of the cooling backward path.

The organic film 92c coated on the entire periphery of the outer periphery of the wafer 90 can be removed by at least one rotation of the stage 10.

When the removing operation of the organic film 92c is finished, the jet-out of gas through the jet nozzle 75 and the suction of gas through the suction nozzle 76 are stopped and the organic film processing head 100 is retreated to the retreating position.

The center pad 111 is lightly lifted upwardly by the lift drive system of the pad drive unit 113 so that the center pad 111 is abutted with the under surface of the wafer 90 for absorption. On the other hand, the absorption of the wafer 90 by the stage main body 110 is canceled. Then, the center pad 111 is lifted upwardly to the projecting position by the lift drive system.

Subsequently, the inorganic film processing head 200 is advanced to the processing position (indicated by the imaginary line of FIGS. 1 and 87) from the retreating position (indicated by the solid line of FIGS. 1 and 87). By doing so, the wafer 90 is inserted into the insertion port 201 of the inorganic film processing head 200 and the outer peripheral part of the wafer 90 is positioned within the guide path 202. Since the wafer 90 is lifted by the center pad 111, the inorganic film processing head 200 can be separated upwardly from the stage main body 110 and thus, the head 200 can be prevented from being interfered with the stage main body 110.

The gas in accordance with the components of the inorganic film 94 such as nitrogen, oxygen and fluorine is plasmatized and the plasmatized gas is introduced to one end part in the extending direction of the guide path 202. While passing through the guide path 202, this plasmatized gas is reacted with the inorganic film 94c coated on the outer peripheral part of the wafer 90. By doing so, as shown in FIG. 5(c), the inorganic film 94c can be removed by etching. The processed gas and the by-products are discharged from the other end of the guide path 202 via an exhaust path not shown.

In parallel, the center pad 111 is rotated by the rotation drive system of the pad drive unit 113. The inorganic film 94c coated on the entire periphery of the outer periphery of the wafer 90 can be removed by at least one rotation of the center pad 111.

When the removal of the inorganic film 92c is finished, the supply of plasma from the plasma discharge apparatus is stopped and the inorganic film processing head 200 is retreated to the retreating position. Then, the fork-like robot arm is inserted between the wafer 90 and the stage 10. This fork-like robot arm is abutted with the lower surface of the wafer 90 located outside the radius of the center pad 111 and absorption of the center pad 111 is canceled. This makes it possible to transfer the wafer 90 onto the fork-like robot arm and carry the wafer 90 out.

According to the stage construction of this surface processing apparatus, since the cooling flow path and the suction flow path of the stage main body 110 can be arranged in such a manner as to be separated in the radial direction from the center axis Lc, a sufficiently large space can be obtained in the central part for arranging the mechanism for lifting and rotating the center pad 111 and the suction flow path directing to the center pad 111.

The above stage construction can also be applied to one which is designed for removing only one kind of film such as an organic film. In that case, the inorganic processing head 200 is, of course, not required. The rotation drive system for the center pad 111 is not required, either.

The groove-like annular path 181 c, 182c, 183c may be formed in the outer surface of the rotary cylinder 150 instead of the inner peripheral surface of the stationary cylinder 180.

FIG. 90 shows a modified example of the second processing head 200. This second processing head 200 (gas guide member) is integrally connected with a plasma discharge apparatus 260 for generating a reactive gas.

The plasma discharge apparatus 260 includes a hot electrode 261H connected to a power source and an earth electrode 261E grounded to the earth. A space formed between those electrodes 261H and 261E serves as a space 261 a for generating a generally normal pressure plasma. This plasma gas generating space 261a allows a process gas such as, for example, nitrogen, oxygen, fluoric gas, chloride gas, or mixed gas thereof to be introduced and plasmatized therein.

A gas converging nozzle 263 is provided in a position lower than the electrodes 261H, 261E of the plasma discharge apparatus 260. This gas converging nozzle 263 is fixed to the upper surface of the second processing head 200 (gas guide member). A gas converging path 263a is formed in the gas converging nozzle 263. The gas converging path 263a is connected to the downstream end of the plasma generating space 261 a and reduced in diameter toward downward therefrom.

The lower end part of the gas converging path 263a is connected to an introduction port 202a of the upstream end of the guide port 202.

The arc length (length to be extended along the peripheral direction of the wafer 90) of the gas guide member 200 is preferably properly set taking into consideration of the life of the active pieces, etc. For example, the gas guide member 200 shown in FIG. 91 has a center angle of about 90 degrees in length. The gas guide member 200 shown in FIG. 92 has a center angle of about 180 degrees in length. The gas guide member 200 has a center angle of about 45 degrees in arc length.

The position of the introduction port 202a of the gas guide member 200 is not limited to the upper part of the guide path 202. As shown in FIG. 94(a), it may be arranged on the outer peripheral side of the guide path 202. This arrangement is suitable when the film coated on the outer end face of the wafer 90 is to be removed primarily.

As shown in FIG. 94(b), the introduction port 202a may be arranged on the lower side of the guide path 202. This arrangement is suitable when the film coated on the reverse surface of the outer peripheral part of the wafer 90 is to be removed primarily.

The introduction port 202a may be provided to the side end face of the gas guide member 200.

Similarly, the discharge port 202b may be provided to the side end face, the upper surface, the lower surface or the outer peripheral surface of the gas guide member 200.

The sectional configuration and the size of the guide path 202 of the gas guide member 200 can properly be set in accordance with the processing region where the unnecessary matter it to be removed, film kind, the quantity of gas to be supplied, the processing purpose and the like.

For example, as shown in FIG. 94(c), the section of the guide path 202 may be reduced. By doing so, the processing width can be reduced.

As shown in FIG. 94(d), it is also accepted that the guide path 202 has an upper half-shaped sectional configuration so that the reverse surface of the wafer 90 is proximate to the flat surface of the guide path 202. Owing to this arrangement, the outer peripheral part of the upper surface of the wafer 90 can be processed primarily. Although not show, it is also accepted that the guide path 202 has a lower half-shaped sectional configuration so that the upper surface of the wafer 90 is proximate to the upper bottom surface of guide path 202. By doing so, the reverse surface of the wafer 90 can be processed primarily.

As shown in FIG. 94(e), the guide path 202 may have a square-shaped sectional configuration.

The gas guide member 200 is not limited to one for removing the inorganic film which requires no heating but it likewise be applicable to one for removing the organic film which requires heating. In that case, as shown in FIG. 95, a radiant heating means such as a laser heater 20 may be attached to the gas guide member 200.

The irradiation unit 22 (irradiator) is fixed to the upper surface of the gas guide member 200 with the axis directing vertically. The optical fiber cable 23 is extended from the laser light source 21 of the laser heater 20 and optically connected to the laser irradiation unit 22.

The laser irradiation unit 22 is arranged near the end part on the introduction port 202a side of the gas guide member 200.

As shown in FIG. 26, a hole part 203 having a circular section is formed in the upper part of the gas guide member 200 in the attachment position of the laser irradiation unit 22. The upper end part of the hoe part 203 is open to the upper surface of the guide member 200 and the lower end part is communicated with the upper end part of the guide path 202.

A circular columnar light transmissive member 204 is embedded in the hole part 203. The light transmissive member 204 is composed of a transparent material having a high light transmission property such as quartz glass. The light transmissive member 204 preferably has a good resistance against the reactive gas such as ozone resisting property. As the material for the light transmissive member 204, resin having a good transparency such as, in addition to quartz glass, boro-silicate glass and other general purpose glass, polycarbonate, acryl and the like may be used. For example, the fact that quartz glass has an excellent light transmission property is already confirmed as per FIG. 69 and the experiment of table 1.

The upper end face of the light transmissive member 204 is exposed in such a manner as to be flush with the upper surface of the gas guide member 200. The lower end face of the light transmissive member 204 is faced with the upper end part of the guide path 202.

The laser irradiation unit 22 is positioned just above the light transmissive material 204, and an outgoing window at the lower end of the laser irradiation unit 22 is opposite to the light transmissive member 204. The laser irradiation unit 22 and the light transmissive member 204 are arranged such that their center lines are aligned.

The laser irradiated to right under from the laser irradiation unit 22 in a converging manner is transmitted through the light transmissive member 204 and focused on the interior of the guide path 202.

An ozonizer 70 is connected to the introduction port 202a of the gas guide member 200 as a reactive gas supply source. An oxygen plasma apparatus may be used instead of the ozonizer 70.

The flowing direction (indicated by the arrows of FIG. 95) of the stage 10 and thus, the wafer 90 is coincident with the flowing direction of the gas within the guide path 202.

According to the apparatus construction, the laser coming from the laser light source 21 is irradiated just under from the irradiation unit 22 via the optical fiber cable 23 in a converging manner. This laser is transmitted through the light transmissive member 204 and entered into the guide path 202 so as to locally hit one place of the outer peripheral part of the wafer 90 within this guide path 202. By doing so, the outer peripheral part of the wafer 90 is locally heated. In parallel, the ozone coming from the ozonizer 70 is introduced to the guide path 202 from the introduction port 202a. This ozone is contacted with the locally heated place. By doing so, the unnecessary film such as organic film which requires heating can be removed efficiently.

Moreover, the outer peripheral part of the wafer 90 is heated at a position near the upstream side of the guide path 202. Owing to this arrangement, the film can be reacted with a sufficient quantity of fresh ozone gas. Thereafter, the above-mentioned heated place is moved toward the downstream side of the guide path 202 in accordance with rotation of the stage 10 and during this downward movement, the heated place keeps high temperature for a while.

Therefore, not only at the upstream side part of the guide path 30, but also at the intermediate part and the downstream side part, a fully amount of reaction can be taken place. This makes it possible to reliably enhance the processing efficiency. In case the film coated on the reverse surface side is to be mainly removed, the laser irradiation unit 22 is preferably provided to a lower side of the gas guide member 200, so that laser can be irradiated to the guide path 202 from thereunder in a converging manner.

FIG. 97 shows an embodiment equipped with a mechanism corresponding to such a cutout part as a notch and an orientation flat of the wafer.

As shown in FIG. 101, the wafer has a disc-like configuration. There are many standards in size (radius) of the wafer 90. A part of the circular outer peripheral part 91 of the wafer 90 is cut out flatwise and an orientation flat 93 is formed as a cutout part. The size of the orientation flat 93 is established by standards of SEMI, JEIDA, etc. For example, in case a wafer has the radius r =100mm, its orientation flat length L93 is 55 mm to 60 mm. Therefore, the distance d from the central part of the orientation flat 93 to the imaginary outer edge of the wafer on the presumption that there is no provision of the orientation flat 93 is d = 3.8 mm to 4.6 mm.

At the time of forming film on the wafer 90, the film 92 is sometimes formed on the edge of the orientation flat 93.

As shown in FIG. 98, the wafer processing apparatus of this embodiment comprises a cassette 310, a robot arm 320, an alignment part 330 and a processing part 340. A wafer 90 to be processed is received in the cassette 310. The robot arm 320 picks up (FIG. 98(a)) the wafer 90 from the cassette 310, transfers the wafer 90 to the processing part 340 (FIG. 98(C)) via the alignment part 330 (FIG. 98(b)), and returns the processed wafer 90, not shown, to the cassette 310.

The alignment part 330 is provided with an alignment unit 331 and an alignment stage 332. As shown in FIG. 98(a), the alignment stage 332 has a disc-like configuration and rotatable about the center axis. As shown in FIG. 98 (b), the wafer 90 is temporarily placed on the alignment stage 332 for the purpose of alignment.

Although not shown in detail, the alignment unit 331 is provided with an optical type non-contact sensor. For example, this non-contact sensor comprises a light projector for outputting laser and a light receiver for receiving the laser. The light projector and the light receiver are arranged in such a manner as to vertically sandwich the outer peripheral part 90a of the wafer 90 placed on the alignment stage 332. The laser light projected from the light projector is blocked at a rate corresponding to the amount of projection of the outer peripheral part of the wafer 90 and thus, the amount of light received by the light receiver is changed. Based on it, the amount of deviation of the wafer can be detected. Moreover, by measuring the place where the amount of received light is discontinuously abruptly changed, the orientation flat 93 (cutout part) can also be detected.

The alignment unit 331 constitutes not only the deviation detecting part of the wafer 90 but also the "cutout detecting part" for detecting the orientation flat 93 (cutout part).

The "alignment mechanism" is constituted by the alignment part 330 and the robot arm 320.

As shown in FIG. 97, the wafer processing apparatus is provided with a processing stage 10 and a processing head 370. The processing stage 10 is rotatable about a vertical axis (rotation axis, center axis). An encoder motor 342 is used as a rotation drive part. The wafer 90 aligned by the alignment part 330 is ready to be set onto the upper surface of the processing stage 10.

As shown in FIGS. 97 and 98(c), the processing head 370 is arranged on a y-axis (first axis) orthogonal to z-axis. Of course, the y-axis is extended along the radial direction of the processing stage 10.

As shown in FIG. 97, a supply nozzle 375 opening like a spot-like manner is provided to the lower end part of the processing head 370. As shown in FIG. 99, the spot-like opening of this supply nozzle 375 is arranged just on the y-axis. As shown in FIG. 97, the basal end part of the supply nozzle 375 is connected to the ozonizer 70 (processing fluid supply source) through the fluid supply tube 71.

A plasma processing head including a pair of electrodes may be used as the processing fluid supply source. Instead of the dry system as the ozonizer and the plasma processing apparatus, a wet system for jetting out a chemical liquid through the supply nozzle 375 may be used as a processing fluid.

Although not shown, the processing head 370 of the dry system is provided with a suction nozzle for sucking a processed fluid (by-products, etc. are included) in the vicinity of the supply nozzle 375.

The processing head 370 is connected to a nozzle position adjusting mechanism 346. The nozzle position adjusting mechanism includes a servo motor, a direct driver and the like. The nozzle head adjusting mechanism is operated to adjust the nozzle position by sliding the processing head 370 and thus, the supply nozzle 376 along the y-axis (see FIGS. 99(a) and 99(c) through 99(i)). The processing head 370 and thus the supply nozzle 375 are movable only along the y-axis but their movement in other directions is restrained.

The wafer 90 to be processed may be any size. In match with the selected size, the processing head 70 is adjusted in position in the direction of the y-axis by the position adjusting mechanism 346 and arranged opposite the outer peripheral part 90a of the wafer 90.

Moreover, the position adjusting mechanism 36 is actuated in synchronism with the rotational motion of the processing stage 10 by a controller 350. Information of the spot where the processing head 370 is to be positioned in accordance with the angle of rotation of the processing stage 10 or information of the direction for the processing head 370 to be moved and the speed of movement is stored in the controller 350. Specifically, as shown in FIG. 100, when the angle of rotation of the processing stage 10 is in the first rotation angle range $\phi_1$, the processing head 370 is fixed in position and the fixed spot is established. When the angle of rotation of the processing stage 10 is in the second rotation angle range $\phi_2$, the processing head 370 is moved and the direction and the speed of the movement are established.

The rotation angle of the processing stage 10 is established in terms of a clockwise angle in a plan view from the y-axis to the reference point 10p on the stage 10 as indicated by a triangle mark of FIG. 99.

The first rotation angle range $\phi_1$ is established in the range from zero degree to the rotation angle $\phi_{91}$ just corresponding

to the value of the center angle of the circular outer peripheral part 91. This rotation angle range $\phi_1$ corresponds to the time period required for the circular outer peripheral part 91 to move across the y-axis.

The second rotation angle range $\phi_2$ is established to the range from $\phi_{91}$ to 360 degrees. The width $(360 - \phi_{91})$ of the second rotation angle range $\phi_2$ is just coincident with the width of the center angle $\phi_{93}$ (see FIG. 101) of the orientation flat 93. This rotation angle range $\phi_2$ corresponds to the time period required for the orientation flat 93 to move across the y-axis.

The fixed spot of the supply nozzle 375 in the first rotation angle range $\phi_1$ is established to a spot (spot away by a substantially equal distance to the radius r of the wafer 90 from the rotation axis) on the y-axis generally equal to the radius r of the wafer 90. This fixed spot is overlapped with the spot where the circular outer peripheral part 91 is moved across the y-axis.

In the second rotation angle range $\phi_2$, the processing head 370 is moved to the direction of the origin (direction toward the rotation axis z) along the y-axis in the former half of the second rotation angle range, counter-rotated just at the middle point of the second rotation angle range $\phi_2$, and moved in the plus direction (direction away from the rotation axis z) in the latter half. Presuming that the speed of rotation of the processing stage 10 is $\omega_{10}$, the moving speed v in both the first and second halves is established by the following equation;

$$V = \frac{(2d\varpi_{10})}{\phi_{93}} \approx 2d\varpi_{10}rL_{93} \qquad \cdots \ (1)$$

wherein is the depth of the orientation flat 93 and $L_{93}$ is the length (see FIG. 101). As shown in the equation (1), the moving speed v (gradient in FIG. 100) is in proportion to the rotation speed $\omega_{10}$ of the processing stage 10.

In case of a wafer of the standards as in the above example wherein the radius r = 100 mm and the orientation flat length L93 = 55 mm to 60 mm, if the speed of rotation is about 1 rpm, the speed v of the processing head in the rotation angle range $\phi_2$ can be expressed by v = about 1.5 mm/sec. to about 1.6 mm/sec.

At the time for removing the unnecessary film 92c coated on the outer peripheral part of the wafer 90 by the wafer processing apparatus equipped with a mechanism corresponding to the orientation flat, as shown in FIGS. 98(a) and 98(b), the wafer 90 to be processed is taken out of the cassette 310 by the robot arm 320 and placed on the alignment stage 332. At that time, the wafer 90 is normally deviated from the alignment stage. A point "a" where the amount of projection from the stage 332 is maximum and a point "b" where the amount of projection is minimum are away from each other by 180 degrees. The alignment stage 332 makes one full rotation in that state. During the time, the maximum projection point "a" and its amount of projection as well as the minimum projection point "b" and its amount of projection are detected by a non-contact sensor of the alignment unit 331. Specifically, the minimum and maximum values of the amount of received light and the angle of rotation of the stage 332 at that time are measured by vertically sandwiching the light projector and the light receiver. In parallel, the place where the orientation flat 93 is located is also preliminarily detected by measuring the angle of rotation of the stage 332 when the amount of received light is discontinuously abruptly increased. Based on the measured result, the wafer 90 is aligned by the robot arm 320. That is, the wafer 90 is moved with respect to the stage 332 toward the minimum projection point "b" from the maximum projection point "a" by a 1/2 distance of the maximum projection amount and the minimum projection amount. As for the movement, the wafer 90 may be moved or the stage 332 may be moved. Simultaneous with this, the orientation flat 93 is directed to a predetermined direction.

Next, as shown in FIG. 98(c), the wafer 90 is transferred to the processing part 340 and set onto the processing stage 10 by the robot arm 320. Since the wafer 90 is already subjected to the alignment operation, it can be correctly aligned in center with the processing state 10.

It is also accepted that the wafer 90 is transferred directly to the processing stage 10 from the cassette 310 so that the wafer 90 can be aligned on the processing stage 10 in the manner as mentioned above. By doing so, the alignment stage 332 can be eliminated.

At the time of setting the wafer 90 onto the processing stage 10, the wafer 90 is aligned in center to the processing stage 10 and in addition, the orientation flat 93 is directed in a predetermined direction. As shown in FIGS. 98(c) and 99(a), in this embodiment, the left end part 93a of the orientation flat 93 is directed to the reference point 10p of the processing stage 10. This reference point 10p of the processing stage 10 is arranged on the y-axis in the initial stage.

Subsequently, as shown in FIG. 99(a), the processing head 370 is adjusted in position in the y-axis direction in match with the size of the wafer 90 by the position adjusting mechanism 346. By doing so, the supply nozzle 375 is arranged opposite the outer peripheral part 90a of the wafer 90. In this embodiment, the supply nozzle 375 is arranged opposite the corner formed between the end part 93a of the orientation flat 93 and the circular outer peripheral part 91.

Thereafter, the ozone generated by the ozonizer 70 is supplied to the processing head through the tube 71 and jetted out through the supply nozzle 375. This ozone is sprayed onto the outer peripheral part 90a of the wafer 90 and reacted with the unnecessary film 92c. By doing so, the unnecessary film 92c can be removed.

In parallel with this ozone spraying operation, the processing stage 10 is rotated about the rotation axis (z-axis) at a predetermined speed of rotation by an encoder motor 342. This rotating direction is, for example, a clockwise direction, in a plan view, as indicated by the arrow of FIG. 99(a). Owing to this arrangement, the wafer 90 is rotated as in the manner shown in FIGS. 99(a) through 99(i) with the passage of time and the place where the ozone is sprayed is sequentially shifted in the peripheral direction, so that the unnecessary film 92c coated on the outer peripheral part 92a of the wafer 90 can sequentially be removed in the peripheral direction. In FIGS. 99(b) through 99(i), the hatched part of the outer peripheral part 90a of the wafer 90 shows the part from where the unnecessary film 92c is already removed.

The steps for removing the unnecessary film will now be described in detail.
The controller 350 is operated to actuate the position adjusting mechanism 346 in synchronism with rotation of the processing stage 10 based on data corresponding to FIG. 100 and adjust in position the processing head 370 and thus, the supply nozzle 375. That is, as shown in FIG. 100, in case the rotation angle of the processing stage 10 is in the range of $\phi_1$, the supply nozzle 375 is fixed to a spot generally equal to the radius r of the wafer 90 on the y-axis. By doing so, as shown in FIG. 99(a) through 99(e), the supply nozzle 91 can reliably be directed toward the circular outer peripheral part 91 during the time period when the circular peripheral part 91 is moved across the y-axis. Thus, the ozone can reliably be sprayed onto the circular outer peripheral part 91 and the unnecessary film 92c coated on the circular outer peripheral part 91 can reliably be removed. Then, the processed part is extended in the peripheral direction of the circular outer peripheral part 91 in accordance with the rotation and before long, as shown in FIG. 99(e), the processing operation is finished over the entire area of the circular outer peripheral part 91. The right end part 93b of the orientation flat 93b reaches the position of the supply nozzle 375. At that time, the rotation angle range is switched from $\phi_1$ to $\phi_2$.

As shown in FIG. 100, in the former half of the rotation angle range $\phi_2$, the processing head 370 and thus, the supply nozzle 375 is moved toward the processing stage 10 at the speed of the above-mentioned equation (1). On the other hand, as shown in FIGS. 99(e) through 99(g), the right side part of the orientation flat 93 is moved across the y-axis at that time. In accordance with this rotation, the crossing spot is deviated toward the rotation axis (z-axis) side. The fluctuation of the crossing point is generally coincident with the movement of the supply nozzle 375. This makes it possible to keep the supply nozzle 375 always along the edge of the right side part of the orientation flat 93 and reliably remove the unnecessary film 92c coated on that particular part.

As shown in FIG. 100, the supply nozzle 375 just in the middle point of the rotation angle range $\phi_2$ is already moved by an amount equal to the depth d of the orientation flat 93 to the processing stage 10 from the position (generally r spot of the y-axis) at the time of processing the circular outer peripheral part 91. At that time, as shown in FIG. 99(g), the orientation flat 93 is orthogonal to the y-axis and just the middle part of the orientation flat 93 is moved across the spot of (r - d) on the y-axis. Therefore, the supply nozzle 375 and the orientation flat 93 are coincident in the middle part with each other and the unnecessary film 92c coated on the middle part of the orientation flat 93 can reliably be removed.

As shown in FIG. 100, the moving direction of the supply nozzle 375 is reversed at the middle point of the rotation angle range $\phi_2$ and moved in the direction away from the processing stage 10 in the latter half of the rotation angle range $\phi_2$. The moving speed is same (speed v in the above-mentioned equation (1) as in the former half. At that time, as shown in FIGS. 99(g) through 99(i), the left side part of the orientation flat 93 is moved across the y-axis and the crossing spot is sequentially deviated in the plus direction of the y-axis in accordance with the rotation. The fluctuation of the crossing spot and the movement of the supply nozzle 375 are generally coincident with each other. This makes it possible to keep the supply nozzle 375 always along the edge of the left side part of the orientation flat 93 and reliably remove the unnecessary film 92c coated on that particular part.
In the manner as discussed above, the unnecessary film 92c can reliably be removed not only from the circular outer peripheral part 91 of the wafer 90 but also the entire region of the outer periphery including the orientation flat 93.
As shown in FIG. 99(i), the supply nozzle 375 is brought back to the initial position when the rotation angle becomes just 360 degrees.
After the end of the unnecessary film removing operation, the wafer 90 is removed from the processing stage 10 and returned to the cassette 310 by the robot arm 320.

According to this wafer processing apparatus, various sizes of the wafer 90 can be met by sliding the processing head 370 in the y-axis direction. In addition, it can also cope with the processing of the orientation flat 93. Therefore, since only two axes consisting of a single slide axis (y-axis) and a single rotation axis (z axis) is required as a drive system of the entire processing part 340, the structure can be simplified. At the time of alignment, the orientation flat 93 is directed in the predetermined direction 10p and the supply nozzle 375 is adjusted in position in synchronism with rotation of the processing stage 10. By doing so, the supply nozzle 375 can be kept along the orientation flat 93 and it is no more required to detect the orientation flat 93 at simultaneous with the unnecessary film removing operation and feed back the detected data. Thus, the controlling operation can be made easily.

As shown in FIG. 102, it is also accepted that the moving speed of the processing head 370 and thus, the supply nozzle 375 in the rotation angle range $\phi_2$ during the time period of the orientation flat processing operation is gradually reduced in the former half of the rotation angle range $\phi_2$ and gradually increased in the latter half in such a manner as to draw a circular arc on a graph. By doing so, the movement of the processing head 370 can be made more precisely coincident than the fluctuation occurred at the first axis crossing spot of the orientation flat 93. Thus, the supply nozzle 375 can more reliably be kept along the edge of the orientation flat 93.

This apparatus can also cope with a case where the cutout formed in the outer periphery of the wafer is a notch. It is good enough that the supply nozzle is slidable in the first axis direction and the entire processing head is not required to move.

In case the processing rate is enhanced under a high temperature, a heater capable of locally heating the part under processing may be employed. This heater is preferably a non-contact heater such as a radiating heater using a laser or the like. On the other hand, a heat absorbing means capable of cooling the wafer by absorbing heat from the central part of the wafer may be provided to the interior of the processing stage.

The processing fluid is not limited to ozone gas but it may properly be selected from gas or fluid containing various components in accordance with the processing system such as the quality of the unnecessary film 92c, wet or dry and the like.

In the apparatus shown in FIGS. 103 and 104, the x-axis is the first axis on which the processing head 370 is arranged. As shown in FIG. 103, the supply nozzle 375 is adjusted in position on the x-axis by the position adjusting mechanism 346.

As shown in FIG. 104, a measuring device 341 for measuring the position of the outer periphery of the wafer is arranged on the y-axis. The measuring device 341 can be advanced and retreated, by an advancing/retreating mechanism not shown, on the y-axis between a measuring position (indicated by a solid line in FIG. 105(a)) where the measuring device is advanced toward the rotation axis z and a retreating position (indicated by the imaginary line in FIG. 105(a)) where the advancing/retreating mechanism is retreated in a direction away from the rotation axis z.

Although not shown in detail, the measuring device 31 is composed of an optical non-contact sensor. For example, this non-contact sensor comprises a light projector for outputting a laser and a light receiver. The light projector and the light receiver are arranged in such a manner as to vertically sandwich the outer peripheral part 90a of the wafer 90 placed on the stage 10. The laser light coming from the light projector is blocked at a rate corresponding to the amount of projection of the outer peripheral part of the wafer and the amount of received light in the light receiver is changed. Owing to this arrangement, the position of the outer peripheral part of the wafer (as well as the deviating amount of the wafer)can be detected.

In FIGS. 104 and 105, the orientation flat and the notch of the outer periphery of the wafer are not shown.

As shown in FIG. 104, this apparatus is not provided with the alignment mechanism 330.

The controller 350 conducts the following control operation (see the flowchart of FIG. 106).

As shown in FIG. 104(a), the wafer 90 to be processed is taken out of the cassette 310 (step 101) and as shown in FIG. 104(b), placed on the stage 10 for chucking (step 102) by the robot arm 320. Since being not subjected to alignment operation, the wafer 90 is, usually, somewhat deviated with respect to the stage 10.

Then, rotation of the stage 10 is started (step 103). The rotating direction is, for example, a clockwise direction in a plan view as indicated by arrowed curved lines of FIG. 105(a). Accordingly, the measuring device 341 is arranged on the upstream side along the rotating direction and the processing head 370 is arranged on the downstream side such that the measuring device 341 and the processing head 370 are away from each other by 90 degrees.

Moreover, as indicated by the white arrow of FIG. 105(a), the measuring device 341 is advanced to the measuring position from the retreating position along the y-axis (step 104), and the processing head 370 is advanced to the process executing position from the retreating position along the x-axis (step 105).

Subsequently, the crossing spot where the outer peripheral part 90a of the wafer 90 moves across the y-axis is measured by the measuring device 341 (step 110). As later described, this operation of the step 110=is equivalent to calculating the momentary spot where the outer peripheral part 90a of the wafer 90 moves across the x-axis before a quarter cycle of the rotation cycle of the stage 10.

The process then proceeds to step 112 via the judgment of step 111 and in step 112, the supply nozzle of the processing head 370 is brought to the same spot on the x-axis as the measured value of the crossing spot on the y-axis in the step 110 by the position adjusting mechanism 346. Moreover, the timing for positioning the supply nozzle 375 in that spot is arranged to be set only after a quarter cycle of the rotation cycle of the stage 10. For example, as shown in FIG. 105(a), presuming that the measured value in step 110 is $r_1$ [mm] on the y-axis, as shown in FIG. 105(b), the supply nozzle 375 after a quarter cycle is positioned at the spot of $r_1$ [mm] of the x-axis. By doing so, when the spot moving across the y-axis at the time of step 110 in the outer peripheral part 90a of the wafer 90 is moved across the x-axis by being rotated 90 degrees, the supply nozzle 375 can be positioned on the x-axis crossing spot. Since there is sufficient time equal to a quarter cycle, the feedback operation can reliably be carried out.

The measuring device 341 and the controller 350 constitute the "calculator for calculating the ever-changing spot where the outer peripheral part of the wafer is moved across with respect to the first axis".

FIGS. 105(a) through 105(d) show the respective states which can appear at every quarter cylce in a sequential order. The wafer 90 indicated by the imaginary line in FIGS. 105(a) through 105(d) show the respective states which can appear before every quarter cycle.

In parallel, the ozone gas coming from the ozonizer 70 is supplied to the processing head 370 through the tube 71 and jetted out through the supply nozzle 375 (step 113). By doing this, the ozone can be sprayed onto the x-axis crossing spot of the outer peripheral part 90a of the wafer 90 and the unnecessary film 92c coated on that spot can be removed. This procedure for starting the jetting operation of ozone in step 113 is executed only in the first flow and thereafter, the ozone jetting operation is continuously executed.

Thereafter, the process returns to step 110 and the y-axis crossing spot of the outer peripheral part 90a of the wafer 90 is measured (step 110). Based on the measured result, the position adjustment of the supply nozzle 375 after a quarter cycle is repeatedly executed (step 112).

As shown in FIGS. 105(a) through 105(e) in a time sequential manner, the unnecessary film 92c coated on the outer peripheral part 90a of the wafer 90 can sequentially be removed in accordance with rotation of the wafer 90. In FIGS. 105(b) through 105(e), the hatched part of the outer peripheral part 90a of the wafer 90 indicates a part from where the unnecessary film 92c is already removed.

Even if the wafer 90 is deviated, the supply nozzle 375 can be adjusted in position in match with the contour of the outer peripheral part 90a and thus, the unnecessary film 92c can reliably be removed. Therefore, there is no need of a provision of an alignment mechanism for correcting the deviation and the apparatus structure can be simplified. Moreover, after the wafer 90 is picked up from the cassette 310, the wafer 90 can be placed directly on the stage 10 without through the alignment mechanism and the removing operation of the unnecessary film 9c can immediately be carried out. Moreover, the alignment operation before the unnecessary film removing operation can be eliminated. Accordingly, the total processing time can be reduced.

Moreover, in parallel with the calculation of the x-axis crossing spot carried out momentarily, the positional adjustment of the supply nozzle 375 and the jetting out operation of ozone are conducted. Accordingly, the processing time can be more reduced.

Before long., the wafer makes one full rotation after the start of the gas jetting operation in step 113 and the unnecessary film removing procedure is finished over the entire region in the peripheral direction of the outer peripheral part 90a of the wafer 90 (see FIG. 105(e)).

At that time, in response to the question reading as "is the process for the entire periphery of the wafer finished?", the judgment is made as "yes".

Based on the above judgment, the ozone gas is stopped jetting out through the supply nozzle 375 (step 120).

Then, as shown in FIG. 105(e), the processing head 370 is retreated to the retreating position (step 121) and the measuring device 341 is retreated to the retreating position (step 122).

The rotation of the stage 10 is then stopped (step 123).

Thereafter, the chucking operation for the wafer 90 onto the stage 10 is canceled (step 124).

Then, the wafer 90 is carried out of the stage 10 by the robot arm 320 (step 125) and returned to the cassette 310 (step 126).

Although the measuring device 341 is arranged in such a manner as to be deviated by 90 degrees toward the upstream side in the rotating direction of the stage from the supply nozzle, the deviation is not limited to 90 degrees but it may be larger or smaller than the amount of that angular deviation.

The cutout part such as the orientation flat and the notch of the wafer is detected by the measuring device 341 and the x-axis crossing spot is calculated. By doing so, the edge of the cutout part can also be processed.

In the controlling operation shown in the flowchart of FIG. 106, in parallel with the calculation of the position of the outer peripheral part 90a of the wafer 90, the procedure for adjusting the position of the nozzle and for jetting out the gas is conducted. As shown in the flowchart of FIG. 107, it is also accepted that after the calculation of the position over the entire periphery of the outer peripheral part 90a of the wafer 90 is executed, the procedure for adjusting the position of the nozzle and for jetting out the gas may be executed.

That is, in FIG. 107, after the positional setting of the measuring device 341 and the processing head 370 is executed in step 104 and in step 105, the spot on the y-axis where the outer peripheral part 90a of the wafer 90 is moved across is measured by the measuring device 341 while the stage 10 makes one full rotation and the positional data of the entire periphery of the outer peripheral part 90a of the wafer 90 are obtained (step 115). That is, the y-axis crossing spot data of the outer peripheral part 90a of the wafer 90 corresponding to the angle of rotation of the stage 10 are obtained. When thus obtained data are deviated by 90 degrees, they become coincident with the calculated data of the x-axis crossing spot of the outer peripheral part 90a of the wafer 90 corresponding (momentarily) to the angle of rotation of the stage 10. The calculated data are stored in the memory of the controller 350.

It is also accepted that instead of the positional date of the entire periphery, the amount of deviation and the deviating direction of the wafer 90 with respect to the stage 10 are calculated and those deviation data are used as the above-mentioned calculated data. That is, due to deviation caused by errors occurred when the wafer 90 is placed on the stage 10 in step 101, as shown in FIG. 104(b), there exist two points "a" and "b" on the outer peripheral part 90a of the wafer 90. In the point "a", the amount of projection of the outer peripheral part 90a from the stage 10 becomes maximum while in the point "b", the amount of projection becomes minimum. The maximum projecting place a as well as the projection amount and the minimum projecting place b as well as the projecting amount are detected by the measuring device 341. The direction toward the maximum projecting point "a" from the minimum projecting point "b" is the deviating direction and a half the difference between the projecting amount of the maximum projecting point "a" and the minimum projecting amount of the minimum projecting point "b" is the deviation amount. Based on the deviation data and the radius data of the wafer 90, the x-axis crossing spot of the outer peripheral part 90a of the wafer 90 corresponding (momentarily) to the angle of rotation of the stage 10 can be calculated.

Thereafter, the process proceeds to step 116 where the processing head 370 and thus, the supply nozzle 375 are adjusted in position in the x-axis direction based on the calculated data by the position adjusting mechanism 346. That is, in accordance with the rotation angle of the stage 10, the supply nozzle 375 is positioned in the calculated spot where the outer peripheral part 90a of the wafer 90 is moved across the x-axis in that rotation angle. In parallel with this positional adjustment, ozone is jetted out through the supply nozzle 375. By doing so, the ozone can reliably jetted onto the x-axis crossing place of the outer peripheral part 90a of the wafer 90 irrespective of deviation of the wafer 90. Thus, the unnecessary film coated on that place can reliably be removed.

The procedure for adjusting the position of the nozzle and for jetting out the ozone in this step 116 is continuously executed. By doing so, the unnecessary film 90c can be removed from the entire region in the peripheral direction of the outer peripheral part 90a of the wafer 90. Thus, in response to the question reading as "is the process for the entire periphery of the wafer finished?", the judgment is made as "yes".

The procedure to follow thereafter is same as in FIG. 106 (steps 120 through 126).

[INDUSTRIAL APPLICABILITY]

This invention can be used, for example, for removing the unnecessary film coated on the outer periphery during the manufacturing process of a semiconductor wafer and during the manufacturing process of a liquid crystal display substrate.

**Claims**

1. A method for processing the outer peripheral part (90a) of a substrate (90) in which an unnecessary matter (92c; 94c) coated on the outer peripheral part (90a) of said substrate (90) is removed by contacting said unnecessary matter (92c; 94c) with a reactive gas, **CHARACTERIZED in that** said method comprises the steps of:

   supporting said substrate (90) by a stage (10) so as to be brought a proximal outer peripheral part of said substrate (90) into contact with a support surface (10a, 10b) of said stage (10) in a manner protruding radially and wardly the outer peripheral part (90a) of said substrate (90) from said stage (10);
   locally radiantly heating the protruded outer peripheral part (90a) of said substrate (90) with a thermal light;
   supplying said reactive gas to the heated outer peripheral part (90a); and heat absorbing the proximal outer peripheral part by heat absorbing means (41;41C;41U,41L;46;Pe) disposed on said stage (10), and

   wherein the locally radiantly heating step and the heat absorbing step are carried out simultaneously.

2. An apparatus for processing the outer peripheral part (90a) of a substrate (90) in which an unnecessary matter (92c; 94c) coated on the outer peripheral part (90a) of said substrate(90) is removed by contacting said unnecessary matter (92c;94c) with a reactive gas, heat absorbing means (41; 41 C; 4 1 U, 41 L; 46; Pe) disposed on at least an outer peripheral side part of said stage (10) and for absorbing heat from said support surface (10a, 10b) **CHARACTERIZED in that** said apparatus comprises:

   (a) a stage (10) including a support surface (10a, 10b) for supporting said substrate (90) thereon so as to be brought a proximal outer peripheral part of said substrate (90) into contact with said support surface (10a, 10b) in a manner radially and wardly protruding the outer peripheral part (90a) of said substrate (90) therefrom;
   (b) a radiating heater (20;120) including an irradiator (22;122) for locally irradiating a thermal light to a target position (P) which exists on the protruded outer peripheral part (90a) of said substrate (90) supported by said stage (10);
   (c) reactive gas supplying means (30; 30X; 36; 36X; 52b; 70, 71, 72, 73, 74, 75; 100; 200; 260; 270; 370) for supplying said reactive gas only to said target position (P).

3. An apparatus for processing the outer peripheral part (90a) of a substrate (90) according to claim 2, wherein the target position (P) is located on a part of the substrate (90) protruding from the supporting surface (10a) of the stage (10).

4. An apparatus for processing the outer peripheral part (90a) of a substrate (90) according to claim 2 or 3, wherein said heat absorbing means is a refrigerator (41; 41C; 4 1 U, 41 L; 46) for cooling said stage (10).

5. An apparatus for processing the outer peripheral part (90a) of a substrate (90) according to claim 4, wherein a refrigerant chamber (41; 41C; 4 1 U, 41 L) as said heat absorbing means is formed within said stage (10), and said refrigerant chamber (41; 41C; 41U, 41L) is connected with a refrigerant supply path (42) and a refrigerant exhaust path (43).

6. An apparatus for processing the outer peripheral part (90a) of a substrate (90) according to claim 4, wherein a refrigerant path (46) as said heat absorbing means is disposed on said stage (10) and a refrigerant is passed through said refrigerant path (46).

7. An apparatus for processing the outer peripheral part (90a) of a substrate (90) according to claim 6, wherein said refrigerant path (46) includes a plurality of concentric annular paths (47) and a communication path (48) for interconnecting said annular paths (47).

8. An apparatus for processing the outer peripheral part (90a) of a substrate (90) according to claim 2 or 3, wherein said heat absorbing means (41; 41C; 41U, 4 1 L; 46; Pe) is disposed only at the outer peripheral side part (10b) of said stage (10) and not at the central side part (10c).

9. An apparatus for processing outer peripheral part (90a) of a substrate (90) according to claim 8, wherein said stage (10) is provided at the outer peripheral side part (10b) with a chuck mechanism (13,14;15) for sucking said substrate (90) and at the central side part with a recess (10c) which is depressed with respect to said area (10b) where said chuck mechanism (13,14;15) is disposed.

10. An apparatus for processing the outer peripheral part (90a) of a substrate (90) according to claim 2 or 3, wherein said support surface (10b) of said stage (10) has an annular shape having a recess (10c) in the central part thereof.

11. An apparatus for processing the outer peripheral part (90a) of a substrate (90) according to claim 10, wherein said stage (10) is provided a chuck mechanism (13,14;15) for sucking said substrate (90) only at the outer peripheral side part (10b) of said stage (10).

12. An apparatus for processing the outer peripheral part (90a) of a substrate (90) according to claim 2 or 3, wherein said reactive gas supplying means includes a jet port (30b;30bx;36;36a;74;75;375) for jetting out said reactive gas to said target position (P), and said jet port (30b;30bx;36;36a;74;75;375) is disposed more proximate to said target position (P) than from said irradiator (22;122).

13. An apparatus for processing the outer peripheral part (90a) of a substrate (90) according to claim 12, wherein said irradiator (22; 122) is disposed so as to face a reverse side of the outer peripheral part (90a) of said substrate (90) supported by said stage (10), and
said jet port (30b;36;36a;74;75) is disposed so as to face the reverse side or an outer end surface of said substrate (90) supported by said stage (10).

14. An apparatus for processing the outer peripheral part (90a) of a substrate (90) according to claim 2 or 3, wherein said irradiator (22;122) irradiates said thermal light toward said target position (P) from a direction declined radially outwardly of said support surface (10a, 10b).

15. An apparatus for processing the outer peripheral part (90a) of a substrate (90) according to claim 2 or 3, further comprising a moving mechanism (30) for moving said irradiator (22;122) in a plane orthogonal to said support surface (10a, 10b) while directing said irradiator (22;122) toward said target position (P).

16. An apparatus for processing the outer peripheral part (90a) of a substrate (90) according to claim 2, wherein said reactive gas supplying means includes a jet port forming member (36;75) for forming said jet port (36a,75), and said jet port forming member (36;75) is composed of a light transmissive material.

17. An apparatus for processing the outer peripheral part (90a) of a substrate (90) according to claim 2 or 3, wherein said reactive gas supplying means comprises an introduction part (162) for introducing said reactive gas to the vicinity of said target position (P) and a cylindrical part (161) connected to said introduction part (162) and overlain said target position (P), the interior of said cylindrical part (161) is more widely spread than said introduction part (162) and defined as a temporary reservoir space (161a) for temporarily reserving therein said reactive gas.

18. An apparatus for processing the outer peripheral part (90a) of a substrate (90) according to claim 17, wherein a basal end part of said cylindrical part (161) is provided with a light transmissive closure part (163) for closing said basal end part, and said irradiator (22;122) is disposed outside said closure part (163).

19. An apparatus for processing the outer peripheral part (90a) of a substrate (90) according to claim 2 or 3, wherein said stage (10) includes a stage main body (110) having a refrigerant chamber (41;41 C) or a refrigerant path formed therein as said heat absorbing means, and a center pad (111) disposed at a central part of said stage main body (110) in such a manner as to be able to be projected from and received in said stage main body (110), said stage (10) further comprises:

    a fixed cylinder (180) provided with a port (181a, 182a, 183a) for a refrigerant,
    a rotary cylinder (150) rotatably passing through said fixed cylinder (180) and coaxially connected to said stage main body (110), and
    a rotation driver (140) for rotating said rotary cylinder (150),
    an annular path (181c, 182c, 183c) connected to said port (181a, 182a, 183a) being formed at an inner peripheral surface of said fixed cylinder (180) or an outer peripheral surface of said rotary cylinder (150),
    an axial path (151a, 152a, 153a) extending in the axial direction being formed in said rotary cylinder (150), one end part of said axial path (151a, 152a, 153a) being connected to said annular path (181c, 182c, 183c) and the other end part being connected to said refrigerant chamber (41;41 C) or said refrigerant path.

20. A stage structure according to claim 19, wherein two annular seal grooves (181d, 182d, 183d) are formed in an inner peripheral surface of said fixed cylinder (180) or an outer peripheral surface of said rotary cylinder (150) such that said seal grooves (181d, 182d, 183d) are located on both sides of said annular path (181c, 182c, 183c) sandwiched therebetween, and
    each of said seal grooves (181d, 182d, 183d) receives therein a gasket (G1,G2,G3) having a II-shaped configuration in section and opening toward said annular path (181c, 182c, 183c).

21. An apparatus for processing the outer peripheral part (90a) of a substrate (90) according to claim 2 or 3, wherein said reactive gas supplying means comprises a gas guide member (200),
    said gas guide member (200) includes an insertion port (201) for allowing said substrate (90) to be removably inserted therein, and a guide path (202) connected to the innermost end of said insertion port (201) and extending in the peripheral direction of said substrate (90) in such a manner as to enclose the outer peripheral part (90a) of said substrate (90), and
    said reactive gas is passed in the extending direction of said guide path (202).

22. An apparatus for processing the outer peripheral part (90a) of a substrate (90) according to claim 21, wherein said irradiator (22;122) irradiates said thermal light toward the interior of said guide path (202) in a converging manner, a light transmissive member (204) for allowing said thermal light of said irradiator (22;122) to transmit therethrough being embedded in said gas guide member (200) in such a manner as to face with said guide path (202).

23. An apparatus for processing the outer peripheral part (90a) of a substrate (90) according to claim 2 or 3, wherein an organic film (92c) and an inorganic film (94c) are laminated on the outer peripheral part (90a) of said substrate (90) as unnecessary matters, and
    said reactive gas reacts with said organic film (92c), and said reactive gas supplying means (100) is provided for removing said organic film (92c),
    said apparatus further comprises another reactive gas supplying means (200) for supplying another reactive gas, which is reactable with said inorganic film (94c), to the outer peripheral part (90a) of said substrate (90) on said stage.

24. An apparatus for processing the outer peripheral part (90a) of a substrate (90) according to claim 2 or 3, wherein said substrate (90) is a circular wafer (90) having a cutout part (93) such as a notch or an orientation flat (93) formed in a part of the outer peripheral part (90a) thereof,
    said reactive gas supplying means (370) includes a reactive gas supply nozzle (375) which can be slid along a first axis (y) orthogonal to the center axis (z) of said stage (10),
    said wafer (90) is centered and arranged on said stage (10), said stage (10) is rotated about the center axis (z), and said supply nozzle (375) is positionally adjusted along said first axis (y) in synchronism with the rotation of said stage (10), thereby sliding said supply nozzle (375) along said first axis (y) so that when said circular outer peripheral part (90a) of said wafer (90) is moved across said first axis (y), a tip part of said supply nozzle (375) is held stationary toward a position on said first axis (y) which is away from said center axis (z) by a substantially same distance as the radius of said wafer (90) and when said cutout part (93) of said wafer (90) is moved across said first axis (y), the tip part of said supply nozzle (375) is normally directed to the crossing point.

25. An apparatus for processing the outer peripheral part (90a) of a substrate (90) according to claim 2 or 3, wherein said substrate (90) is a circular wafer (90),
said reactive gas supplying means (370) includes a reactive gas supply nozzle (375) which is slidable along a first axis (x) orthogonal to the center axis (z) of said stage (10),
said stage (10) is rotatable about said center axis (z) while absorptively retaining said wafer (90),
said apparatus further comprises a calculator (350) for calculating momentary points where the outer peripheral part (90a) of said wafer (90) crosses said first axis (x), and
said supply nozzle (375) is positionally adjusted along said first axis (x) based on the calculated result, thereby supplying said processing fluid while being always directed toward said crossing points.


**Patentansprüche**

1. Verfahren zur Bearbeitung des äußeren peripheren Teils (90a) eines Substrats (90), bei dem unnötiges Material (92c; 94c), das auf dem äußeren peripheren Teil (90a) des Substrats (90) beschichtet ist, durch Inkontaktbringen des unnötigen Materials (92c; 94c) mit einem reaktiven Gas entfernt wird, **dadurch gekennzeichnet, dass** das Verfahren die Schritte umfasst:

Stützen des Substrats (90) durch einen Träger (10), so dass ein naher, äußerer peripherer Teil des Substrats (90) mit einer Stützoberfläche (10a, 10b) des Trägers (10) auf eine Weise in Kontakt gebracht wird, dass der äußere periphere Teil (90a) des Substrats (90) von dem Träger (10) radial nach außen hervorsteht;
lokales Erhitzen durch Strahlung des hervorstehenden, äußeren peripheren Teils (90a) des Substrats (90) mit thermischem Licht;
Zuführen des reaktiven Gases zum erhitzten, äußeren peripheren Teil (90a); und
Absorbieren der Hitze des nahen, äußeren peripheren Teils durch ein am Träger (10) angeordnetes Mittel zur Hitzeabsorption (41; 41C; 41U, 41L; 46; Pe),
wobei der Schritt des lokalen Erhitzens durch Strahlung und der Schritt der Hitzeabsorption gleichzeitig ausgeführt werden.

2. Vorrichtung zur Bearbeitung des äußeren peripheren Teils (90a) eines Substrats (90), bei dem unnötiges Material (92c; 94c), das auf dem äußeren peripheren Teil (90a) des Substrats (90) beschichtet ist, durch Inkontaktbringen des unnötigen Materials (92c; 94c) mit einem reaktiven Gas entfernt wird, wobei ein Mittel zur Hitzeabsorption (41; 41C; 41U, 41L; 46; Pe) auf mindestens einem äußeren peripheren Seitenteil des Trägers (10) angeordnet ist und zum Absorbieren von Hitze von der Stützoberfläche (10a, 10b) dient, **dadurch gekennzeichnet, dass** diese Vorrichtung umfasst:

(a) einen Träger (10), der eine Stützoberfläche (10a, 10b) zum Stützen des Substrats (90) darauf einschließt, sodass ein naher, äußerer peripherer Teil des Substrats (90) mit der Stützoberfläche (10a, 10b) auf eine Weise in Kontakt gebracht wird, dass der äußere periphere Teil (90a) des Substrats (90) davon radial nach außen hervorsteht;
(b) einen Heizstrahler (20;120), der eine Bestrahlungseinheit (22; 122) zum lokalen Ausstrahlen von thermischem Licht zu einer Zielposition (P) einschließt, welche sich auf dem hervorstehenden, äußeren peripheren Teil (90a) des Substrats (90), welches von dem Träger (10) gestützt wird, befindet;
(c) Mittel zur Zufuhr von reaktivem Gas (30, 30X; 36; 36X; 52b; 70, 71, 72, 73, 74, 75; 100; 200; 260; 270; 370) zum Zuführen des reaktiven Gases nur zu der Zielposition (P).

3. Vorrichtung zur Bearbeitung des äußeren peripheren Teils (90a) eines Substrats (90) gemäß Anspruch 2, wobei die Zielposition (P) auf einem Teil des Substrats (90), der von der Stützoberfläche (10a) des Trägers (10) hervorsteht, lokalisiert ist.

4. Vorrichtung zur Bearbeitung des äußeren peripheren Teils (90a) eines Substrats (90) gemäß Anspruch 2 oder 3, wobei das Mittel zur Hitzeabsorption ein Kühlaggregat (41; 41C; 4 1 U, 4 1 L; 46) zum Kühlen des Trägers (10) ist.

5. Vorrichtung zur Bearbeitung des äußeren peripheren Teils (90a) eines Substrats (90) gemäß Anspruch 4, wobei eine Kühlmittelkammer (41; 41C; 4 1 U, 4 1 L) als Mittel zur Hitzeabsorption innerhalb des Trägers (10) ausgebildet ist und wobei die Kühlmittelkammer (41; 41C; 4 1 U, 41 L) mit einem Kühlmittelzufuhrpfad (42) und einem Kühlmittelabsaugpfad (43) verbunden ist.

6. Vorrichtung zur Bearbeitung des äußeren peripheren Teils (90a) eines Substrats (90) gemäß Anspruch 4, wobei der Kühlmittelpfad (46) als Mittel zur Hitzeabsorption an dem Träger (10) angeordnet ist und ein Kühlmittel durch den Kühlmittelpfad (46) befördert wird.

7. Vorrichtung zur Bearbeitung des äußeren peripheren Teils (90a) eines Substrats (90) gemäß Anspruch 6, wobei der Kühlmittelpfad (46) eine Vielzahl von konzentrischen, ringförmigen Pfaden (47) und einen Verbindungspfad (48) zum Verbinden der ringförmigen Pfade (47) untereinander einschließt.

8. Vorrichtung zur Bearbeitung des äußeren peripheren Teils (90a) eines Substrats (90) gemäß Anspruch 2 oder 3, wobei das Mittel zur Hitzeabsorption (41; 41C; 41U, 4 1 L; 46; Pe) nur am äußeren peripheren Seitenteil (10b) des Trägers (10) und nicht am zentralen Seitenteil (10c) angeordnet sind.

9. Vorrichtung zur Bearbeitung des äußeren peripheren Teils (90a) eines Substrats (90) gemäß Anspruch 8, wobei der Träger (10) am äußeren peripheren Seitenteil (10b) mit einer Spannvorrichtung (13, 14; 15) zum Ansaugen des Substrats (90) und am zentralen Seitenteil mit einer Vertiefung (10c) ausgestattet ist, welche in Bezug zu dem Bereich (10b), an dem die Spannvorrichtung (13, 14;15) angeordnet ist, vertieft ist.

10. Vorrichtung zur Bearbeitung des äußeren peripheren Teils (90a) eines Substrats (90) gemäß Anspruch 2 oder 3, wobei die Stützoberfläche (10b) des Trägers (10) eine ringförmige Form hat, die eine Vertiefung (10c) im zentralen Teil davon aufweist.

11. Vorrichtung zur Bearbeitung des äußeren peripheren Teils (90a) eines Substrats (90) gemäß Anspruch 10, wobei der Träger (10) mit einer Spannvorrichtung (13, 14; 15) zum Ansaugen des Substrats (90) nur am äußeren peripheren Seitenteil (10b) des Trägers (10) ausgestattet ist.

12. Vorrichtung zur Bearbeitung des äußeren peripheren Teils (90a) eines Substrats (90) gemäß Anspruch 2 oder 3, wobei das Mittel zur Zufuhr von reaktivem Gas eine Ausstoßöffnung (30b; 30bx; 36; 36a; 74; 75; 375) zum Ausstoßen des reaktiven Gases zur Zielposition (P) einschließt und wobei die Ausstoßöffnung (30b; 30bx; 36; 36a; 74; 75; 375) dichter zur Zielposition (P) als zur Bestrahlungseinheit (22;122) angeordnet ist.

13. Vorrichtung zur Bearbeitung des äußeren peripheren Teils (90a) eines Substrats (90) gemäß Anspruch 12, wobei die Bestrahlungseinheit (22;122) so angeordnet ist, dass sie einer Rückseite des äußeren peripheren Teils (90a) des vom Träger (10) gestützten Substrats (90) gegenüberliegt und wobei die Ausstoßöffnung (30b; 36; 36a; 74; 75) so angeordnet ist, dass sie der Rückseite oder einer am äußeren Ende liegenden Oberfläche des vom Träger (10) gestützten Substrats (90) gegenüberliegt.

14. Vorrichtung zur Bearbeitung des äußeren peripheren Teils (90a) eines Substrats (90) gemäß Anspruch 2 oder 3, wobei die Bestrahlungseinheit (22; 122) thermisches Licht in Richtung der Zielposition (P) aus einer Richtung, welche radial nach außen von der Stützoberfläche (10a, 10b) geneigt ist, ausstrahlt.

15. Vorrichtung zur Bearbeitung des äußeren peripheren Teils (90a) eines Substrats (90) gemäß Anspruch 2 oder 3, die weiter eine Bewegungsvorrichtung (30) zum Bewegen der Bestrahlungseinheit (22; 122) in einer zur Stützoberfläche (10a, 10b) orthogonalen Ebene während des Ausrichtens der Bestrahlungseinheit (22;122) in Richtung der Zielposition (P) umfasst.

16. Vorrichtung zur Bearbeitung des äußeren peripheren Teils (90a) eines Substrats (90) gemäß Anspruch 2, wobei das Mittel zur Zufuhr von reaktivem Gas ein eine Ausstoßöffnung bildendes Bauteil (36;75) zum Bilden der Ausstoßöffnung (36a, 75) einschließt und wobei das die Ausstoßöffnung bildende Bauteil (36;75) aus einem lichtdurchlässigen Material aufgebaut ist.

17. Vorrichtung zur Bearbeitung des äußeren peripheren Teils (90a) eines Substrats (90) gemäß Anspruch 2 oder 3, wobei das Mittel zur Zufuhr von reaktivem Gas ein Einleitungsteil (162) zum Einleiten des reaktiven Gases in die Nähe der Zielposition (P) und einen zylindrischen Teil (161), der mit dem Einleitungsteil (162) verbunden ist und

**EP 1 801 861 B1**

die Zielposition (P) überlagert, umfasst, wobei das Innere des zylindrischen Teils (161) weiter verbreitert als das Einleitungsteil (162) ist und als zeitweiliger Vorratsplatz (161a) zum zeitweiligen Aufbewahren von reaktiven Gas darin bestimmt ist.

18. Vorrichtung zur Bearbeitung des äußeren peripheren Teils (90a) eines Substrats (90) gemäß Anspruch 17, wobei ein die Basis bildendes Endteil des zylindrischen Teils (161) mit einem lichtdurchlässigen Verschlussteil (163) zum Verschließen des die Basis bildenden Endteils ausgestattet ist, und wobei die Bestrahlungseinheit (22;122) außerhalb des Verschlussteils (163) angeordnet ist.

19. Vorrichtung zur Bearbeitung des äußeren peripheren Teils (90a) eines Substrats (90) gemäß Anspruch 2 oder 3, wobei der Träger (10) einen Trägerhauptteil (110), der eine Kühlmittelkammer (41; 41 C) oder einen gebildeten Kühlmittelpfad als Mittel zur Hitzeabsorption darin aufweist, und ein Zentrumsfeld (111) einschließt, welches an einem zentralen Teil des Trägerhauptteil (110) auf eine Weise angebracht ist, dass es vom Trägerhauptteil (110) hervorstehen und darin aufgenommen sein kann, wobei der Träger (10) weiter umfasst:

einen feststehenden Zylinder (180), der mit einem Anschluss (181a, 182a, 183a) für ein Kühlmittel ausgestattet ist,

einen Drehzylinder (150), welcher drehbar den feststehenden Zylinder (180) durchläuft und koaxial mit dem Trägerhauptteil (110) verbunden ist,

einen Rotationsantrieb (140) zum Drehen des Drehzylinders (150),

einen ringförmigen Pfad (181c, 182, 183c), der mit dem Anschluss (181a, 182a, 183a) verbundenen ist, welcher an einer inneren peripheren Oberfläche des feststehenden Zylinders (180) oder einer äußeren peripheren Oberfläche des Drehzylinders (150) ausgebildet ist,

einen sich in axialer Richtung erstreckenden, axialen Pfad (151a, 152a, 153a), der in dem Drehzylinder (150) ausgebildet ist, wobei das eine Endteil des axialen Pfads (151a, 152a, 153a) mit dem ringförmigen Pfad (181c, 182c, 183c) verbunden ist und das andere Endteil mit der Kühlmittelkammer (41; 41C) oder dem Kühlmittelpfad verbunden ist.

20. Trägerstruktur gemäß Anspruch 19, wobei zwei ringförmige Dichtungsrillen (181d, 182d, 183d) in einer inneren peripheren Oberfläche des feststehenden Zylinders (180) oder einer äußeren peripheren Oberfläche des Drehzylinders (150) derart ausgebildet sind, dass die Dichtungsrillen (181d, 182d, 183d) auf beiden Seiten des dazwischen eingeklemmtem, ringförmigen Pfads (181c, 182c, 183c) angeordnet sind und dass jede der Dichtungsrillen (181d, 182d, 183d) ein Dichtung (G1, G2, G3) darin aufnimmt, welche eine II- geformte Gestaltung im Schnitt und eine Öffnung in Richtung des ringförmigen Pfads (181c, 182c, 183c) aufweist.

21. Vorrichtung zur Bearbeitung des äußeren peripheren Teils (90a) eines Substrats (90) gemäß Anspruch 2 oder 3, wobei das Mittel zur Zufuhr von reaktivem Gas ein Gasführungselement (200) aufweist, wobei das Gasführungselement (200) einen Einführungsanschluss (201), der es erlaubt, das Substrat (90) lösbar darin einzuführen, und einen Führungspfad (202) einschließt, der mit dem innersten Ende des Einführungsanschlusses (201) verbunden ist und sich in peripherer Richtung des Substrats (90) auf so eine Weise erstreckt, dass er den äußeren peripheren Teil (90a) des Substrats (90) umgibt und wobei das reaktive Gas in die sich erstreckende Richtung des Führungspfads (202) geleitet wird.

22. Vorrichtung zur Bearbeitung des äußeren peripheren Teils (90a) eines Substrats (90) gemäß Anspruch 21, wobei die Bestrahlungseinheit (22;122) thermisches Licht in Richtung des Inneren des Führungspfads (202) in konvergierender Art und Weise ausstrahlt, wobei ein lichtdurchlässiges Bauteil (204), welches thermischem Licht der Bestrahlungseinheit (22;122) erlaubt, es zu durchqueren, in dem Gasführungselement (200) auf so eine Weise eingebettet ist, dass es dem Führungspfad (202) gegenüberliegt.

23. Vorrichtung zur Bearbeitung des äußeren peripheren Teils (90a) eines Substrats (90) gemäß Anspruch 2 oder 3, wobei ein organischer Film (92c) und ein anorganischer Film (94c) auf den äußeren peripheren Teil (90a) des Substrats (90) als unnötiges Material aufgebracht sind, und wobei reaktives Gas mit dem organischen Film (92c) reagiert und das Mittel zur Zufuhr von reaktivem Gas (100) zur Entfernung des organischen Films (92c) zur Verfügung gestellt wird, und wobei die Vorrichtung weiterhin ein anderes Mittel zur Zufuhr von reaktivem Gas (200) zur Zufuhr eines anderen reaktiven Gases, welches mit dem anorganischen Film (94c) reagieren kann, zu dem äußeren peripheren Teil (90a) des Substrats (90) auf dem Träger umfasst.

24. Vorrichtung zur Bearbeitung des äußeren peripheren Teils (90a) eines Substrats (90) gemäß Anspruch 2 oder 3, wobei das Substrat (90) ein kreisförmiger Wafer (90) ist, der ein Ausschnittsteil (93), wie eine Aussparung oder eine Einregelungsscheibe (93), aufweist, welcher in einem Teil des äußeren peripheren Teils (90a) davon ausgebildet ist, wobei das Mittel zur Zufuhr von reaktivem Gas (370) eine Zufuhrdüse für reaktives Gas (375) einschließt, welche entlang einer ersten Achse (y) orthogonal zu der zentralen Achse (z) des Trägers (10) verschoben werden kann, wobei der Wafer (90) auf dem Träger (10) zentriert und angeordnet ist, wobei der Träger (10) um die zentrale Achse (z) gedreht wird, und wobei die Zufuhrdüse (375) entlang der ersten Achse (y) im Gleichlauf mit der Drehung des Trägers (10) positionell justiert ist, wobei dabei die Zufuhrdüse (375) entlang der ersten Achse (y) gleitet, so dass wenn der kreisförmige, äußere periphere Teil (90a) des Wafers (90) quer über die erste Achse (y) bewegt wird, ein Spitzenteil der Zuführdüse (375) stationär in Richtung einer Position auf der ersten Achse (y) gehalten wird, welche von der zentralen Achse (z) um eine im Wesentlichen gleiche Distanz wie der Radius des Wafers (90) entfernt ist und dass, wenn das Ausschnittsteil (93) des Wafers (90) quer über die erste Achse (y) bewegt wird, das Spitzenteil der Zufuhrdüse (375) normal auf den Querungspunkt gerichtet ist.

25. Vorrichtung zur Bearbeitung des äußeren peripheren Teils (90a) eines Substrats (90) gemäß Anspruch 2 oder 3, wobei das Substrat (90) ein kreisförmiger Wafer (90) ist, wobei das Mittel zur Zufuhr von reaktiven Gas (370) eine Zufuhrdüse für reaktives Gas (375) einschließt, welche entlang einer ersten Achse (x) orthogonal zu der zentralen Achse (z) des Trägers (10) verschiebbar ist, wobei der Träger (10) um die zentrale Achse (z) drehbar ist, während er den Wafer (90) durch Absorption festhält, wobei die Vorrichtung weiterhin einen Rechner (350) zum Errechnen momentaner Punkte, wo der äußere periphere Teil (90a) des Wafers (90) die erste Achse (x) kreuzt, umfasst und wobei die Zufuhrdüse (375) basierend auf dem errechneten Ergebnis entlang der ersten Achse (x) positionell justiert wird und dabei die Bearbeitungsflüssigkeit zuführt, während sie immer in Richtung der Querungspunkte gerichtet ist.

## Revendications

1. Procédé pour traiter la partie périphérique extérieure (90a) d'un substrat (90) dans lequel une matière non nécessaire (92c;94c) recouverte sur la partie périphérique extérieure (90a) dudit substrat (90) est enlevée en faisant entrer en contact ladite matière non nécessaire (92c;94c) avec le gaz réactif,
   **CARACTÉRISÉ en ce que** ledit procédé comprend les étapes de :

   support dudit substrat (90) par un étage (10) de manière à amener une partie périphérique extérieure dudit substrat (90) en contact avec une surface de support (10a, 10b) dudit étage (10) d'une manière dépassant radialement de l'extérieur de la partie périphérique extérieure (90a) dudit substrat (90) dudit étage (10) ;
   chauffant localement de manière rayonnante la partie périphérique extérieure (90a) dudit substrat (90) avec une lumière thermique ;
   fournissant ledit gaz réactif vers la partie périphérique extérieure chauffée (90a); et absorbant la chaleur de la partie périphérique extérieure par des moyens d'absorption de chaleur (41 ;41 C;41 U,41 L;46;Pe) disposés sur ledit étage (10), et
   où l'étape de chauffage localement et de manière rayonnante et l'étape d'absorption de chaleur sont effectuées simultanément.

2. Appareil pour traiter la partie périphérique extérieure (90a) d'un substrat (90) dans lequel une matière non nécessaire (92c;94c) recouverte sur la partie périphérique extérieure (90a) dudit substrat (90) est enlevée en faisant entrer en contact ladite matière non nécessaire (92c;94c) avec le gaz réactif, des moyens d'absorption de chaleur (41 ;41 C; 41 U,41 L;46;Pe) disposés sur au moins une partie latérale périphérique extérieure dudit étage (10) et pour absorber la chaleur provenant de ladite surface de support (10a, 10b) **CARACTÉRISÉ en ce que** ledit appareil comprend :

   (a) un étage (10) incluant une surface de support (10a, 10b) pour supporter ledit substrat (90) là-dessus pour que soit amenée une partie périphérique extérieure proximale dudit substrat (90) en contact avec ladite surface de support (10a, 10b) d'une manière dépassant radialement de l'extérieur de la partie périphérique extérieure (90b) dudit substrat (90) ici :
   (b) un chauffage rayonnant (20 ; 120) incluant un irradiateur (22 : 122) pour irradier localement une lumière thermique vers une position cible (P) qui existe sur la partie périphérique extérieure qui dépasse (90a) dudit substrat (90) supportée par ledit étage (10) ;
   (c) un moyen d'alimentation en gaz réactif (30; 30X; 36; 36X; 52b; 70, 71, 72, 73, 74, 75; 100; 200; 260; 270; 370) pour fournir le dit gaz réactif uniquement vers ladite position cible (P).

3. Appareil pour traiter la partie périphérique extérieure (90a) d'un substrat (90) selon la revendication 2, où la position cible (P) est située sur une partie du substrat (90) dépassant de la surface de support (10a) de l'étage (10).

**4.** Appareil pour traiter la partie périphérique extérieure (90a) d'un substrat (90) selon la revendication 2 ou 3, où ledit moyen d'absorption de chaleur est un réfrigérateur (41; 41C; 41U, 41L; 46) pour refroidir ledit étage (10).

**5.** Appareil pour traiter la partie périphérique extérieure (90a) d'un substrat (90) selon la revendication 4, où une chambre réfrigérante (41; 41C; 41U, 41L) tel que ledit moyen d'absorption de chaleur est formé dans ledit étage (10), et ladite chambre réfrigérante (41; 41C; 41U, 41L) est raccordée à un chemin d'alimentation de réfrigérant (42) et un chemin d'évacuation de réfrigérant (43).

**6.** Appareil pour traiter la partie périphérique extérieure (90a) d'un substrat (90) selon la revendication 4, où un chemin réfrigérant (46) tel que ledit moyen d'absorption est disposé sur ledit étage (10) et un réfrigérant est passé par ledit chemin de réfrigérant (46).

**7.** Appareil pour traiter la partie périphérique extérieure (90a) d'un substrat (90) selon la revendication 6, où ledit chemin de réfrigérant (46) inclut une pluralité de chemins annulaires concentriques (47) et un chemin de communication (48) pour interconnecter lesdits chemins annulaires (47).

**8.** Appareil pour traiter la partie périphérique extérieure (90a) d'un substrat (90) selon la revendication 2 ou 3, où ledit moyen d'absorption de chaleur (41 ;41 C;41 U,41 L;46;Pe) est disposé uniquement sur la partie latérale périphérique extérieure (10b) dudit étage (10) et non sur la partie latérale centrale (10c).

**9.** Appareil pour traiter la partie périphérique extérieure (90a) d'un substrat (90) selon la revendication 8, où ledit étage (10) est prévu sur la partie latérale périphérique extérieure (10b) avec un mécanisme de serrage (13,14,15) pour aspirer ledit substrat (90) et sur la partie latérale centrale avec un recoin (10c) qui est abaissée par rapport à ladite zone (10b) où ledit mécanisme de serrage (13,14,15) est disposé.

**10.** Appareil pour traiter la partie périphérique extérieure (90a) d'un substrat (90) selon la revendication 2 ou 3, où ladite surface de support (10b) dudit étage (10) a une forme annulaire ayant un recoin (10c) dans sa partie centrale.

**11.** Appareil pour traiter la partie périphérique extérieure (90a) d'un substrat (90) selon la revendication 10, où ledit étage (10) est prévu avec un mécanisme de serrage (13,14,15) pour aspirer ledit substrat (90) uniquement sur la partie latérale périphérique extérieure (10b) dudit étage (10).

**12.** Appareil pour traiter la partie périphérique extérieure (90a) d'un substrat (90) selon la revendication 2 ou 3, où ledit moyen d'alimentation en gaz réactif inclut un orifice gicleur (30b; 30bx; 36; 36a; 74; 75; 375) pour rejeter ledit gaz réactif vers ladite position cible (P) et ledit orifice gicleur (30b; 30bx; 36; 36a; 74; 75; 375) est disposé plus près de ladite position cible (P) que dudit irradiateur (22; 122).

**13.** Appareil pour traiter la partie périphérique extérieure (90a) d'un substrat (90) selon la revendication 12, où ledit irradiateur (22; 122) est disposé de manière à faire face à un côté inverse de la partie périphérique extérieure (90a) dudit substrat (90) supporté par ledit étage (10), et ledit orifice gicleur (30b; 36; 36a; 74; 75) est disposé de manière à faire face au côté inverse ou à une surface d'extrémité extérieure dudit substrat (90) supporté par ledit étage (10).

**14.** Appareil pour traiter la partie périphérique extérieure (90a) d'un substrat (90) selon la revendication 2 ou 3, où ledit irradiateur (22; 122) irradie ladite lumière thermique vers ladite position cible (P) à partir d'un sens abaissé radialement vers l'extérieur de ladite surface de support (10a, 10b).

**15.** Appareil pour traiter la partie périphérique extérieure (90a) d'un substrat (90) selon la revendication 2 ou 3, comprenant en outre un mécanisme de déplacement (30) pour déplacer ledit irradiateur (22; 122) sur un plan orthogonal vers ladite surface de support (10a, 10b) tout en dirigeant ledit irradiateur (22 ; 122) vers ladite position cible (P).

**16.** Appareil pour traiter la partie périphérique extérieure (90a) d'un substrat (90) selon la revendication 2, où ledit moyen d'alimentation en gaz réactif inclut un élément formant un orifice gicleur (36; 75) pour former ledit orifice gicleur (36a, 75), et le dit élément formant un orifice gicleur (36 ; 75) est composé d'un matériau de transmission de lumière.

**17.** Appareil pour traiter la partie périphérique extérieure (90a) d'un substrat (90) selon la revendication 2 ou 3, où ledit moyen d'alimentation en gaz réactif comprend une partie d'introduction (162) pour introduire ledit gaz réactif dans le voisinage de ladite position cible (P) et une partie cylindrique (161) raccordée à ladite partie d'introduction (162) et recouvrant ladite position cible (P), l'intérieur de ladite partie cylindrique (161) est plus largement déployé que ladite partie d'introduction (162) et défini comme un espace de réservoir temporaire (161a) pour mettre temporairement en réserve ici ledit gaz réactif.

18. Appareil pour traiter la partie périphérique extérieure (90a) d'un substrat (90) selon la revendication 17, où une partie d'extrémité basale de ladite partie cylindrique (161) est équipée d'une partie de fermeture transmettant la lumière (163) pour fermer ladite partie d'extrémité basale, et ledit irradiateur (22 ; 122) est disposé hors de ladite partie de fermeture.

19. Appareil pour traiter la partie périphérique extérieure (90a) d'un substrat (90) selon la revendication 2 ou 3, où ledit étage (10) comprend un corps d'étage principal (110) ayant une chambre réfrigérante (41 ; 41c) ou un chemin réfrigérant formé ici comme moyen d'absorption de la chaleur, et un tampon central (111) disposé sur une partie centrale dudit corps d'étage principal (110) d'une manière permettant d'être projeté de et reçu dans ledit corps d'étage principal,
ledit étage (100) comprend en outre :

un cylindre fixe (180) équipé d'un orifice (181a,182a,183a) pour un réfrigérant,
un cylindre rotatif (150) passant de manière rotative par ledit cylindre fixe (180) et raccordé coaxialement au dit corps d'étage principal (110), et
un actionneur de rotation (140) pour faire tourner ledit cylindre rotatif (150),
un chemin annulaire (181c,182c,183c) raccordé au dit orifice (181a, 182a, 183a) étant formé sur une surface périphérique intérieure dudit cylindre fixe (180) ou une surface périphérique extérieure dudit cylindre rotatif (150),
un chemin axial (151a,152a,153a) se prolongeant dans le sens axial étant formé dans ledit cylindre rotatif (150),
une extrémité dudit chemin axial (151a,152a,153a) étant raccordée au dit chemin annulaire (181c,182c,183c) et l'autre partie d'extrémité étant raccordée à ladite chambre réfrigérante (41 ;41C) ou au dit chemin réfrigérant.

20. Structure d'étage selon la revendication 19, où deux rainures pour joint (181 d, 182d, 183d) sont formées dans une surface périphérique intérieure dudit cylindre fixe (180) ou une surface périphérique extérieure dudit cylindre rotatif (150) de manière à ce que lesdites rainures pour joint (181d,182d,183d) soient situées sur les deux côtés dudit chemina annulaire (181c,182c,183c) coincées entre ceux-ci, et
chacune des rainures pour joint (181d,182d,183d) reçoit ici un joint d'étanchéité (G1,G2,G3) ayant une configuration en $\pi$ dans la section et s'ouvrant vers ledit chemin annulaire (181c, 182c, 183c).

21. Appareil pour traiter la partie périphérique extérieure (90a) d'un substrat (90) selon la revendication 2 ou 3, où ledit moyen d'alimentation en gaz réactif comprend un élément guide du gaz (200),
ledit élément guide du gaz (200) comprend un orifice d'insertion (201) pour permettre audit substrat (90) d'être inséré à l'intérieur de manière amovible, et un chemin guide (202) raccordé à l'extrémité la plus extrême dudit orifice d'insertion (201) et se prolongeant dans le sens périphérique dudit substrat (90) de manière à clôturer ladite partie périphérique extérieure (90a) dudit substrat (90), et
ledit gaz réactif est passé dans le sens de prolongement dudit chemin guide (202).

22. Appareil pour traiter la partie périphérique extérieure (90a) d'un substrat (90) selon la revendication 21, où ledit irradiateur (22 ; 122) irradie ladite lumière thermique vers l'intérieur dudit chemin guide (202) d'une manière convergeante, un élément de transmission de la lumière (204) pour permettre à ladite lumière thermique dudit irradiateur (22 ; 122) de transmettre au travers de celui-ci étant incorporé au dit élément guide du gaz (200) de manière à faire face au dit chemin guide (202).

23. Appareil pour traiter la partie périphérique extérieure (90a) d'un substrat (90) selon la revendication 2 ou 3, où un film organique (82c) et un film inorganique (94c) sont laminés sur la partie périphérique extérieure (90a) dudit substrat (90) comme matières non nécessaires,
ledit gaz réactif réagit avec ledit film organique (92c) et ledit moyen d'alimentation en gaz réactif (100) est prévu pour enlever ledit film organique (92c),
ledit appareil comprend un autre moye, d'alimentation en gaz réactif (200) pour fournir un autre gaz réactif ; qui est lisible avec ledit film inorganique (94c), vers la partie périphérique extérieure (90a) dudit substrat (90) sur ledit étage.

24. Appareil pour traiter la partie périphérique extérieure (90a) d'un substrat (90) selon la revendication 2 ou 3, où ledit substrat (90) est une tranche circulaire (90) ayant une partie découpée (93) tel qu'une encoche ou une planche d'orientation (93) formée dans une partie de la partie périphérique extérieure (90a) de celui-ci,

ledit moyen d'alimentation en gaz réactif (370) inclut un embout d'alimentation en gaz réactif (375) qui peut être glissé le long d'un premier axe (y) orthogonal vers l'axe central (z) dudit étage (10),

ladite tranche (90) est centrée et disposée sur ledit étage (10), ledit étage (10) est tourné autour de l'axe central (z), et ledit embout d'alimentation (375) est ajusté positionnellement le long dudit premier axe (y) en synchronisation avec la rotation dudit étage (10), glissant ainsi ledit embout d'alimentation (375) le long dudit premier axe (y) de manière à ce que quand ladite partie périphérique extérieure circulaire (90a) de ladite tranche (90) est déplacée sur ledit premier axe (y), une partie d'extrémité dudit embout d'alimentation (375) est maintenue stationnaire vers une position dudit premier axe (y) qui est loin dudit axe central (z) par une substantiellement même distance que le rayon de ladite tranche (90) et quand ladite partie découpée (93) de ladite tranche (90) est déplacée sur ledit premier axe (y), la partie d'extrémité dudit embout d'alimentation (375) est normalement dirigée vers le point de croisement.

25. Appareil pour traiter la partie périphérique extérieure (90a) d'un substrat (90) selon la revendication 2 ou 3, où ledit substrat (90) est une tranche circulaire (90),

ledit moyen d'alimentation en gaz réactif (370) inclut un embout d'alimentation en gaz réactif (375) qui peut être glissé le long d'un premier axe (y) orthogonal vers l'axe central (z) dudit étage (10),

ledit étage (10) est orientable autour dudit axe central (z) tout en retenant de manière absorbante ladite tranche (90)

ledit appareil comprend en outre un calculateur (350) pour calculer des points momentanés où la partie périphérique extérieure (90a) de ladite tranche (90) croise ledit premier axe (x), et

ledit embout d'alimentation (375) est ajusté positionnellement le long dudit premier axe (x) sur la base du résultat calculé, fournissant ainsi ledit liquide de traitement tout en étant toujours dirigé vers lesdits points de croisement.

FIG. 1

FIG. 2

FIG. 3

FIG. 4(a)

FIG. 4(b)

FIG. 5

FIG. 6

(REFRIGERANT out) ◄—  —(REFRIGERANT in)

FIG. 7

(REFRIGERANT out) ◄—  —(REFRIGERANT in)

FIG. 8

FIG. 9

FIG. 10(a)

FIG. 10(b)

FIG. 11

FIG. 12

FIG. 13

FIG. 14

(a)  (b)  (c)

**FIG. 15**

**FIG. 16**

**FIG. 17**

FIG. 18(a)

FIG. 18(b)

~41~

(SUCTION)                              (SUCTION)

FIG. 19(a)

FIG. 19(b)

(SUCTION)

FIG. 20

FIG. 21

FIG. 22

FIG. 23

42
(REFRIGERANT in)

41c

10c

43

(REFRIGERANT out)

(SUCTION)

FIG. 24

**FIG. 25**

**FIG. 26**

FIG. 27

## FIG. 28

**FIG. 29**

FIG. 30

FIG. 31

FIG. 32

FIG. 33

FIG. 34

FIG. 35

EP 1 801 861 B1

FIG. 36

FIG. 37

(N₂)

N

10

90

10a

N₂

80a

82

P

130

81

80

131

(REFRIGERANT in)

(REFRIGERANT out)

132

12a

36

52b

52

12

~50a~

11

43

42

61

62

60

51c

50

(REFRIGERANT out) (REFRIGERANT in)

51

22

72

20

71

(EXHAUST)

OZONIZER

70

FIG. 38

FIG. 39

FIG. 40(a)

52b

36b

36b

52b

36X

(REACTIVE GAS)

52b

36a

36b

52b

FIG. 40(b)

36X

36b

52b

(REACTIVE GAS)

36a

36b

52b

**FIG. 41**

ROTATION DIRECTION

**FIG. 42**

LASER

FIG. 43

COOLING WATER (in)
COOLING WATER (out)

FIG. 44

FIG. 45

( a )

90

(GAS FLOW)

L76

76

L75

75

( b )

76

D

75

(GAS FLOW)

L76

L75

Rs

90

(WAFER ROTATION
DIRECTION)

FIG. 46(a)

FIG. 46(b)

FIG. 47

FIG. 48

FIG. 49

FIG. 50

FIG. 51

FIG. 52

FIG. 53

FIG. 54

FIG. 55

FIG. 56

FIG. 57

FIG. 58

FIG. 59

FIG. 60

FIG. 61

**FIG. 62**

(OZONE)    (EXHAUST)    (EXHAUST)

## FIG. 63

FIG. 64

FIG. 65

FIG. 66

FIG. 67

## FIG. 68

FIG. 69

FIG. 70

FIG. 71

# FIG. 72

**FIG. 73**

**FIG. 74**

# FIG. 75

21

LASER

LXXIV

23

100

101

22

170

179a 179 170a 173

171
171a

175 174

~102~ 172

90

76X

71

76Y

(OZONE)  (EXHAUST)  (EXHAUST)

LXXIV

## FIG. 76

## FIG. 77

EXHAUST

FIG. 78

( a )

92
94
90

( b )

92c
94
90

( c )

94c
90

FIG. 79

FIG. 80

FIG. 81

FIG. 82

FIG. 83

FIG. 84

FIG. 85

FIG. 86(a)

FIG. 86(b)

FIG. 87

## FIG. 88

FIG. 89(a)

FIG. 89(b)

FIG. 89(c)

EP 1 801 861 B1

FIG. 90

FIG. 91

FIG. 92

FIG. 93

FIG. 94

( a )

202
200
90
201
202a

( b )

202
200
90
201
202a

( c )

202a
200
202
90
201

( d )

202a
202
200
90
201

( e )

202a
200
202
90
201

FIG. 95

FIG. 96

FIG. 97

## FIG. 98

( a )

( b )

( c )

FIG. 99

**FIG. 100**

POSITION OF JET NOZZLE 375

y

d

r

$\phi_1$

$\phi_2$

0      $\phi_{91}$   360

(ROTATION ANGLE OF STANDARD POINT 10p OF STAGE 10)

**FIG. 101**

$L_{93}$

93a   d   93b    **90**

r

$\phi_{93}$

91

$\phi_{91}$

90a

**FIG. 102**

y

POSITION OF JET NOZZLE 375

d

r

$\phi_1$

$\phi_2$

0      $\phi_{91}$   360

(ROTATION ANGLE OF STANDARD POINT 10p OF STAGE 10)

**FIG. 103**

FIG. 104

( a )

( b )

**FIG. 105**

( a )

( b )

( c )

( d )

( e )

## FIG. 106

WAFER IS PICKED UP FROM CASSETTE — 101

WAFER IS SET TO STAGE — 102

STAGE STARTS ROTATION — 103

WAFER OUTER PERIPHERAL POSITION DETECTOR
IS BROUGHT TO MEASURING POSITION — 104

PROCESSING HEAD IS BROUGHT TO
PROCESSING EXECUTING POSITION — 105

y-AXIS CROSSING SPOT OF WAFER OUTER
PERIPHERAL PART IS MEASURED
(x-AXIS CROSSING SPOT IS CALCULATED) — 110

IS PROCESSING OVER ENTIRE
PERIPHERY OF WAFER FINISHED? — 111    yes

no

POSITION OF SUPPLY NOZZLE IS ADJUSTED — 112

(FROM SECOND
TIME ON)                    (FIRST TIME)

GAS STARTS JETTING OUT OF
SUPPLY NOZZLE — 113

GAS IS STOPPED JETTING OUT OF
SUPPLY NOZZLE — 120

PROCESSING HEAD IS RETREATED — 121

WAFER OUTER PERIPHERAL POSITION
DETECTOR IS RETREATED — 123

STAGE IS STOPPED ROTATION — 124

WAFER CHUCKING OF STAGE IS CANCELLED — 125

WAFER IS CARRIED OUT OF STAGE — 126

WAFER IS BROUGHT TO CASSETTE — 127

## FIG. 107

WAFER IS PICKED UP FROM CASSETTE — 101

WAFER IS SET TO STAGE — 102

STAGE STARTS ROTATION — 103

WAFER OUTER PERIPHERAL POSITION DETECTOR IS BROUGHT TO MEASURING POSITION — 104

PROCESSING HEAD IS BROUGHT TO PROCESSING EXECUTING POSITION — 105

y-AXIS CROSSING SPOT OF WAFER OUTER PERIPHERAL PART IS MEASURED (x-AXIS CROSSING SPOT IS CALCULATED) — 115

POSITION OF SUPPLY NOZZLE IS ADJUSTED AND GAS IS JETTED — 116

IS PROCESSING OVER ENTIRE PERIPHERY OF WAFER FINISHED? — 117

no

yes

GAS IS STOPPED JETTING OUT OF SUPPLY NOZZLE — 120

PROCESSING HEAD IS RETREATED — 121

WAFER OUTER PERIPHERAL POSITION DETECTOR IS RETREATED — 123

STAGE IS STOPPED ROTATION — 124

WAFER CHUCKING OF STAGE IS CANCELLED — 125

WAFER IS CARRIED OUT OF STAGE — 126

WAFER IS SET TO CASSETTE — 127

FIG. 108

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0582478 B
- JP H08279494 B
- JP H10189515 B
- JP 2003264168 A
- JP 2004096086 A
- JP H05144725 B

- JP 2003188234 A
- JP 2003152051 A
- JP 2004047654 A
- US 2002036047 A1
- JP 2003197570 A